# EUROPEAN PATENT SPECIFICATION

(11) **EP 4 516 878 B1**
(45) Date of publication and mention of the grant of the patent: **10.12.2025**
(21) Application number: 24190812.8
(22) Date of filing: 25.07.2024
(51) Int. Cl.: C09K 11/06, C07F 5/02, C07F 7/08, H10K 50/11, H10K 85/60, H10K 101/00

(54) **LIGHT EMITTING ELEMENT, FUSED POLYCYCLIC COMPOUND FOR THE SAME, AND DISPLAY DEVICE INCLUDING THE SAME**
LICHTEMITTIERENDES ELEMENT, KONDENSIERTE POLYCYCLISCHE VERBINDUNG DAFÜR UND ANZEIGEVORRICHTUNG DAMIT
ÉLÉMENT ÉLECTROLUMINESCENT, COMPOSÉ POLYCYCLIQUE FUSIONNÉ POUR CELUI-CI ET DISPOSITIF D'AFFICHAGE LE COMPRENANT

(30) Priority: 24.08.2023 KR 20230110961
(43) Date of publication of application: 05.03.2025
(60) Divisional application: 25205377.2
(73) Proprietor: Samsung Display Co., Ltd., Gyeonggi-do 17113 (KR)
(72) Inventor: SIM, Mun-Ki, Yongin-si, Gyeonggi-Do 17113 (KR); MIYASHITA, Hirokazu, Yongin-si, Gyeonggi-Do 17113 (KR); KIM, Taeil, Yongin-si, Gyeonggi-Do 17113 (KR); PAK, Sun Young, Yongin-si, Gyeonggi-Do 17113 (KR); PARK, Junha, Yongin-si, Gyeonggi-Do 17113 (KR); JUNG, Minjung, Yongin-si, Gyeonggi-Do 17113 (KR); HUR, Seonhyoung, Yongin-si, Gyeonggi-Do 17113 (KR)
(74) Representative: Gulde & Partner

(56) References cited:
- CN-A- 116 478 198
- CN-A- 116 574 116
- CN-A- 116 621 863
- US-A1- 2022 181 557
- US-A1- 2023 232 715

## Description

### BACKGROUND

### 1. Filed

One or more embodiments of the present disclosure herein relates to a light emitting element, a fused polycyclic compound utilized in the light emitting element, and a display device including the light emitting element.

### 2. Description of the Related Art

Recently, the development of an organic electroluminescence device as an image display device is being actively conducted. The organic electroluminescence device is different from a liquid crystal display device and is a self-luminescent device in which holes and electrons respectively injected from a first electrode and a second electrode combine in an emission layer of the organic electroluminescence device so that a light emitting material including an organic compound in the emission layer emits light to achieve display (e.g., of images).

In the application of an organic electroluminescence device to a display device, reducing a driving voltage and increasing the emission efficiency and lifetime of the organic electroluminescence device are desired or required, and thus development on materials for an organic electroluminescence device stably achieving such requirements is being continuously desired or pursued.

For example, recently, in order to accomplish an organic electroluminescence device with relatively high efficiency, techniques on phosphorescence emission which utilizes energy in a triplet state or fluorescence emission which utilizes the generating phenomenon of singlet excitons by the collision of triplet excitons (triplet-triplet annihilation, TTA) are being developed, and development on a thermally activated delayed fluorescence (TADF) material utilizing the delayed fluorescence phenomenon is being actively conducted.

### SUMMARY

The invention is defined by the appended claims. The description that follows is subjected to this limitation. Any disclosure lying outside the scope of said claims is only intended for illustrative as well as comparative purposes. One or more aspects of embodiments of the present disclosure are directed toward a light emitting element having improved emission efficiency and element lifetime.

One or more aspects of embodiments of the present disclosure are directed toward a fused polycyclic compound which may improve the emission efficiency and element lifetime of a light emitting element.

One or more aspects of embodiments of the present disclosure are directed toward a display device having excellent or suitable display quality by including a light emitting element having improved emission efficiency and lifetime.

Additional aspects will be set forth in part in the description which follows and, in part, will be apparent from the description, or may be learned by practice of the presented embodiments.

According to one or more embodiments of the present disclosure, a light emitting element includes a first electrode, a second electrode on the first electrode, and an emission layer between the first electrode and the second electrode, wherein the emission layer includes a first compound represented by Formula 1.

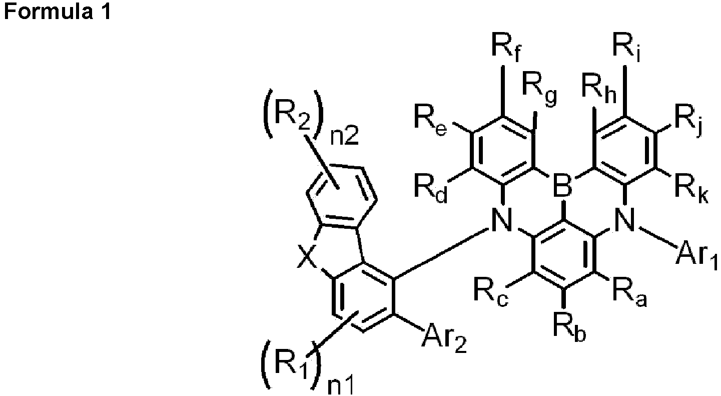

In Formula 1, X may be O or S, Ar₁ and Ar₂ may each independently be a substituted or unsubstituted aryl group of 6 to 30 ring-forming carbon atoms or a substituted or unsubstituted heteroaryl group of 2 to 30 ring-forming carbon atoms, R₁, R₂, and Rₐ to Rₖ may each independently be hydrogen, deuterium, a halogen, a cyano group, a nitro group, a substituted or unsubstituted amine group, a substituted or unsubstituted oxy group, a substituted or unsubstituted thio group, a substituted or unsubstituted boron group, a substituted or unsubstituted silyl group, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms, and/or combined with an adjacent group to form (or provide) a ring, n1 may be an integer of 0 to 2, and n2 may be an integer of 0 to 4. US 2023/232715 A1 discloses a fused polycyclic compound similar to Formula 1.

In one or more embodiments, the first compound represented by Formula 1 may be represented by Formula 2.

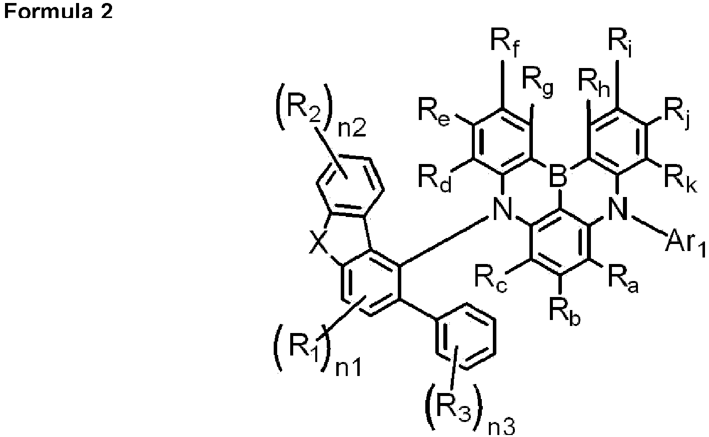

In Formula 2, R₃ may each independently be hydrogen, deuterium, a halogen, a cyano group, a nitro group, a substituted or unsubstituted amine group, a substituted or unsubstituted oxy group, a substituted or unsubstituted thio group, a substituted or unsubstituted boron group, a substituted or unsubstituted silyl group, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms, and/or combined with an adjacent group to form (or provide) a ring, and n3 is may be integer of 0 to 5.

In Formula 2, the same contents defined in Formula 1 may be applied for X, Ar₁, R₁, R₂, Rₐ to Rₖ, n1, and n2.

In one or more embodiments, the first compound represented by Formula 1 may be represented by Formula 3-1 or Formula 3-2.

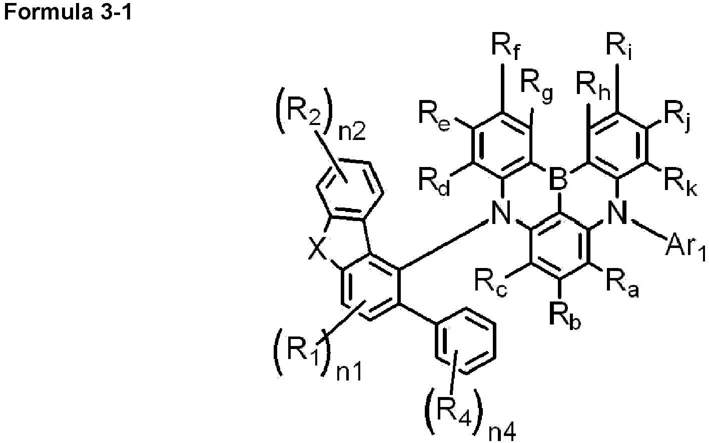

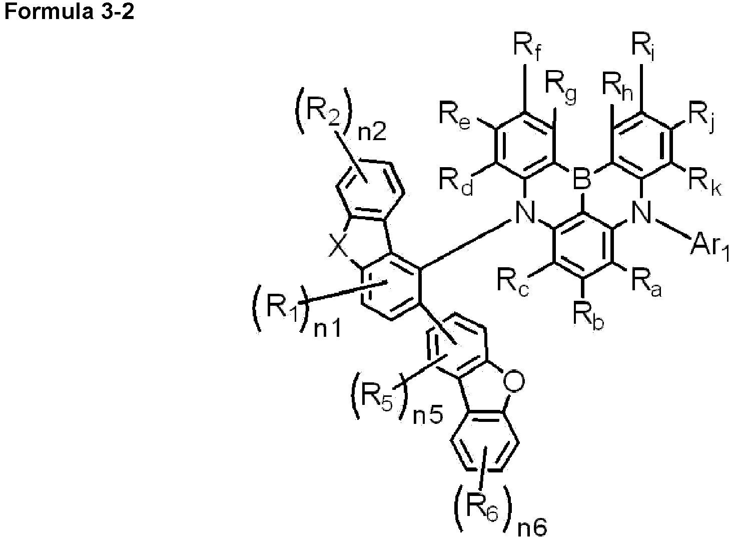

In Formula 3-1 and Formula 3-2, R₄ to R₆ may each independently be hydrogen, deuterium, a halogen, a cyano group, a nitro group, a substituted or unsubstituted amine group, a substituted or unsubstituted oxy group, a substituted or unsubstituted thio group, a substituted or unsubstituted boron group, a substituted or unsubstituted silyl group, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms, n4 may be an integer of 0 to 5, n5 may be an integer of 0 to 3, and n6 may be an integer of 0 to 4

In Formula 3-1 and Formula 3-2, the same contents defined in Formula 1 may be applied for X, Ar₁, R₁, R₂, Rₐ to Rₖ, n1, and n2.

In one or more embodiments, the first compound represented by Formula 1 may be represented by Formula 4.

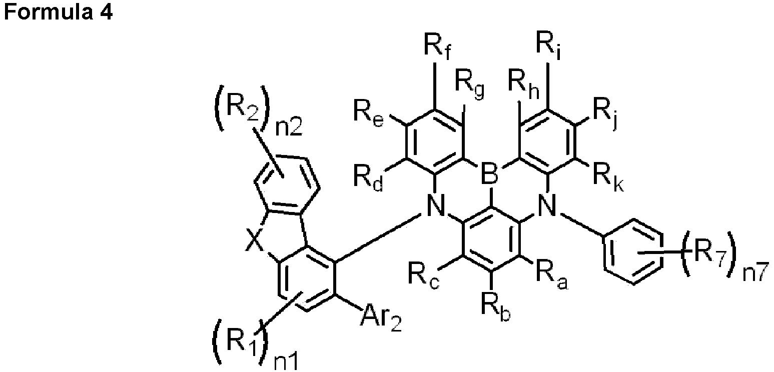

In Formula 4, R₇ may each independently be hydrogen, deuterium, a halogen, a cyano group, a nitro group, a substituted or unsubstituted amine group, a substituted or unsubstituted oxy group, a substituted or unsubstituted thio group, a substituted or unsubstituted boron group, a substituted or unsubstituted silyl group, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms, and/or combined with an adjacent group to form (or provide) a ring, and n7 may be an integer of 0 to 5.

In Formula 4, the same contents defined in Formula 1 may be applied for X, Ar₂, R₁, R₂, Rₐ to Rₖ, n1, and n2.

In one or more embodiments, the first compound represented by Formula 1 may be represented by Formula 5-1 or Formula 5-2.

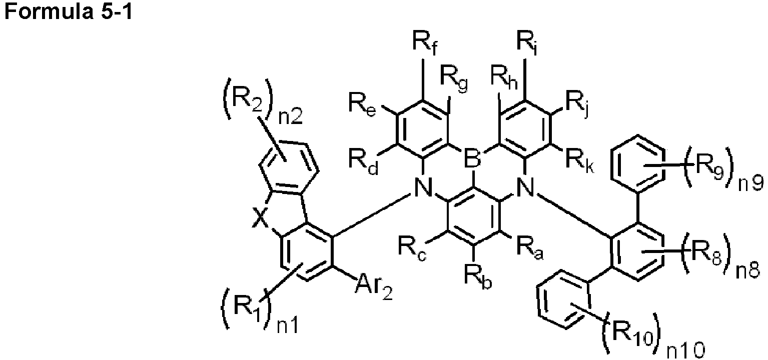

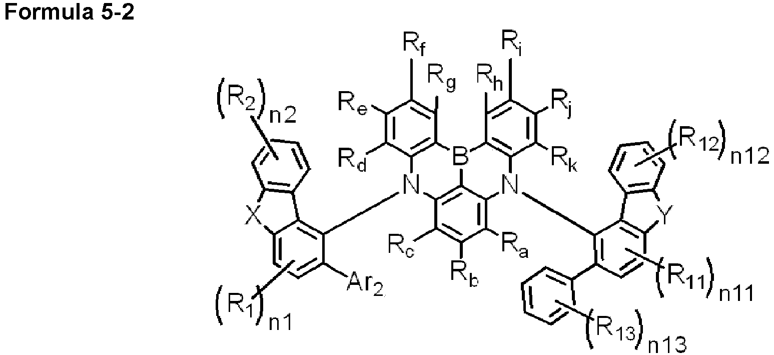

In Formula 5-1 and Formula 5-2, Y may be O or S, R₈ to R₁₂ may each independently be hydrogen, deuterium, a halogen, a cyano group, a nitro group, a substituted or unsubstituted amine group, a substituted or unsubstituted oxy group, a substituted or unsubstituted thio group, a substituted or unsubstituted boron group, a substituted or unsubstituted silyl group, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms, R₁₃ may each independently be hydrogen, deuterium, a halogen, a cyano group, a nitro group, a substituted or unsubstituted amine group, a substituted or unsubstituted oxy group, a substituted or unsubstituted thio group, a substituted or unsubstituted boron group, a substituted or unsubstituted silyl group, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms, and/or combined with an adjacent group to form (or provide) a ring, n8 may be an integer of 0 to 3, n12 may be an integer of 0 to 4, n9, n10, and n13 may each independently be an integer of 0 to 5, and n11 may be an integer of 0 to 2.

In Formula 5-1 and Formula 5-2, the same contents defined in Formula 1 may be applied for X, Ar₂, R₁, R₂, Rₐ to Rₖ, n1, and n2.

In one or more embodiments, the first compound represented by Formula 1 may be represented by one selected from among Formula 6-1 to Formula 6-4.

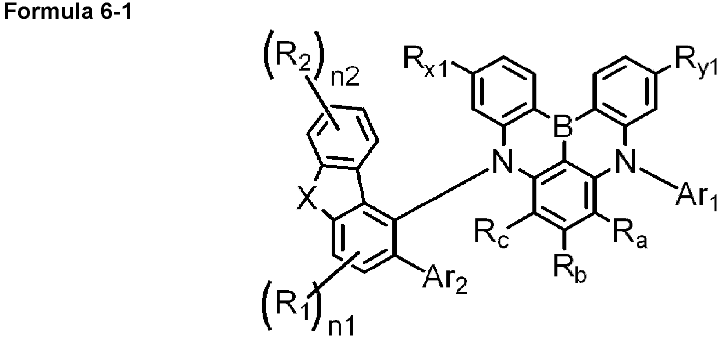

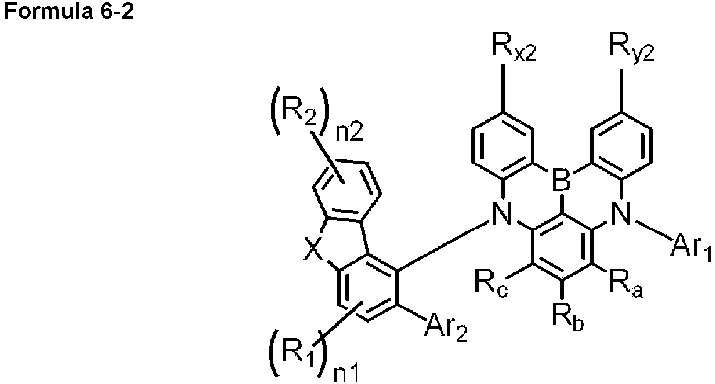

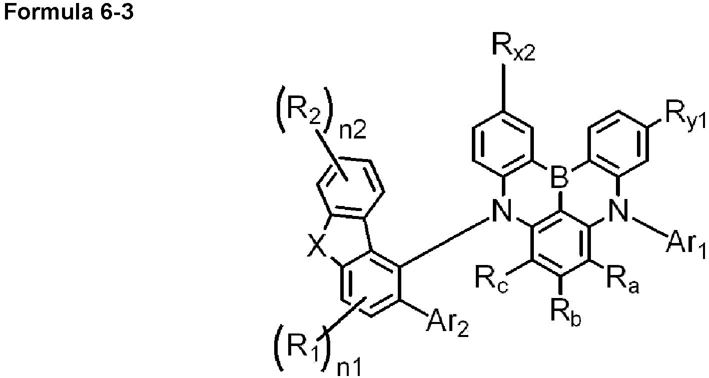

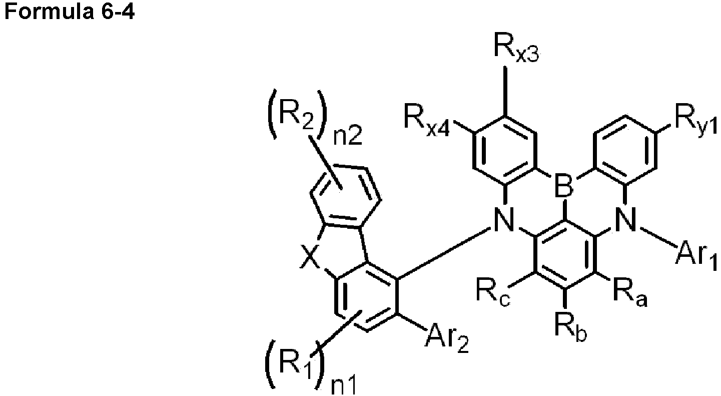

In Formula 6-1 to Formula 6-4, Rₓ₁, Rₓ₂, R_{y1}, and R_{y2} may each independently be deuterium, a halogen, a substituted or unsubstituted amine group, a substituted or unsubstituted silyl group, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms, Rₓ₃ and Rₓ₄ may each independently be deuterium, a halogen, a substituted or unsubstituted amine group, a substituted or unsubstituted silyl group, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms, and/or combined with an adjacent group to form (or provide) a ring.

In Formula 6-1 to Formula 6-4, the same contents defined in Formula 1 may be applied for X, Ar₁, Ar₂, R₁, R₂, Rₐ to R_{c}, n1, and n2.

In one or more embodiments, in Formula 6-1 to Formula 6-4, Rₓ₁, Rₓ₂, R_{y1}, and R_{y2} may each independently be a substituted or unsubstituted silyl group, a substituted or unsubstituted amine group, a substituted or unsubstituted phenyl group, a substituted or unsubstituted biphenyl group, a substituted or unsubstituted dibenzofuran group, a substituted or unsubstituted N-carbazole group, or a substituted or unsubstituted acridine group.

In one or more embodiments, the first compound represented by Formula 1 may be represented by Formula 7.

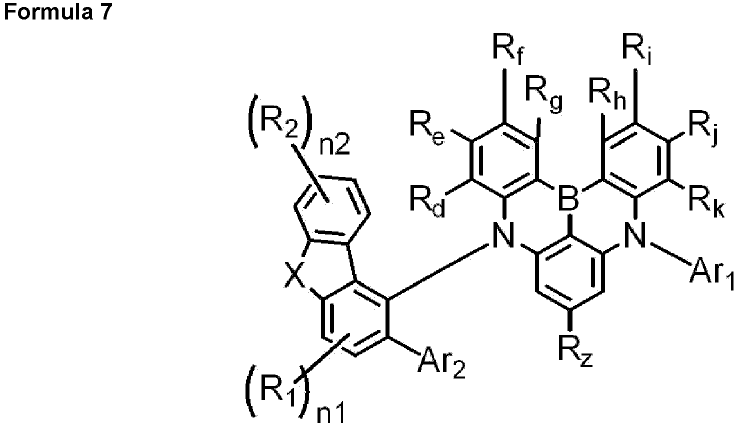

In Formula 7, R_{z} may be deuterium, a halogen, a substituted or unsubstituted amine group, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms.

In Formula 7, the same contents defined in Formula 1 may be applied for X, Ar₁, Ar₂, R₁, R₂, R_{d} to Rₖ, n1, and n2.

In one or more embodiments, in Formula 7, R_{z} may be a substituted or unsubstituted t-butyl group, a substituted or unsubstituted phenyl group, a substituted or unsubstituted biphenyl group, a substituted or unsubstituted terphenyl group, a substituted or unsubstituted dibenzofuran group, a substituted or unsubstituted carbazole group, a substituted or unsubstituted fluorenyl group, a substituted or unsubstituted xanthene group, or a substituted or unsubstituted indolocarbazole group.

In one or more embodiments, the first compound represented by Formula 1 may be represented by Formula 8.

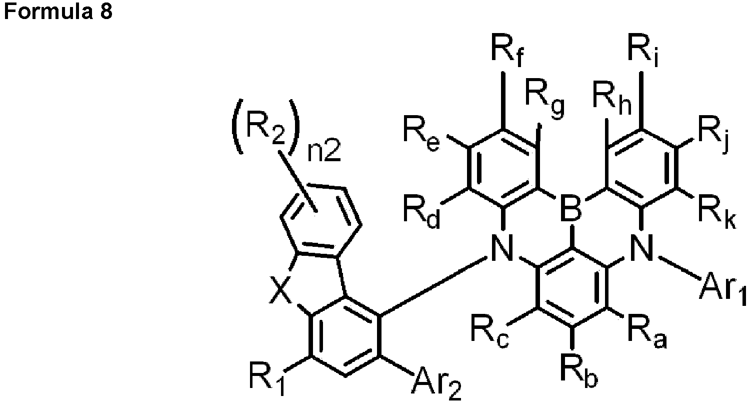

In Formula 8, the same contents defined in Formula 1 may be applied for X, Ar₁, Ar₂, R₁, R₂, Rₐ to Rₖ, and n2.

In one or more embodiments, the emission layer may further include at least one selected from among a second compound represented by Formula HT-1, a third compound represented by Formula ET-1, and a fourth compound represented by Formula D-1.

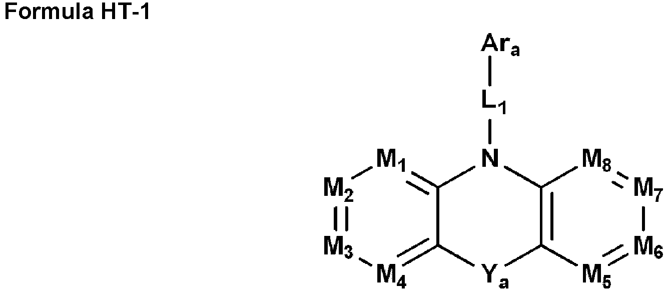

In Formula HT-1, M₁ to M₈ may each independently be N or CR₅₁, L₁ may be a direct linkage, a substituted or unsubstituted arylene group of 6 to 30 ring-forming carbon atoms, or a substituted or unsubstituted heteroarylene group of 2 to 30 ring-forming carbon atoms, Yₐ may be a direct linkage, CR₅₂R₅₃, or SiR₅₄R₅₅, Arₐ may be a substituted or unsubstituted aryl group of 6 to 30 ring-forming carbon atoms, or a substituted or unsubstituted heteroaryl group of 2 to 30 ring-forming carbon atoms, and R₅₁ to R₅₅ may each independently be hydrogen, deuterium, a halogen, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group of 1 to 20 carbon atoms, a substituted or unsubstituted alkenyl group of 2 to 20 carbon atoms, a substituted or unsubstituted aryl group of 6 to 60 ring-forming carbon atoms, or a substituted or unsubstituted heteroaryl group of 2 to 60 ring-forming carbon atoms, and/or combined with an adjacent group to form (or provide) a ring.

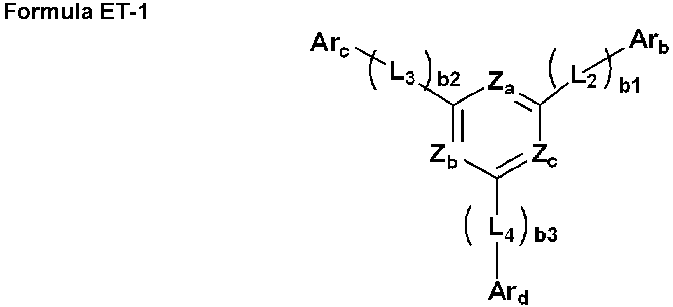

In Formula ET-1, at least one selected from among Zₐ to Z_{c} is N, and the remainder may be CR₅₆, R₅₆ may be hydrogen, deuterium, a substituted or unsubstituted alkyl group of 1 to 20 carbon atoms, a substituted or unsubstituted aryl group of 6 to 60 ring-forming carbon atoms, or a substituted or unsubstituted heteroaryl group of 2 to 60 ring-forming carbon atoms, b1 to b3 may each independently be an integer of 0 to 10, Ar_{b} to Ar_{d} may each independently be hydrogen, deuterium, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms, and L₂ to L₄ may each independently be a direct linkage, a substituted or unsubstituted arylene group of 6 to 30 ring-forming carbon atoms, or a substituted or unsubstituted heteroarylene group of 2 to 30 ring-forming carbon atoms.

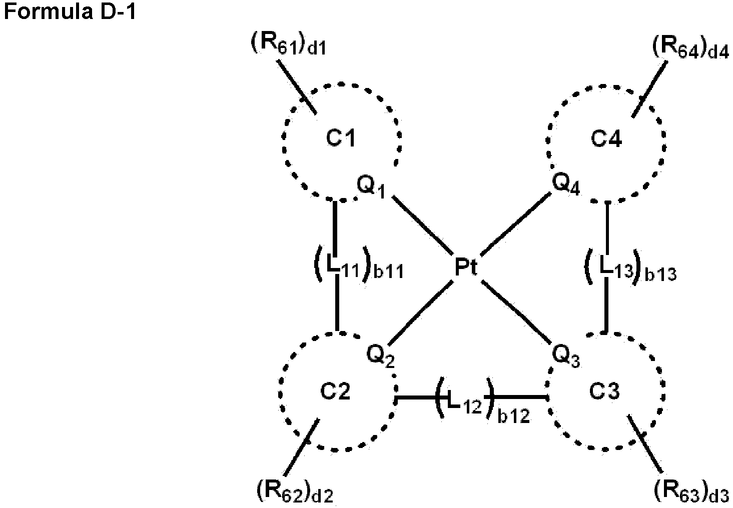

In Formula D-1, Q₁ to Q₄ may each independently be C or N, rings C1 to C4 may each independently be a substituted or unsubstituted hydrocarbon ring of 5 to 30 ring-forming carbon atoms, or a substituted or unsubstituted heterocycle of 2 to 30 ring-forming carbon atoms, L₁₁ to L₁₃ may each independently be a direct linkage, *-O-* , *-S-* , 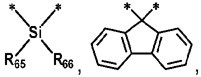 a substituted or unsubstituted alkylene group of 1 to 20 carbon atoms, a substituted or unsubstituted arylene group of 6 to 30 ring-forming carbon atoms, or a substituted or unsubstituted heteroarylene group of 2 to 30 ring-forming carbon atoms, b11 to b13 may each independently be 0 or 1, R₆₁ to R₆₆ may each independently be hydrogen, deuterium, a halogen, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group of 1 to 20 carbon atoms, a substituted or unsubstituted alkenyl group of 2 to 20 carbon atoms, a substituted or unsubstituted aryl group of 6 to 60 ring-forming carbon atoms, or a substituted or unsubstituted heteroaryl group of 2 to 60 ring-forming carbon atoms, and d1 to d4 may each independently be an integer of 0 to 4.

A display device according to one or more embodiments of the present disclosure includes a base layer, a circuit layer on the base layer, and a display device layer on the circuit layer and including a light emitting element. The light emitting element includes a first electrode, a second electrode on the first electrode, and an emission layer between the first electrode and the second electrode and including a first compound represented by Formula 1.

In one or more embodiments, the light emitting element may further include a capping layer on the second electrode. A refractive index of the capping layer may be about 1.6 or more with respect to light in a wavelength range of about 550 nm to about 660 nm.

In one or more embodiments, the display device may further include a light control layer on the display device layer and including a quantum dot. The light emitting element may be to emit first color light, and the light control layer may include a first light control part including a first quantum dot converting first color light into second color light in a wavelength region longer than the first color light, a second light control part including a second quantum dot converting the first color light into third color light in a wavelength region longer than the first color light and the second color light, and a third light control part transmitting the first color light.

In one or more embodiments, the display device may further include a color filter layer on the light control layer. The color filter layer may include a first filter configured to transmit the second color light, a second filter configured to transmit the third color light, and a third filter configured to transmit the first color light.

According to one or more embodiments of the present disclosure, a fused polycyclic compound e may be represented by Formula 1.

### BRIEF DESCRIPTION OF THE DRAWINGS

The accompanying drawings are included to provide a further understanding of the present disclosure and are incorporated in and constitute a part of this disclosure. The drawings illustrate example embodiments of the present disclosure and, together with the description, serve to explain principles of the present disclosure. Above and/or other aspects of the present disclosure should become apparent and appreciated from the following description of embodiments taken in conjunction with the accompanying drawings. In the drawings:
FIG. 1 is a plan view of a display apparatus according to one or more embodiments of the present disclosure;
FIG. 2 is a cross-sectional view of a display apparatus according to one or more embodiments of the present disclosure;
FIG. 3 is a cross-sectional view schematically showing a light emitting element according to one or more embodiments of the present disclosure;
FIG. 4 is a cross-sectional view schematically showing a light emitting element according to one or more embodiments of the present disclosure;
FIG. 5 is a cross-sectional view schematically showing a light emitting element according to one or more embodiments of the present disclosure;
FIG. 6 is a cross-sectional view schematically showing a light emitting element according to one or more embodiments of the present disclosure;
FIG. 7 and FIG. 8 are each a cross-sectional view of a display apparatus according to one or more embodiments of the present disclosure;
FIG. 9 is a cross-sectional view showing a display apparatus according to one or more embodiments of the present disclosure;
FIG. 10 is a cross-sectional view showing a display apparatus according to one or more embodiments of the present disclosure; and
FIG. 11 is a diagram showing a vehicle in which display apparatuses according to one or more embodiments are arranged.

### DETAILED DESCRIPTION

When explaining each of drawings, like reference numbers are utilized for referring to like elements. In the accompanying drawings, the dimensions of each structure may be exaggeratingly illustrated for clarity of the present disclosure. It will be understood that, although the terms "first," "second," and/or the like, may be utilized herein to describe one or more suitable components, these components should not be limited by these terms. These terms are only utilized to distinguish one component from another. For example, a first component could be termed a second component, and, similarly, a second component could be termed a first component, without departing from the scope of example embodiments of the present disclosure. As utilized herein, the singular forms, "a," "an," "one," and "the" are intended to include the plural forms as well, unless the context clearly indicates otherwise. Further, the utilization of "may" when describing embodiments of the present disclosure refers to "one or more embodiments of the present disclosure".

In the present disclosure, it will be understood that the terms "comprise(s)/comprising," "include(s)/including," "have(has)/having," and/or the like specify the presence of features, numbers, steps, operations, component, parts, or combinations thereof disclosed in the disclosure, but do not exclude the possibility of presence or addition of one or more other features, numbers, steps, operations, component, parts, or combinations thereof. As used herein, the terms "and", "or", and "and/or" may include any and all combinations of one or more of the associated listed items. Expressions such as "at least one of," "one of," and "selected from," when preceding a list of elements, modify the entire list of elements and do not modify the individual elements of the list. For example, "at least one of a, b, or c", "at least one selected from a, b, and c", "at least one selected from among a to c", *etc.*, may indicate only a, only b, only c, both (e.g., simultaneously) a and b, both (e.g., simultaneously) a and c, both (e.g., simultaneously) b and c, all of a, b, and c, or variations thereof. The "/" utilized herein may be interpreted as "and" or as "or" depending on the situation.

In the present disclosure, if a layer, a film, a region, or a plate is referred to as being "on" or "in an upper portion of" another layer, film, region, or plate, it may be not only "directly on" the layer, film, region, or plate, but one or more intervening layers, films, regions, or plates may also be present. Opposite this, if a layer, a film, a region, or a plate is referred to as being "below", "in a lower portion of" another layer, film, region, or plate, it can be not only directly under the layer, film, region, or plate, but one or more intervening layers, films, regions, or plates may also be present. In one or more embodiments, it will be understood that if a part is referred to as being "on" another part, it can be arranged above the other part, or arranged under the other part as well. In one or more embodiments, "directly on" may refer to that there are no additional layers, films, regions, plates, *etc.*, between a layer, a film, a region, a plate, *etc.* and the other part. For example, "directly on" may refer to two layers or two members are disposed without utilizing an additional member such as an adhesive member therebetween.

In the present disclosure, the term "substituted" refers to the replacement of hydrogen by one of deuterium, a halogen, a cyano group, a nitro group, an amino group, a silyl group, an oxy group, a thio group, a sulfinyl group, a sulfonyl group, a carbonyl group, a boron group, a phosphine oxide group, a phosphine sulfide group, an alkyl group, an alkenyl group, an alkynyl group, a hydrocarbon ring group, an aryl group, and a heterocyclic group. For example, a biphenyl group may be interpreted as an aryl group or a phenyl group substituted with a phenyl group.

In the present disclosure, the phrase "bonded to an adjacent group to form (or provide) a ring" refers to that a group is bonded to an adjacent group to form (or provide) a substituted or unsubstituted hydrocarbon ring, or a substituted or unsubstituted heterocycle. The hydrocarbon ring may include an aliphatic hydrocarbon ring and/or an aromatic hydrocarbon ring. The heterocycle may include an aliphatic heterocycle and/or an aromatic heterocycle. The hydrocarbon ring and the heterocycle may each be monocyclic or polycyclic. In one or more embodiments, the rings formed by adjacent groups being bonded to each other may be connected to another ring to form (or provide) a spiro structure.

In the present disclosure, the term "adjacent group" refers to a substituent substituted for an atom which is directly linked to an atom substituted with a corresponding substituent, another substituent substituted for an atom which is substituted with a corresponding substituent, or a substituent sterically positioned at the nearest position to a corresponding substituent. For example, two methyl groups in 1,2-dimethylbenzene may be interpreted as "adjacent groups" to each other and two ethyl groups in 1,1-diethylcyclopentane may be interpreted as "adjacent groups" to each other. In one or more embodiments, two methyl groups in 4,5-dimethylphenanthrene may be interpreted as "adjacent groups" to each other.

In the present disclosure, examples of a halogen include fluorine, chlorine, bromine, or iodine.

In the present disclosure, an alkyl group may be linear or branched. The number of carbons in the alkyl group may be 1 to 50, 1 to 30, 1 to 20, 1 to 10, or 1 to 6. Examples of the alkyl group may include a methyl group, an ethyl group, an n-propyl group, an isopropyl group, an n-butyl group, an s-butyl group, a t-butyl group, an i-butyl group, a 2-ethylbutyl group, a 3,3-dimethylbutyl group, an n-pentyl group, an i-pentyl group, a neopentyl group, a t-pentyl group, a 1-methylpentyl group, a 3-methylpentyl group, a 2-ethylpentyl group, a 4-methyl-2-pentyl group, an n-hexyl group, a 1-methylhexyl group, a 2-ethylhexyl group, a 2-butylhexyl group, an n-heptyl group, a 1-methylheptyl group, a 2,2-dimethylheptyl group, a 2-ethylheptyl group, a 2-butylheptyl group, an n-octyl group, a t-octyl group, a 2-ethyloctyl group, a 2-butyloctyl group, a 2-hexyloctyl group, a 3,7-dimethyloctyl group, an n-nonyl group, an n-decyl group, an adamantyl group, a 2-ethyldecyl group, a 2-butyldecyl group, a 2-hexyldecyl group, a 2-octyldecyl group, an n-undecyl group, an n-dodecyl group, a 2-ethyldodecyl group, a 2-butyldodecyl group, a 2-hexyldocecyl group, a 2-octyldodecyl group, an n-tridecyl group, an n-tetradecyl group, an n-pentadecyl group, an n-hexadecyl group, a 2-ethylhexadecyl group, a 2-butylhexadecyl group, a 2-hexylhexadecyl group, a 2-octylhexadecyl group, an n-heptadecyl group, an n-octadecyl group, an n-nonadecyl group, an n-eicosyl group, a 2-ethyleicosyl group, a 2-butyleicosyl group, a 2-hexyleicosyl group, a 2-octyleicosyl group, an n-henicosyl group, an n-docosyl group, an n-tricosyl group, an n-tetracosyl group, an n-pentacosyl group, an n-hexacosyl group, an n-heptacosyl group, an n-octacosyl group, an n-nonacosyl group, an n-triacontyl group, and/or the like, but embodiments of the present disclosure are not limited thereto.

In the present disclosure, a cycloalkyl group refers to a cyclic alkyl group. The number of carbons in the cycloalkyl group may be 3 to 50, 3 to 30, 3 to 20, or 3 to 10. Examples of the cycloalkyl group may include a cyclopropyl group, a cyclobutyl group, a cyclopentyl group, a cyclohexyl group, a 4-methylcyclohexyl group, a 4-t-butylcyclohexyl group, a cycloheptyl group, a cyclooctyl group, a cyclononyl group, a cyclodecyl group, a norbornyl group, a 1-adamantyl group, a 2-adamantyl group, an isobornyl group, a bicycloheptyl group, and/or the like, but embodiments of the present disclosure are not limited thereto.

In the present disclosure, an alkenyl group refers to a hydrocarbon group including at least one carbon-carbon double bond in the middle or terminal of an alkyl group having 2 or more carbon atoms. The alkenyl group may be linear or branched. The number of carbon atoms in the alkenyl group is not specifically limited, for example, may be 2 to 30, 2 to 20, or 2 to 10. Examples of the alkenyl group may include a vinyl group, a 1-butenyl group, a 1-pentenyl group, a 1,3-butadienyl aryl group, a styrenyl group, a styryl vinyl group, and/or the like, but embodiments of the present disclosure are not limited thereto.

In the present disclosure, an alkynyl group refers to a hydrocarbon group including at least one carbon-carbon triple bond in the middle or terminal of an alkyl group having 2 or more carbon atoms. The alkynyl group may be linear or branched. Although the number of carbon atoms is not specifically limited, it may be 2 to 30, 2 to 20, or 2 to 10. Examples of the alkynyl group may include an ethynyl group, a propynyl group, and/or the like, but embodiments of the present disclosure are not limited thereto.

In the present disclosure, a hydrocarbon ring group refers to any functional group or substituent derived from an aliphatic hydrocarbon ring. The hydrocarbon ring group may be a saturated hydrocarbon ring group having 5 to 20 ring-forming carbon atoms.

In the present disclosure, an aryl group refers to any functional group or substituent derived from an aromatic hydrocarbon ring. The aryl group may be a monocyclic aryl group or a polycyclic aryl group. The number of ring-forming carbon atoms in the aryl group may be 6 to 30, 6 to 20, or 6 to 15. Examples of the aryl group may include a phenyl group, a naphthyl group, a fluorenyl group, an anthracenyl group, a phenanthryl group, a biphenyl group, a terphenyl group, a quaterphenyl group, a quinquephenyl group, a sexiphenyl group, a triphenylenyl group, a pyrenyl group, a benzofluoranthenyl group, a chrysenyl group, and/or the like, but embodiments of the present disclosure are not limited thereto.

In the present disclosure, a fluorenyl group may be substituted, and two substituents may be bonded to each other to form (or provide) a spiro structure. Examples of the substituted fluorenyl group are as follows. However, embodiments of the present disclosure are not limited thereto.

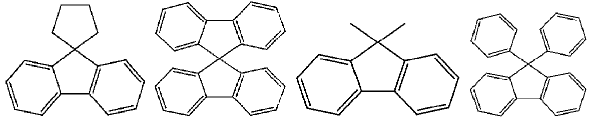

A heterocyclic group utilized herein refers to any functional group or substituent derived from a ring containing at least one of B, O, N, P, Si, or Se as a heteroatom. The heterocyclic group may include an aliphatic heterocyclic group and/or an aromatic heterocyclic group. The aromatic heterocyclic group may be a heteroaryl group. The aliphatic heterocycle and the aromatic heterocycle may each be monocyclic or polycyclic.

In the present disclosure, the heterocyclic group may contain at least one of B, O, N, P, Si or S as a heteroatom. If the heterocyclic group contains two or more heteroatoms, the two or more heteroatoms may be the same as or different from each other. The heterocyclic group may be a monocyclic heterocyclic group or a polycyclic heterocyclic group, and may include a heteroaryl group. The number of ring-forming carbon atoms in the heterocyclic group may be 2 to 30, 2 to 20, or 2 to 10.

In the present disclosure, an aliphatic heterocyclic group may include at least one of B, O, N, P, Si, or S as a heteroatom. The number of ring-forming carbon atoms in the aliphatic heterocyclic group may be 2 to 30, 2 to 20, or 2 to 10. Examples of the aliphatic heterocyclic group may include an oxirane group, a thiirane group, a pyrrolidine group, a piperidine group, a tetrahydrofuran group, a tetrahydrothiophene group, a thiane group, a tetrahydropyran group, a 1,4-dioxane group, and/or the like, but embodiments of the present disclosure are not limited thereto.

In the present disclosure, a heteroaryl group may contain at least one of B, O, N, P, Si, or S as a heteroatom. If the heteroaryl group contains two or more heteroatoms, the two or more heteroatoms may be the same as or different from each other. The heteroaryl group may be a monocyclic heterocyclic group or a polycyclic heterocyclic group. The number of ring-forming carbon atoms in the heteroaryl group may be 2 to 30, 2 to 20, or 2 to 10. Examples of the heteroaryl group may include a thiophene group, a furan group, a pyrrole group, an imidazole group, a pyridine group, a bipyridine group, a pyrimidine group, a triazine group, a triazole group, an acridine group, a pyridazine group, a pyrazinyl group, a quinoline group, a quinazoline group, a quinoxaline group, a phenoxazine group, a phthalazine group, a pyrido pyrimidine group, a pyrido pyrazine group, a pyrazino pyrazine group, an isoquinoline group, an indole group, a carbazole group, an N-arylcarbazole group, an N-heteroarylcarbazole group, an N-alkylcarbazole group, a benzoxazole group, a benzimidazole group, a benzothiazole group, a benzocarbazole group, a benzothiophene group, a dibenzothiophene group, a thienothiophene group, a benzofuran group, a phenanthroline group, a thiazole group, an isoxazole group, an oxazole group, an oxadiazole group, a thiadiazole group, a phenothiazine group, a dibenzosilole group, a dibenzofuran group, a xanthene group, a indolocarbazole group, and/or the like, but embodiments of the present disclosure are not limited thereto.

In the disclosure, the above description of the aryl group may be applied to an arylene group except that the arylene group is a divalent group. The above description of the heteroaryl group may be applied to a heteroarylene group except that the heteroarylene group is a divalent group.

In the present disclosure, a silyl group may include an alkylsilyl group and/or an arylsilyl group. Examples of the silyl group may include a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group, and/or the like, but embodiments of the present disclosure are not limited thereto.

In the present disclosure, the number of carbon atoms in a carbonyl group is not specifically limited, but may be 1 to 40, 1 to 30, or 1 to 20. For example, the carbonyl group may have the following structures, but embodiments of the present disclosure are not limited thereto.

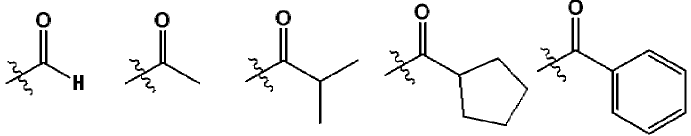

In the present disclosure, the number of carbon atoms in a sulfinyl group or a sulfonyl group is not particularly limited, for example, may be 1 to 30. The sulfinyl group may include an alkyl sulfinyl group and/or an aryl sulfinyl group. The sulfonyl group may include an alkyl sulfonyl group and/or an aryl sulfonyl group.

In the present disclosure, a thio group may include an alkylthio group and/or an arylthio group. The thio group may refer to that a sulfur atom is bonded to the alkyl group or the aryl group defined above. Examples of the thio group may include a methylthio group, an ethylthio group, a propylthio group, a pentylthio group, a hexylthio group, an octylthio group, a dodecylthio group, a cyclopentylthio group, a cyclohexylthio group, a phenylthio group, and a naphthylthio group, but embodiments of the present disclosure are not limited thereto.

In the present disclosure, an oxy group may refer to that an oxygen atom is bonded to the alkyl group or the aryl group defined above. The oxy group may include an alkoxy group and/or an aryl oxy group. The alkoxy group may be a linear chain, a branched chain, or a ring. The number of carbon atoms in the alkoxy group is not specifically limited, but may be, for example, 1 to 20 or 1 to 10. Examples of the oxy group may include methoxy, ethoxy, n-propoxy, isopropoxy, butoxy, pentyloxy, hexyloxy, octyloxy, nonyloxy, decyloxy, benzyloxy, and/or the like, but embodiments of the present disclosure are not limited thereto.

A boron group utilized herein may refer to that a boron atom is bonded to the alkyl group or the aryl group defined above. The boron group may include an alkyl boron group and/or an aryl boron group. Examples of the boron group may include a dimethylboron group, a trimethylboron group, a t-butyldimethylboron group, a diphenylboron group, a phenylboron group, and/or the like, but embodiments of the present disclosure are not limited thereto.

In the present disclosure, the number of carbon atoms in an amine group is not specifically limited, for example, may be 1 to 30. The amine group may include an alkyl amine group and/or an aryl amine group. Examples of the amine group may include a methylamine group, a dimethylamine group, a phenylamine group, a diphenylamine group, a naphthylamine group, a 9-methyl-anthracenylamine group, and/or the like, but embodiments of the present disclosure are not limited thereto.

In the present disclosure, the alkyl group among an alkylthio group, an alkylsulfoxy group, an alkylaryl group, an alkylamino group, an alkyl boron group, an alkyl silyl group, and an alkyl amine group may be the same as the examples of the alkyl group described above.

In the present disclosure, the aryl group among an aryloxy group, an arylthio group, an arylsulfoxy group, an arylamino group, an arylboron group, an arylsilyl group, and an arylamine group may be the same as the examples of the aryl group described above.

In the present disclosure, a direct linkage may refer to a single bond.

In the present disclosure, 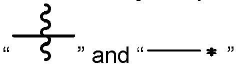 refer to a position to be connected.

Hereinafter, embodiments of the present disclosure will be described in more detail with reference to the accompanying drawings. In the present disclosure, the term "light emitting device" may be utilized interchangeably with the term "light emitting element."

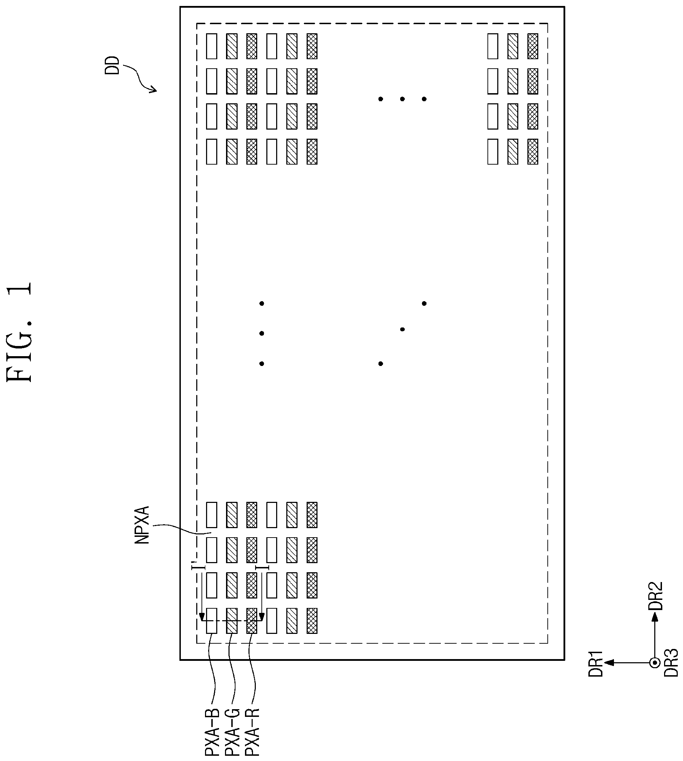

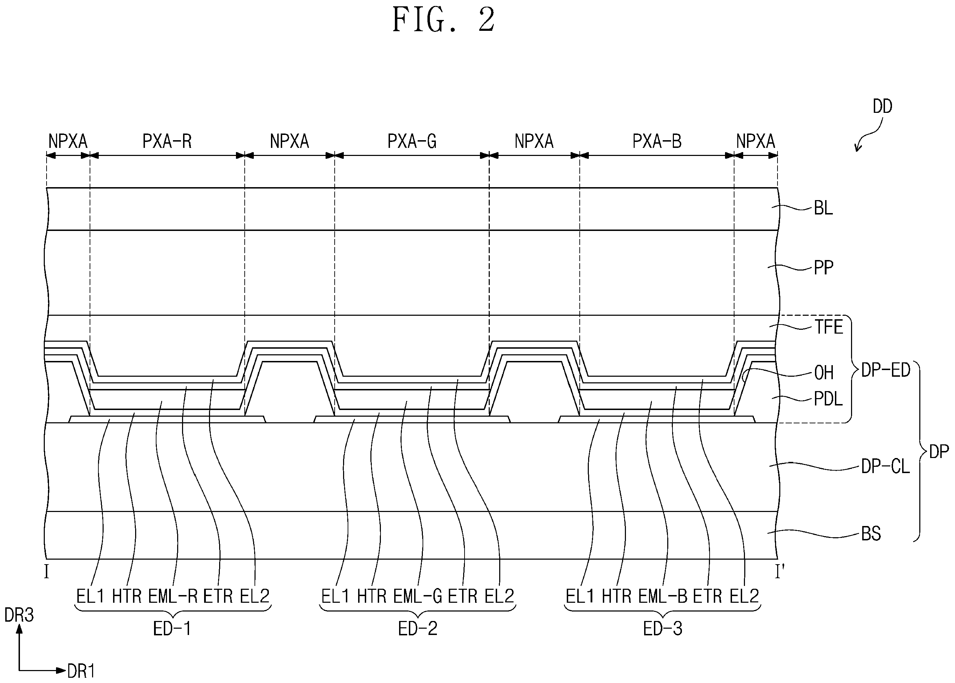

FIG. 1 is a plan view illustrating a display apparatus DD according to one or more embodiments of the present disclosure. FIG. 2 is a cross-sectional view of the display apparatus DD according to one or more embodiments. FIG. 2 is a cross-sectional view illustrating a part taken along the line I-I' of the display apparatus of FIG. 1.

The display apparatus DD may include a display panel DP and an optical layer PP arranged on the display panel DP. The display panel DP may include light emitting devices ED-1, ED-2, and ED-3. The display apparatus DD may include a plurality of light emitting devices ED-1, ED-2, and ED-3. The optical layer PP may be arranged on the display panel DP to control reflected light in the display panel DP due to external light. The optical layer PP may include, for example, a polarization layer and/or a color filter layer. In one or more embodiments, the optical layer PP may not be provided in the display apparatus DD.

A base substrate BL may be arranged on the optical layer PP. The base substrate BL may be a member which provides a base surface on which the optical layer PP arranged. The base substrate BL may be a glass substrate, a metal substrate, a plastic substrate, and/or the like. However, embodiments of the present disclosure are not limited thereto, and the base substrate BL may be an inorganic layer, an organic layer, or a composite material layer. In one or more embodiments, the base substrate BL may not be provided.

The display apparatus DD according to one or more embodiments may further include a filling layer . The filling layer may be arranged between a display device layer DP-ED and the base substrate BL. The filling layer may be an organic material layer. The filling layer may include at least one of an acrylic-based resin, a silicone-based resin, or an epoxy-based resin.

The display panel DP may include a base layer BS, a circuit layer DP-CL provided on the base layer BS, and a display device layer DP-ED. The display device layer DP-ED may include a pixel defining film PDL, the light emitting devices ED-1, ED-2, and ED-3 arranged between respective portions of the pixel defining film PDL, and an encapsulation layer TFE arranged on the light emitting devices ED-1, ED-2, and ED-3.

The base layer BS may be a member which provides a base surface on which the display device layer DP-ED is arranged. The base layer BS may be a glass substrate, a metal substrate, a plastic substrate, and/or the like. However, embodiments of the present disclosure are not limited thereto, and the base layer BS may be an inorganic layer, an organic layer, or a composite material layer.

In one or more embodiments, the circuit layer DP-CL may be arranged on the base layer BS, and the circuit layer DP-CL may include a plurality of transistors . Each of the transistors may include a control electrode, an input electrode, and an output electrode. For example, in some embodiments, the circuit layer DP-CL may include switching transistor(s) and driving transistor(s) for driving the light emitting devices ED-1, ED-2, and ED-3 of the display device layer DP-ED.

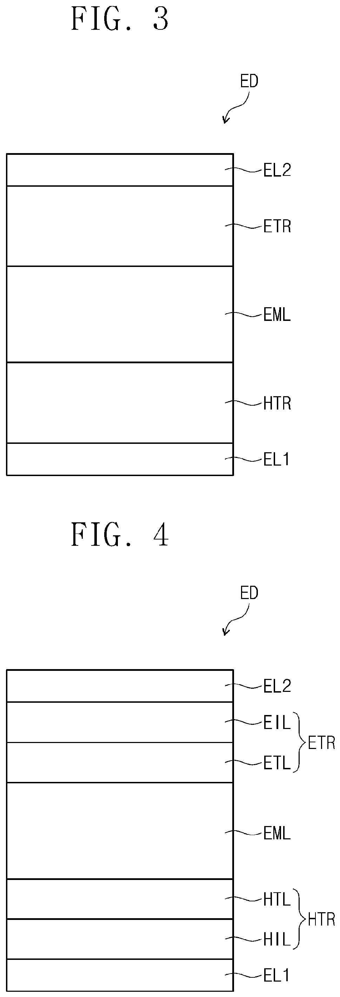

Each of the light emitting devices ED-1, ED-2, and ED-3 may have a structure of one of light emitting elements(devices) ED of embodiments according to FIGs. 3 to 6, which will be described later. Each of the light emitting devices ED-1, ED-2, and ED-3 may include a first electrode EL1, a hole transport region HTR, respective emission layers EML-R, EML-G, and EML-B, an electron transport region ETR, and a second electrode EL2.

FIG. 2 illustrates an embodiment in which the respective emission layers EML-R, EML-G, and EML-B of the light emitting devices ED-1, ED-2, and ED-3 are arranged in openings OH defined in the pixel defining film PDL, and the hole transport region HTR, the electron transport region ETR, and the second electrode EL2 are each provided as a common layer in the entire light emitting devices ED-1, ED-2, and ED-3. However, embodiments of the present disclosure are not limited thereto, for example, in one or more embodiments, the hole transport region HTR and the electron transport region ETR may be provided by being patterned inside the openings OH defined in the pixel defining film PDL. For example, in some embodiments, the hole transport region HTR, the respective emission layers EML-R, EML-G, and EML-B, and the electron transport region ETR of the light emitting devices ED-1, ED-2, and ED-3 may be provided by being patterned in an inkjet printing method.

The encapsulation layer TFE may cover the light emitting devices ED-1, ED-2 and ED-3. The encapsulation layer TFE may seal the display device layer DP-ED. The encapsulation layer TFE may be a thin film encapsulation layer. The encapsulation layer TFE may be formed by laminating one layer or a plurality of layers. The encapsulation layer TFE may include at least one insulation layer. In some embodiments, the encapsulation layer TFE may include at least one inorganic film (hereinafter, an encapsulation-inorganic film). In some embodiments, the encapsulation layer TFE may include at least one organic film (hereinafter, an encapsulation-organic film) and at least one encapsulation-inorganic film.

The encapsulation-inorganic film protects the display device layer DP-ED from moisture/oxygen, and the encapsulation-organic film protects the display device layer DP-ED from foreign substances such as dust particles. The encapsulation-inorganic film may include silicon nitride, silicon oxynitride, silicon oxide, titanium oxide, aluminum oxide, and/or the like, but embodiments of the present disclosure are not particularly limited thereto. In some embodiments, the encapsulation-organic film may include an acrylic-based compound, an epoxy-based compound, and/or the like. In some embodiments, the encapsulation-organic film may include a photopolymerizable organic material, but embodiments of the present disclosure are not particularly limited thereto.

The encapsulation layer TFE may be arranged on the second electrode EL2 and may be arranged filling the opening OH.

Referring to FIG. 1 and FIG. 2, the display apparatus DD may include a non-light emitting region NPXA and light emitting regions PXA-R, PXA-G, and PXA-B. The light emitting regions PXA-R, PXA-G, and PXA-B may be regions in which light generated by the respective light emitting devices ED-1, ED-2, and ED-3 is emitted. The light emitting regions PXA-R, PXA-G, and PXA-B may be spaced and/or apart from each other on a plane (e.g., in a plan view).

Each of the light emitting regions PXA-R, PXA-G, and PXA-B may be a region divided by the pixel defining film PDL. The non-light emitting areas NPXA may be areas between adjacent light emitting areas PXA-R, PXA-G, and PXA-B, which correspond to the pixel defining film PDL. In one or more embodiments, the light emitting regions PXA-R, PXA-G, and PXA-B may respectively correspond to pixels. The pixel defining film PDL may divide the light emitting devices ED-1, ED-2, and ED-3. The respective emission layers EML-R, EML-G, and EML-B of the light emitting devices ED-1, ED-2, and ED-3 may be arranged in openings OH defined in the pixel defining film PDL and separated from each other.

The light emitting regions PXA-R, PXA-G, and PXA-B may be divided into a plurality of groups according to the color of light generated from the light emitting devices ED-1, ED-2, and ED-3. In the display apparatus DD of one or more embodiments illustrated in FIG. 1 and FIG. 2, three light emitting regions PXA-R, PXA-G, and PXA-B, which emit red light, green light, and blue light, respectively, are exemplarily illustrated. For example, in one or more embodiments, the display device DD may include a red light emitting region PXA-R, a green light emitting region PXA-G, and a blue light emitting region PXA-B that are separated from each other.

In the display apparatus DD according to one or more embodiments, the plurality of light emitting devices ED-1, ED-2 and ED-3 may be to emit light beams having wavelengths different from each other. For example, in some embodiments, the display apparatus DD may include a first light emitting device ED-1 that emits red light, a second light emitting device ED-2 that emits green light, and a third light emitting device ED-3 that emits blue light. For example, in some embodiments, the red light emitting region PXA-R, the green light emitting region PXA-G, and the blue light emitting region PXA-B of the display apparatus DD may correspond to the first light emitting device ED-1, the second light emitting device ED-2, and the third light emitting device ED-3, respectively.

However, embodiments of the present disclosure are not limited thereto, and the first to third light emitting devices ED-1, ED-2, and ED-3 may be to emit light beams in substantially the same wavelength range or at least one light emitting device may be to emit a light beam in a wavelength range different from the others. For example, in some embodiments, the first to third light emitting devices ED-1, ED-2, and ED-3 may all emit blue light.

The light emitting regions PXA-R, PXA-G, and PXA-B in the display apparatus DD according to one or more embodiments may be arranged in a stripe form. Referring to FIG. 1, a plurality of red light emitting regions PXA-R may be arranged with each other along a second direction axis DR2, a plurality of green light emitting regions PXA-G may be arranged with each other along the second direction axis DR2, and a plurality of blue light emitting regions PXA-B may be arranged with each other along the second direction axis DR2. In one or more embodiments, the red light emitting region PXA-R, the green light emitting region PXA-G, and the blue light emitting region PXA-B may be alternately arranged in this order along a first direction axis DR1.

FIG. 1 and FIG. 2 illustrate that all the light emitting regions PXA-R, PXA-G, and PXA-B have similar area, but embodiments of the present disclosure are not limited thereto. Thus, the light emitting regions PXA-R, PXA-G, and PXA-B may have different areas from each other according to the wavelength range of the emitted light. The areas of the light emitting regions PXA-R, PXA-G, and PXA-B may refer to areas when viewed on a plane defined by the first direction axis DR1 and the second direction axis DR2 (e.g., the areas in a plan view).

In one or more embodiments, an arrangement form of the light emitting regions PXA-R, PXA-G, and PXA-B are not limited to the configuration illustrated in FIG. 1, and the order in which the red light emitting region PXA-R, the green light emitting region PXA-G, and the blue light emitting region PXA-B are arranged may be provided in one or more suitable combinations according to the characteristics of display quality desired or required in the display apparatus DD. For example, in one or more embodiments, the arrangement form of the light emitting regions PXA-R, PXA-G, and PXA-B may be a pentile (PENTILE^{®}) arrangement form (for example, an RGBG matrix, an RGBG structure, or an RGBG matrix structure) or a diamond (Diamond Pixel^{™}) arrangement form (e.g., a display (e.g., an OLED display) containing red, blue, and green (RGB) light-emitting regions arranged in the shape of diamonds). PENTILE^{®} is a duly registered trademark of Samsung Display Co., Ltd. Diamond Pixel^{™} is a trademark of Samsung Display Co., Ltd.

In one or more embodiments, the areas of the light emitting regions PXA-R, PXA-G, and PXA-B may be different from each other. For example, in some embodiments, the area of the green light emitting region PXA-G may be smaller than that of the blue light emitting region PXA-B, but embodiments of the present disclosure are not limited thereto.

Hereinafter, FIG. 3 to FIG. 6 are each a cross-sectional view schematically showing a light emitting element according to one or more embodiments of the present disclosure. The light emitting element ED of one or more embodiments may include a first electrode EL1, a hole transport region HTR, an emission layer EML, an electron transport region ETR, and a second electrode EL2 stacked in the stated order.

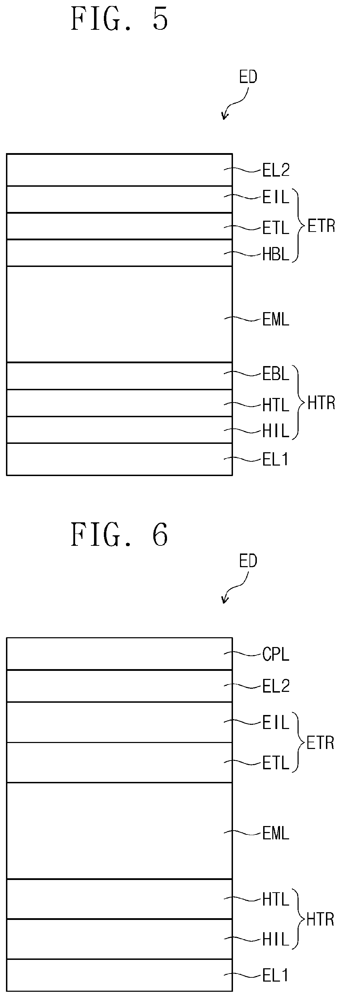

Compared with FIG. 3, FIG. 4 illustrates a cross-sectional view of a light emitting element ED of one or more embodiments, in which a hole transport region HTR includes a hole injection layer HIL and a hole transport layer HTL, and an electron transport region ETR includes an electron injection layer EIL and an electron transport layer ETL. Compared with FIG. 3, FIG. 5 illustrates a cross-sectional view of a light emitting element ED of one or more embodiments, in which a hole transport region HTR includes a hole injection layer HIL, a hole transport layer HTL, and an electron blocking layer EBL, and an electron transport region ETR includes an electron injection layer EIL, an electron transport layer ETL, and a hole blocking layer HBL. Compared with FIG. 4, FIG. 6 illustrates a cross-sectional view of a light emitting element ED of one or more embodiments including a capping layer CPL arranged on a second electrode EL2.

The first electrode EL1 has conductivity (e.g., is a conductor). The first electrode EL1 may be formed of a metal material, a metal alloy, and/or a conductive compound. The first electrode EL1 may be an anode or a cathode. However, embodiments of the present disclosure are not limited thereto. In one or more embodiments, the first electrode EL1 may be a pixel electrode. The first electrode EL1 may be a transmissive electrode, a transflective electrode, or a reflective electrode. The first electrode EL1 may include at least one of (e.g., at least one selected from among) silver (Ag), magnesium (Mg), copper (Cu), aluminum (Al), platinum (Pt), palladium (Pd), gold (Au), nickel (Ni), neodymium (Nd), iridium (Ir), chromium (Cr), lithium (Li), calcium (Ca), lithium fluoride (LiF), molybdenum (Mo), titanium (Ti), tungsten (W), indium (In), tin (Sn), zinc (Zn), a compound of two or more thereof, a mixture of two or more thereof, and/or an oxide thereof.

If the first electrode EL1 is a transmissive electrode, the first electrode EL1 may include a transparent metal oxide such as indium tin oxide (ITO), indium zinc oxide (IZO), zinc oxide (ZnO), and/or indium tin zinc oxide (ITZO). If the first electrode EL1 is the transflective electrode or the reflective electrode, the first electrode EL1 may include Ag, Mg, Cu, Al, Pt, Pd, Au, Ni, Nd, Ir, Cr, Li, Ca, LiF/Ca (a stacked structure of LiF and Ca), LiF/Al (a stacked structure of LiF and Al), Mo, Ti, W, any compound thereof, or any mixture thereof (e.g., a mixture of Ag and Mg). In one or more embodiments, the first electrode EL1 may have a multilayer structure including a reflective film or a transflective film formed of one or more of the above-described materials, and a transparent conductive film formed of ITO, IZO, ZnO, ITZO, and/or the like. For example, the first electrode EL1 may have a three-layer structure of ITO/Ag/ITO, but embodiments of the present disclosure are not limited thereto. In one or more embodiments, e the first electrode EL1 may include one of the above-described metal materials, one or more combinations of at least two metal materials of the above-described metal materials, any oxide of the above-described metal materials, and/or the like. A thickness of the first electrode EL1 may be from about 700 ångström (Å) to about 10,000 Å. For example, in one or more embodiments, the thickness of the first electrode EL1 may be from about 1,000 Å to about 3,000 Å.

The hole transport region HTR may be provided on the first electrode EL1. The hole transport region HTR may include at least one of a hole injection layer HIL, a hole transport layer HTL, a buffer layer or an emission-auxiliary layer , or an electron blocking layer EBL. A thickness of the hole transport region HTR may be, for example, from about 50 Å to about 15,000 Å.

The hole transport region HTR may have a single layer formed of a single material, a single layer formed of a plurality of different materials, or a multilayer structure including a plurality of layers formed of a plurality of different materials.

For example, in one or more embodiments, the hole transport region HTR may have a single layer structure of a hole injection layer HIL or a hole transport layer HTL, or may have a single layer structure formed of a hole injection material and a hole transport material. In one or more embodiments, the hole transport region HTR may have a single layer structure formed of a plurality of different materials, or a structure in which a hole injection layer HIL/hole transport layer HTL, a hole injection layer HIL/hole transport layer HTL/buffer layer , a hole injection layer HIL/buffer layer , a hole transport layer HTL/buffer layer , or a hole injection layer HIL/hole transport layer HTL/electron blocking layer EBL are stacked in order (e.g., in the stated order) from the first electrode EL1, but embodiments of the present disclosure are not limited thereto.

The hole transport region HTR may be formed utilizing one or more suitable methods such as a vacuum deposition method, a spin coating method, a casting method, a Langmuir-Blodgett (LB) method, an inkjet printing method, a laser printing method, and/or a laser induced thermal imaging (LITI) method.

In one or more embodiments, the hole transport region HTR may include a compound represented by Formula H-1 :

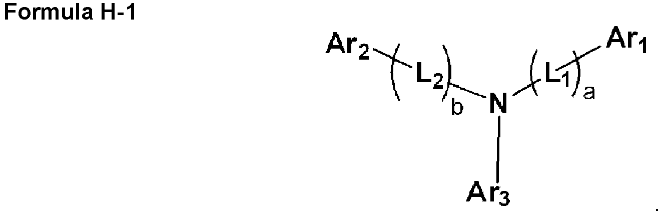

In Formula H-1, L₁ and L₂ may each independently be a direct linkage, a substituted or unsubstituted arylene group having 6 to 30 ring-forming carbon atoms, or a substituted or unsubstituted heteroarylene group having 2 to 30 ring-forming carbon atoms. a and b may each independently be an integer of 0 to 10. In one or more embodiments, if a or b is an integer of 2 or greater, a plurality of L₁'s and L₂'s may each independently be a substituted or unsubstituted arylene group having 6 to 30 ring-forming carbon atoms, or a substituted or unsubstituted heteroarylene group having 2 to 30 ring-forming carbon atoms.

In Formula H-1, Ar₁ and Ar₂ may each independently be a substituted or unsubstituted aryl group having 6 to 30 ring-forming carbon atoms, or a substituted or unsubstituted heteroaryl group having 2 to 30 ring-forming carbon atoms. In one or more embodiments, in Formula H-1, Ar₃ may be a substituted or unsubstituted aryl group having 6 to 30 ring-forming carbon atoms, or a substituted or unsubstituted heteroaryl group having 2 to 30 ring-forming carbon atoms.

In one or more embodiments, the compound represented by Formula H-1 may be a monoamine compound. In one or more embodiments, the compound represented by Formula H-2 may be a diamine compound in which at least one selected from among Ar₁ to Ar₃ includes an amine group as a substituent. In one or more embodiments, the compound represented by Formula H-1 may be a carbazole-based compound including a substituted or unsubstituted carbazole group in at least one of Ar₁ or Ar₂, or a fluorene-based compound including a substituted or unsubstituted fluorene group in at least one of Ar₁ or Ar₂.

The compound represented by Formula H-1 may be any one selected from among compounds in Compound Group H . However, the compounds listed in Compound Group H are mere examples, and the compounds represented by Formula H-1 are not limited to those represented in Compound Group H :

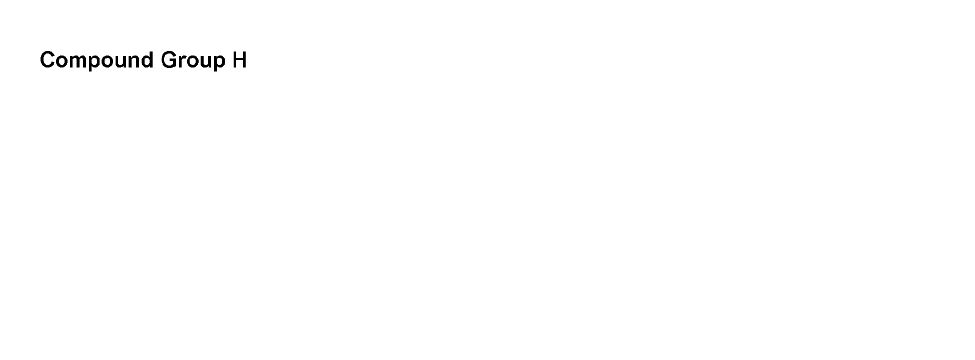

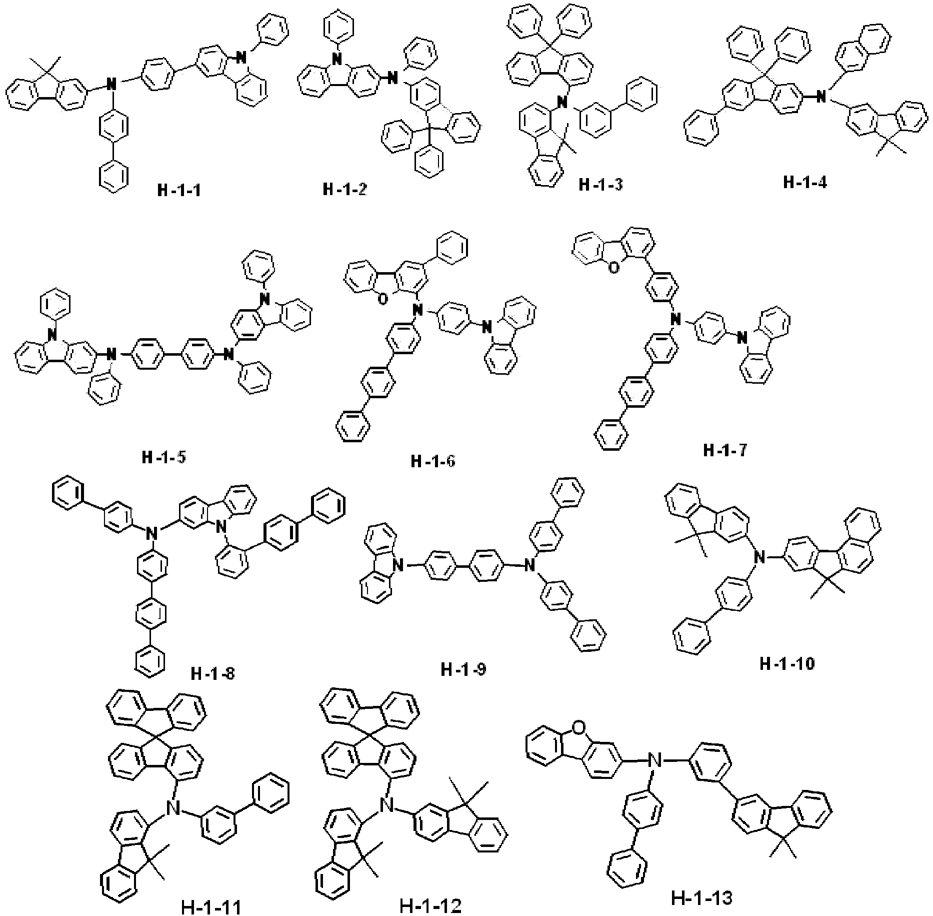

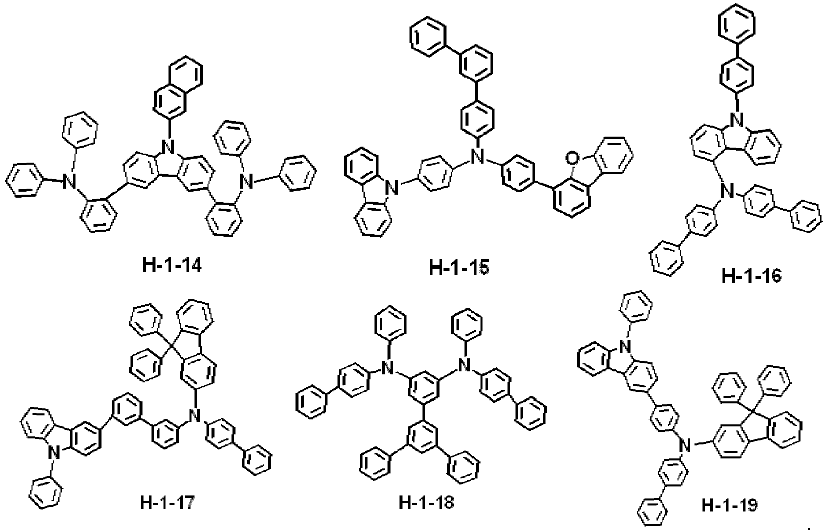

In some embodiments, the hole transport region HTR may include at least one selected from among a phthalocyanine compound such as copper phthalocyanine; N¹,N^{1'}-([1,1'-biphenyl]-4,4'-diyl)bis(N¹-phenyl-N⁴,N⁴-di-m-tolylbenzene-1,4-diamine) (DNTPD), 4,4',4"-[tris(3-methylphenyl)phenylamino] triphenylamine (m-MTDATA), 4,4',4"-tris(N,N-diphenylamino)triphenylamine (TDATA), 4,4',4"-tris[N-(2-naphthyl)-N-phenylamino]-triphenylamine (2-TNATA), poly(3,4-ethylenedioxythiophene)/poly(4-styrenesulfonate) (PEDOT/PSS), polyaniline/dodecylbenzenesulfonic acid (PANI/DBSA), polyaniline/camphor sulfonic acid (PANI/CSA), polyaniline/poly(4-styrenesulfonate) (PANI/PSS), N,N'-di(naphthalen-1-yl)-N,N'-diphenyl-benzidine (NPB), triphenylamine-containing polyetherketone (TPAPEK), 4-isopropyl-4'-methyldiphenyliodonium [tetrakis(pentafluorophenyl)borate], dipyrazino[2,3-f: 2',3'-h]quinoxaline-2,3,6,7,10,11-hexacarbonitrile (HATCN), and/or the like.

In one or more embodiments, the hole transport region HTR may include at least one selected from among a carbazole-based derivative such as N-phenyl carbazole or polyvinyl carbazole, a fluorene-based derivative, a triphenylamine-based derivative such as N,N'-bis(3-methylphenyl)-N,N'-diphenyl-[1,1-biphenyl]-4,4'-diamine (TPD) or 4,4',4"-tris(N-carbazolyl)triphenylamine (TCTA), N,N'-di(naphthalen-1-yl)-N,N'-diphenyl-benzidine (NPB), 4,4'-cyclohexylidene bis[N,N-bis(4-methylphenyl]benzenamine] (TAPC), 4,4'-bis[N,N'-(3-tolyl)amino]-3,3'-dimethylbiphenyl (HMTPD), 1,3-bis(N-carbazolyl)benzene (mCP), and/or the like.

In one or more embodiments, the hole transport region HTR may include at least one selected from 9-(4-*tert*-butylphenyl)-3,6-bis(triphenylsilyl)-9H-carbazole (CzSi), 9-phenyl-9H-3,9'-bicarbazole (CCP), 1,3-bis(1,8-dimethyl-9H-carbazol-9-yl)benzene (mDCP), and/or the like.

The hole transport region HTR may include one or more of the above-described compounds of the hole transport region in at least one of a hole injection layer HIL, a hole transport layer HTL, or an electron blocking layer EBL.

A thickness of the hole transport region HTR may be from about 100 Å to about 10,000 Å, for example, from about 100 Å to about 5,000 Å. When the hole transport region HTR includes a hole injection layer HIL, the hole injection layer HIL may have, for example, a thickness of about 30 Å to about 1,000 Å. When the hole transport region HTR includes a hole transport layer HTL, the hole transport layer HTL may have a thickness of about 250 Å to about 1,000 Å. For example, if the hole transport region HTR includes an electron blocking layer EBL, the electron blocking layer EBL may have a thickness of about 10 Å to about 1,000 Å. If the thicknesses of the hole transport region HTR, the hole injection layer HIL, the hole transport layer HTL, and the electron blocking layer EBL satisfy the above-described ranges, satisfactory hole transport properties may be achieved without a substantial increase in driving voltage.

In one or more embodiments, the hole transport region HTR may further include a charge generating material to increase conductivity in addition to the above-described materials. The charge generating material may be dispersed uniformly (substantially uniformly) or non-uniformly (substantially non-uniformly) in the hole transport region HTR. The charge generating material may be, for example, a p-dopant. The p-dopant may include at least one of a halogenated metal compound, a quinone derivative, a metal oxide, or a cyano group-containing compound, but embodiments of the present disclosure are not limited thereto. For example, in some embodiments, the p-dopant may include a metal halide compound such as Cul and/or Rbl, a quinone derivative such as tetracyanoquinodimethane (TCNQ) and/or 2,3,5,6-tetrafluoro-7,7,8,8-tetracyanoquinodimethane (F4-TCNQ), a metal oxide such as tungsten oxide and/or molybdenum oxide, a cyano group-containing compound such as dipyrazino[2,3-f: 2',3'-h] quinoxaline-2,3,6,7,10,11-hexacarbonitrile (HATCN) and/or 4-[[2,3-bis[cyano-(4-cyano-2,3,5,6-tetrafluorophenyl)methylidene]cyclopropylidene]-cyanomethyl]-2,3,5,6-tetrafluorobenzonitrile (NDP9), and/or the like, but embodiments of the present disclosure are not limited thereto.

As described above, the hole transport region HTR may further include at least one of the buffer layer or the electron blocking layer EBL in addition to the hole injection layer HIL and the hole transport layer HTL. The buffer layer may compensate for a resonance distance according to the wavelength of light emitted from the emission layer EML and may thus increase light emission efficiency. A material that may be included in the hole transport region HTR may be utilized as a material to be included in the buffer layer . The electron blocking layer EBL is a layer that serves to prevent or reduce electron injection from the electron transport region ETR to the hole transport region HTR.

In one or more embodiments, the emission layer EML may be provided on the hole transport region HTR. The emission layer EML may have a thickness of, for example, about 100 Å to about 1,000 Å or about 100 Å to about 300 Å. The emission layer EML may have a single layer formed utilizing a single material, a single layer formed utilizing multiple different materials, or a multilayer structure having multiple layers formed utilizing multiple different materials.

The light emitting element ED of one or more embodiments may include the fused polycyclic compound represented by Formula 1 in at least one functional layer arranged between the first electrode EL1 and the second electrode EL2. In the light emitting element ED of one or more embodiments, the emission layer EML may include the fused polycyclic compound of one or more embodiments. In one or more embodiments, the emission layer EML may include the fused polycyclic compound of one or more embodiments as a dopant. The fused polycyclic compound of one or more embodiments may be a dopant material of the emission layer EML. In the present disclosure, the fused polycyclic compound of one or more embodiments may be referred to as a first compound.

The fused polycyclic compound of one or more embodiments may include a fused structure of multiple aromatic rings via a boron atom and a nitrogen atom. The fused polycyclic compound of one or more embodiments may include a fused structure of multiple aromatic rings via a boron atom and two nitrogen atoms. The fused polycyclic compound of one or more embodiments may include a fused structure of multiple aromatic rings via a first boron atom, a first nitrogen atom and a second nitrogen atom. For example, the fused polycyclic compound of one or more embodiments may include a fused ring formed by fusing multiple aromatic rings via a boron atom, a first nitrogen atom and a second nitrogen atom.

The fused polycyclic compound of one or more embodiments may include a fused structure of first to third aromatic rings (i.e., first aromatic ring, second aromatic ring, and third aromatic ring) via a first boron atom, a first nitrogen atom, and a second nitrogen atom. The first aromatic ring, the second aromatic ring and the third aromatic rings may be connected with the first boron atom, the first aromatic ring and the third aromatic ring may be further connected with each other via the first nitrogen atom, and the second aromatic ring and the third aromatic ring may be further connected with each other via the second nitrogen atom. In the present disclosure, the first boron atom, the first nitrogen atom, the second nitrogen atom, and the fused structure formed through fusing the first to second to third aromatic rings via the first boron atom, the first nitrogen atom, and the second nitrogen atom, may be referred to as a "fused ring core".

In one or more embodiments, the first to third aromatic rings may each independently be a substituted or unsubstituted monocyclic aromatic hydrocarbon ring of 6 to 30 ring-forming carbon atoms. In one or more embodiments, the first to third aromatic rings may each independently be a six-member aromatic hydrocarbon ring. For example, in one or more embodiments, the first to third aromatic rings may each independently be a benzene ring.

The fused polycyclic compound of one or more embodiments may include a first substituent connected with the first nitrogen atom. The first substituent may include a dibenzoheterole moiety including an oxygen or sulfur atom. For example, in one or more embodiments, the first substituent may include a dibenzofuran moiety or a dibenzothiophene moiety. The first substituent is connected at carbon at position 1 with the first nitrogen atom, and includes a structure in which a second substituent such as an aryl group and a heteroaryl group is substituted at carbon at position 2. In the present disclosure, the structure and carbon number of the first substituent may be the same as shown in Formula S.

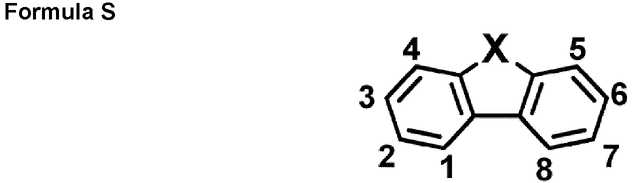

In Formula S, X is O or S.

The first substituent may be directly bonded to the first nitrogen atom of the fused ring core without a linker (e.g., without a separate linker).

The fused polycyclic compound of one or more embodiments may be represented by Formula 1.

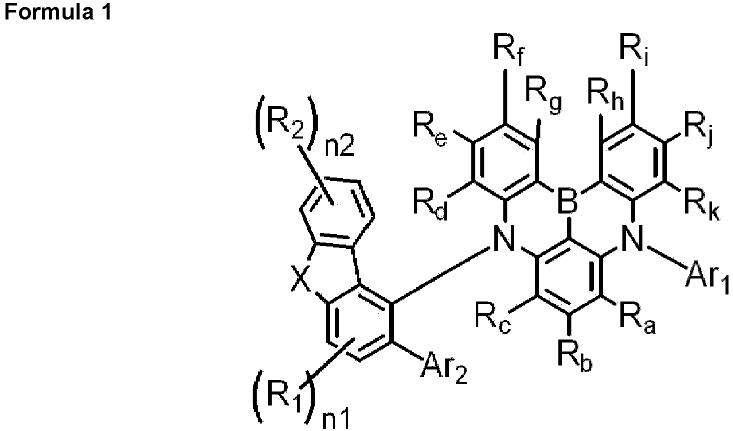

The fused polycyclic compound of one or more embodiments, represented by Formula 1, may include a fused structure of three aromatic rings via a boron atom, a first nitrogen atom, and a second nitrogen atom. In the present disclosure, in Formula 1, a benzene ring at which substituents represented by R_{d} to R_{g} are substituted may correspond to the above-described first aromatic ring, a benzene ring at which substituents represented by Rₕ to Rₖ are substituted may correspond to the above-described second aromatic ring, and a benzene ring at which substituents represented by Rₐ to R_{c} are substituted may correspond to the above-described third aromatic ring. In Formula 1, a fused heteroaryl moiety of three rings, which is connected with the nitrogen atom and includes X, may correspond to the above-described first substituent. In Formula 1, Ar₂ may correspond to the above-described second substituent.

In Formula 1, X may be O or S.

In Formula 1, Ar₁ and Ar₂ may each independently be a substituted or unsubstituted aryl group of 6 to 30 ring-forming carbon atoms, or a substituted or unsubstituted heteroaryl group of 2 to 30 ring-forming carbon atoms. For example, in one or more embodiments, Ar₁ and Ar₂ may each independently be a substituted or unsubstituted phenyl group, a substituted or unsubstituted biphenyl group, a substituted or unsubstituted terphenyl group, or a substituted or unsubstituted dibenzofuran group.

In Formula 1, R₁, R₂, and Rₐ to Rₖ may each independently be hydrogen, deuterium, a halogen, a cyano group, a substituted or unsubstituted amine group, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms. In one or more embodiments, one or more selected from among R₁, R₂, and Rₐ to Rₖ may be combined with an adjacent group to form (or provide) a ring. For example, in one or more embodiments, R₁, R₂, and Rₐ to Rₖ may each independently be hydrogen, deuterium, a halogen, a substituted or unsubstituted silyl group, a substituted or unsubstituted amine group, a substituted or unsubstituted methyl group, a substituted or unsubstituted t-butyl group, a substituted or unsubstituted phenyl group, a substituted or unsubstituted biphenyl group, a substituted or unsubstituted dibenzofuran group, a substituted or unsubstituted carbazole group, a substituted or unsubstituted fluorenyl group, a substituted or unsubstituted xanthene group, a substituted or unsubstituted acridine group, or a substituted or unsubstituted indolocarbazole group. In one or more embodiments, adjacently arranged groups of Rₑ and R_{f} may be combined from each other to form (or provide) an additional hydrocarbon ring or a heterocycle.

In Formula 1, n1 is may be integer of 0 to 2. In Formula 1, if n1 is 0, the fused polycyclic compound of one or more embodiments may be unsubstituted with R₁. An embodiment where n1 is 2 and all R₁'s are each hydrogen, may be the same as an embodiment where n1 is 0. If n1 is 2, multiple R₁'s may be all the same, or at least one selected from among multiple R₁'s may be different.

In Formula 1, n2 is may be integer of 0 to 4. In Formula 1, if n2 is 0, the fused polycyclic compound of one or more embodiments may be unsubstituted with R₂. An embodiment where n2 is 4 and all R₂'s are each hydrogen, may be the same as an embodiment where n2 is 0. If n2 is an integer of 2 or more, multiple R₂'s may be all the same, or at least one selected from among multiple R₂'s may be different.

In one or more embodiments, in Formula 1, R_{d} to Rₖ may each independently be hydrogen, deuterium, or one selected from among substituents represented by Formula a-1 to Formula a-22.

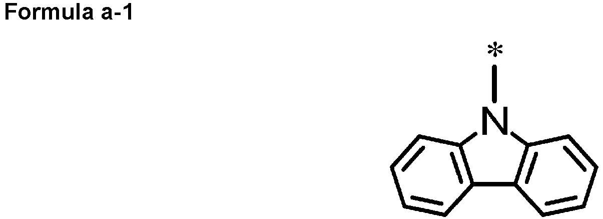

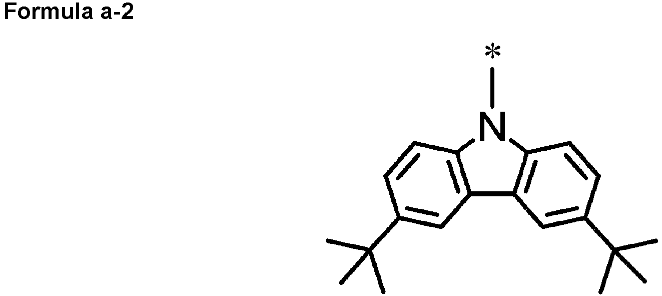

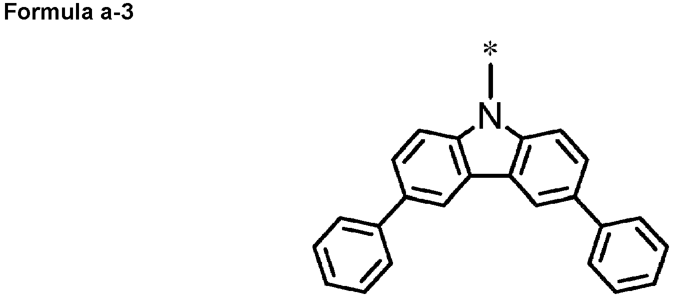

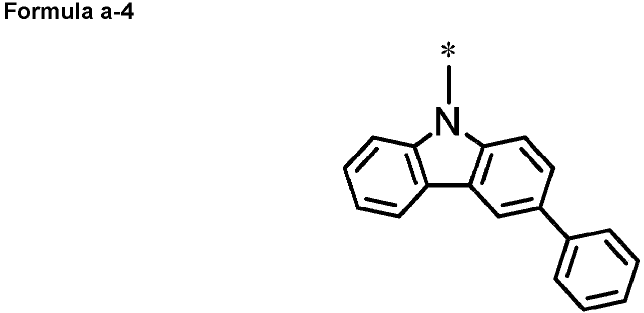

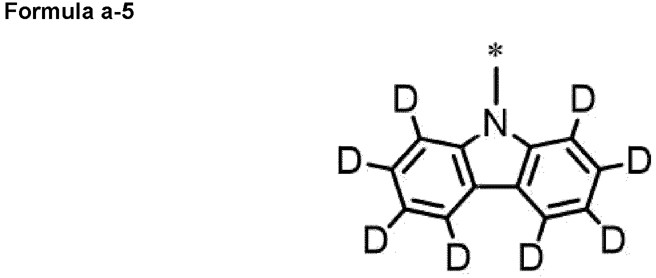

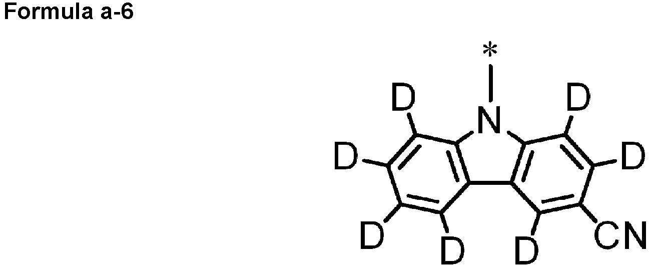

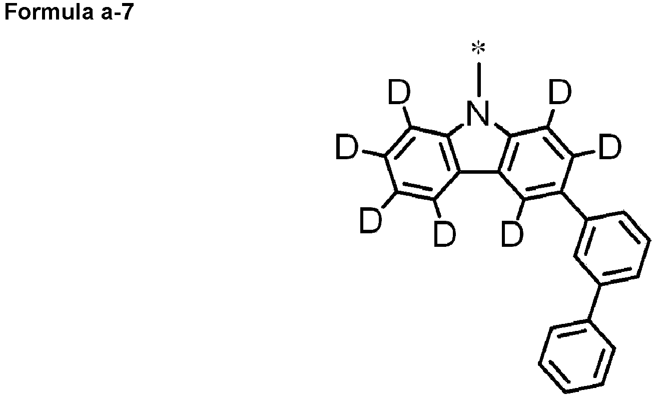

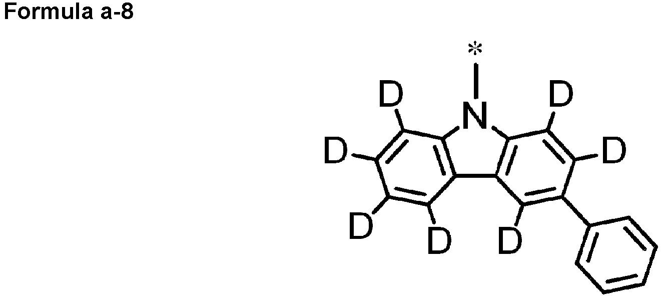

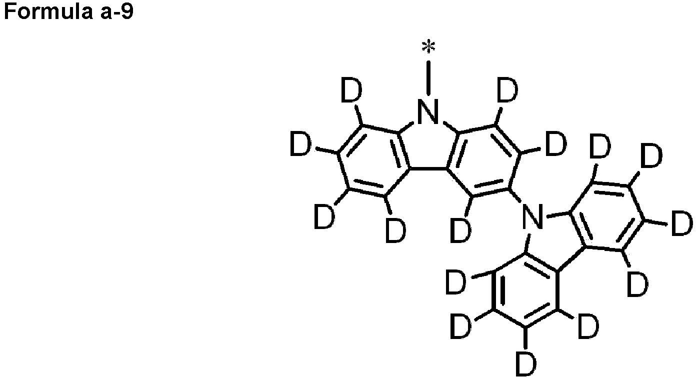

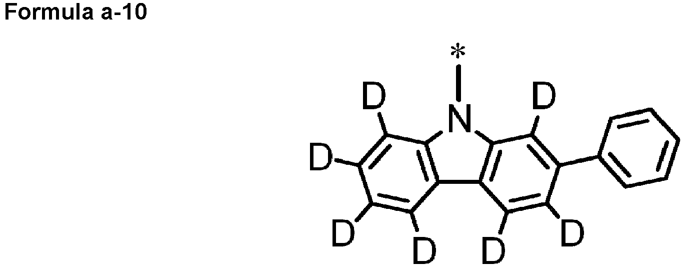

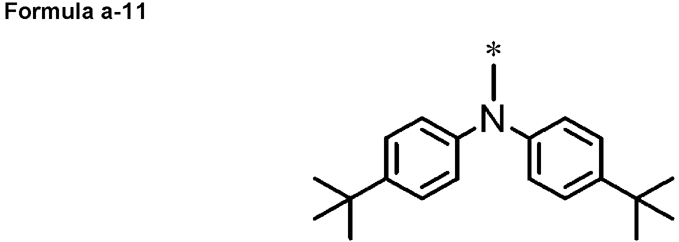

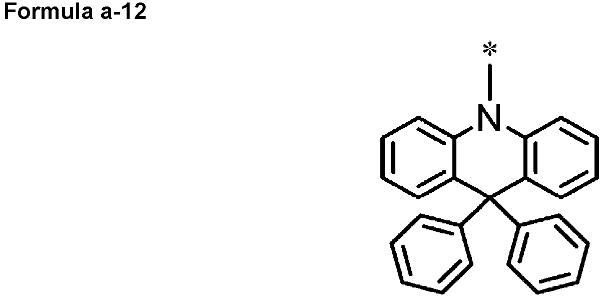

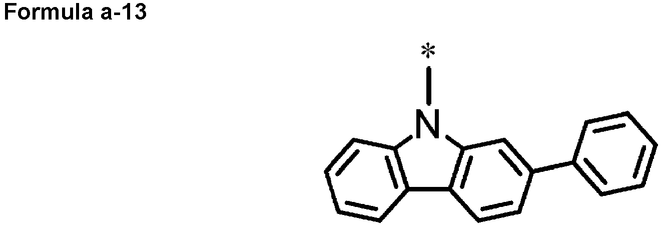

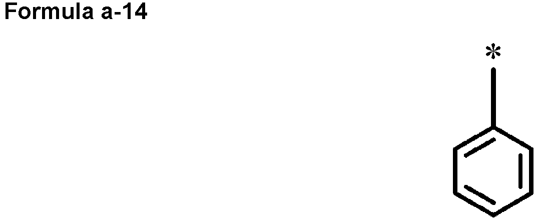

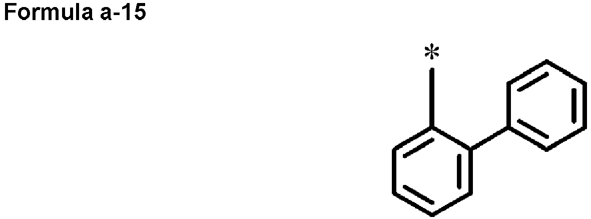

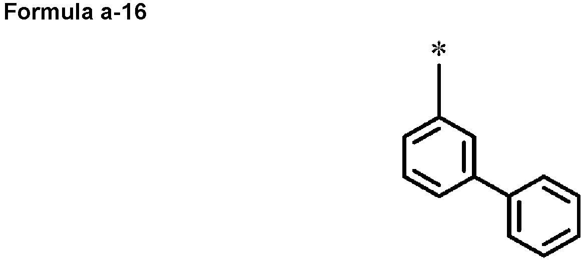

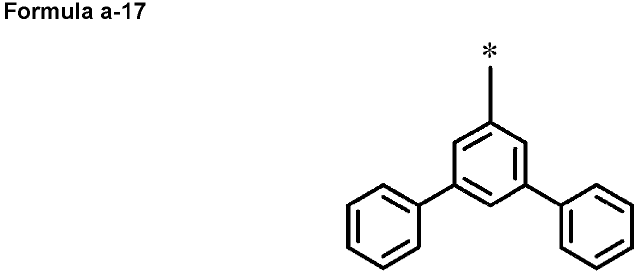

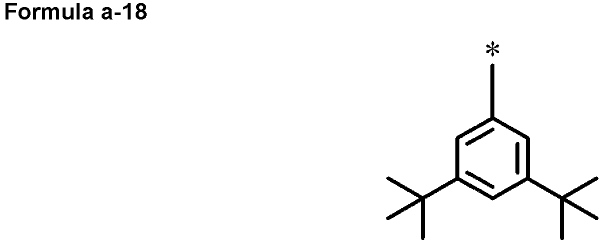

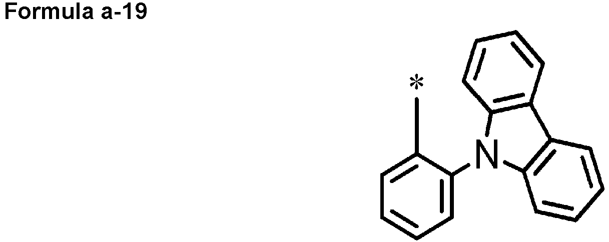

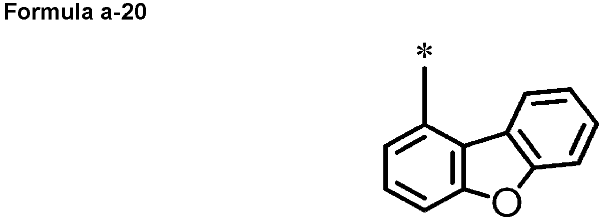

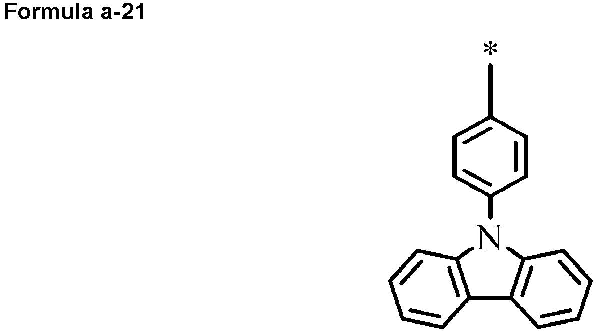

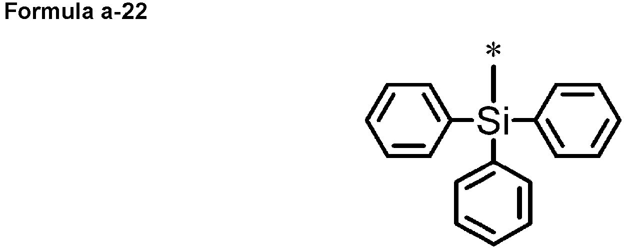

In Formula a-1 to Formula a-22, " * -" is a position connected with the fused ring core of the fused polycyclic compound represented by Formula 1.

In one or more embodiments, in Formula 1, Rₐ to R_{c} may each independently be hydrogen, deuterium, an unsubstituted t-butyl group, or one selected from among substituents represented by Formula b-1 to Formula b-17.

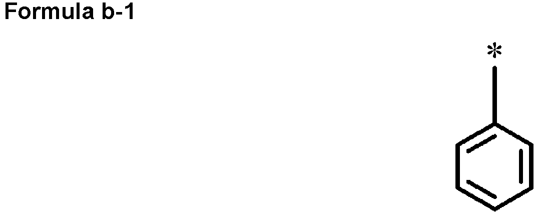

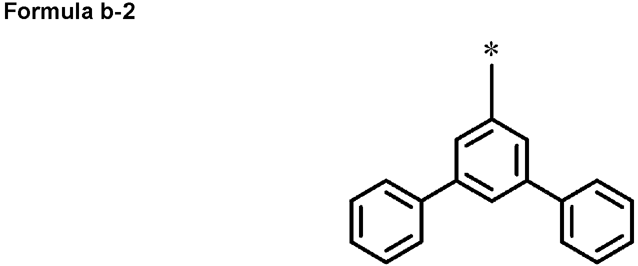

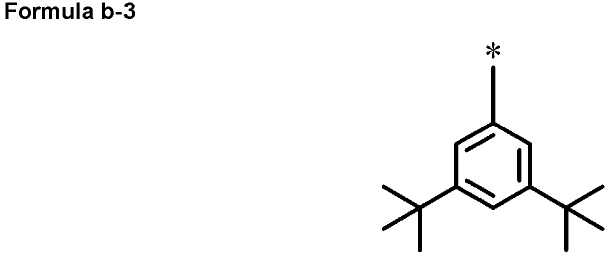

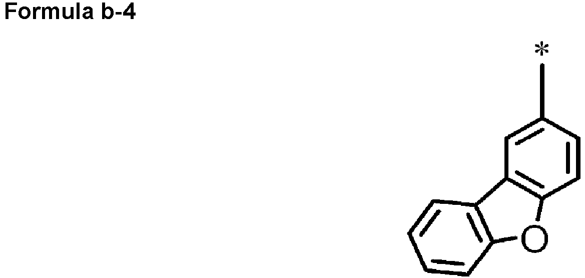

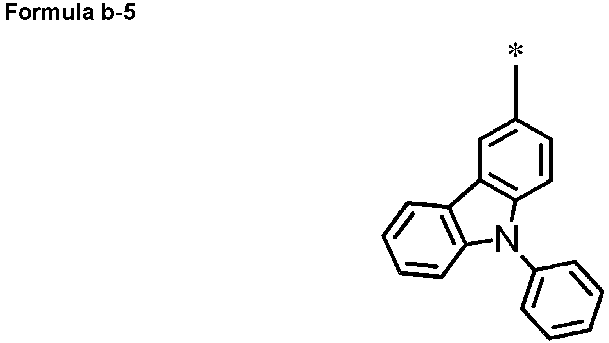

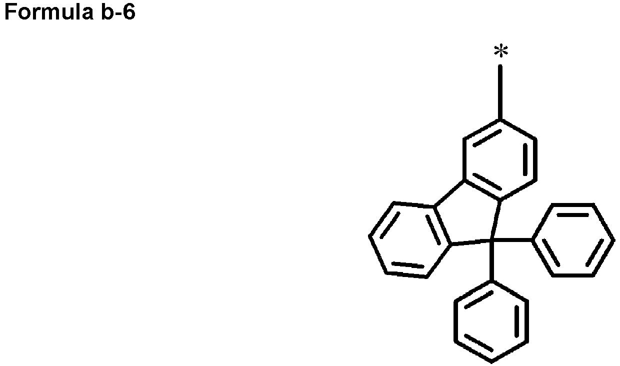

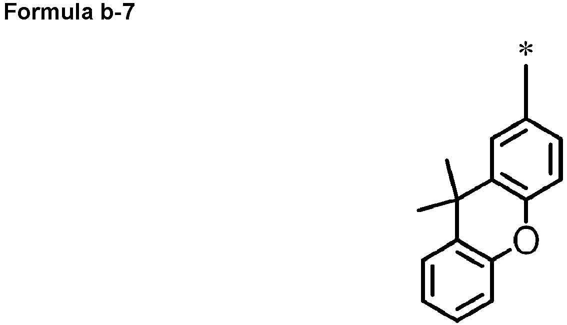

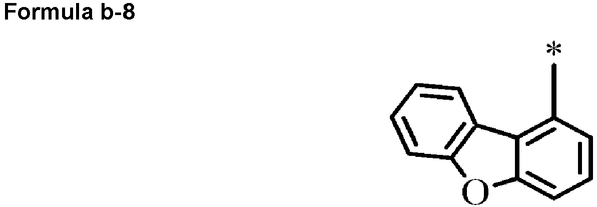

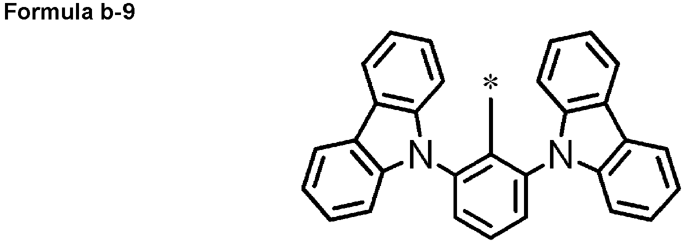

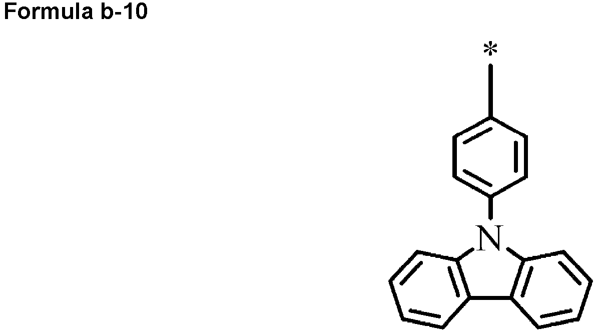

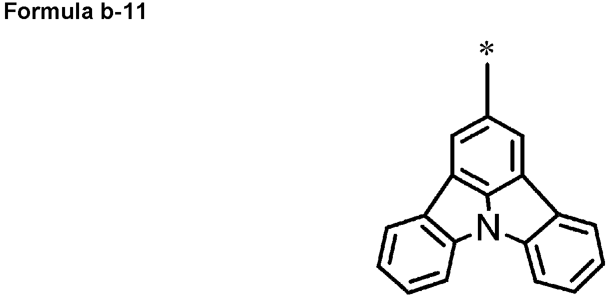

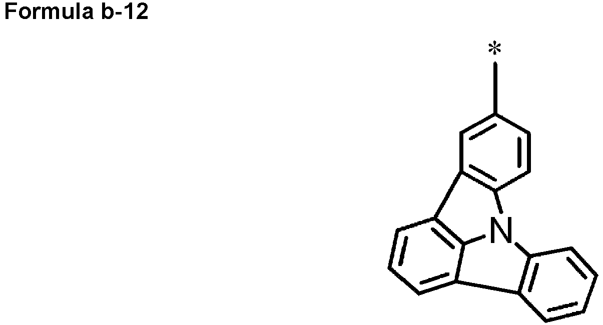

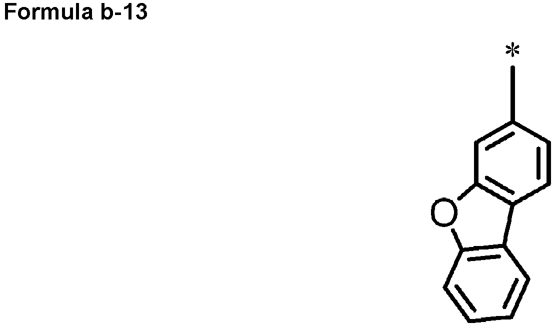

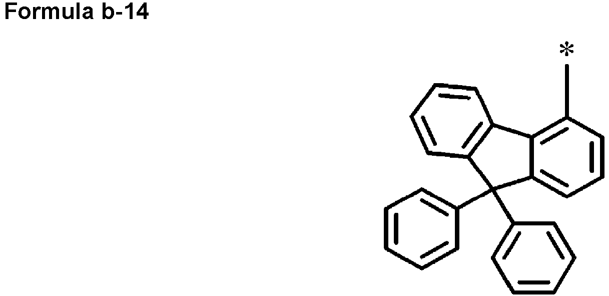

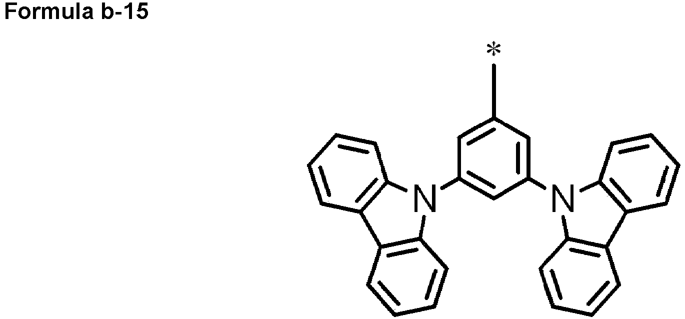

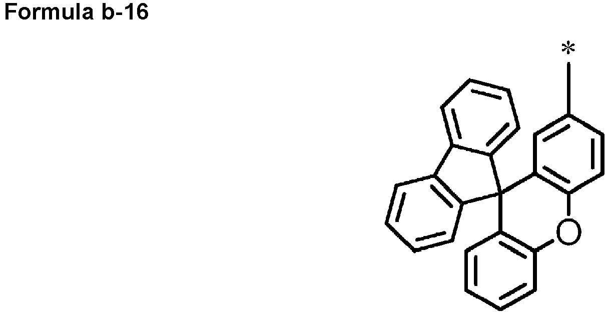

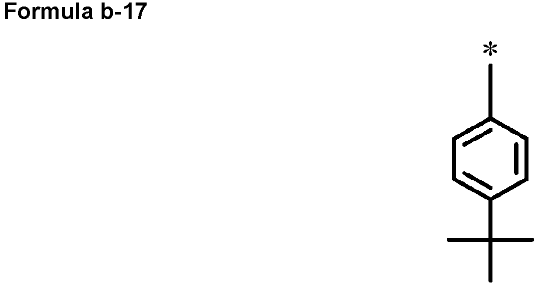

In Formula b-1 to Formula b-17, " * -" is a position connected with the fused ring fore of the fused polycyclic compound represented by Formula 1.

The fused polycyclic compound of one or more embodiments, represented by Formula 1, has a structure in which the first substituent is connected with the fused ring core, and high efficiency and long lifetime may be achieved.

The fused polycyclic compound of one or more embodiments includes a "fused ring core" of five rings formed by fusing first to third aromatic rings (i.e., first aromatic ring, second aromatic ring, and third aromatic ring) via a boron atom, a first nitrogen atom, and a second nitrogen atom. In addition, the fused polycyclic compound of one or more embodiments includes a first substituent connected with the first nitrogen atom of the fused ring core. The fused polycyclic compound represented by Formula 1 according to one or more embodiments includes the first substituent, and may accomplish high emission efficiency and increased lifetime.

The first substituent may include a dibenzofuran moiety or a dibenzothiophene moiety. The first substituent is connected with the first nitrogen atom at carbon at position 1 of the dibenzofuran moiety or the dibenzothiophene moiety, represented by Formula S. At carbon at position 2 of the first substituent, a second substituent which is an aryl group or a heteroaryl group, is substituted. The fused polycyclic compound of one or more embodiments includes the first substituent connected with the first nitrogen atom, and may effectively maintain the trigonal planar structure of the boron atom through the steric hindrance effect caused by the first substituent having high steric bulkiness. The boron atom has electron-deficient properties due to a vacant p-orbital and may form a bond with another nucleophile to be transformed into a tetrahedral structure. This may become a factor deteriorating an element. According to the present disclosure, in the fused polycyclic compound of one or more embodiments, because the first substituent is introduced to the fused ring core, the vacant p-orbital of the boron atom may be effectively protected, and the deterioration phenomenon due to structural deformation may be prevented or reduced.

In one or more embodiments, in the fused polycyclic compound of one or more embodiments, intermolecular interaction may be suppressed or reduced through steric hindrance effects of the first substituent, the aggregation, and the formation of excimer or exciplex may be controlled or reduced, and thus emission efficiency may be increased. Because the fused polycyclic compound of one or more embodiments, represented by Formula 1, has a bulky structure, an intermolecular distance may increase, and Dexter energy transfer may be reduced. Accordingly, the increase in a concentration of triplet excitons in the fused polycyclic compound may be suppressed or reduced. The triplet excitons of a high concentration stay in an excited state for a long time to induce the decomposition of a compound and to induce the production of hot excitons having high energy, which are produced through triplet-triplet annihilation (TTA), to induce the destruction of structures around (e.g., surrounding) compounds. In addition, the triplet-triplet annihilation is a bimolecular reaction and rapidly burns out (e.g., annihilates) the triplet excitons utilized for emitting light, which may induce the deterioration of emission efficiency through non-radiative transition. The fused polycyclic compound of one or more embodiments has an increased intermolecular distance due to the first substituent and may suppress or reduce Dexter energy transfer, and thus, the deterioration of lifetime due to the increase of a triplet concentration may be suppressed or reduced. Accordingly, if the fused polycyclic compound of one or more embodiments is applied to an emission layer EML of a light emitting element ED, emission efficiency may be increased, and element lifetime may be improved.

Further, in the fused polycyclic compound of one or more embodiments, because the first substituent is connected with the first nitrogen atom at carbon at position 1 of the first substituent where an electron density is the lowest, the highest occupied molecular orbital (HOMO) energy level of a molecule is lowered even further due to electron-withdrawing effects, deep HOMO may be accomplished, a difference between a HOMO energy level of a host and the HOMO energy level of the fused polycyclic compound may be reduced, and the increase of the concentration of the triplet excitons caused by hole trapping and consequent exciton recombination may be prevented or reduced. Accordingly, the emission efficiency and lifetime of a light emitting element may be improved.

The fused polycyclic compound of one or more embodiments includes the first substituent, and a higher excitation triplet energy level (Tn level, where n is 2 or more) adjacent to the lowest excitation singlet energy level (S1 level) may be relatively low. In one or more embodiments, in the fused polycyclic compound of one or more embodiments, represented by Formula 1, a difference (ΔEs_{1Tn}) between the lowest excitation singlet energy level (S1 level) and a higher excitation triplet energy level (Tn level, where n is 2 or more) adjacent to the lowest excitation singlet energy level (S1 level) may be about 0.6 eV or less. In some embodiments, in the fused polycyclic compound of one or more embodiments, represented by Formula 1, a difference (ΔE_{S1Tn}) between the lowest excitation singlet energy level (S1 level) and a higher excitation triplet energy level (Tn level, where n is 2 or more) adjacent to the lowest excitation singlet energy level (S1 level) may be about 0.2 eV or less. For example, in the fused polycyclic compound of one or more embodiments, including the first substituent, a difference between the lowest excitation singlet energy level and a second excitation triplet energy level (T2 level) may be about 0.2 eV or less.

A compound exhibiting thermally activated delayed fluorescence properties shows inter system crossing (ICS) which is the transition of excitons from the lowest singlet energy level to the triplet energy level, then, shows reverse inter system crossing (RISC) which is the transition of excitons from the triplet energy level to the lowest singlet energy level, and finally emits delayed fluorescence through the transition from the singlet energy level to a ground state. Here, the mechanism of the thermally activated delayed fluorescence may include the pass of a higher triplet energy level (Tn level) as well as the lowest triplet energy level (T1 level) in the inter system crossing (ICS) and the reverse inter system crossing (RISC) processes. Because the fused polycyclic compound of one or more embodiments includes the first substituent, the higher excitation triplet energy level (Tn level) adjacent to the lowest excitation singlet energy level (S1 level) may be low, and accordingly, spin-flip may be increased. In the present disclosure, the spin-flip may refer to transition phenomenon of excitons from the higher excitation triplet energy level (Tn level) to the lowest excitation singlet energy level (S1 level) by the spin-orbit coupling (SOC) between the lowest excitation singlet energy level (S1 level) and the adjacent higher excitation triplet energy level (Tn level). Accordingly, the fused polycyclic compound of one or more embodiments exhibits the relatively low energy level characteristics of the higher excitation triplet energy level (Tn level) adjacent to the lowest excitation singlet energy level (S1 level), the rate of the reverse inter system crossing (RISC) via the higher excitation triplet energy level (Tn level) to the lowest singlet energy level (S1 level) may increase, delayed fluorescence lifetime (Tau, τ) may decrease, and the emission efficiency and lifetime characteristics may be improved.

In one or more embodiments, the fused polycyclic compound represented by Formula 1 may be represented by Formula 2.

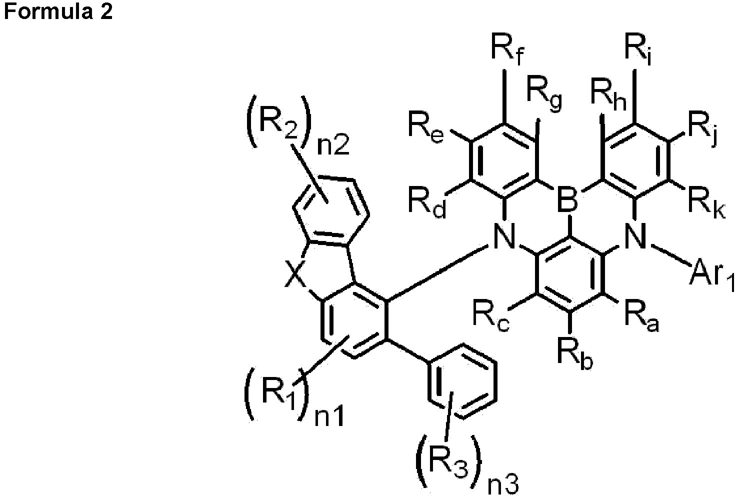

In Formula 2, R₃ may be hydrogen, deuterium, a halogen, a cyano group, a nitro group, a substituted or unsubstituted amine group, a substituted or unsubstituted oxy group, a substituted or unsubstituted thio group, a substituted or unsubstituted boron group, a substituted or unsubstituted silyl group, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms. In one or more embodiments, R₃ may be combined with an adjacent group to form (or provide) a ring. For example, in some embodiments, R₃ may be hydrogen, deuterium, a substituted or unsubstituted t-butyl group or a substituted or unsubstituted phenyl group. In one or more embodiments, two adjacent R₃ may include an oxy group and a phenyl group, respectively, and may be combined with each other to form (or provide) a dibenzofuran moiety.

In Formula 2, n3 may be an integer of 0 to 5. In Formula 2, if n3 is 0, the fused polycyclic compound of one or more embodiments may be unsubstituted with R₃. In Formula 2, an embodiment where n3 is 5, and all R₃'s are each hydrogen, may be the same as an embodiment where n3 is 0. In Formula 2, if n3 is an integer of 2 or more, multiple R₃'s may be all the same, or at least one selected from among multiple R₃'s may be different.

In Formula 2, the same contents explained in Formula 1 may be applied for X, Ar₁, R₁, R₂, Rₐ to Rₖ, n1, and n2.

In one or more embodiments, the fused polycyclic compound represented by Formula 1 may be represented by one selected from among Formula 3-1 and Formula 3-2.

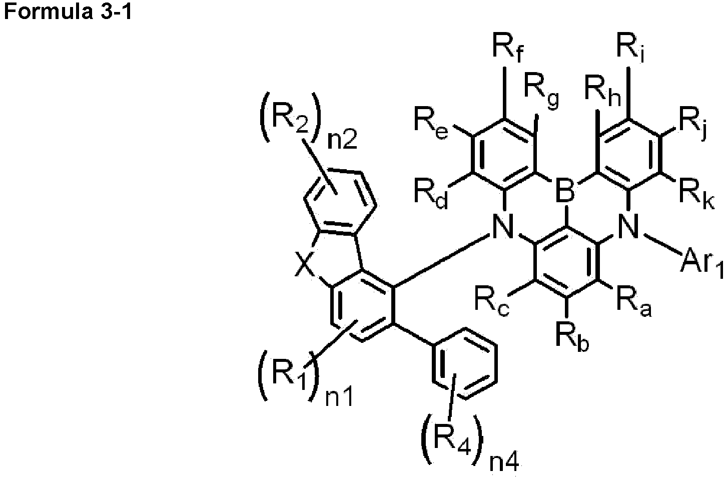

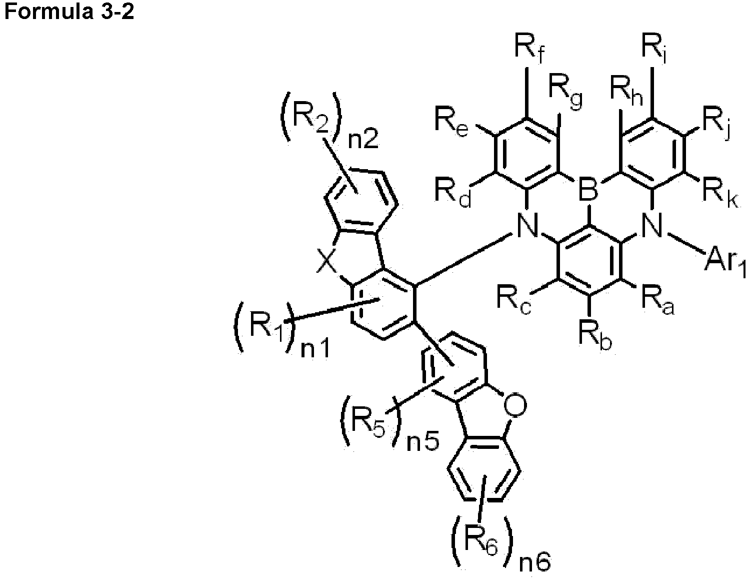

In Formula 3-1 and Formula 3-2, R₄ to R₆ may each independently be hydrogen, deuterium, a halogen, a cyano group, a nitro group, a substituted or unsubstituted amine group, a substituted or unsubstituted oxy group, a substituted or unsubstituted thio group, a substituted or unsubstituted boron group, a substituted or unsubstituted silyl group, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms. In one or more embodiments, each of R₄ to R₆ may not be combined with an adjacent group to form (or provide) a ring. For example, in some embodiments, each of R₄ to R₆ may independently be hydrogen, deuterium, a substituted or unsubstituted t-butyl group, or a substituted or unsubstituted phenyl group.

In Formula 3-1, n4 may be an integer of 0 to 5. If n4 is 0, the fused polycyclic compound of one or more embodiments may be unsubstituted with R₄. An embodiment where n4 is 5, and all R₄'s are each hydrogen, may be the same as an embodiment where n4 is 0. If n4 is an integer of 2 or more, multiple R₄'s may be all the same, or at least one selected from among multiple R₄'s may be different.

In Formula 3-2, n5 may be an integer of 0 to 3. If n5 is 0, the fused polycyclic compound of one or more embodiments may be unsubstituted with R₅. An embodiment where n5 is 3, and all R₅'s are each hydrogen, may be the same as an embodiment where n5 is 0. If n5 is an integer of 2 or more, multiple R₅'s may be all the same, or at least one selected from among multiple R₅'s may be different.

In Formula 3-2, n6 is may be integer of 0 to 4. If n6 is 0, the fused polycyclic compound of one or more embodiments may be unsubstituted with R₆. An embodiment where n6 is 4, and all R₆'s are each hydrogen, may be the same as an embodiment where n6 is 0. If n6 is an integer of 2 or more, multiple R₆'s may be all the same, or at least one selected from among multiple R₆'s may be different.

In Formula 3-1 and Formula 3-2, the same contents explained in Formula 1 may be applied for X, Ar₁, R₁, R₂, Rₐ to Rₖ, n1, and n2.

In one or more embodiments, the fused polycyclic compound represented by Formula 3-2 may be represented by one selected from among Formula 3-2-1 and Formula 3-2-2.

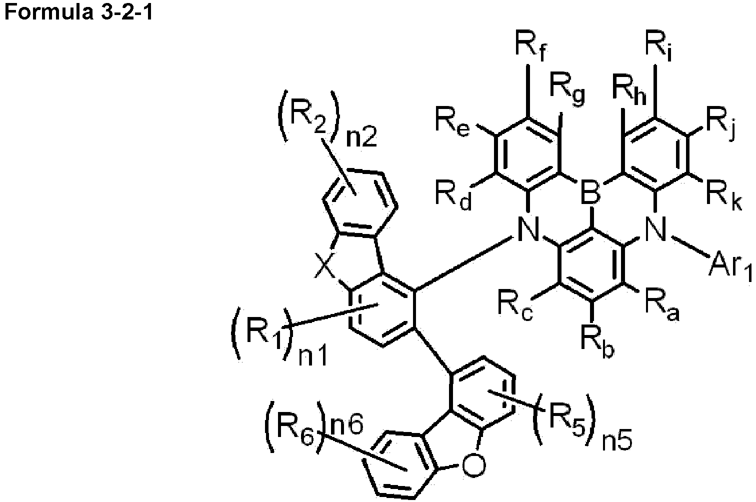

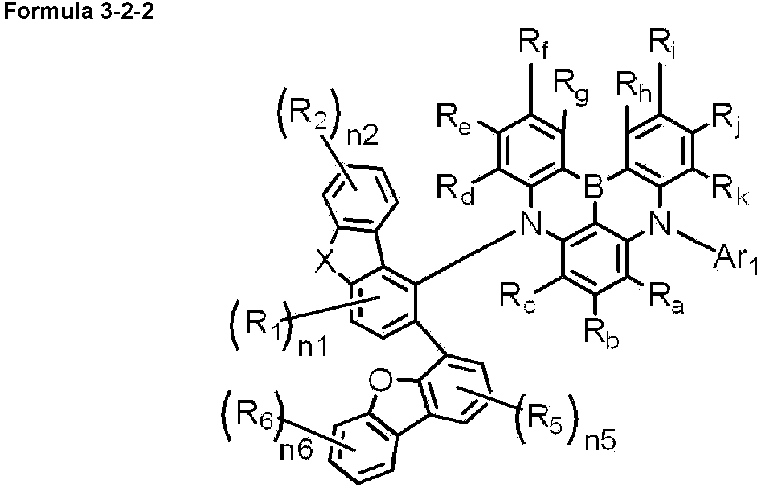

In Formula 3-2-1 and Formula 3-2-2, the same contents explained in Formula 1 may be applied for X, Ar₁, R₁, R₂, Rₐ to Rₖ, n1, and n2. The same contents explained in Formula 3-2 may be applied for R₅, R₆, n5, and n6.

In one or more embodiments, the fused polycyclic compound represented by Formula 1 may be represented by Formula 4.

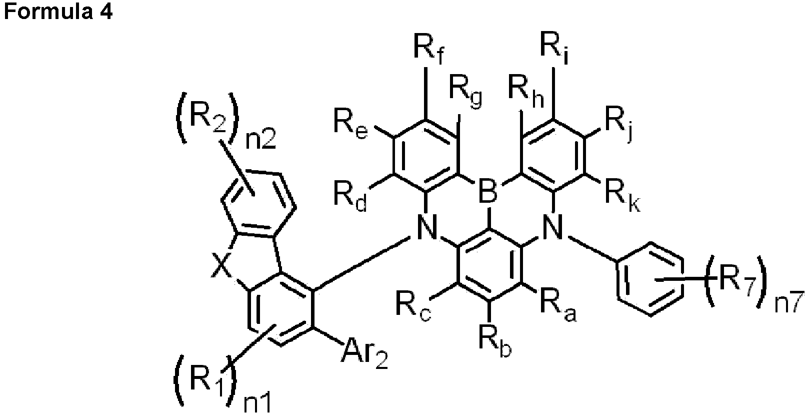

In Formula 4, R₇ may be hydrogen, deuterium, a halogen, a cyano group, a substituted or unsubstituted amine group, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms. In one or more embodiments, multiple R₇'s may be provided, and adjacent R₇ groups may be combined with each other to form (or provide) a ring. For example, in some embodiments, R₇ may each independently be hydrogen, deuterium, a halogen, a substituted or unsubstituted oxy group, a substituted or unsubstituted methyl group, a substituted or unsubstituted t-butyl group, a substituted or unsubstituted phenyl group, a substituted or unsubstituted biphenyl group, or a substituted or unsubstituted dibenzofuran group. In one or more embodiments, two adjacent R₇ groups may include an oxy group and a phenyl group, respectively, and may be combined with each other to form (or provide) a ring, thereby forming (or providing) a dibenzofuran moiety.

In Formula 4, n7 may be an integer of 0 to 5. In Formula 4, if n7 is 0, the fused polycyclic compound of one or more embodiments may be unsubstituted with R₇. In Formula 4, an embodiment where n7 is 5, and all R₇'s are each hydrogen, may be the same as an embodiment where n7 is 0. In Formula 4, if n7 is an integer of 2 or more, multiple R₇'s may be all the same, or at least one selected from among multiple R₇'s may be different.

In Formula 4, the same contents explained in Formula 1 may be applied for X, Ar₂, R₁, R₂, Rₐ to Rₖ, n1, and n2.

In one or more embodiments, the fused polycyclic compound represented by Formula 1 may be represented by Formula 5-1 or Formula 5-2.

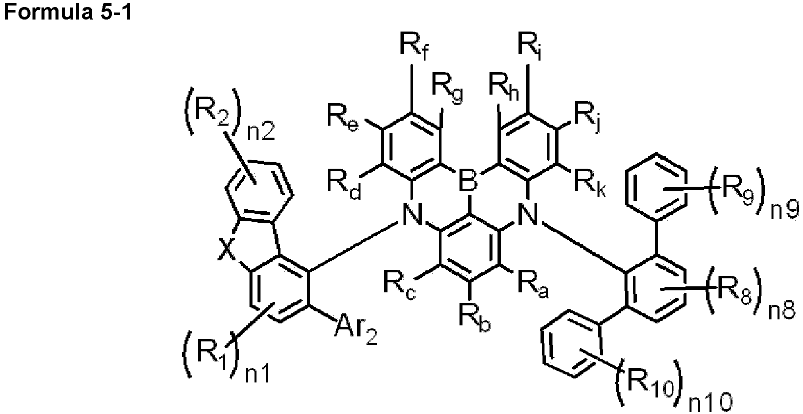

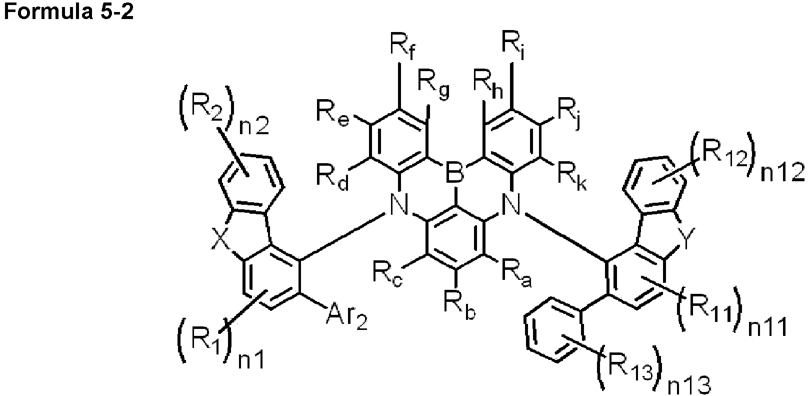

In Formula 5-2, Y may be O or S.

In Formula 5-1 and Formula 5-2, R₈ to R₁₂ may each independently be hydrogen, deuterium, a halogen, a cyano group, a nitro group, a substituted or unsubstituted amine group, a substituted or unsubstituted oxy group, a substituted or unsubstituted thio group, a substituted or unsubstituted boron group, a substituted or unsubstituted silyl group, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms. In one or more embodiments, each of R₈ to R₁₂ may not be combined with an adjacent group to form (or provide) a ring. For example, in some embodiments, each of R₈ to R₁₂ may be hydrogen, deuterium, a substituted or unsubstituted t-butyl group, or a substituted or unsubstituted phenyl group.

In one or more embodiments, in Formula 5-2, R₁₃ may be hydrogen, deuterium, a halogen, a cyano group, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms. In one or more embodiments, multiple R₁₃'s may be provided, and adjacent R₁₃ groups may be combined with each other to form (or provide) a ring. For example, in some embodiments, R₁₃ may each independently be hydrogen, deuterium, a halogen, a substituted or unsubstituted oxy group, a substituted or unsubstituted methyl group, a substituted or unsubstituted t-butyl group, a substituted or unsubstituted phenyl group, a substituted or unsubstituted biphenyl group, or a substituted or unsubstituted dibenzofuran group. In one or more embodiments, two adjacent R₁₃ may include an oxy group and a phenyl group, respectively, and may be combined with each other to form (or provide) a ring, thereby forming (or providing) a dibenzofuran moiety.

In Formula 5-1 and Formula 5-2, n8 may be an integer of 0 to 3, n12 may be an integer of 0 to 4, n9, n10, and n13 may each independently be an integer of 0 to 5. n11 is an integer of 0 to 2.

If n8 is 0, the fused polycyclic compound of one or more embodiments may be unsubstituted with R₈. An embodiment where n8 is 3, and all R₈'s are each hydrogen, may be the same as an embodiment where n8 is 0. If n8 is an integer of 2 or more, multiple R₈'s may be all the same, or at least one selected from among multiple R₈'s may be different.

If n9 is 0, the fused polycyclic compound of one or more embodiments may be unsubstituted with R₉. An embodiment where n9 is 5, and all R₉'s are each hydrogen, may be the same as an embodiment where n9 is 0. If n9 is an integer of 2 or more, multiple R₉'s may be all the same, or at least one selected from among multiple R₉'s may be different.

If n10 is 0, the fused polycyclic compound of one or more embodiments may be unsubstituted with R₁₀. An embodiment where n10 is 5, and all R₁₀'s are each hydrogen, may be the same as an embodiment where n10 is 0. If n10 is an integer of 2 or more, multiple R₁₀'s may be all the same, or at least one selected from among multiple R₁₀'s may be different.

If n11 is 0, the fused polycyclic compound of one or more embodiments may be unsubstituted with R₁₁. An embodiment where n11 is 2, and all R₁₁'s are each hydrogen, may be the same as an embodiment where n11 is 0. If n11 is an integer of 2, two R₁₁'s may be all the same, or at least one selected from among two R₁₁'s may be different.

If n12 is 0, the fused polycyclic compound of one or more embodiments may be unsubstituted with R₁₂. An embodiment where n12 is 4, and all R₁₂'s are each hydrogen, may be the same as an embodiment where n12 is 0. If n12 is an integer of 2 or more, multiple R₁₂'s may be all the same, or at least one selected from among multiple R₁₂'s may be different.

If n13 is 0, the fused polycyclic compound of one or more embodiments may be unsubstituted with R₁₃. An embodiment where n13 is 4, and all R₁₃'s are each hydrogen, may be the same as an embodiment where n13 is 0. If n13 is an integer of 2 or more, multiple R₁₃'s may be all the same, or at least one selected from among multiple R₁₃'s may be different.

In Formula 5-1 and Formula 5-2, the same contents explained referring to Formula 1 may be applied for X, Ar₂, R₁, R₂, Rₐ to Rₖ, n1, and n2.

In one or more embodiments, the fused polycyclic compound of one or more embodiments may have an axial symmetry structure with the boron atom and the third aromatic ring of the fused ring core as a center. In one or more embodiments, the fused polycyclic compound may be represented by Formula 5-2, X and Y may be the same, and Ar₂ may have the same structure as a phenyl moiety at which R₁₃ is substituted.

In one or more embodiments, the fused polycyclic compound represented by Formula 1 may be represented by one selected from among Formula 6-1 to Formula 6-4.

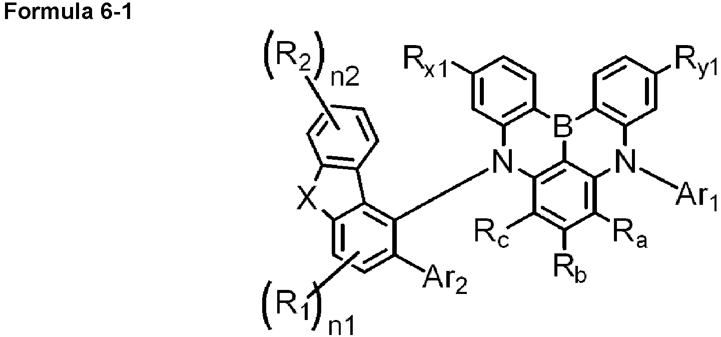

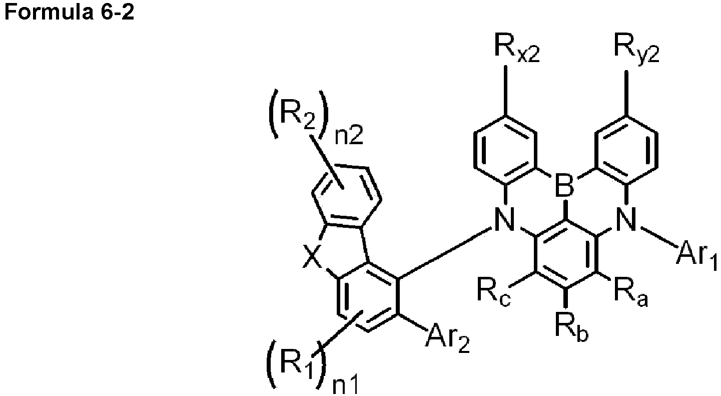

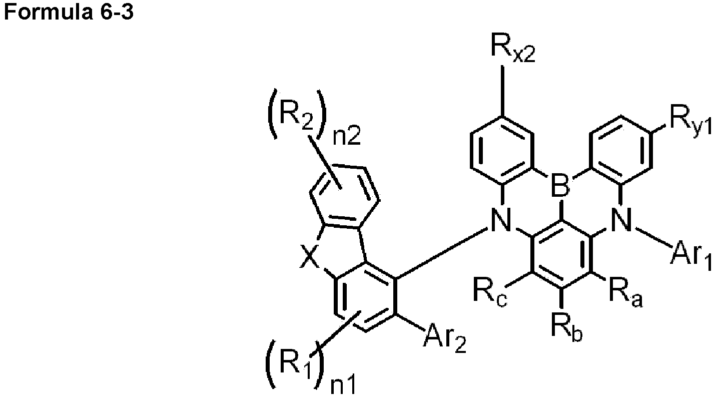

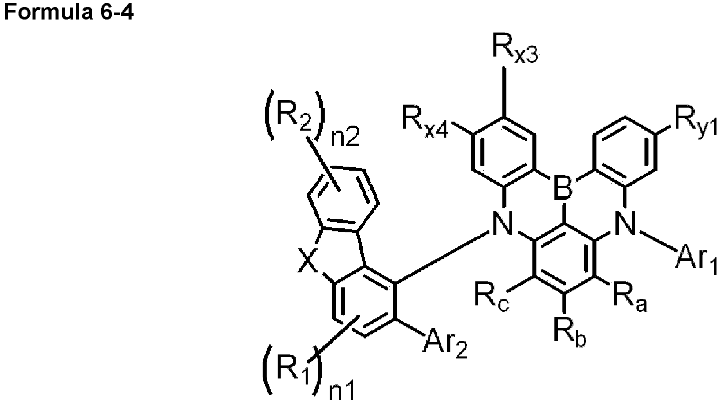

In Formula 6-1 to Formula 6-4, Rₓ₁, Rₓ₂, R_{y1}, and R_{y2} may each independently be deuterium, a halogen, a substituted or unsubstituted amine group, a substituted or unsubstituted silyl group, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms. For example, in one or more embodiments, Rₓ₁, Rₓ₂, R_{y1}, and R_{y2} may each independently be a substituted or unsubstituted silyl group, a substituted or unsubstituted amine group, a substituted or unsubstituted phenyl group, a substituted or unsubstituted biphenyl group, a substituted or unsubstituted dibenzofuran group, a substituted or unsubstituted N-carbazole group, or a substituted or unsubstituted acridine group. In one or more embodiments, the N-carbazole group may refer to a substituent connected with the fused ring core of the fused polycyclic compound via a nitrogen atom of the N-carbazole group. In one or more embodiments, Rₓ₁, Rₓ₂, R_{y1}, and R_{y2} may each independently be one selected from among substituents represented by Formula a-1 to Formula a-22.

In Formula 6-4, Rₓ₃ and Rₓ₄ may each independently be deuterium, a halogen, a substituted or unsubstituted amine group, a substituted or unsubstituted silyl group, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms. In one or more embodiments, Rₓ₃ and/or Rₓ₄ may each independently be combined with an adjacent group to form (or provide) a ring. For example, in some embodiments, adjacently arranged Rₓ₃ and Rₓ₄ may be combined with each other to form (or provide) an additional hydrocarbon ring or a heterocycle.

In Formula 6-1 to Formula 6-4, the same contents explained in Formula 1 may be applied for X, Ar₁, Ar₂, R₁, R₂, Rₐ to R_{c}, n1, and n2.

In one or more embodiments, the fused polycyclic compound represented by Formula 1 may be represented by Formula 7.

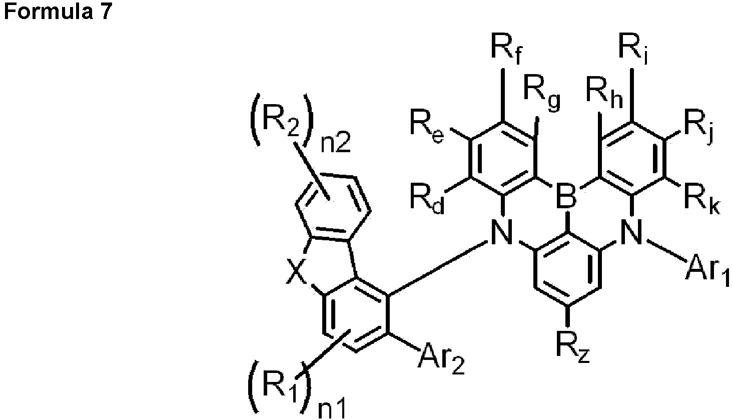

In Formula 7, R_{z} may be deuterium, a halogen, a substituted or unsubstituted amine group, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms. In one or more embodiments, R_{z} may not be combined with an adjacent group to form (or provide) a ring. For example, in some embodiments, R_{z} may be a substituted or unsubstituted t-butyl group, a substituted or unsubstituted phenyl group, a substituted or unsubstituted biphenyl group, a substituted or unsubstituted terphenyl group, a substituted or unsubstituted dibenzofuran group, a substituted or unsubstituted carbazole group, a substituted or unsubstituted fluorenyl group, a substituted or unsubstituted xanthene group, or a substituted or unsubstituted indolocarbazole group. In one or more embodiments, R_{z} may be an unsubstituted t-butyl group or one selected from among substituents represented by Formula b-1 to Formula b-17.

In Formula 7, the same contents explained in Formula 1 may be applied for X, Ar₁, Ar₂, R₁, R₂, R_{d} to Rₖ, n1, and n2.

In one or more embodiments, the fused polycyclic compound represented by Formula 1 may be represented by Formula 8.

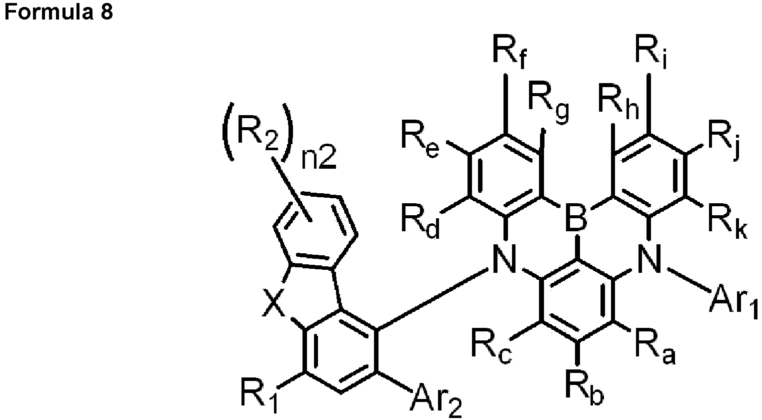

In Formula 8, the same contents explained in Formula 1 may be applied for X, Ar₁, Ar₂, R₁, R₂, Rₐ to Rₖ, and n2.

In one or more embodiments, the fused polycyclic compound of one or more embodiments, represented by Formula 1, may include at least one deuterium as a substituent. The fused polycyclic compound of one or more embodiments, represented by Formula 1, may include a structure in which at least one hydrogen is substituted with deuterium.

The fused polycyclic compound of one or more embodiments may be one selected from among compounds represented in Compound Group 1. At least one functional layer included in the light emitting element ED of one or more embodiments may include at least one fused polycyclic compound selected from among the compounds represented in Compound Group 1. The light emitting element ED of one or more embodiments may include at least one fused polycyclic compound selected from among the compounds represented in Compound Group 1 in an emission layer EML.

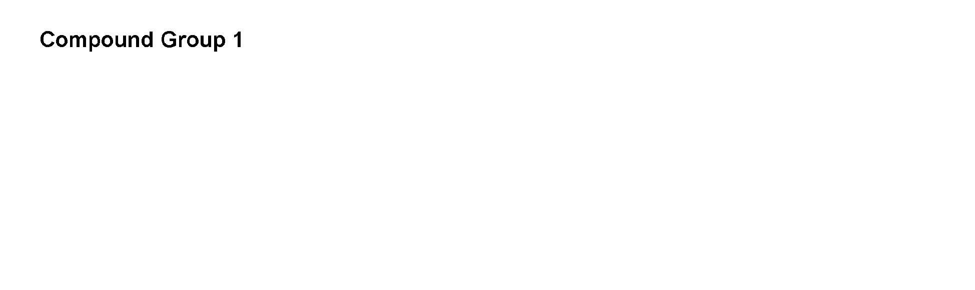

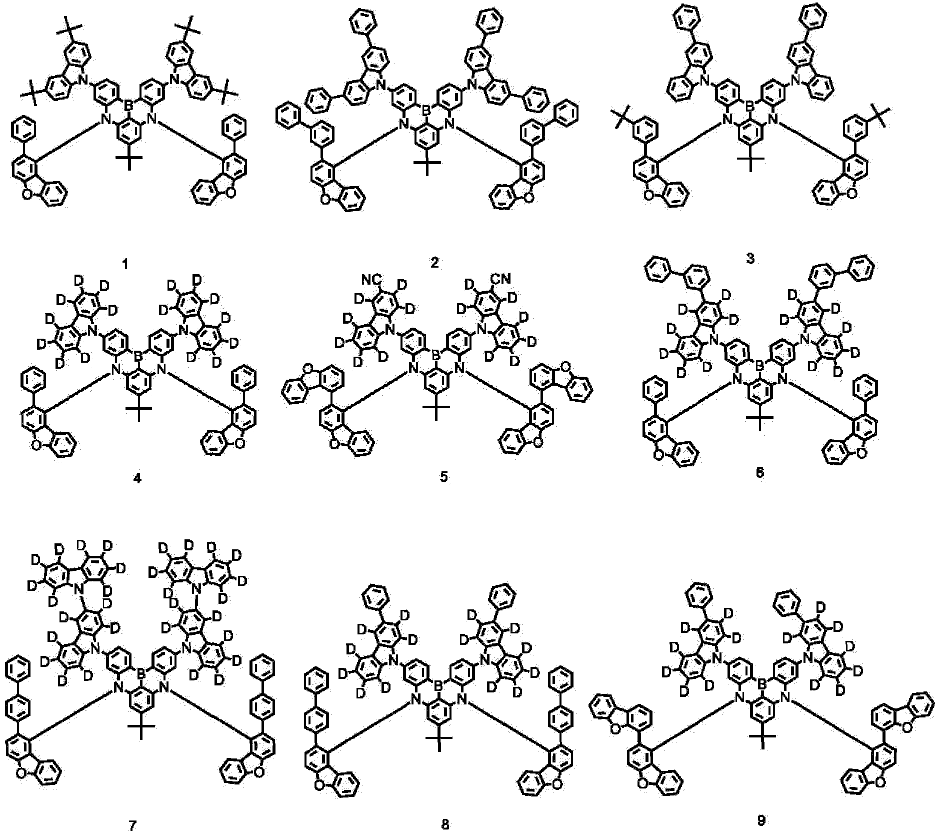

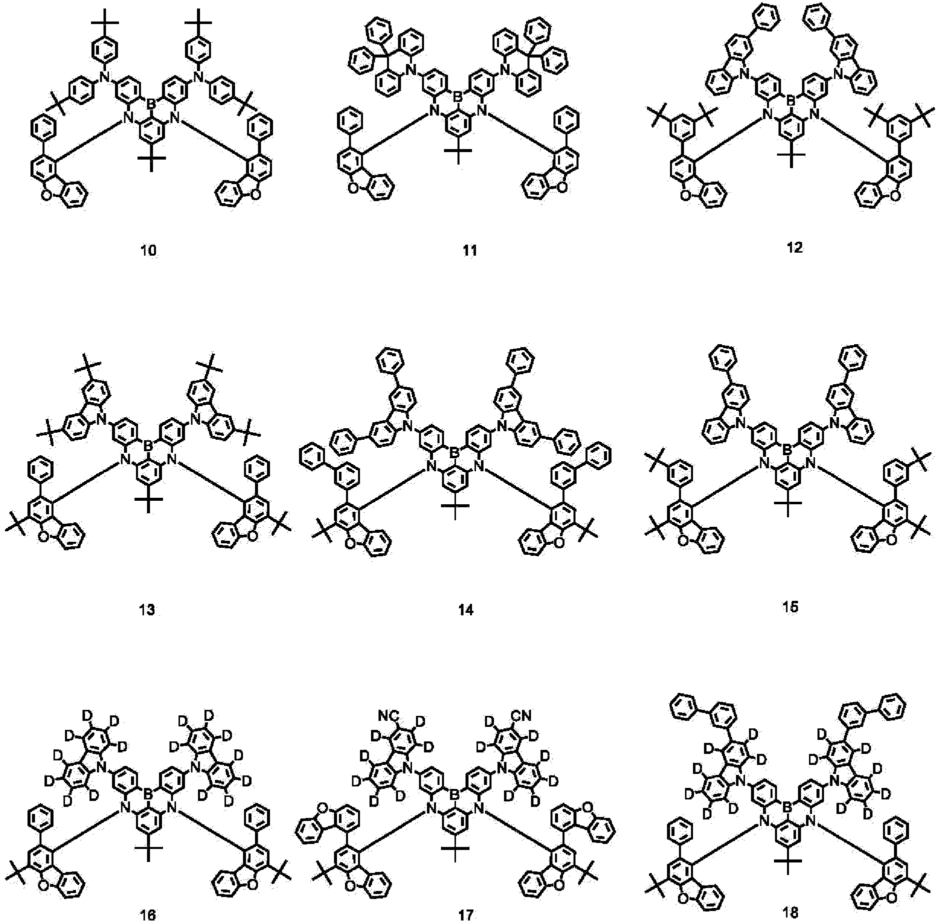

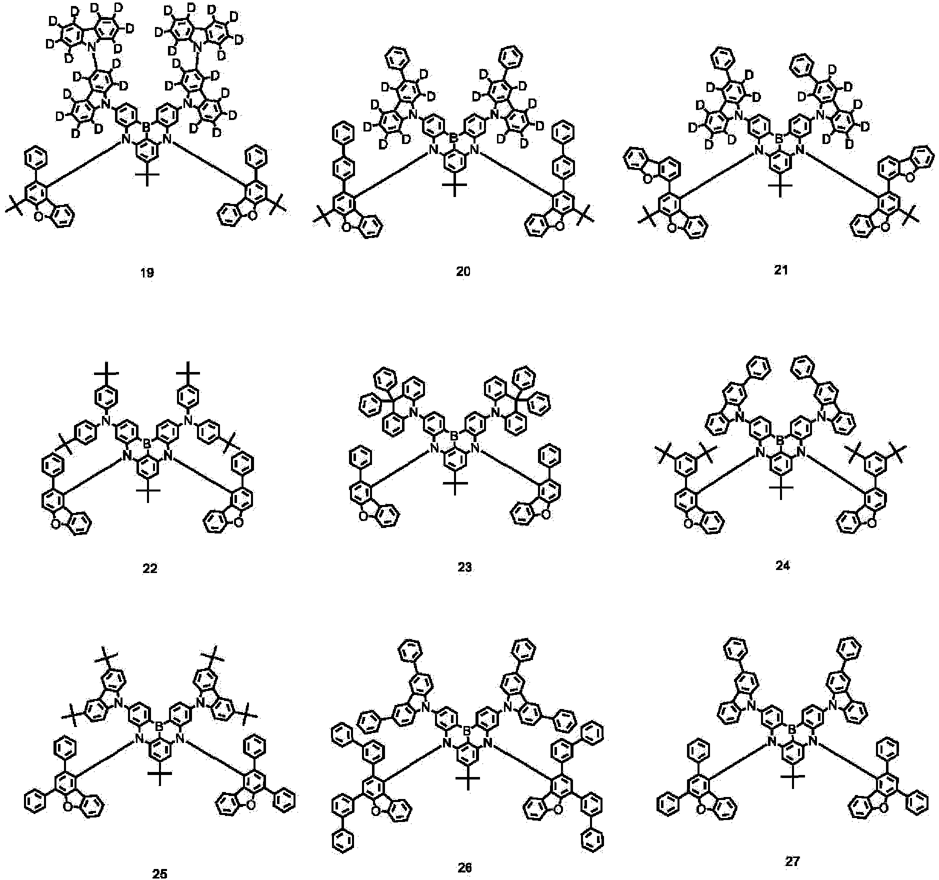

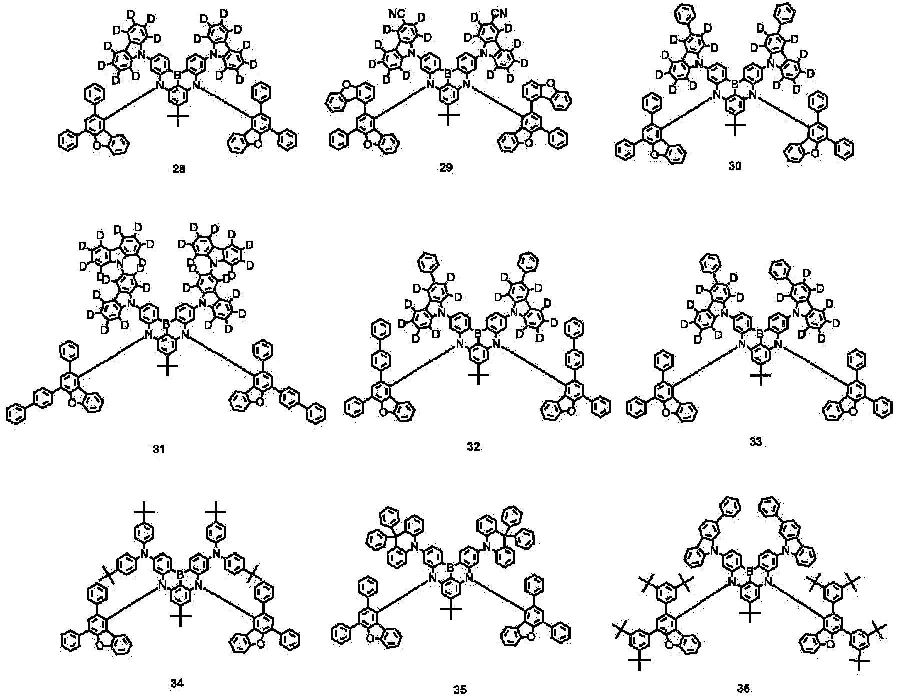

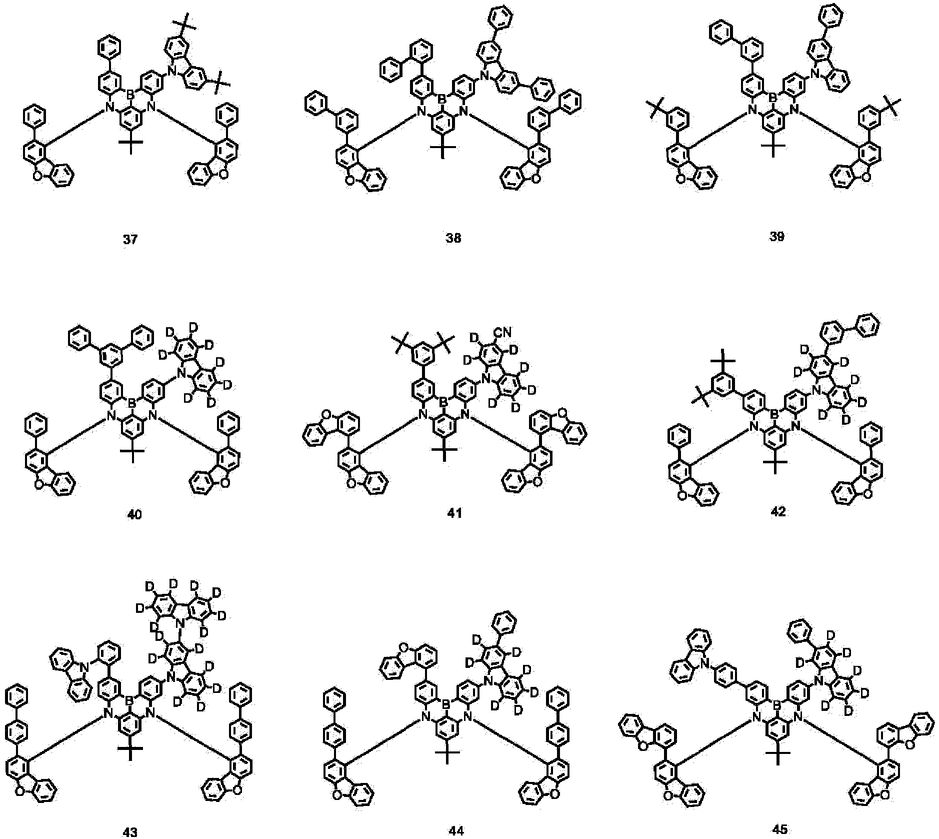

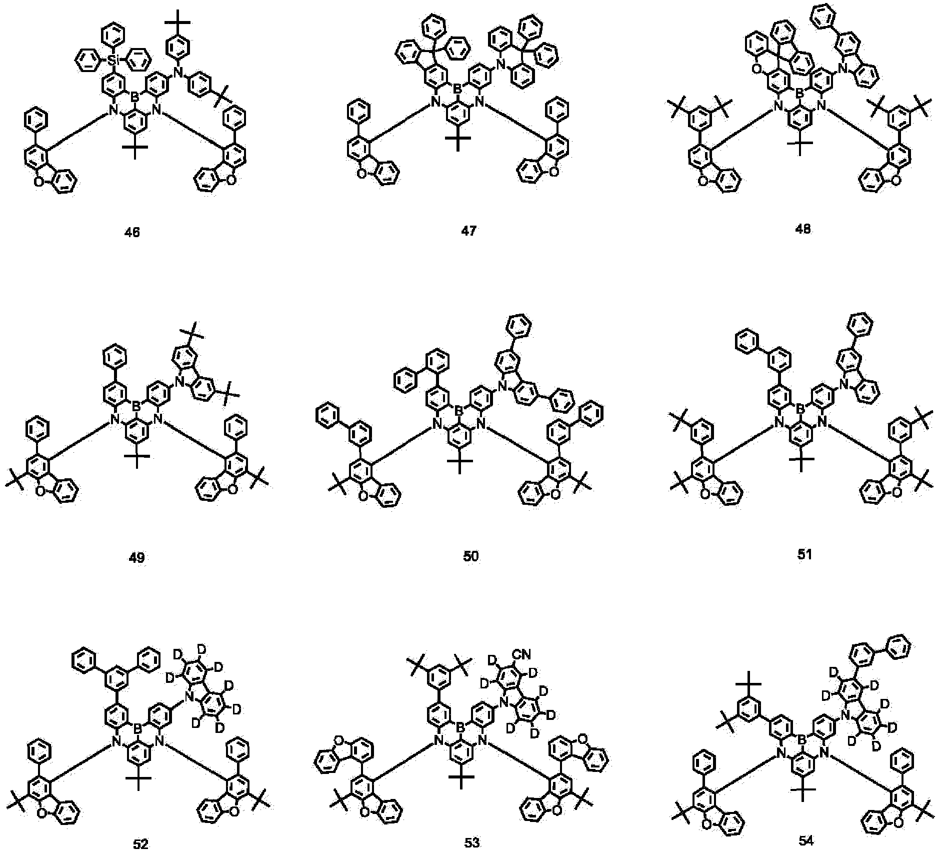

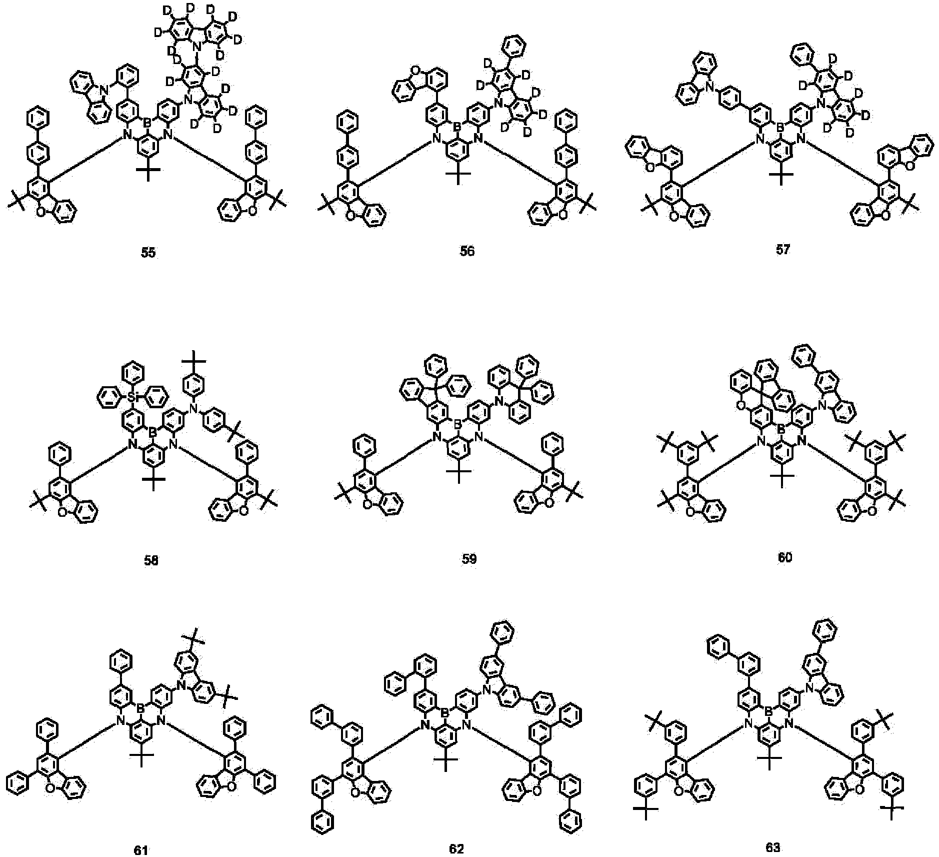

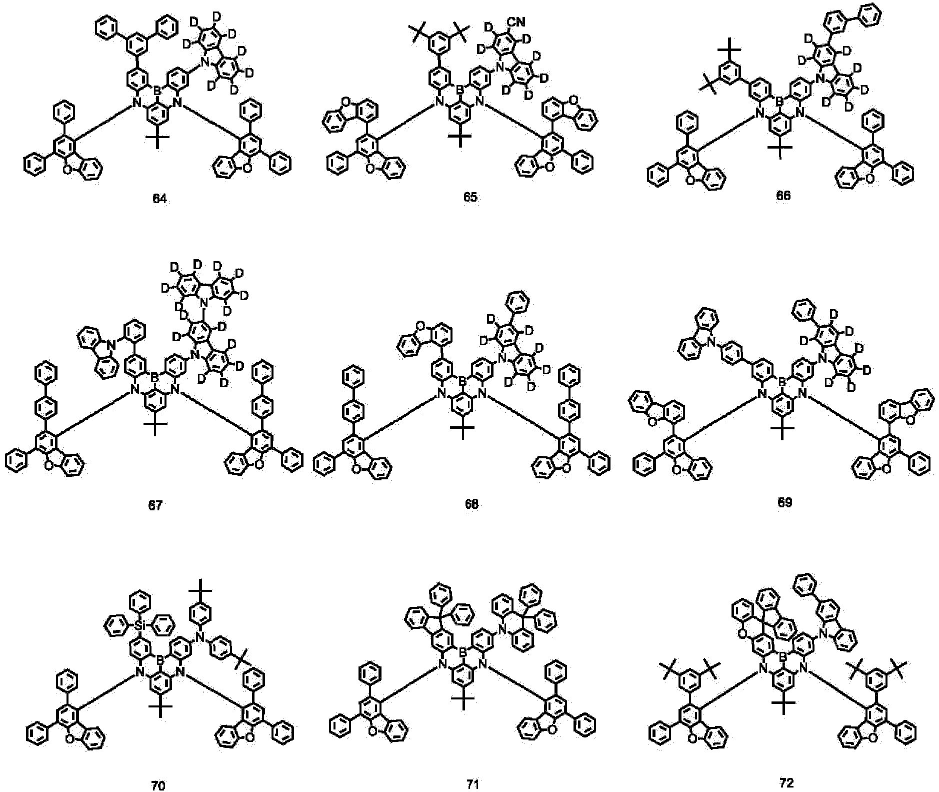

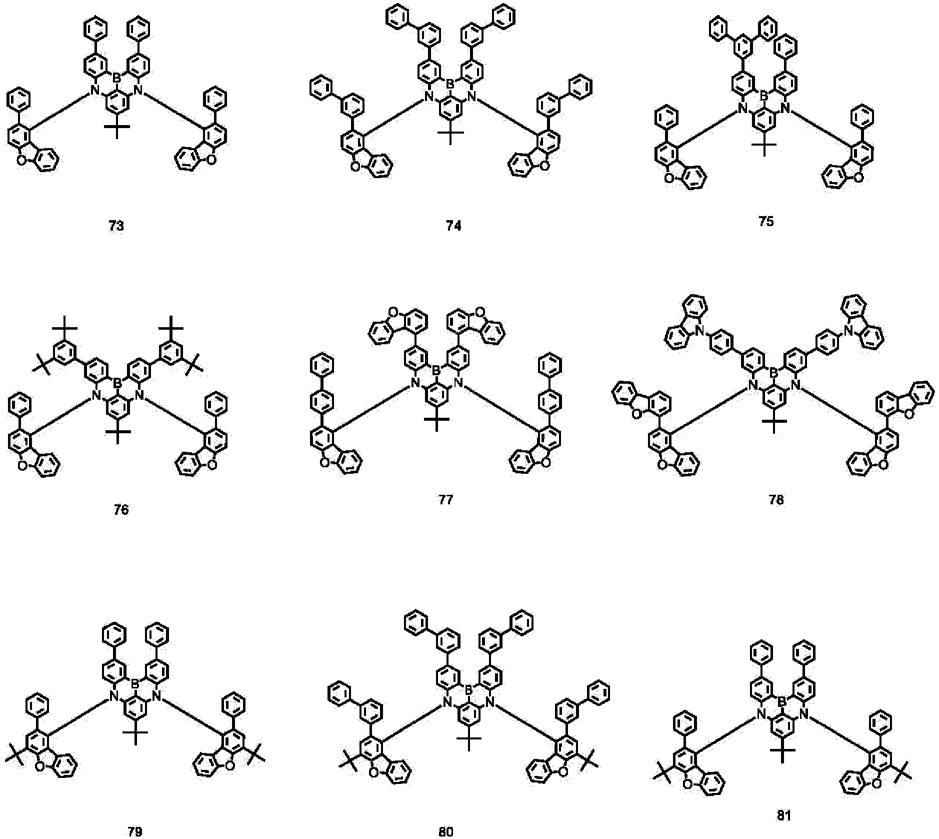

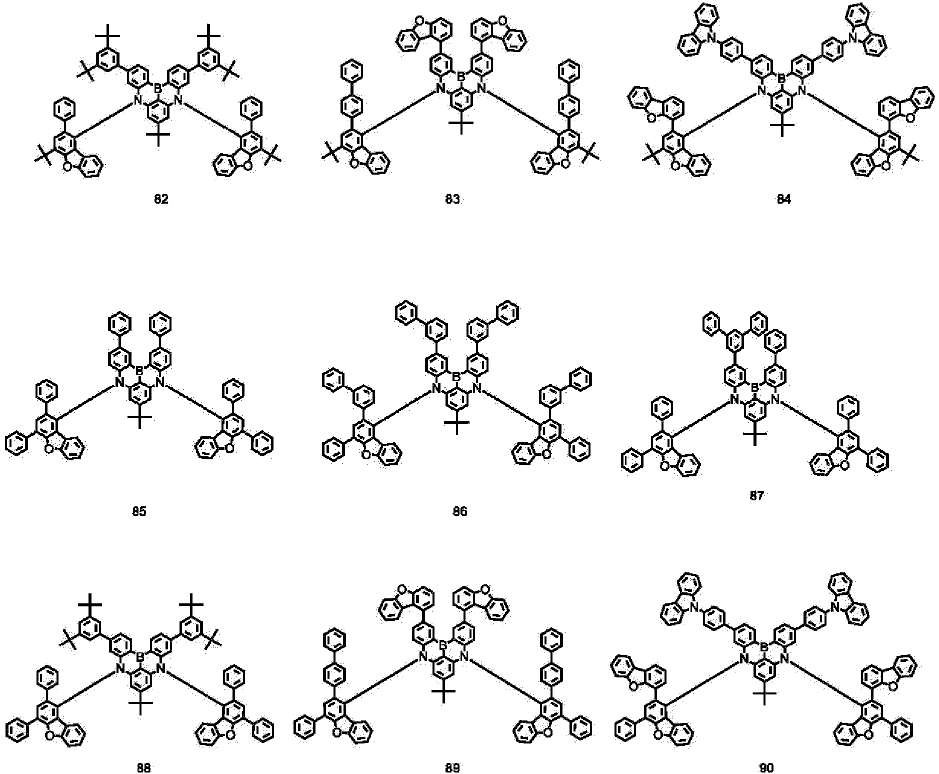

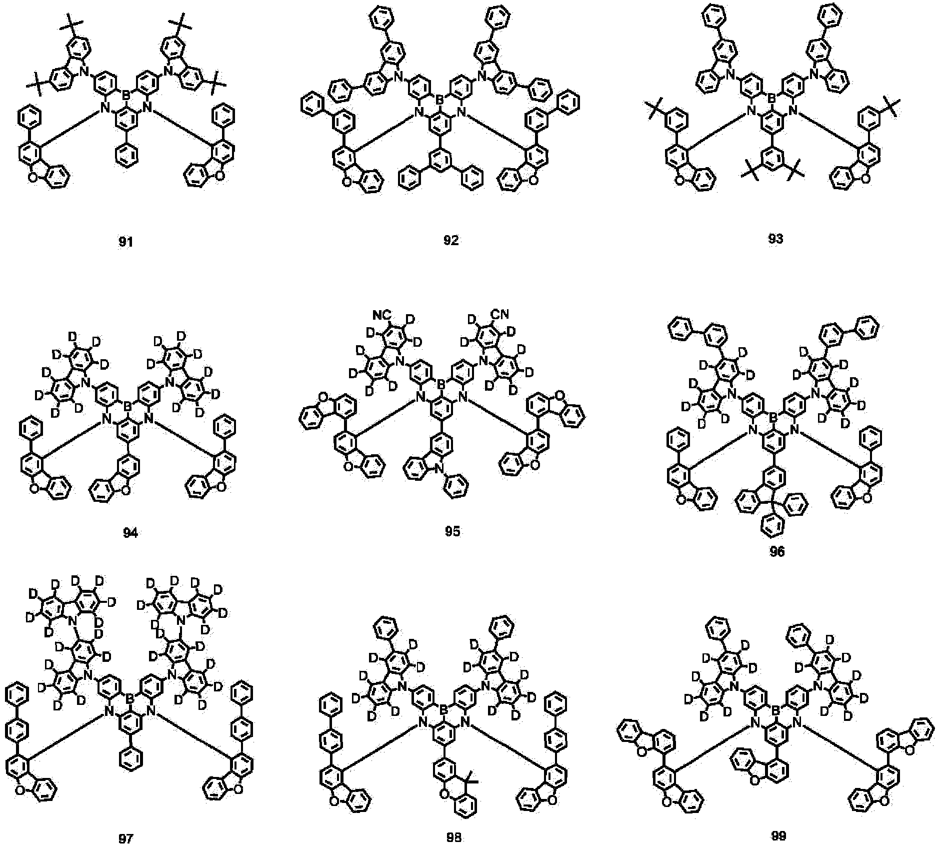

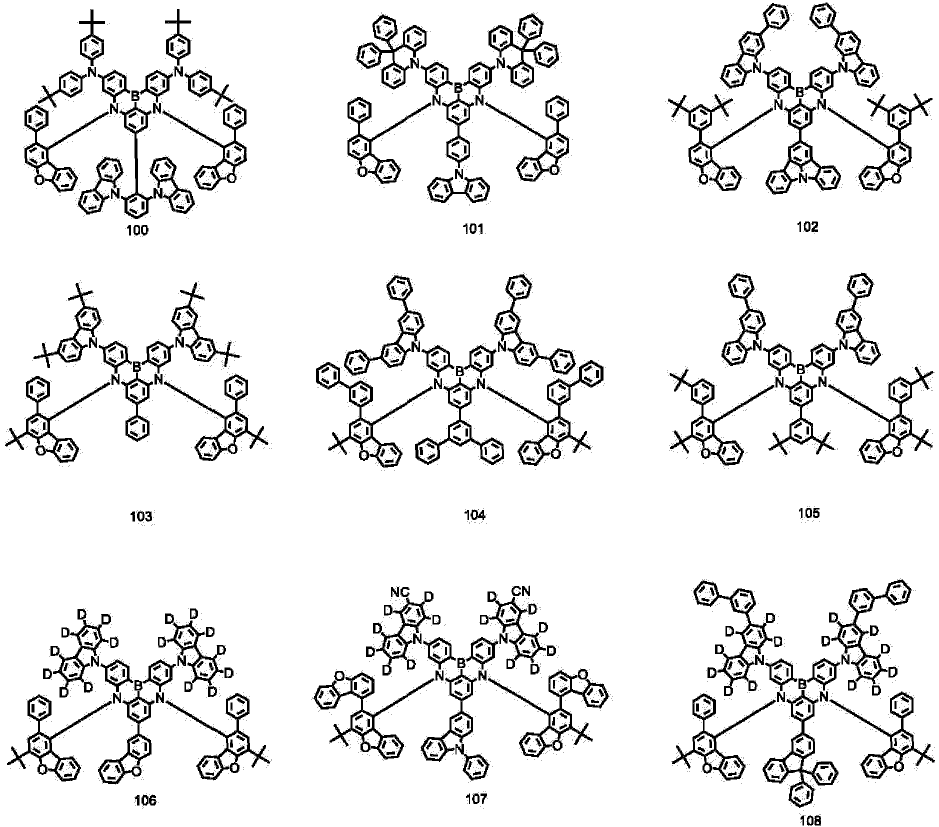

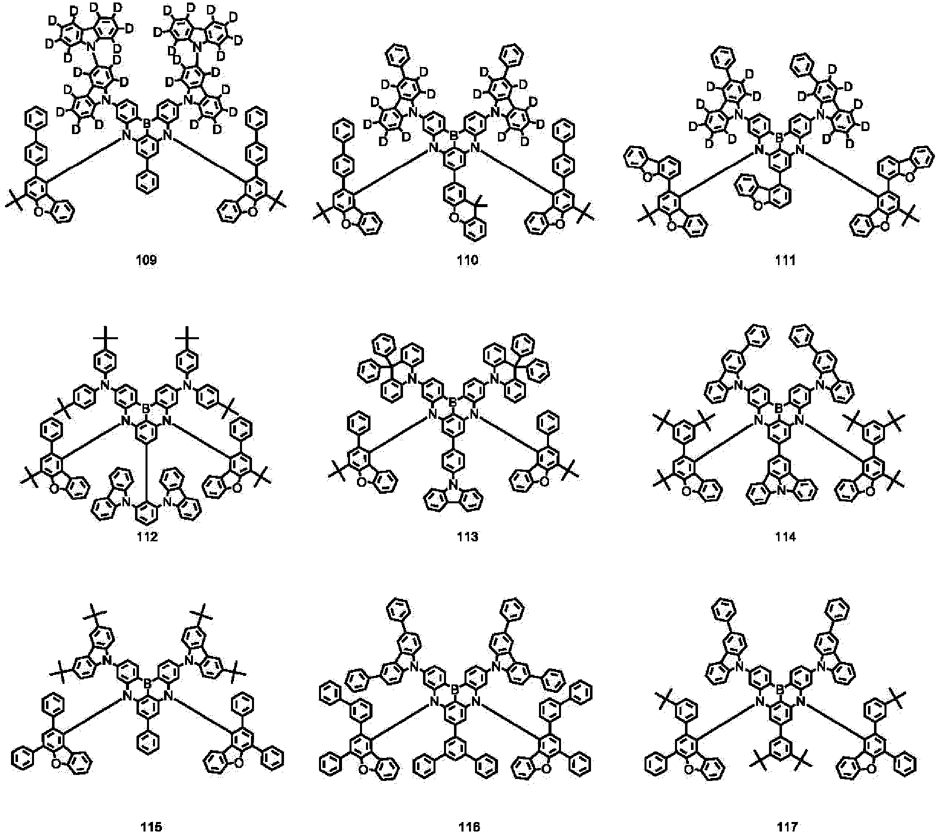

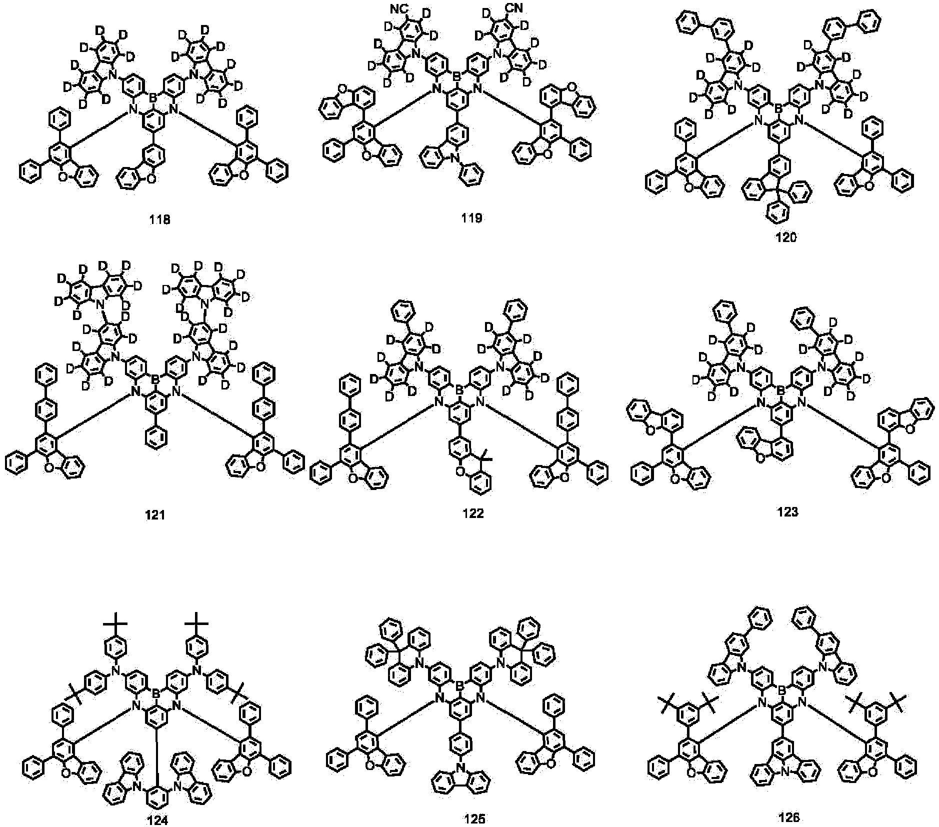

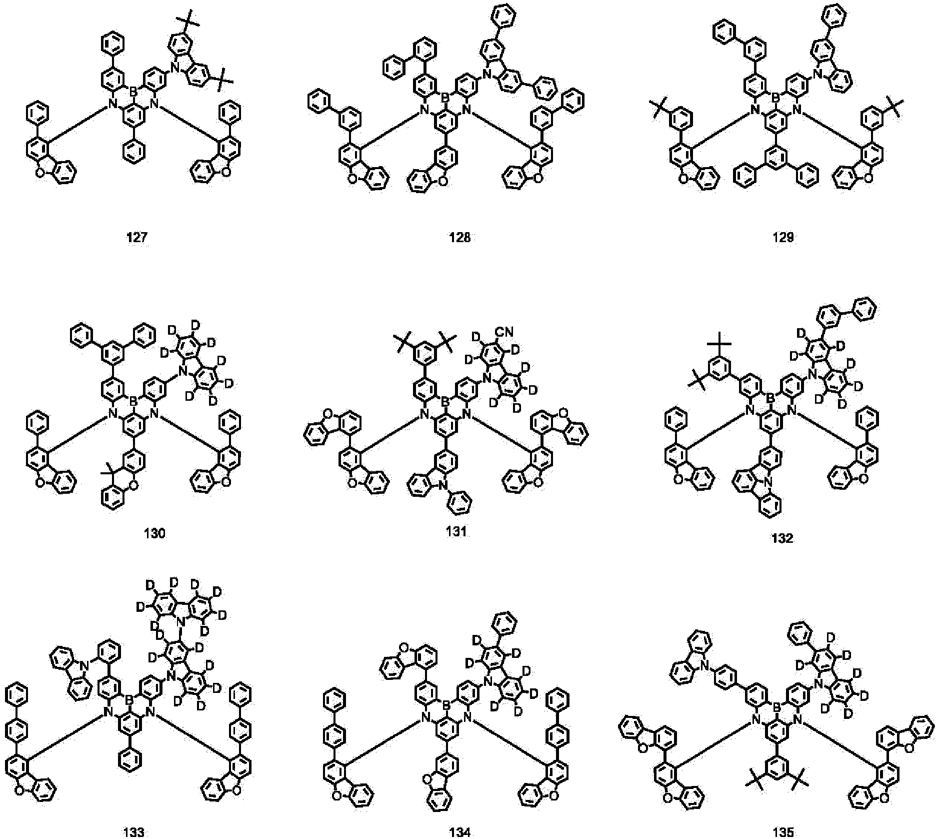

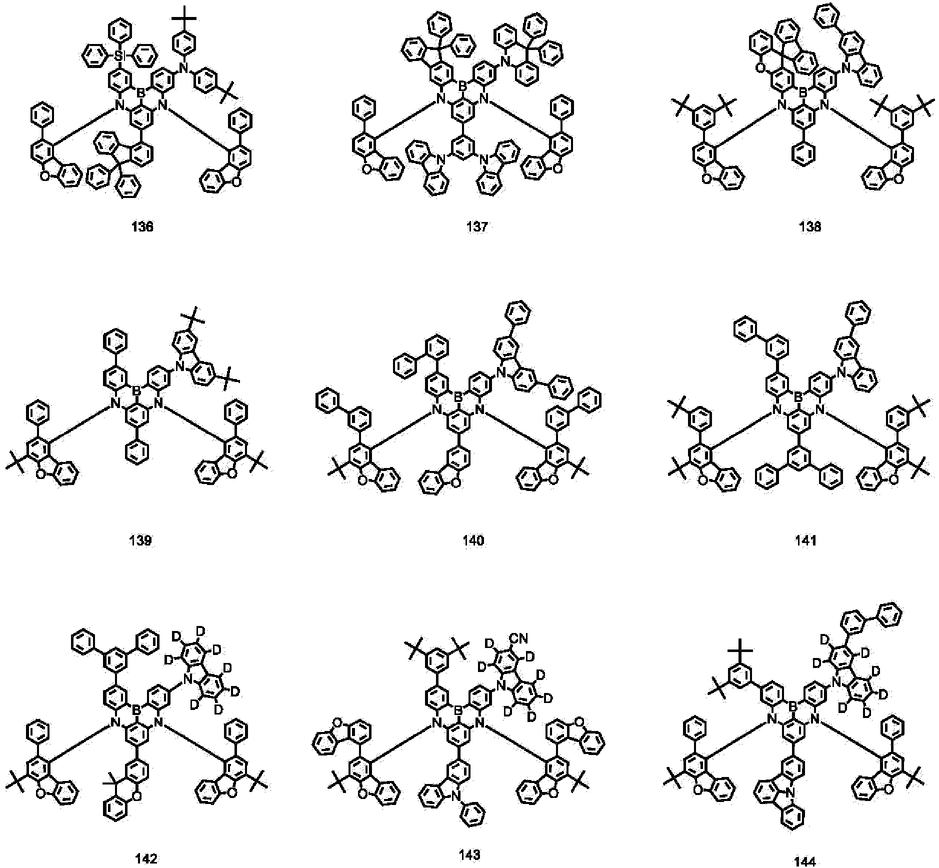

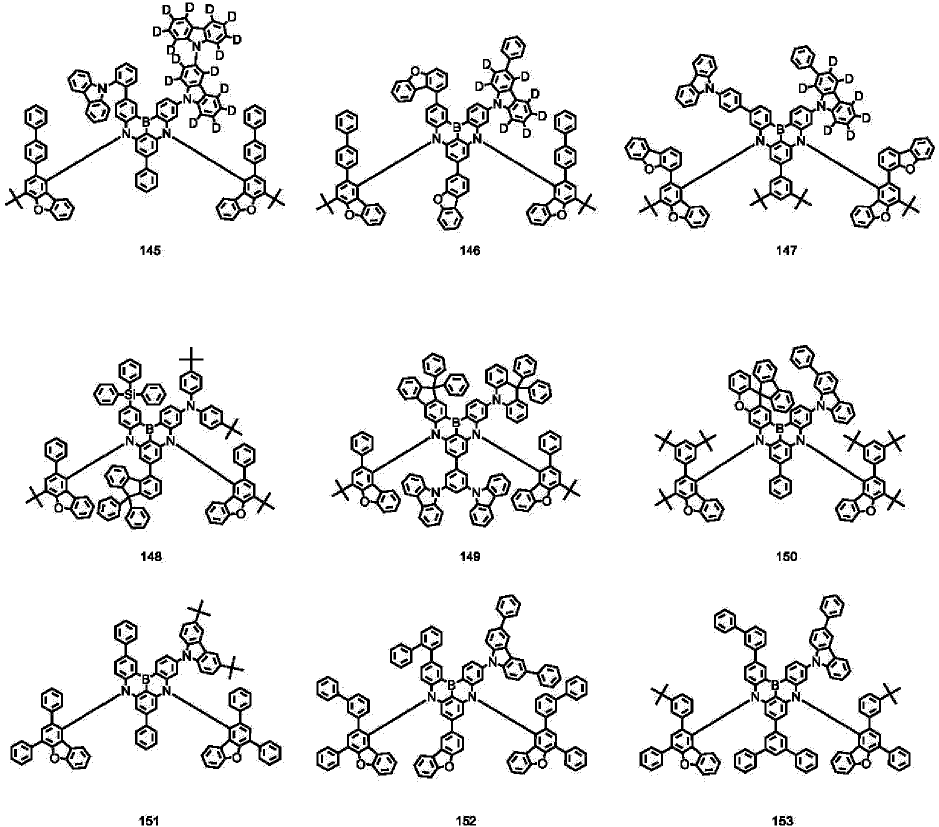

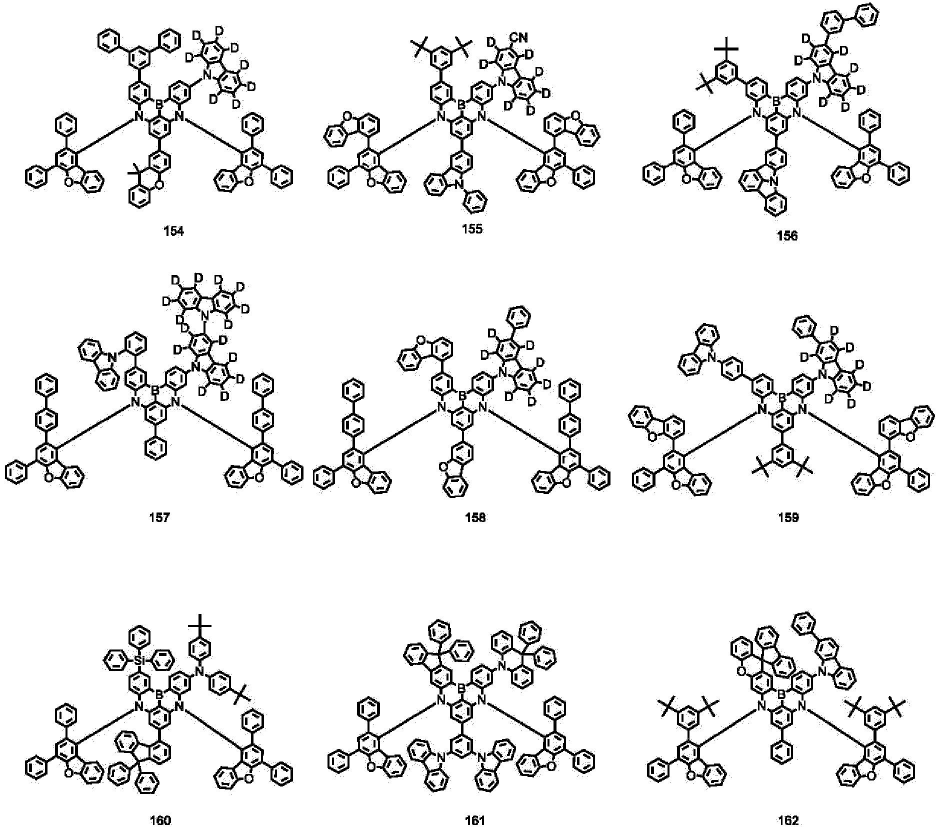

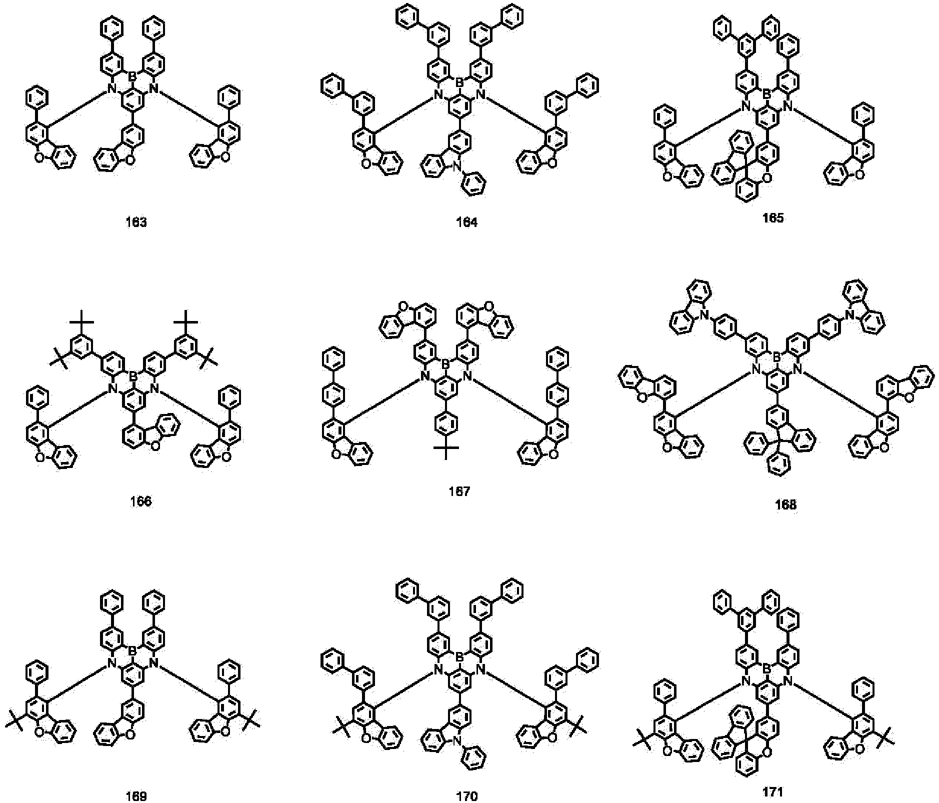

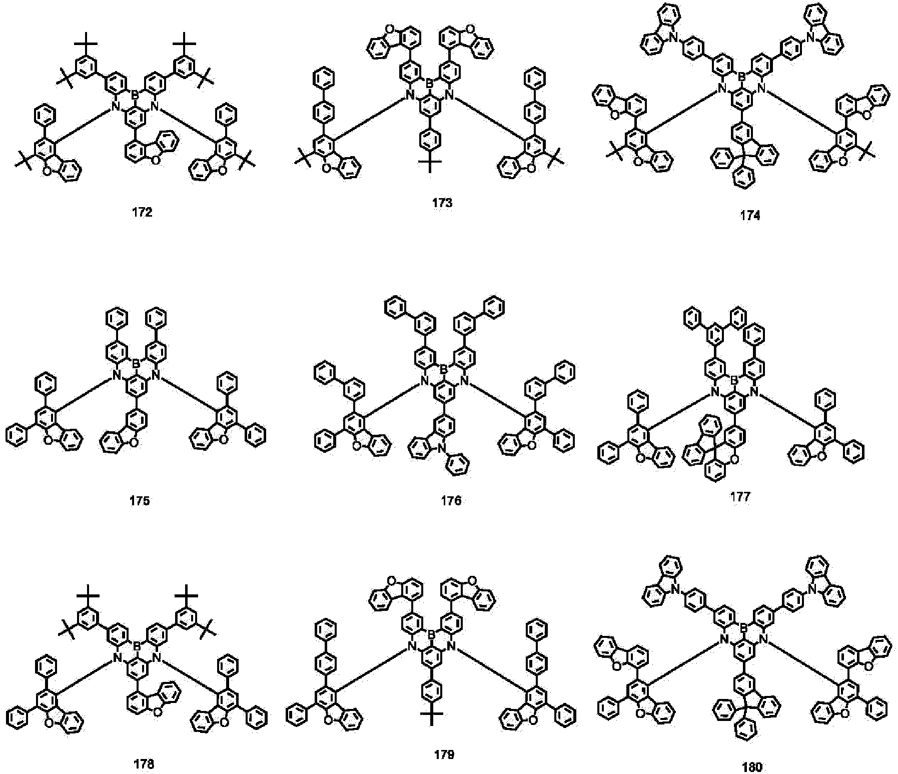

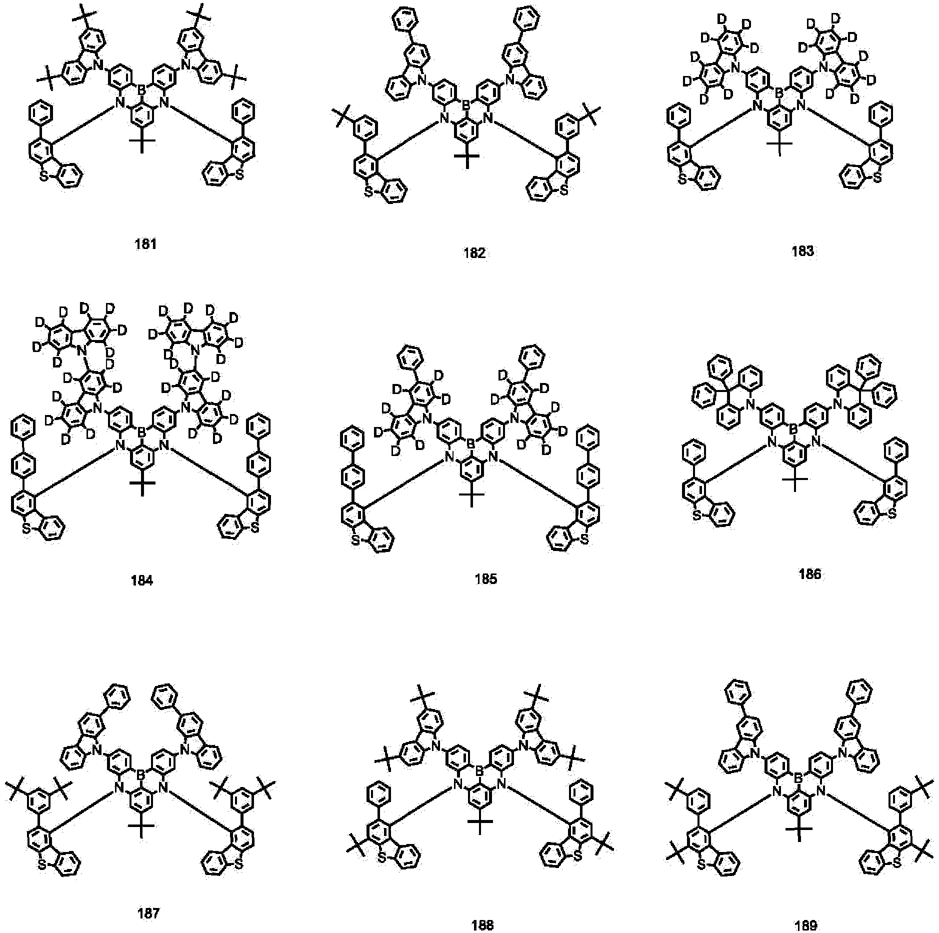

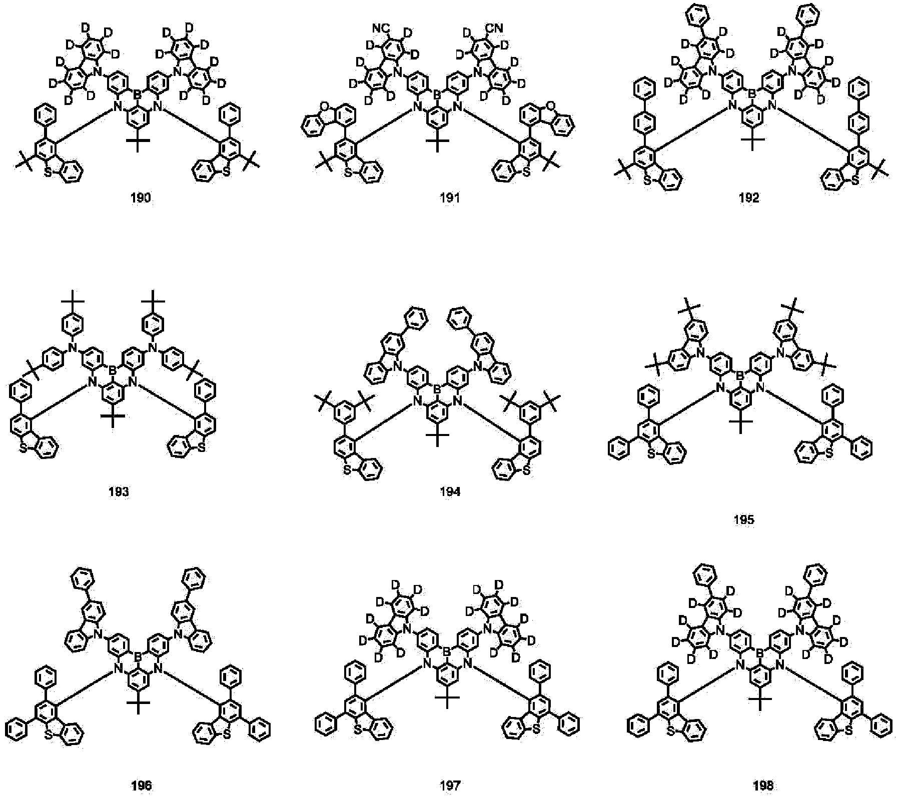

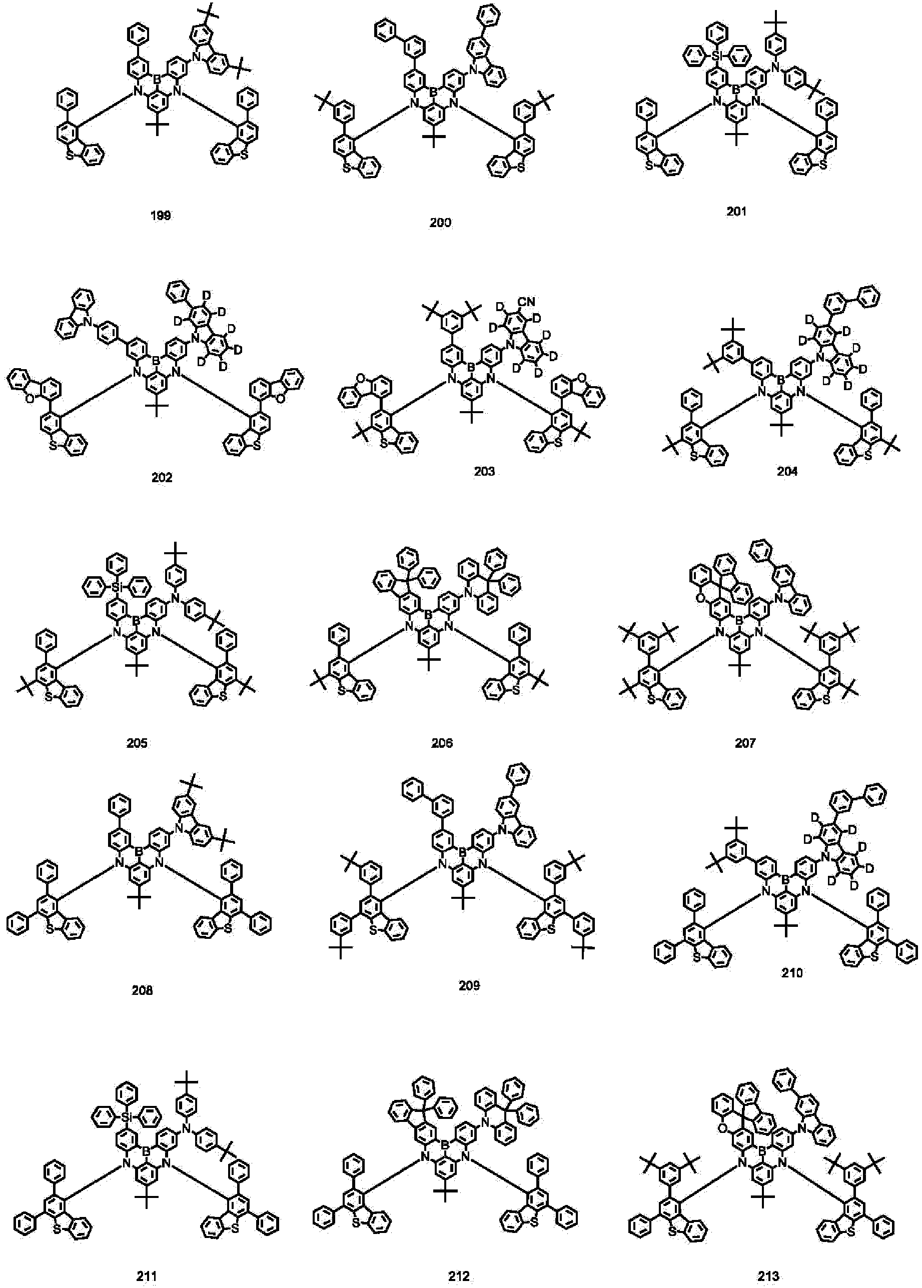

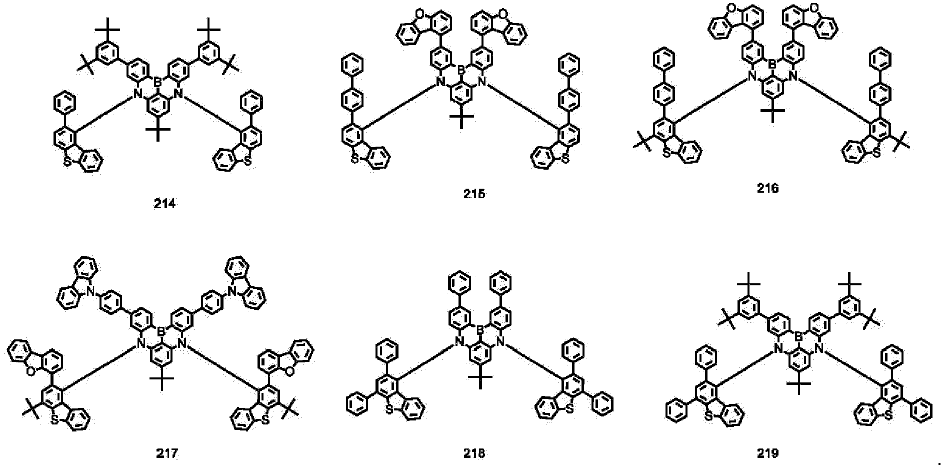

In the example compounds suggested in Compound Group 1, "D" refers to deuterium.

The emission spectrum of the fused polycyclic compound of one or more embodiments, represented by Formula 1, has a full width at half maximum of about 10 nm to about 50 nm, or, about 20 nm to about 40 nm. Because the emission spectrum of the first dopant (e.g., the first compound) of one or more embodiments, represented by Formula 1, has the above-described range of the full width at half maximum, if applied to a light emitting element, emission efficiency may be improved. In one or more embodiments, if the fused polycyclic compound of one or more embodiments is utilized as a material for a blue light emitting element, element lifetime may be improved.

In one or more embodiments, the fused polycyclic compound of one or more embodiments, represented by Formula 1, may be a material for emitting thermally activated delayed fluorescence. In one or more embodiments, the fused polycyclic compound of one or more embodiments, represented by Formula 1, may be a thermally activated delayed fluorescence dopant having a difference (△E_{ST}) between the lowest triplet excitation energy level (T1 level) and the lowest singlet excitation energy level (S1 level) of about 0.6 eV or less. In one or more embodiments, the fused polycyclic compound of one or more embodiments, represented by Formula 1, may be a thermally activated delayed fluorescence dopant having a difference (△E_{ST}) between the lowest triplet excitation energy level (T1 level) and the lowest singlet excitation energy level (S1 level) of about 0.2 eV or less. However, embodiments of the present disclosure are not limited thereto.

In one or more embodiments, the fused polycyclic compound of one or more embodiments, represented by Formula 1, may include the first substituent and the second substituent in the compound. The singlet energy level and the triplet energy level of the whole compound may be appropriately controlled or selected by controlling the substitution numbers and substitution positions of the first substituent and the second substitution. Through this, the fused polycyclic compound of one or more embodiments of the present disclosure may show improved thermally activated delayed fluorescence properties.

The fused polycyclic compound of one or more embodiments, represented by Formula 1, may be a light emitting material having a light emission center wavelength in a wavelength region of about 430 nm to about 490 nm. For example, the fused polycyclic compound of one or more embodiments, represented by Formula 1, may be a blue thermally activated delayed fluorescence (TADF) dopant. However, embodiments of the present disclosure are not limited thereto, and if the fused polycyclic compound of one or more embodiments is utilized as a light emitting material, the first dopant/compound may be utilized as a dopant material emitting light in one or more suitable wavelength regions such as a red emitting dopant, and green emitting dopant.

In the light emitting element ED of one or more embodiments, the emission layer EML may be to emit delayed fluorescence. For example, in one or more embodiments, the emission layer EML may be to emit thermally activated delayed fluorescence (TADF).

In one or more embodiments, the emission layer EML of the light emitting element ED may be to emit blue light. For example, in some embodiments, the emission layer EML of a light emitting element ED may be to emit blue light in a wavelength region of about 490 nm or less. However, embodiments of the present disclosure are not limited thereto, and the emission layer EML may be to emit green light or red light.

In one or more embodiments, the fused polycyclic compound of one or more embodiments may be included in the emission layer EML. In one or more embodiments, the fused polycyclic compound of one or more embodiments may be included in the emission layer EML as a dopant material. In some embodiments, the fused polycyclic compound of one or more embodiments may be a thermally activated delayed fluorescence emitting material. The fused polycyclic compound of one or more embodiments may be utilized as a thermally activated delayed fluorescence dopant. For example, in the light emitting element ED of one or more embodiments, the emission layer EML may include at least one selected from among the fused polycyclic compounds represented in Compound Group 1 as a thermally activated delayed fluorescence dopant. However, the utilization of the fused polycyclic compound of one or more embodiments is not limited thereto.

In one or more embodiments, the emission layer EML may include a plurality of compounds. The emission layer EML of one or more embodiments may include a fused polycyclic compound represented by Formula 1, that is, a first compound, in addition, a second compound represented by Formula HT-1, a third compound represented by Formula ET-1, and it may include at least one of a fourth compound represented by Formula D-1.

In one or more embodiments, the emission layer EML may include the first compound represented by Formula 1, and, in some embodiments, may include at least one of the first compound represented by Formula 1, the second compound represented by Formula HT-1 , the third compound represented by Formula ET-1 , or the fourth compound represented by Formula D-1 .

In one or more embodiments, the second compound may be utilized as a hole transporting host material of the emission layer EML.

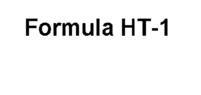

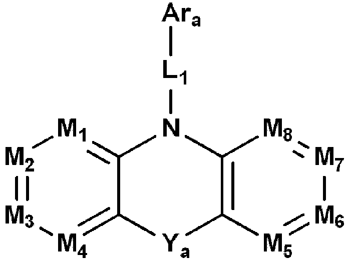

In Formula HT-1, M₁ to M₈ may each independently be N or CR₅₁. For example, in one or more embodiments, all of M₁ to M₈ may be CR₅₁. In one or more embodiments, any one selected from among M₁ to M₈ may be N, and the rest may be CR₅₁.

In Formula HT-1, L₁ may be a direct linkage, a substituted or unsubstituted arylene group having 6 to 30 ring-forming carbon atoms, or a substituted or unsubstituted heteroarylene group having 2 to 30 ring-forming carbon atoms. For example, in one or more embodiments, L₁ may be a direct linkage, a substituted or unsubstituted phenylene group, a substituted or unsubstituted divalent biphenyl group, a substituted or unsubstituted divalent carbazole group, and/or the like, but embodiments of the present disclosure are not limited thereto.

In Formula HT-1, Yₐ may be a direct linkage, CR₅₂R₅₃, or SiR₅₄R₅₅. For example, it may refer to that the two benzene rings linked to the nitrogen atom in Formula HT-1 are linked via a direct linkage, 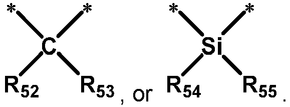 In Formula HT-1, if Yₐ is a direct linkage, the second compound represented by Formula HT-1 may include a carbazole moiety.

In Formula HT-1, Arₐ may be a substituted or unsubstituted aryl group having 6 to 30 ring-forming carbon atoms, or a substituted or unsubstituted heteroaryl group having 2 to 30 ring-forming carbon atoms. For example, in one or more embodiments, Arₐ may be a substituted or unsubstituted carbazole group, a substituted or unsubstituted dibenzofuran group, a substituted or unsubstituted dibenzothiophene group, a substituted or unsubstituted biphenyl group, and/or the like, but embodiments of the present disclosure are not limited thereto.

In Formula HT-1, R₅₁ to R₅₅ may each independently be hydrogen, deuterium, a halogen, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 carbon atoms, a substituted or unsubstituted aryl group having 6 to 60 ring-forming carbon atoms, or a substituted or unsubstituted heteroaryl group having 2 to 60 ring-forming carbon atoms. In one or more embodiments, one or more selected from among R₅₁ to R₅₅ may each independently be bonded to an adjacent group to form (or provide) a ring. For example, in some embodiments, R₅₁ to R₅₅ may each independently be hydrogen or deuterium. In some embodiments, R₅₁ to R₅₅ may each independently be an unsubstituted methyl group or an unsubstituted phenyl group.

In one or more embodiments, the second compound represented by Formula HT-1 may be any one (e.g., one) selected from among compounds represented by Compound Group 2 . The emission layer EML may include at least one selected from among the compounds represented by Compound Group 2 as a hole transporting host material.

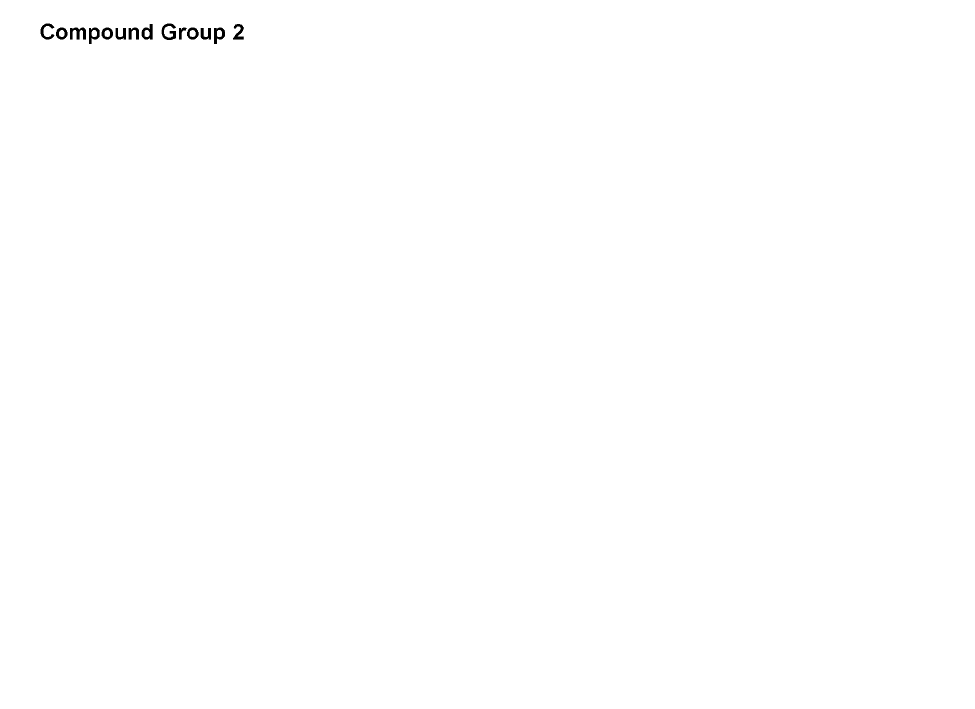

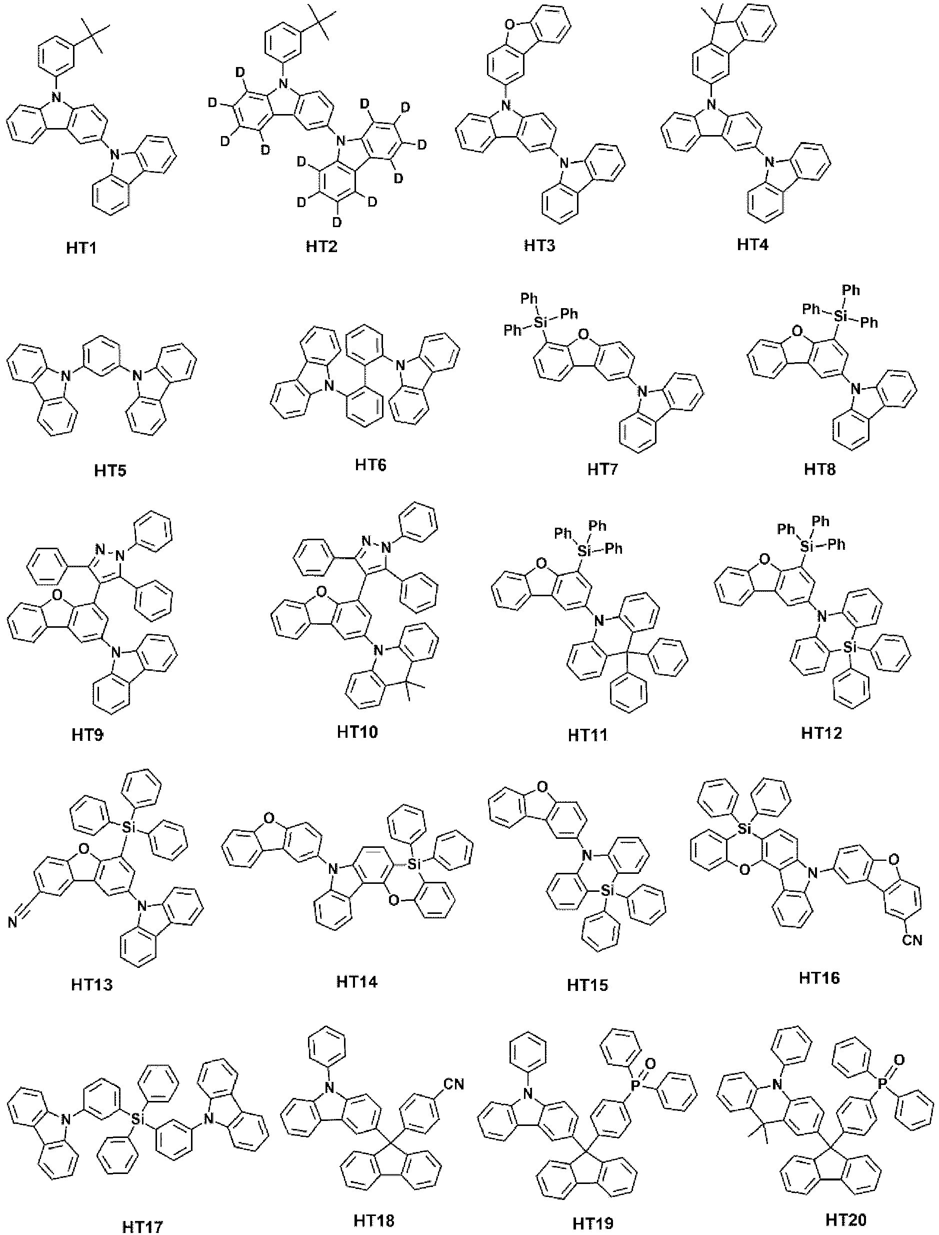

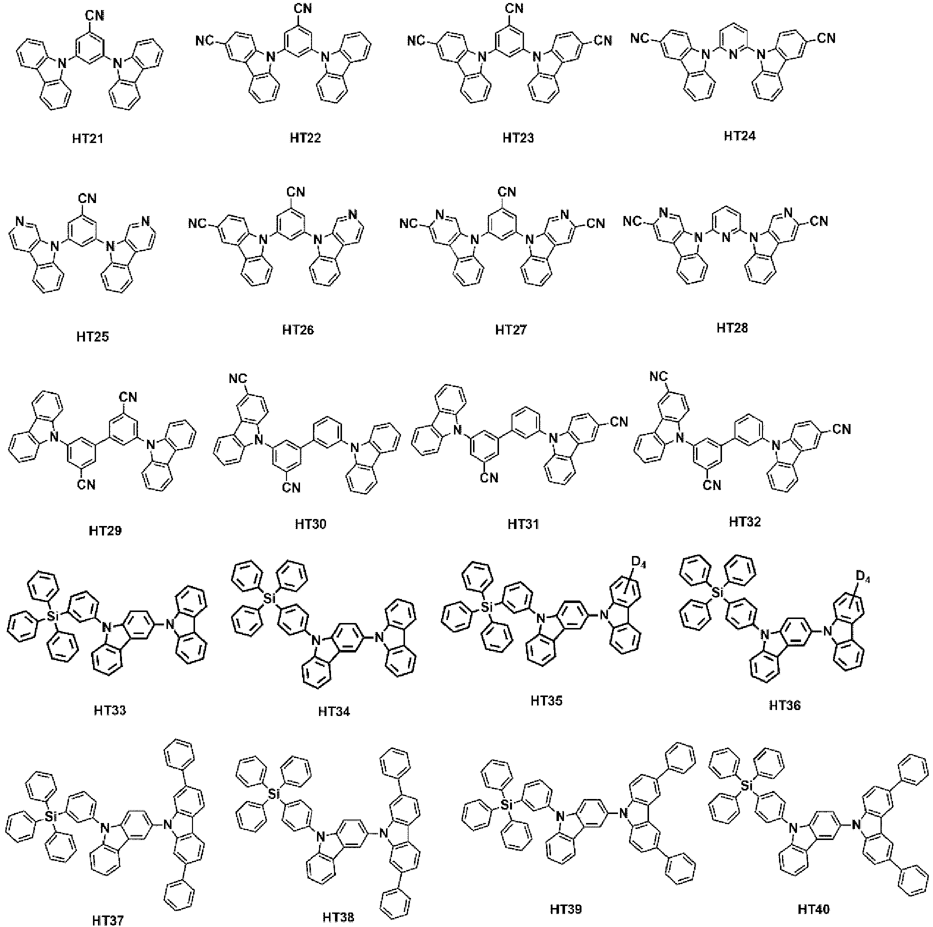

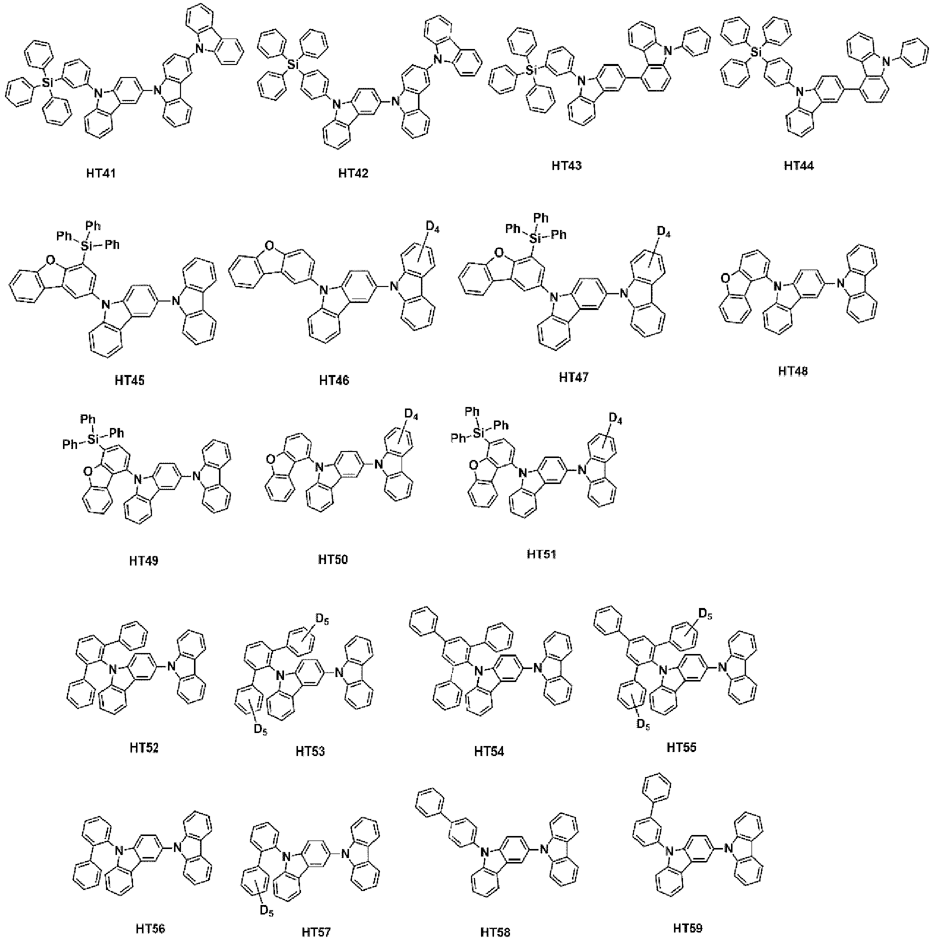

In embodiment compounds presented in Compound Group 2, "D" may refer to deuterium, and "Ph" may refer to a substituted or unsubstituted phenyl group. For example, in embodiment compounds presented in Compound Group 2, "Ph" may refer to an unsubstituted phenyl group.

In one or more embodiments, the emission layer EML may include the third compound represented by Formula ET-1 . For example, the third compound may be utilized as an electron transporting host material for the emission layer EML.

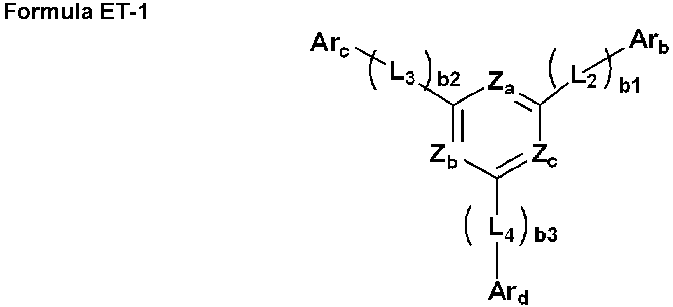

In Formula ET-1, at least one selected from among Zₐ to Z_{c} may be N, and the rest may be CR₅₆. For example, in one or more embodiments, any one selected from among X₁ to X₃ may be N, and the rest may each independently be CR₅₆. In those embodiments, the third compound represented by Formula ET-1 may include a pyridine moiety. In one or more embodiments, two selected from among X₁ to X₃ may be N, and the rest may be CR₅₆. In those embodiments, the third compound represented by Formula ET-1 may include a pyrimidine moiety. In one or more embodiments, X₁ to X₃ may all be N. In those embodiments, the third compound represented by Formula ET-1 may include a triazine moiety.

In Formula ET-1, R₅₆ may be hydrogen, deuterium, a substituted or unsubstituted alkyl group having 1 to 20 carbon atoms, a substituted or unsubstituted aryl group having 6 to 60 ring-forming carbon atoms, or a substituted or unsubstituted heteroaryl group having 2 to 60 ring-forming carbon atoms.

In Formula ET-1, b1 to b3 may each independently be an integer of 0 to 10.

In Formula ET-1, Ar_{b} to Ar_{d} may each independently be hydrogen, deuterium, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. For example, in one or more embodiments, Ar_{b} to Ar_{d} may each independently be a substituted or unsubstituted phenyl group or a substituted or unsubstituted carbazole group.

In Formula ET-1, L₂ to L₄ may each independently be a direct linkage, a substituted or unsubstituted arylene group having 6 to 30 ring-forming carbon atoms, or a substituted or unsubstituted heteroarylene group having 2 to 30 ring-forming carbon atoms. In one or more embodiments, if b1 to b3 are integers of 2 or greater, L₂'s to L₄'s may each independently be a substituted or unsubstituted arylene group having 6 to 30 ring-forming carbon atoms or a substituted or unsubstituted heteroarylene group having 2 to 30 ring-forming carbon atoms.

In one or more embodiments, the third compound may be any one selected from among compounds in Compound Group 3. The light emitting device ED of one or more embodiments may include any one selected from among the compounds in Compound Group 3 .

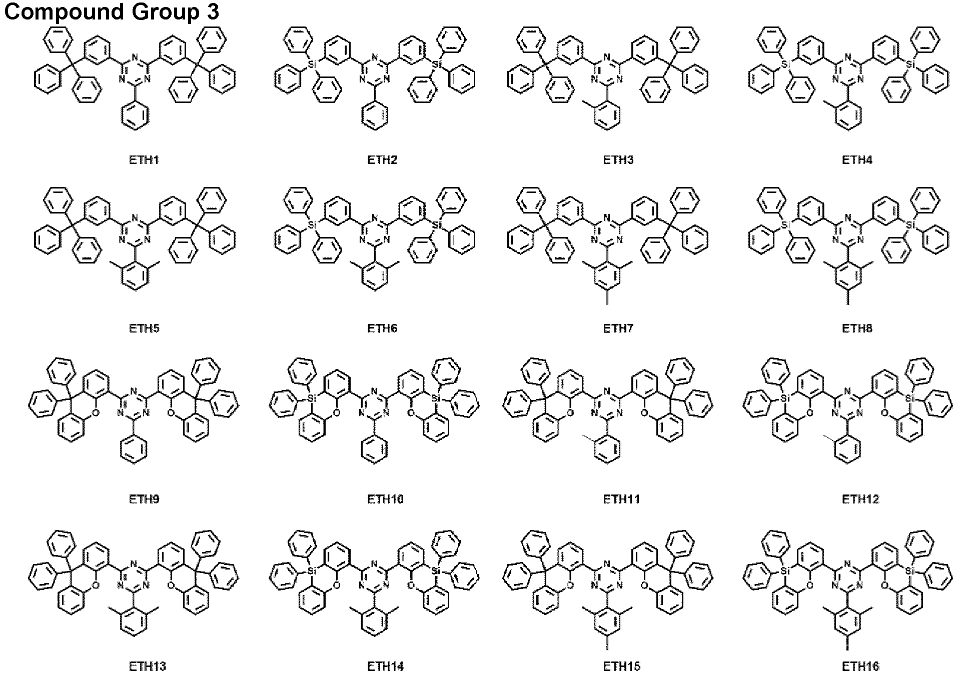

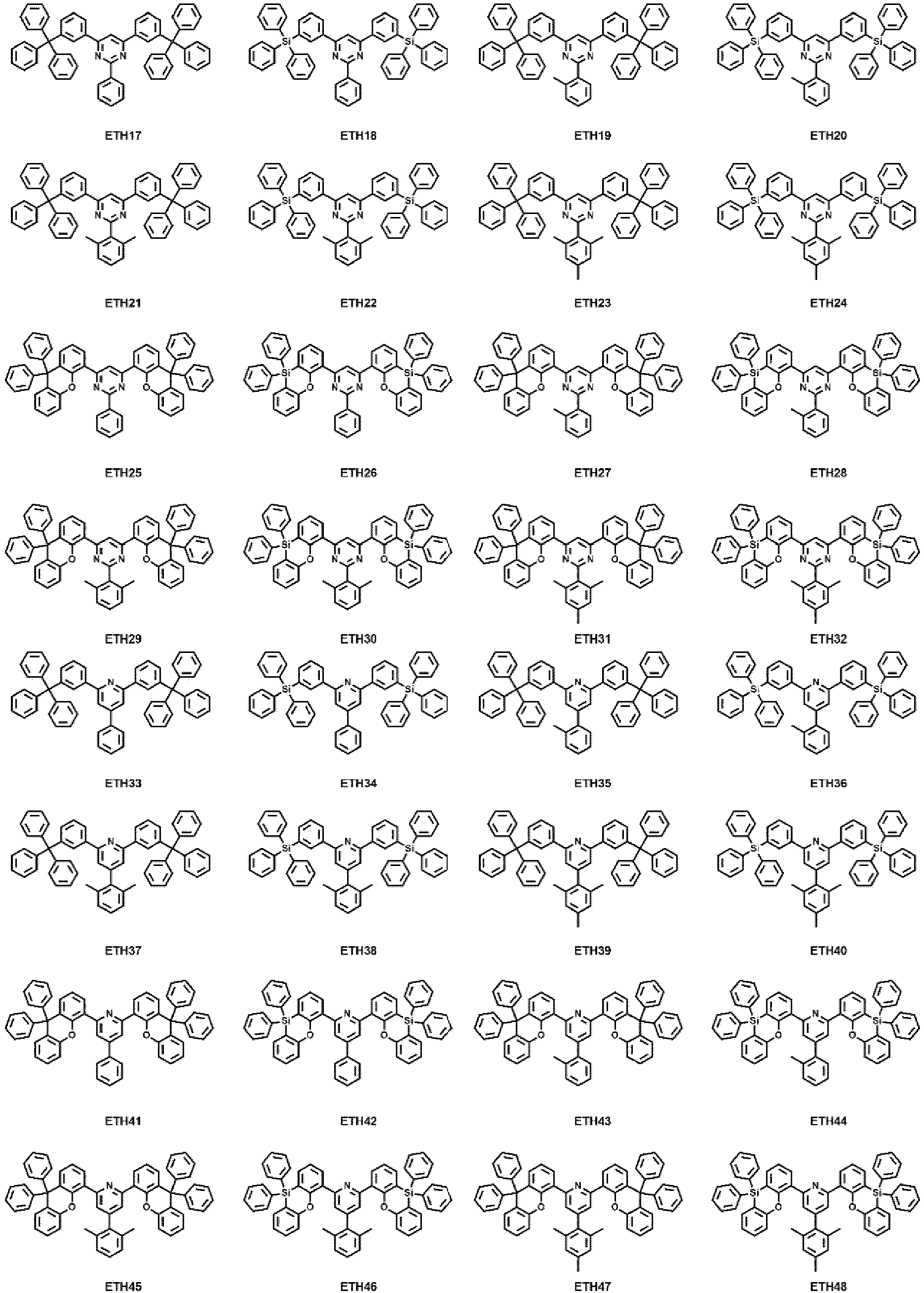

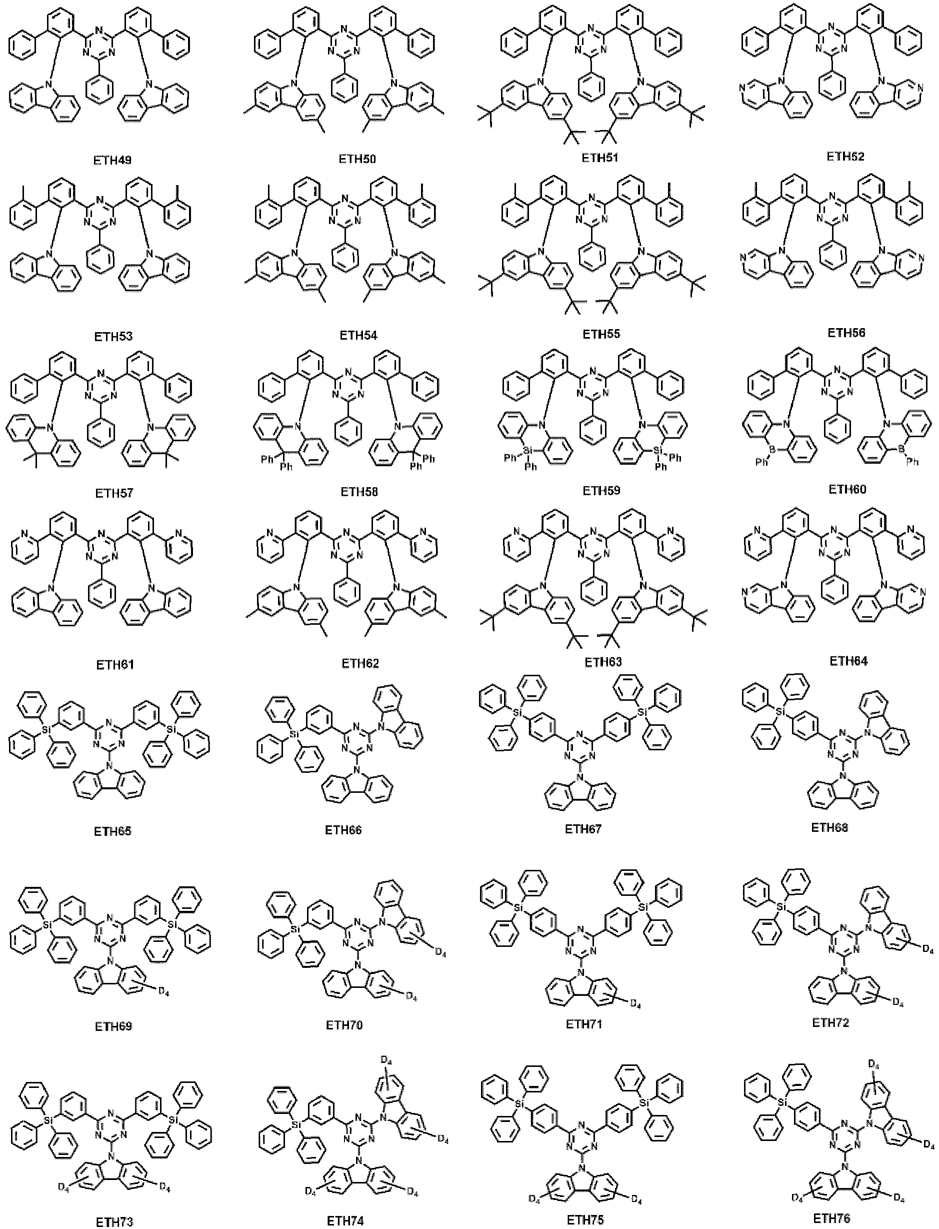

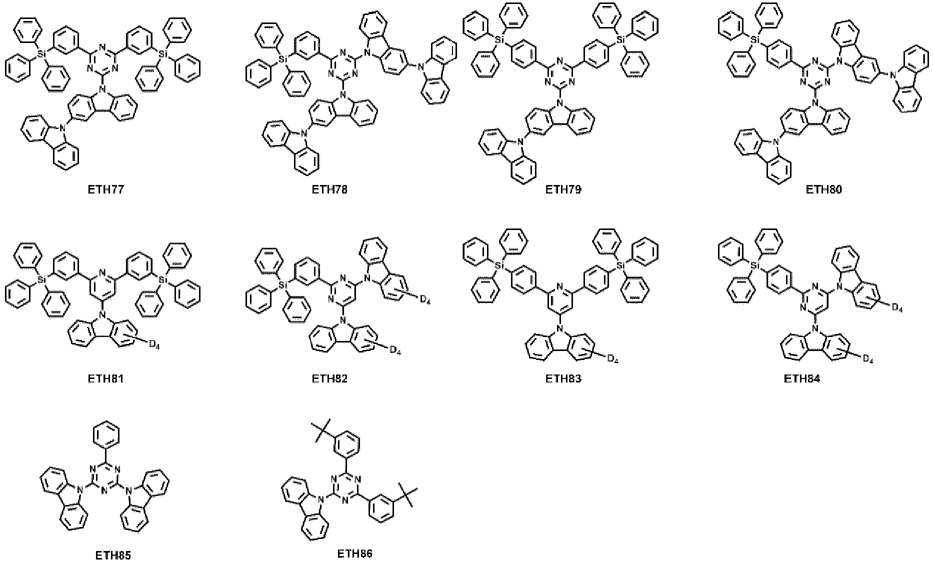

In the embodiment compounds presented in Compound Group 3, "D" refers to deuterium, and "Ph" refers to an unsubstituted phenyl group.

In one or more embodiments, the emission layer EML may include the second compound and the third compound, and the second compound and the third compound may form (or provide) an exciplex. In the emission layer EML, an exciplex may be formed by the hole transporting host and the electron transporting host. In these embodiments, a triplet energy of the exciplex formed by the hole transporting host and the electron transporting host may correspond to a difference between a lowest unoccupied molecular orbital (LUMO) energy level of the electron transporting host and a highest occupied molecular orbital (HOMO) energy level of the hole transporting host.

For example, in one or more embodiments, an absolute value of the triplet energy (T1) of the exciplex formed by the hole transporting host and the electron transporting host may be about 2.4 eV to about 3.0 eV. In one or more embodiments, the triplet energy of the exciplex may be a value smaller than an energy gap of each host material. The exciplex may have a triplet energy of about 3.0 eV or less that is an energy gap between the hole transporting host and the electron transporting host.

In one or more embodiments, the emission layer EML may include a fourth compound in addition to the first compound to the third compound as described above. The fourth compound may be utilized as a phosphorescent sensitizer of the emission layer EML. The energy may be transferred from the fourth compound to the first compound, thereby emitting light.

For example, in one or more embodiments, the emission layer EML may include, as the fourth compound, an organometallic complex containing platinum (Pt) as a central metal atom and ligands linked to the central metal atom. The emission layer EML in the light emitting device ED of one or more embodiments may include, as the fourth compound, a compound represented by Formula D-1 :

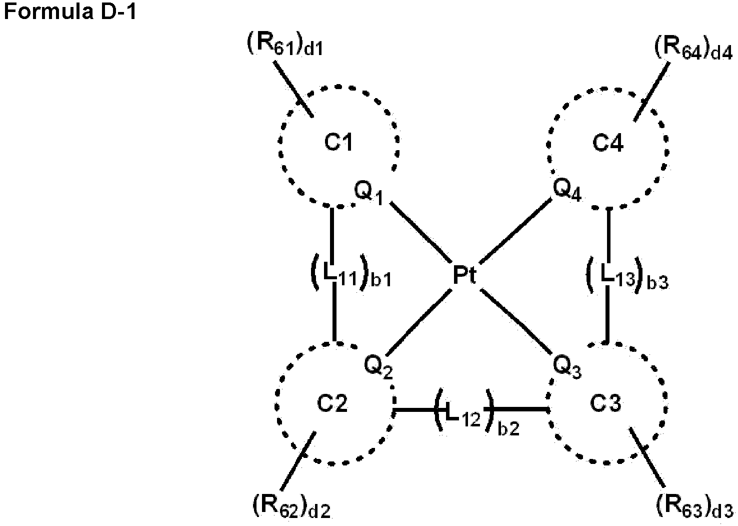

In Formula D-1, Q₁ to Q₄ may each independently be C or N.

In Formula D-1, C1 to C4 may each independently be a substituted or unsubstituted hydrocarbon ring having 5 to 30 ring-forming carbon atoms, or a substituted or unsubstituted heterocycle having 2 to 30 ring-forming carbon atoms.

In Formula D-1, L₁₁ to L₁₃ may each independently be a direct linkage, *-O-*, *-S-* 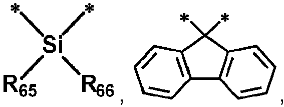 a substituted or unsubstituted alkylene group having 1 to 20 carbon atoms, a substituted or unsubstituted arylene group having 6 to 30 ring-forming carbon atoms, or a substituted or unsubstituted heteroarylene group having 2 to 30 ring-forming carbon atoms. In L₁₁ to L₁₃, "-* " refers to a part linked to C1 to C4.

In Formula D-1, b1 to b3 may each independently be 0 or 1. If b1 is 0, C1 and C2 may not be linked to each other. If b2 is 0, C2 and C3 may not be linked to each other. If b3 is 0, C3 and C4 may not be linked to each other.

In Formula D-1, R₆₁ to R₆₆ may each independently be hydrogen, deuterium, a halogen, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group having 1 to 20 carbon atoms, a substituted or unsubstituted alkenyl group having 2 to 20 carbon atoms, a substituted or unsubstituted aryl group having 6 to 60 ring-forming carbon atoms, or a substituted or unsubstituted heteroaryl group having 2 to 60 ring-forming carbon atoms. In one or more embodiments, one or more selected from among R₆₁ to R₆₆ may be independently bonded to an adjacent group to form (or provide) a ring. In some embodiments, R₆₁ to R₆₆ may each independently be a substituted or unsubstituted methyl group or a substituted or unsubstituted t-butyl group.

In Formula D-1, d1 to d4 may each independently be an integer of 0 to 4. In Formula D-1, if each of d1 to d4 is 0, the fourth compound may not be substituted with each of R₆₁ to R₆₄. The embodiment where each of d1 to d4 is 4 and R₆₁'s to R₆₄' are each hydrogen may be the same as the embodiment where each of d1 to d4 is 0. When each of d1 to d4 is an integer of 2 or more, a plurality of R₆₁'s to R₆₄'s may each be the same or at least one selected from among the plurality of R₆₁'s to R₆₄'s may be different from the others.

In Formula D-1, C1 to C4 may each independently be a substituted or unsubstituted hydrocarbon ring or a substituted or unsubstituted heterocycle represented by any one selected from among C-1 to C-4 :

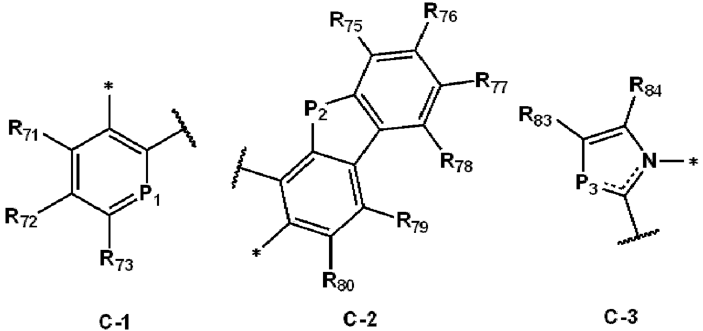

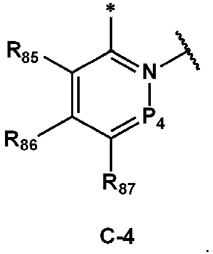

In C-1 to C-4, P₁ may be c-* or CR₇₄, P₂ may be N-* or NR₈₁, P₃ may be N-* or NR₈₂, and P₄ may be c-* or CR₈₈. R₇₁ to R₈₈ may each independently be a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, or may be bonded to an adjacent group to form (or provide) a ring.

In one or more embodiments, in C-1 to C-4, 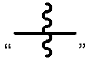 corresponds to a part linked to Pt that is a central metal atom, and "-*" corresponds to a part linked to a neighboring cyclic group (C1 to C4) or a linker (L₁₁ to L₁₃).

The emission layer EML of one or more embodiments may include the first compound, which is a fused polycyclic compound of the present disclosure, and at least one selected from among the second to fourth compounds. For example, in one or more embodiments, the emission layer EML may include the first compound, the second compound, and the third compound. In the emission layer EML, the second compound and the third compound may form (or provide) an exciplex, and the energy may be transferred from the exciplex to the first compound, thereby emitting light.

In one or more embodiments, the emission layer EML may include the first compound, the second compound, the third compound, and the fourth compound. In the emission layer EML, the second compound and the third compound may form (or provide) an exciplex, and the energy may be transferred from the exciplex to the fourth compound and the first compound, thereby emitting light. In some embodiments, the fourth compound may be a sensitizer. The fourth compound included in the emission layer EML in the light emitting element ED of one or more embodiments may serve as a sensitizer to deliver energy from the host to the first compound that is a light emitting dopant. For example, in some embodiments, the fourth compound serving as an auxiliary dopant accelerates energy delivery to the first compound that is a light emitting dopant, thereby increasing the emission ratio of the first compound. Therefore, the emission layer EML of one or more embodiments may improve luminous efficiency. In one or more embodiments, if the energy delivery to the first compound is increased, an exciton formed in the emission layer EML is not accumulated inside the emission layer EML and emits light rapidly, and thus deterioration of the device may be reduced. Therefore, the service life of the light emitting element ED of one or more embodiments may increase.

The light emitting element ED of one or more embodiments may include all of the first compound, the second compound, the third compound, and the fourth compound, and the emission layer EML may include the combination of two host materials and two dopant materials. In the light emitting element ED of one or more embodiments, the emission layer EML may concurrently (e.g., simultaneously) include the second compound and the third compound, which are two different hosts, the first compound that emits a delayed fluorescence, and the fourth compound including an organometallic complex, thereby exhibiting excellent or suitable luminous efficiency characteristics.

In one or more embodiments, the fourth compound represented by Formula D-1 may be any one (e.g., one) selected from among compounds represented in Compound Group 4. The emission layer EML may include at least one (e.g., one or more) selected from among the compounds represented in Compound Group 4 as a sensitizer material.

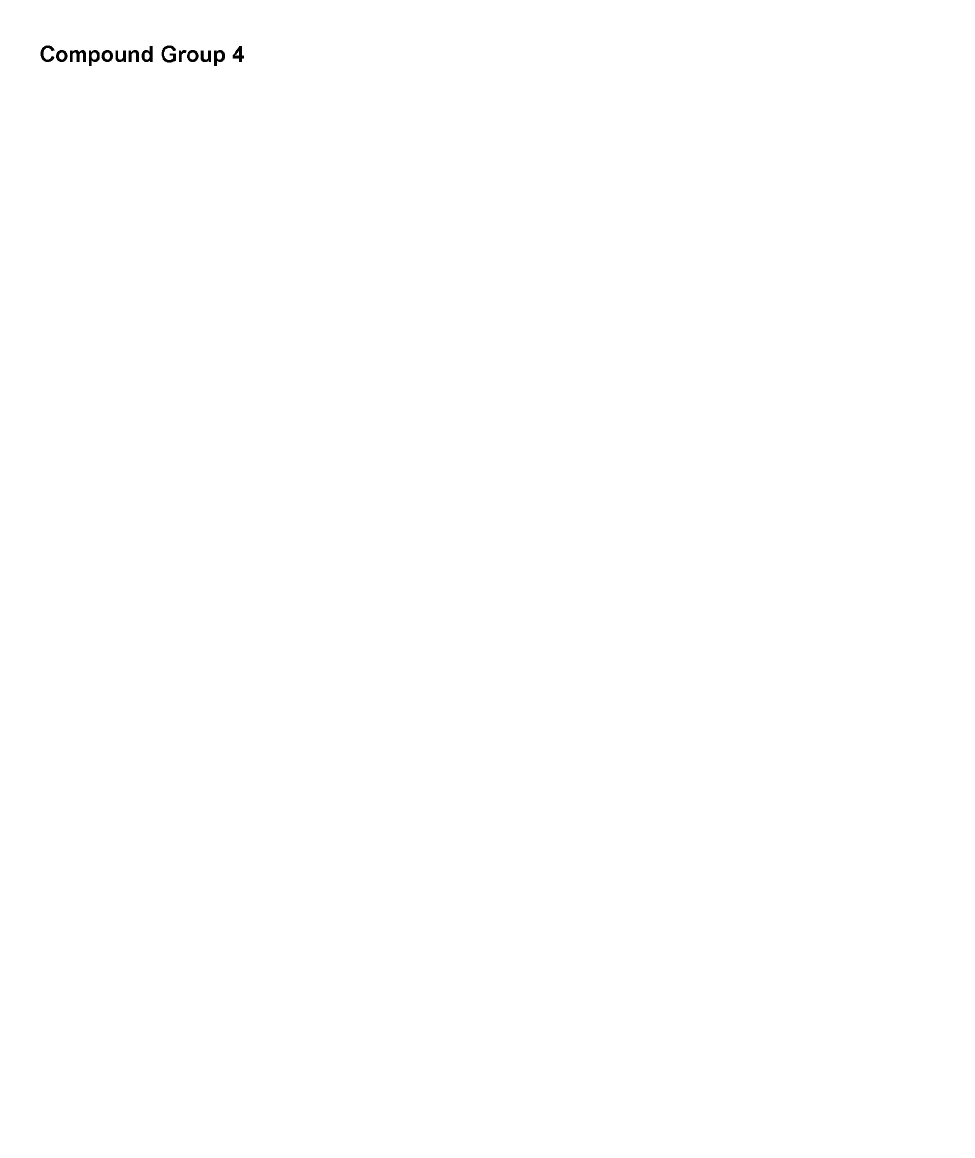

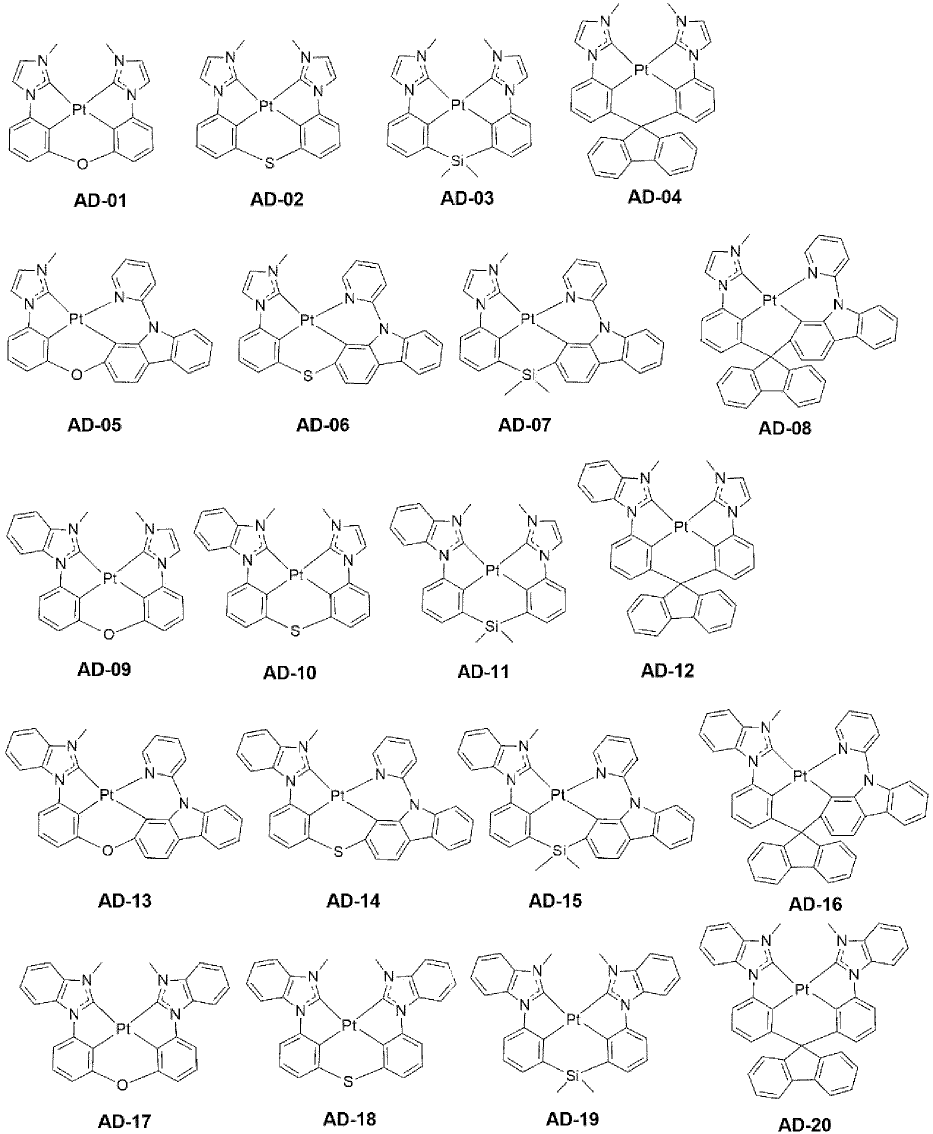

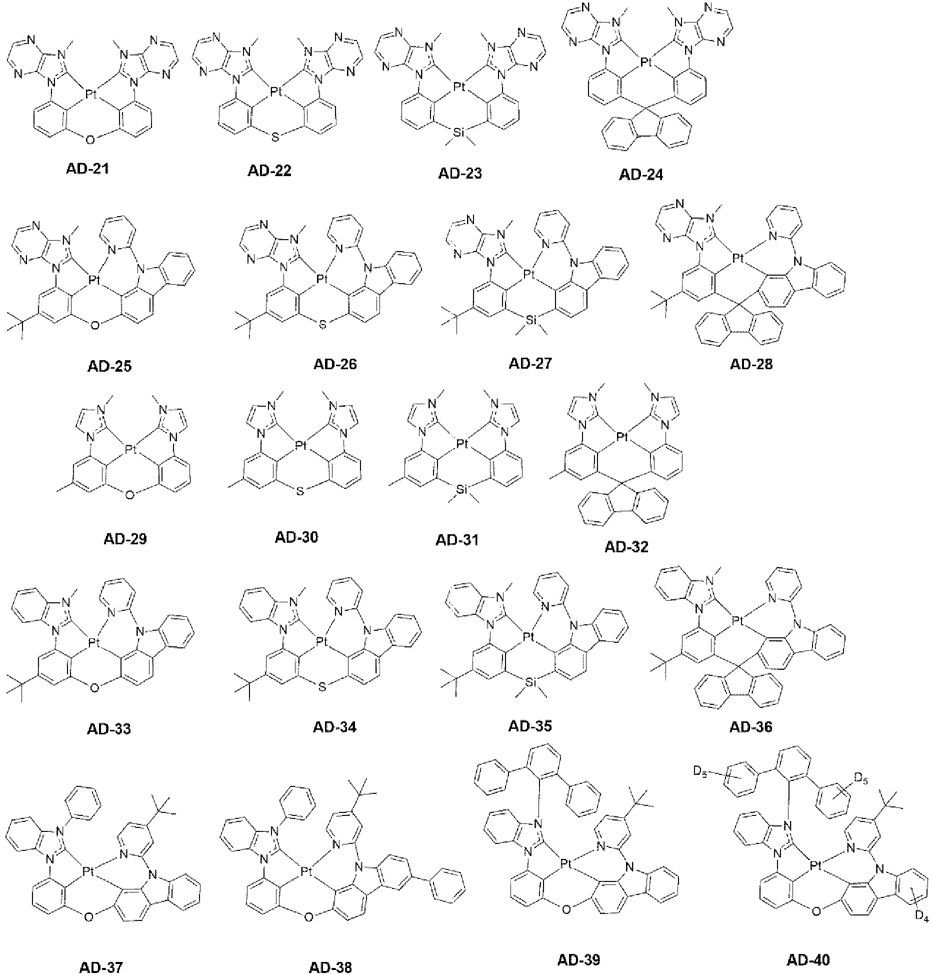

In the embodiment compounds presented in Compound Group 4, "D" refers to deuterium.

When the emission layer EML in the light emitting element ED of one or more embodiments includes all of the first compound, the second compound, and the third compound, with respect to the total weight of the first compound, the second compound, and the third compound, a content (e.g., amount) of the first compound may be about 0.1 wt% to about 5 wt%. However, embodiments of the present disclosure are not limited thereto. When the content (e.g., amount) of the first compound satisfy the above-described proportion, the energy transfer from the second compound and the third compound to the first compound may increase, and thus the luminous efficiency and element service life may increase.

The contents (e.g., amounts) of the second compound and the third compound in the emission layer EML may be the rest excluding the weight of the first compound. For example, the contents of the second compound and the third compound in the emission layer EML may be about 65 wt% to about 95 wt% with respect to the total weight of the first compound, the second compound, and the third compound.

In the total weight of the second compound and the third compound, a weight ratio of the second compound and the third compound may be about 3:7 to about 7:3.

When the contents of the second compound and the third compound satisfy the above-described ratio, charge balance characteristics in the emission layer EML are improved, and thus the luminous efficiency and element service life may increase. When the contents of the second compound and the third compound deviate from the above-described ratio range, a charge balance in the emission layer EML is broken, and thus the luminous efficiency may be reduced and the element may be easily deteriorated.

In one or more embodiments, when the emission layer EML includes the fourth compound, a content (e.g., amount) of the fourth compound in the emission layer EML may be about 10 wt% to about 30 wt% with respect to the total weight of the first compound, the second compound, the third compound, and the fourth compound. However, embodiments of the present disclosure are not limited thereto. When the content (e.g., amount) of the fourth compound satisfies the above-described content (e.g., amount), the energy delivery from the host to the first compound which is a light emitting dopant may be increased, thereby a luminous ratio may be improved, and thus the luminous efficiency of the emission layer EML may be improved. When the first compound, the second compound, the third compound, and the fourth compound included in the emission layer EML satisfy the above-described content (e.g., amount) ratio range, excellent or suitable luminous efficiency and long service life of the light emitting element may be achieved.

In the light emitting element ED of one or more embodiments, the emission layer EML may include at least one of an anthracene derivative, a pyrene derivative, a fluoranthene derivative, a chrysene derivative, a dehydrobenzanthracene derivative, or a triphenylene derivative. For example, in some embodiments, the emission layer EML may include one or more anthracene derivatives and/or one or more pyrene derivatives.

In each light emitting element ED of embodiments illustrated in FIGs. 3 to 6, the emission layer EML may further include a suitable host and/or dopant besides the above-described host and dopant, and for example, in some embodiments, the emission layer EML may include a compound represented by Formula E-1 . The compound represented by Formula E-1 may be utilized as a fluorescent host material.

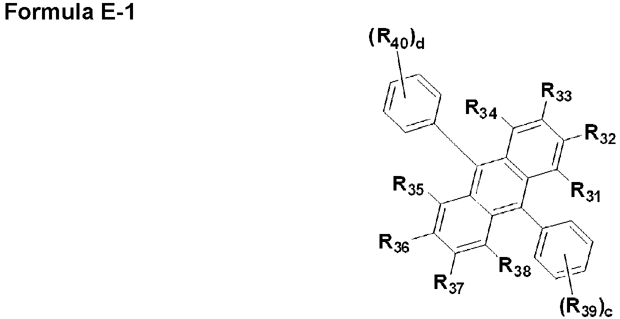

In Formula E-1, R₃₁ to R₄₀ may each independently be hydrogen, deuterium, a halogen, a substituted or unsubstituted silyl group, a substituted or unsubstituted thio group, a substituted or unsubstituted oxy group, a substituted or unsubstituted alkyl group having 1 to 10 carbon atoms, a substituted or unsubstituted alkenyl group having 2 to 10 carbon atoms, a substituted or unsubstituted aryl group having 6 to 30 ring-forming carbon atoms, or a substituted or unsubstituted heteroaryl group having 2 to 30 ring-forming carbon atoms, and/or may be bonded to an adjacent group to form (or provide) a ring. In one or more embodiments, one or more selected from among R₃₁ to R₄₀ may be each independently bonded to an adjacent group to form (or provide) a saturated hydrocarbon ring, an unsaturated hydrocarbon ring, a saturated heterocycle, or an unsaturated heterocycle.

In Formula E-1, c and d may each independently be an integer of 0 to 5.

The compound represented by Formula E-1 may be any one selected from among Compound E1 to Compound E19 :

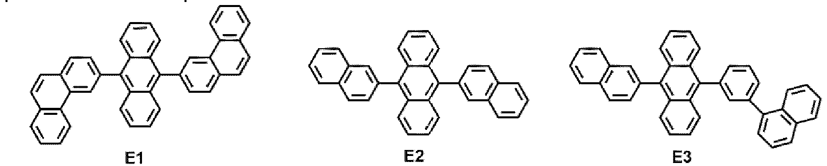

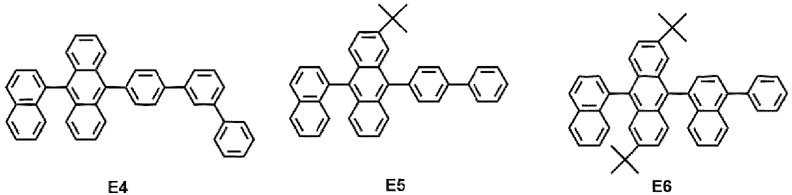

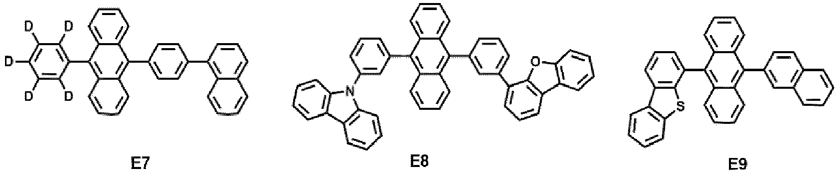

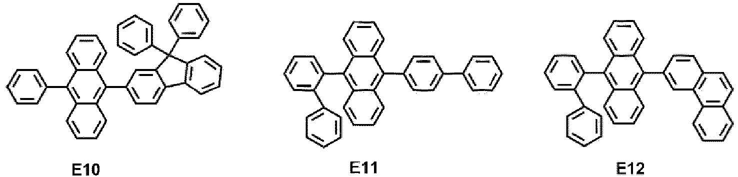

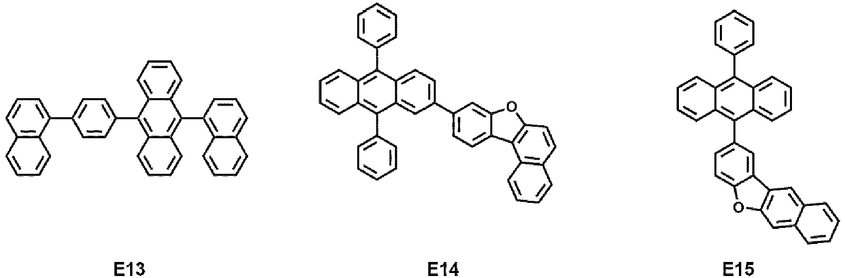

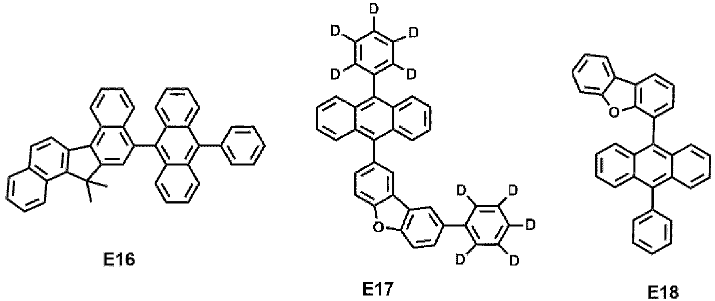

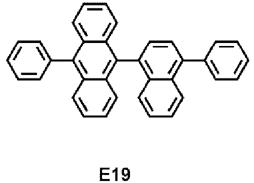

In one or more embodiments, the emission layer EML may include a compound represented by Formula E-2a or Formula E-2b . The compound represented by Formula E-2a or Formula E-2b may be utilized as a phosphorescent host material.

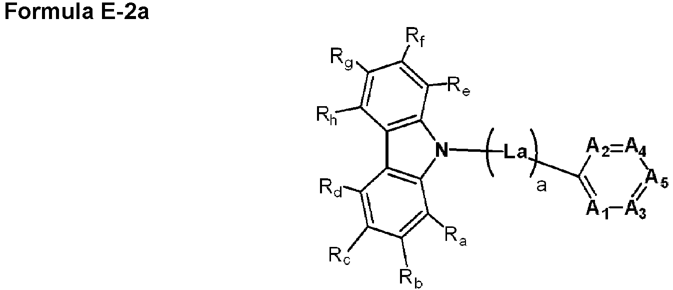

In Formula E-2a, a may be an integer of 0 to 10, and Lₐ may be a direct linkage, a substituted or unsubstituted arylene group having 6 to 30 ring-forming carbon atoms, or a substituted or unsubstituted heteroarylene group having 2 to 30 ring-forming carbon atoms. In one or more embodiments, if a is an integer of 2 or greater, a plurality of Lₐ's may each independently be a substituted or unsubstituted arylene group having 6 to 30 ring-forming carbon atoms or a substituted or unsubstituted heteroarylene group having 2 to 30 ring-forming carbon atoms.

In one or more embodiments, in Formula E-2a, A₁ to A₅ may each independently be N or CRᵢ. Rₐ to Rᵢ may each independently be hydrogen, deuterium, a substituted or unsubstituted amine group, a substituted or unsubstituted thio group, a substituted or unsubstituted oxy group, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, and/or may be bonded to an adjacent group to form (or provide) a ring. In some embodiments, one or more selected from among Rₐ to Rᵢ may be bonded to an adjacent group to form (or provide) a hydrocarbon ring or a heterocycle containing N, O, S, and/or the like, as a ring-forming atom.

In one or more embodiments, in Formula E-2a, two or three of (e.g., selected from among) A₁ to A₅ may be N, and the rest may be CRᵢ.

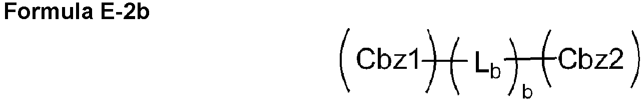

In Formula E-2b, Cbz1 and Cbz2 may each independently be an unsubstituted carbazole group or a carbazole group substituted with an aryl group having 6 to 30 ring-forming carbon atoms. L_{b} may be a direct linkage, a substituted or unsubstituted arylene group having 6 to 30 ring-forming carbon atoms, or a substituted or unsubstituted heteroarylene group having 2 to 30 ring-forming carbon atoms. In one or more embodiments, b may be an integer of 0 to 10, and if b is an integer of 2 or more, a plurality of L_{b}'s may each independently be a substituted or unsubstituted arylene group having 6 to 30 ring-forming carbon atoms or a substituted or unsubstituted heteroarylene group having 2 to 30 ring-forming carbon atoms.

The compound represented by Formula E-2a or Formula E-2b may be any one selected from among compounds of Compound Group E-2 . However, the compounds listed in Compound Group E-2 are only examples, and the compound represented by Formula E-2a or Formula E-2b is not limited to those represented in Compound Group E-2 .

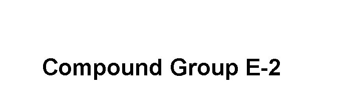

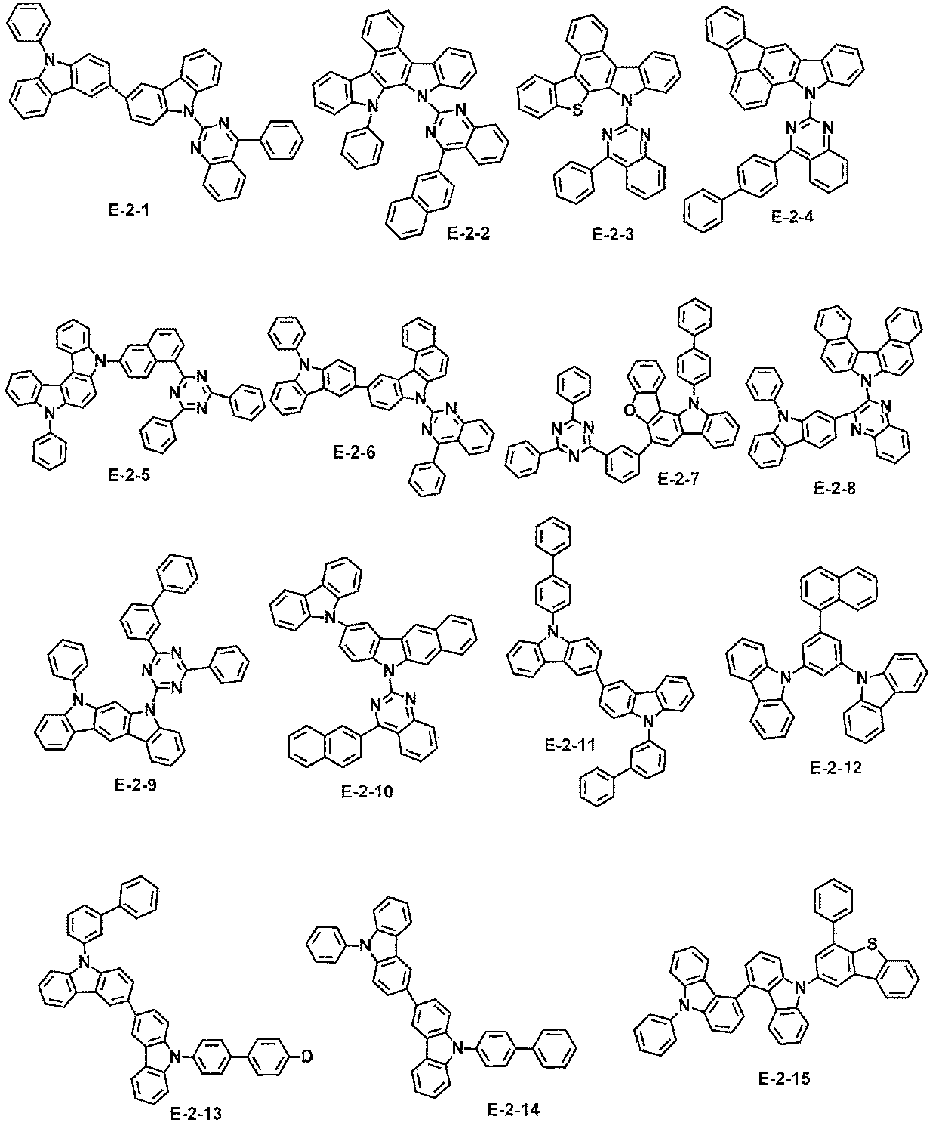

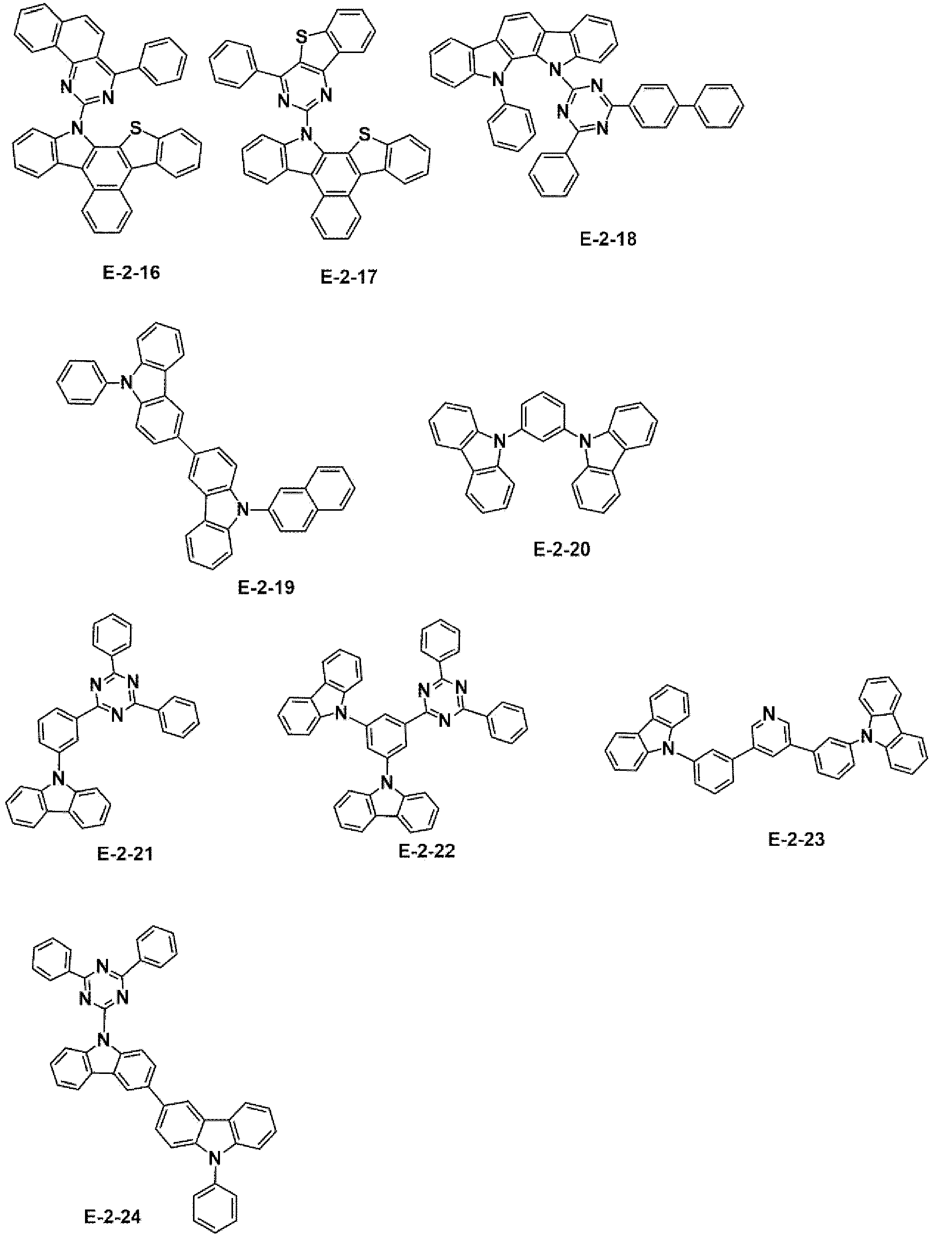

In one or more embodiments, the emission layer EML may further include a material suitable in the art as a host material. For example, the emission layer EML may include, as a host material, at least one of bis(4-(9H-carbazol-9-yl)phenyl)diphenylsilane (BCPDS), (4-(1-(4-(diphenylamino)phenyl)cyclohexyl)phenyl)diphenyl-phosphine oxide (POPCPA), bis[2-(diphenylphosphino)phenyl]ether oxide (DPEPO), 4,4'-bis(N-carbazolyl)-1,1'-biphenyl (CBP), 1,3-bis(carbazol-9-yl)benzene (mCP), 2,8-bis(diphenylphosphoryl)dibenzo[b,d]furan (PPF), 4,4',4"-tris(carbazol-9-yl)-triphenylamine (TCTA), or 1,3,5-tris(1-phenyl-1H-benzo[d]imidazol-2-yl)benzene (TPBi). However, embodiments of the present disclosure are not limited thereto, for example, tris(8-hydroxyquinolinato)aluminum (Alq₃), 9,10-di(naphthalen-2-yl)anthracene (ADN), *2-tert-butyl-9,10-di(naphth-2-yl)anthracene* (TBADN), distyrylarylene (DSA), 4,4'-bis(9-carbazolyl)-2,2'-dimethyl-biphenyl (CDBP), 2-methyl-9,10-bis(naphthalen-2-yl)anthracene (MADN), hexaphenyl cyclotriphosphazene (CP1), 1,4-bis(triphenylsilyl)benzene (UGH2), hexaphenylcyclotrisiloxane (DPSiO₃), octaphenylcyclotetrasiloxane (DPSiO₄), and/or the like may be utilized as a host material.

In one or more embodiments, the emission layer EML may include a compound represented by Formula M-a. The compound represented by Formula M-a may be utilized as a phosphorescent dopant material.

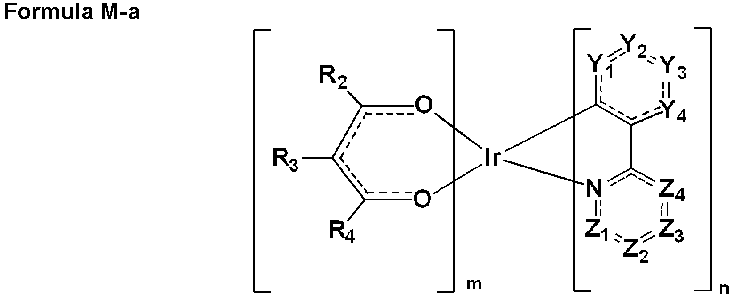

In Formula M-a, Y₁ to Y₄ and Z₁ to Z₄ may each independently be CR₁ or N, R₁ to R₄ may each independently be hydrogen, deuterium, a substituted or unsubstituted amine group, a substituted or unsubstituted thio group, a substituted or unsubstituted oxy group, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, and/or may be bonded to an adjacent group to form (or provide) a ring. In Formula M-a, m is 0 or 1, and n is 2 or 3. In Formula M-a, if m is 0, n is 3, and if m is 1, n is 2.

The compound represented by Formula M-a may be utilized as a phosphorescent dopant.

The compound represented by Formula M-a may be any one selected from among Compound M-a1 to Compound M-a25 . However, Compounds M-a1 to M-a25 are mere examples, and the compound represented by Formula M-a is not limited to those represented by Compounds M-a1 to M-a25 .

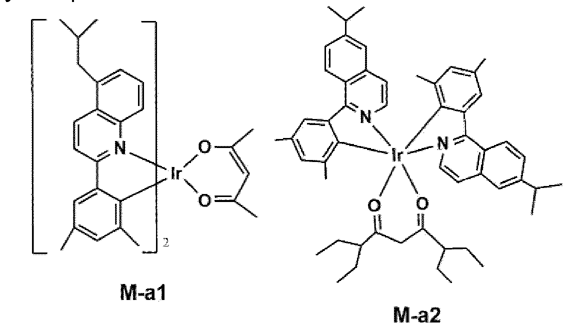

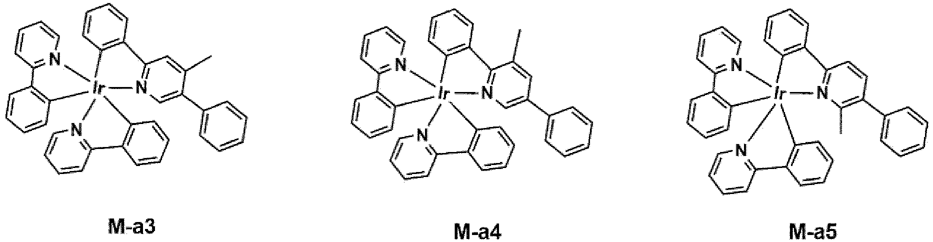

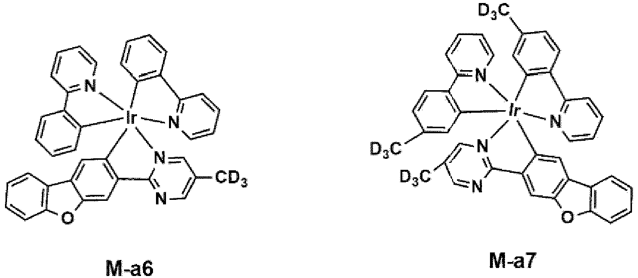

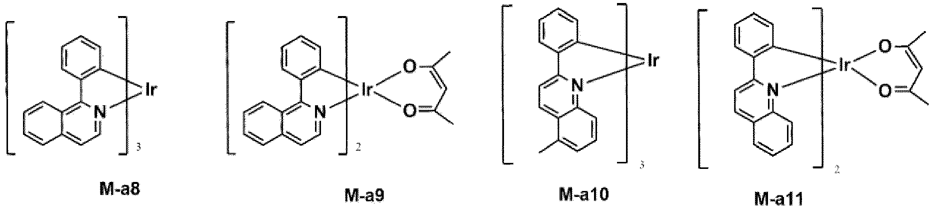

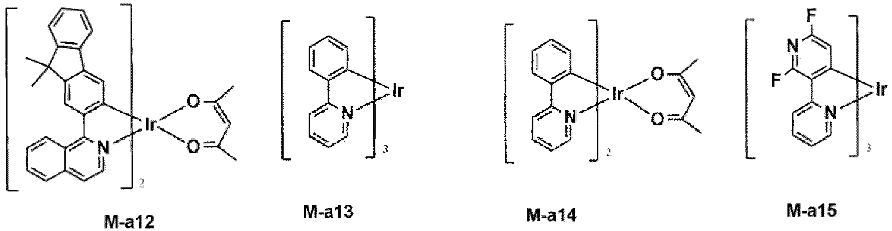

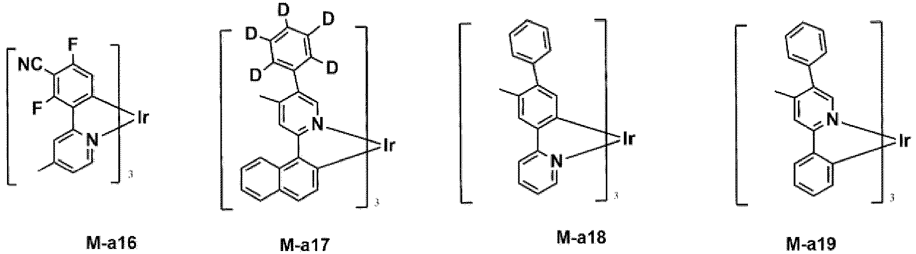

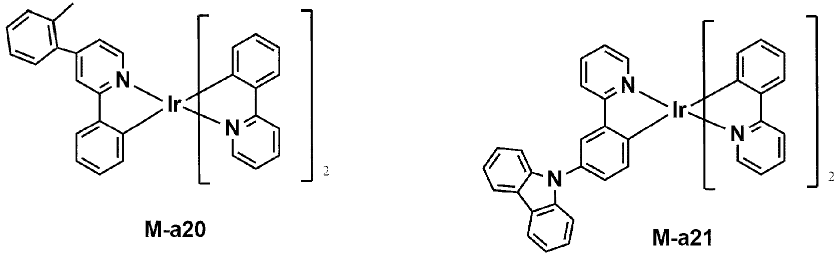

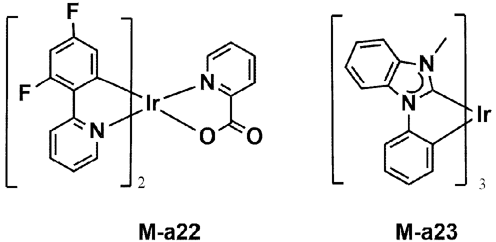

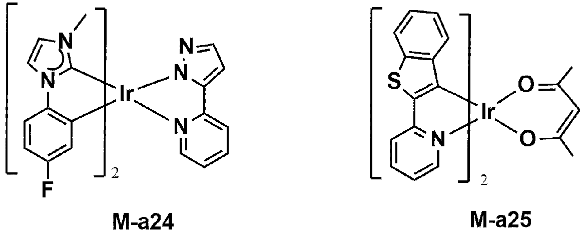

In one or more embodiments, the emission layer EML may include a compound represented by any one selected from among Formula F-a to Formula F-c. The compound represented by Formula F-a to Formula F-c may be utilized as a fluorescence dopant material.

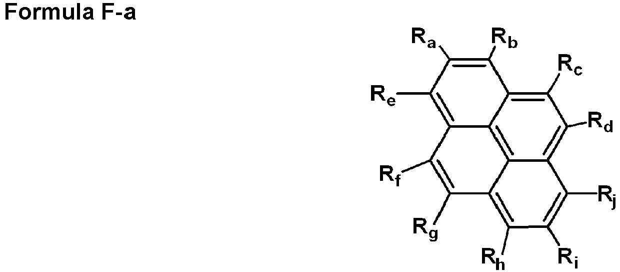

In Formula F-a, two of (e.g., selected from among) Rₐ to Rⱼ may each independently be substituted with *-NAr₁Ar₂. The others, which are not substituted with *-NAr₁Ar₂, among Rₐ to Rⱼ may each independently be hydrogen, deuterium, a halogen, a cyano group, a substituted or unsubstituted amine group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms.

In *-NAr₁Ar₂, Ar₁ and Ar₂ may each independently be a substituted or unsubstituted aryl group having 6 to 30 ring-forming carbon atoms or a substituted or unsubstituted heteroaryl group having 2 to 30 ring-forming carbon atoms. For example, in some embodiments, at least one of Ar₁ or Ar₂ may be a heteroaryl group containing O or S as a ring-forming atom.

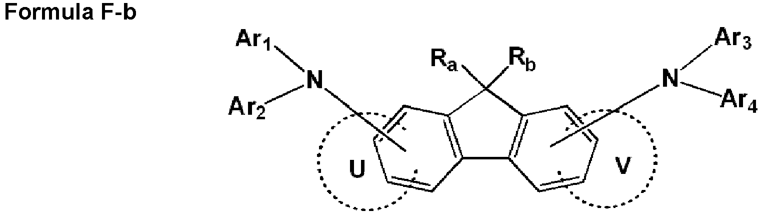

In Formula F-b, Rₐ and R_{b} may each independently be hydrogen, deuterium, a substituted or unsubstituted alkyl group having 1 to 20 carbon atoms, a substituted or unsubstituted alkenyl group having 2 to 20 carbon atoms, a substituted or unsubstituted aryl group having 6 to 30 ring-forming carbon atoms, or a substituted or unsubstituted heteroaryl group having 2 to 30 ring-forming carbon atoms, and/or may be bonded to an adjacent group to form (or provide) a ring. Ar₁ to Ar₄ may each independently be a substituted or unsubstituted aryl group having 6 to 30 ring-forming carbon atoms or a substituted or unsubstituted heteroaryl group having 2 to 30 ring-forming carbon atoms.

In Formula F-b, U and V may each independently be a substituted or unsubstituted hydrocarbon ring having 5 to 30 ring-forming carbon atoms or a substituted or unsubstituted heterocycle having 2 to 30 ring-forming carbon atoms. In some embodiments, at least one selected from among Ar₁ to Ar₄ may be a heteroaryl group containing O or S as a ring-forming atom.

In Formula F-b, the number of rings represented by U and V may each independently be 0 or 1. For example, in Formula F-b, it refers to that if the number of U or V is 1, one ring constitutes a part of a fused ring at a portion indicated by U or V, and if the number of U or V is 0, a ring indicated by U or V does not exist. For example, if the number of U is 0 and the number of V is 1, or if the number of U is 1 and the number of V is 0, the fused ring having a fluorene core in Formula F-b may be a cyclic compound having four rings. In one or more embodiments, if each number of U and V is 0, the fused ring in Formula F-b may be a cyclic compound having three rings. In one or more embodiments, if each number of U and V is 1, the fused ring having a fluorene core in Formula F-b may be a cyclic compound having five rings.

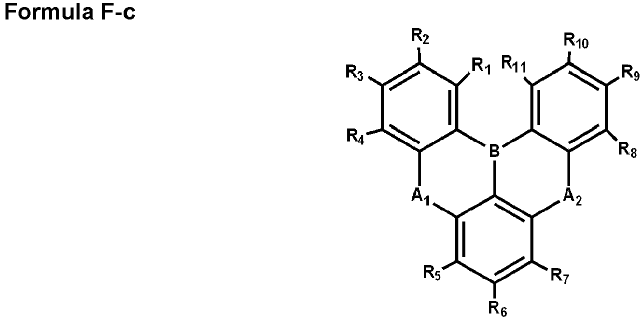

In Formula F-c, A₁ and A₂ may each independently be O, S, Se, or NRₘ, and Rₘ may be hydrogen, deuterium, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. R₁ to R₁₁ may each independently be hydrogen, deuterium, a halogen, a cyano group, a substituted or unsubstituted amine group, a substituted or unsubstituted boryl group, a substituted or unsubstituted oxy group, a substituted or unsubstituted thio group, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms, and/or may be bonded to an adjacent group to form (or provide) a ring.

In one or more embodiments, in Formula F-c, A₁ and A₂ may each independently be bonded to substituents of an adjacent ring to form (or provide) a fused ring. For example, if A₁ and A₂ may each independently be NRₘ, in one or more embodiments, A₁ may be bonded to R₄ or R₅ to form (or provide) a ring. In one or more embodiments, A₂ may be bonded to R₇ or R₈ to form (or provide) a ring.

In one or more embodiments, the emission layer EML may further include, as a suitable dopant material, one or more selected from among styryl derivatives (e.g., 1,4-bis[2-(3-N-ethylcarbazolyl)vinyl]benzene (BCzVB), 4-(di-p-tolylamino)-4'-[(di-p-tolylamino)styryl]stilbene (DPAVB), and N-(4-((E)-2-(6-((E)-4-(diphenylamino)styryl)naphthalen-2-yl)vinyl)phenyl)-N-phenylbenzenamine (N-BDAVBi), 4,4'-bis[2-(4-(N,N-diphenylamino)phenyl)vinyl]biphenyl (DPAVBi)), perylene and derivatives thereof (*e.g*., 2,5,8,11-tetra-t-butylperylene (TBP)), pyrene and derivatives thereof (*e*.*g*., 1,1-dipyrene, 1,4-dipyrenylbenzene, 1,4-bis(N,N-diphenylamino)pyrene), and/or the like.

In one or more embodiments, the emission layer EML may further include a suitable phosphorescence dopant material. For example, a metal complex containing iridium (Ir), platinum (Pt), osmium (Os), aurum (Au), titanium (Ti), zirconium (Zr), hafnium (Hf), europium (Eu), terbium (Tb), or thulium (Tm) may be utilized as a phosphorescent dopant. For example, iridium(III) bis(4,6-difluorophenylpyridinato-N,C2) (Flrpic), bis(2,4-difluorophenylpyridinato)-tetrakis(1-pyrazolyl)borate iridium(III) (Fir6), or platinum octaethyl porphyrin (PtOEP) may be utilized as a phosphorescent dopant. However, embodiments of the present disclosure are not limited thereto.

In one or more embodiments, the emission layer EML may include a quantum dot material. In one or more embodiments, the quantum dot material may have a core/shell structure. The core of the quantum dot may be selected from among a Group II-VI compound, a Group III-VI compound, a Group I-III-IV compound, a Group III-V compound, a Group III-II-V compound, a Group IV-VI compound, a Group IV element, a Group IV compound, and/or a (e.g., any suitable) combination thereof.

The Group II-VI compound may be selected from the group consisting of a binary compound selected from the group consisting of CdSe, CdTe, CdS, ZnS, ZnSe, ZnTe, ZnO, HgS, HgSe, HgTe, MgSe, MgS, and a mixture thereof, a ternary compound selected from the group consisting of CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and a mixture thereof, and a quaternary compound selected from the group consisting of HgZnTeS, CdZnSeS, CdZnSeTe, CdZnSTe, CdHgSeS, CdHgSeTe, CdHgSTe, HgZnSeS, HgZnSeTe, HgZnSTe, and a mixture thereof.

The Group III-VI compound may include a binary compound such as In₂S₃ and/or In₂Se₃, a ternary compound such as InGaS₃ and/or InGaSe₃, or a (e.g., any suitable) combination thereof.

The Group I-III-VI compound may be selected from a ternary compound selected from the group consisting of AgInS, AgInS₂, CulnS, CuInS₂, AgGaS₂, CuGaS₂ CuGaO₂, AgGaO₂, AgAlO₂, and a mixture thereof, and/or a quaternary compound such as AgInGaS₂ and/or CuInGaS₂.

The Group III-V compound may be selected from the group consisting of a binary compound selected from the group consisting of GaN, GaP, GaAs, GaSb, AIN, AlP, AlAs, AlSb, InN, InP, InAs, InSb, and a mixture thereof, a ternary compound selected from the group consisting of GaNP, GaNAs, GaNSb, GaPAs, GaPSb, AINP, AlNAs, AlNSb, AlPAs, AlPSb, InGaP, InAlP, InNP, InNAs, InNSb, InPAs, InPSb, and a mixture thereof, and a quaternary compound selected from the group consisting of GaAlNP, GaAINAs, GaAINSb, GaAlPAs, GaAlPSb, GalnNP, GalnNAs, GalnNSb, GalnPAs, GalnPSb, InAlNP, InAlNAs, InAlNSb, InAlPAs, InAlPSb, and a mixture thereof. In one or more embodiments, the Group III-V compound may further include a Group II metal. For example, InZnP, and/or the like, may be selected as a Group III-II-V compound.

The Group IV-VI compound may be selected from the group consisting of a binary compound selected from the group consisting of SnS, SnSe, SnTe, PbS, PbSe, PbTe, and a mixture thereof, a ternary compound selected from the group consisting of SnSeS, SnSeTe, SnSTe, PbSeS, PbSeTe, PbSTe, SnPbS, SnPbSe, SnPbTe, and a mixture thereof, and a quaternary compound selected from the group consisting of SnPbSSe, SnPbSeTe, SnPbSTe, and a mixture thereof. The Group IV element may be selected from the group consisting of Si, Ge, and a mixture thereof. The Group IV compound may be a binary compound selected from the group consisting of SiC, SiGe, and a mixture thereof.

Each element included in a polynary compound such as the binary compound, the ternary compound, or the quaternary compound may be present in a particle with a substantially uniform or non-uniform concentration distribution. For example, the formulae refer to the types (kinds) of elements included in the compounds, and elemental ratios in the compound may be different. For example, AglnGaS₂ may refer to AglnₓGa₁₋ₓS₂ (where x is a real number of 0 to 1).

In one or more embodiments, the quantum dot may have a single structure or a double structure of core-shell in which the concentration of each element included in the quantum dot is substantially uniform. For example, a material included in the core may be different from a material included in the shell.

The shell of the quantum dot may serve as a protection layer to prevent or reduce the chemical deformation of the core to maintain semiconductor properties, and/or a charging layer to impart electrophoresis properties to the quantum dot. The shell may be a single layer or multiple layers. An interface between the core and the shell may have a concentration gradient in which the concentration of an element present in the shell becomes lower towards the center.

In some embodiments, the quantum dot may have the above-described core/shell structure including a core containing nanocrystals and a shell around (e.g., surrounding) the core. Examples of the shell of the quantum dots may include a metal or non-metal oxide, a semiconductor compound, and/or a (e.g., any suitable) combination thereof.

For example, the metal or non-metal oxide for the shell may be a binary compound such as SiO₂, Al₂O₃, TiO₂, ZnO, MnO, Mn₂O₃, Mn₃O₄, CuO, FeO, Fe₂O₃, Fe₃O₄, CoO, Co₃O₄, and/or NiO, and/or a ternary compound such as MgAl₂O₄, CoFe₂O₄, NiFe₂O₄, and/or CoMn₂O₄, but embodiments of the present disclosure are not limited thereto.

Also, examples of the semiconductor compound suitable as a shell may include CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, and/or the like, but embodiments of the present disclosure are not limited thereto.

Each element included in a polynary compound such as the binary compound or the ternary compound may be present in a particle with a substantially uniform or non-uniform concentration distribution. For example, the formulae refer to the types (kinds) of elements included in the compounds, and elemental ratios in the compound may be different.

The quantum dot may have a full width at half maximum (FWHM) of an emission spectrum of about 45 nm or less, about 40 nm or less, or about 30 nm or less, and the color purity or color reproducibility of the quantum dot may be improved within the above range. In one or more embodiments, light emitted through such quantum dot is emitted in all directions so that a wide viewing angle may be improved.

In one or more embodiments, although the form (or shape) of the quantum dot is not particularly limited as long as it is a form (or a shape) utilized in the art, in some embodiments, the quantum dot in the form of spherical nanoparticles, pyramidal nanoparticles, multi-arm nanoparticles, or cubic nanoparticles, nanotubes, nanowires, nanofibers, nanoplate particles, or the like may be utilized.

As the size of the quantum dot is adjusted or the elemental ratio in the quantum dot compound is adjusted, it may control the energy band gap of the quantum dots, and thus light in one or more suitable wavelength ranges may be obtained in a quantum dot emission layer. Therefore, the quantum dots as described above (utilizing different sizes of quantum dots or different elemental ratios in the quantum dot compound) may be utilized, and thus the light emitting device, which emits light in one or more suitable wavelengths, may be implemented. For example, the adjustment of the size of the quantum dot and/or the elemental ratio in the quantum dot compound may enable the quantum dots to emit red, green, and/or blue light. In one or more embodiments, the quantum dots may be configured to emit white light by combining one or more suitable colors of light.

In each of the light emitting elements ED of embodiments illustrated in FIGs. 3 to 6, the electron transport region ETR may be provided on the emission layer EML. The electron transport region ETR may include at least one of a hole blocking layer HBL, an electron transport layer ETL, or an electron injection layer EIL, but embodiments of the present disclosure are not limited thereto.

The electron transport region ETR may have a single layer formed of a single material, a single layer formed of a plurality of different materials, or a multilayer structure including a plurality of layers formed of a plurality of different materials.

For example, in one or more embodiments, the electron transport region ETR may have a single layer structure of an electron injection layer EIL or an electron transport layer ETL, or may have a single layer structure formed of an electron injection material and an electron transport material. In one or more embodiments, the electron transport region ETR may have a single layer structure formed of a plurality of different materials, or may have a structure in which an electron transport layer ETL/electron injection layer EIL, or a hole blocking layer HBL/electron transport layer ETL/electron injection layer EIL are stacked in order (e.g., in the stated order) from the emission layer EML, but embodiments of the present disclosure are not limited thereto. The electron transport region ETR may have a thickness, for example, from about 1,000 Å to about 1,500 Å.

The electron transport region ETR may be formed utilizing one or more suitable methods such as a vacuum deposition method, a spin coating method, a casting method, a Langmuir-Blodgett (LB) method, an inkjet printing method, a laser printing method, and/or a laser induced thermal imaging (LITI) method.

In one or more embodiments, the electron transport region ETR may include a compound represented by Formula ET-2 :

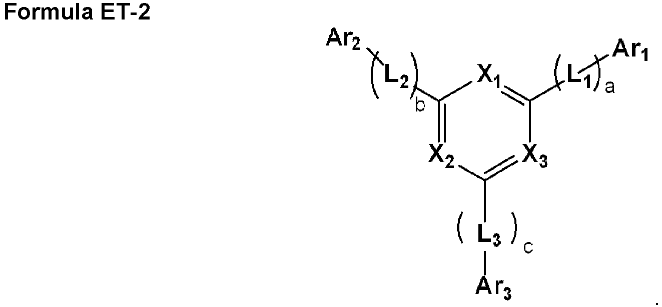

In Formula ET-2, at least one selected from among X₁ to X₃ may be N, and the rest are CRₐ. Rₐ may be hydrogen, deuterium, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms. Ar₁ to Ar₃ may each independently be hydrogen, deuterium, a substituted or unsubstituted alkyl group having 1 to 20 carbon atoms, a substituted or unsubstituted aryl group having 6 to 30 ring-forming carbon atoms, or a substituted or unsubstituted heteroaryl group having 2 to 30 ring-forming carbon atoms.

In Formula ET-2, a to c may each independently be an integer of 0 to 10. In Formula ET-2, L₁ to L₃ may each independently be a direct linkage, a substituted or unsubstituted arylene group having 6 to 30 ring-forming carbon atoms, or a substituted or unsubstituted heteroarylene group having 2 to 30 ring-forming carbon atoms. In one or more embodiments, if a to c may each independently be an integer of 2 or more, L₁'s to L₃'s may each independently be a substituted or unsubstituted arylene group having 6 to 30 ring-forming carbon atoms or a substituted or unsubstituted heteroarylene group having 2 to 30 ring-forming carbon atoms.

In some embodiments, the electron transport region ETR may include an anthracene-based compound. However, embodiments of the present disclosure are not limited thereto, for example, in some embodiments, the electron transport region ETR may include, for example, at least one selected from among tris(8-hydroxyquinolinato)aluminum (Alq₃), 1,3,5-tri[(3-pyridyl)-phen-3-yl]benzene, 2,4,6-tris(3'-(pyridin-3-yl)biphenyl-3-yl)-1,3,5-triazine, 2-(4-(N-phenylbenzoimidazol-1-yl)phenyl)-9,10-dinaphthylanthracene, 1,3,5-tri(1-phenyl-1H-benzo[d]imidazol-2-yl)benzene (TPBi), 2,9-dimethyl-4,7-diphenyl-1,10-phenanthroline (BCP), 4,7-diphenyl-1,10-phenanthroline (Bphen), 3-(biphenyl-4-yl)-4-phenyl-5-*tert*-butylphenyl-1,2,4-triazole (TAZ), 4-(naphthalen-1-yl)-3,5-diphenyl-4H-1,2,4-triazole (NTAZ), 2-(biphenyl-4-yl)-5-(4-*tert*-butylphenyl)-1,3,4-oxadiazole (tBu-PBD), bis(2-methyl-8-quinolinolato-N1,O8)-(1,1'-biphenyl-4-olato)aluminum (BAlq), beryllium bis(benzoquinolin-10-olate) (Bebq₂), 9,10-di(naphthalen-2-yl)anthracene (ADN), 1,3-bis[3,5-di(pyridin-3-yl)phenyl]benzene (BmPyPhB), and/or mixtures thereof.

In one or more embodiments, the electron transport region ETR may include at least one selected from among Compound ET1 to Compound ET36 :

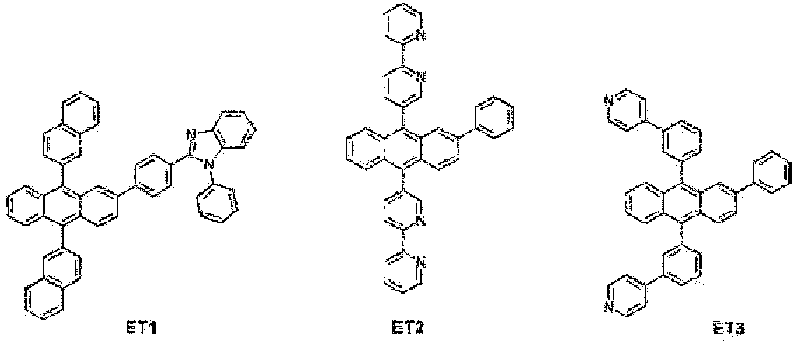

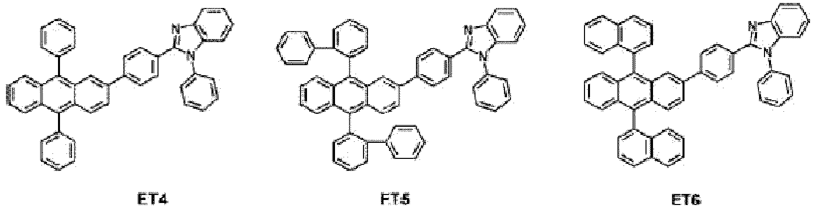

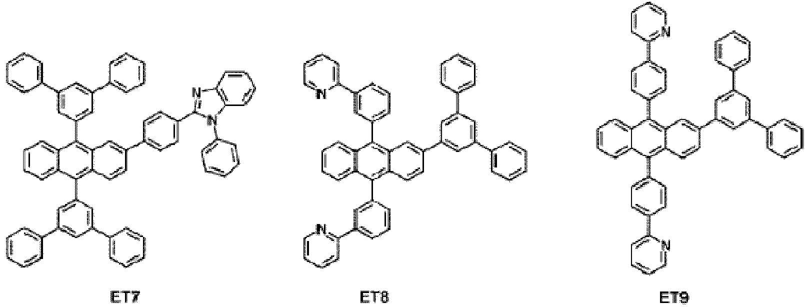

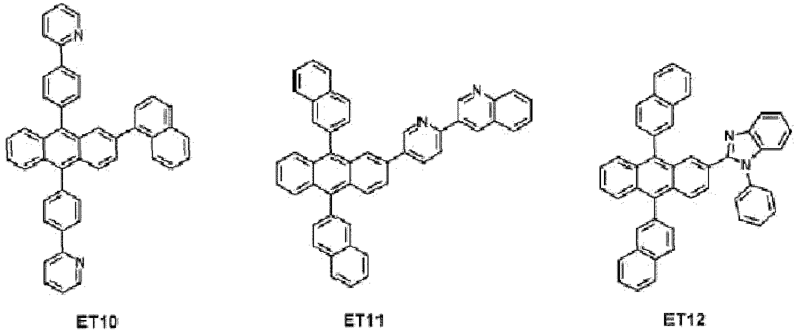

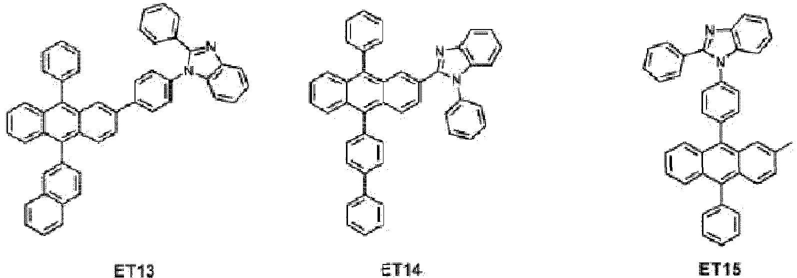

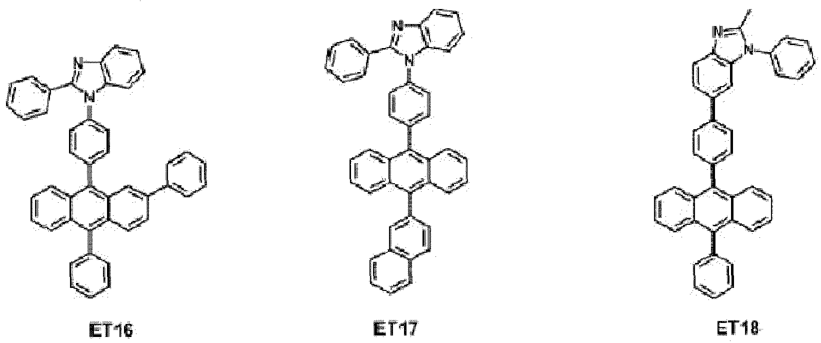

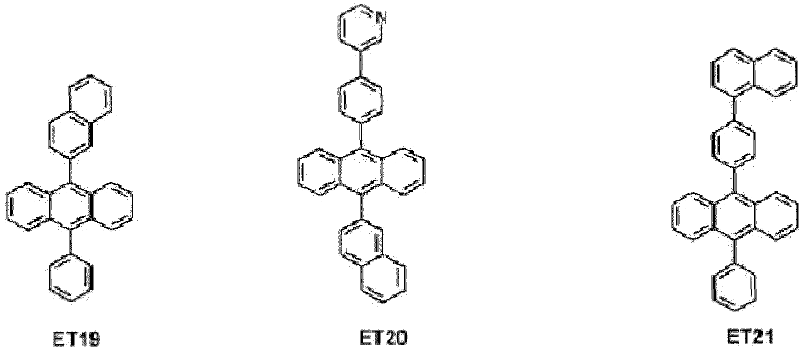

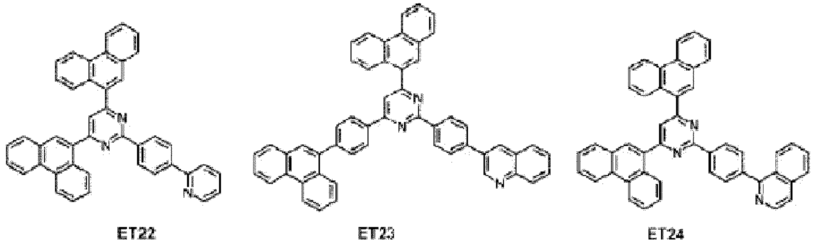

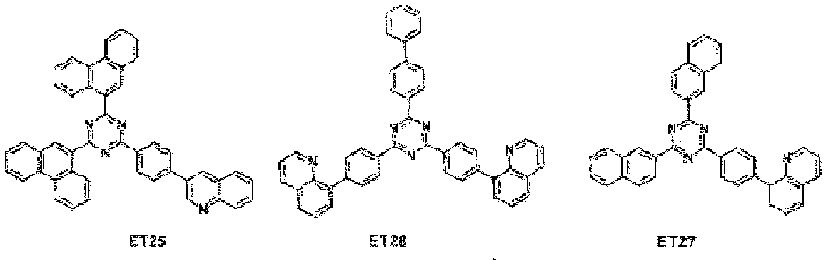

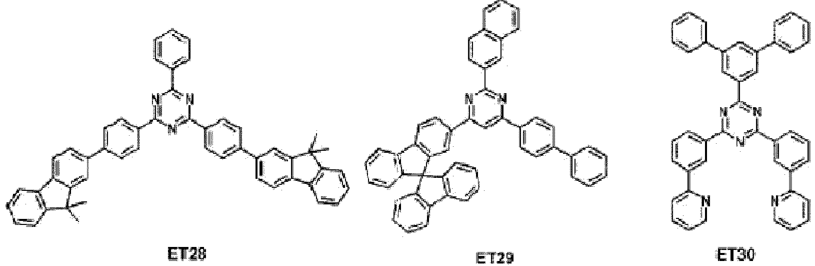

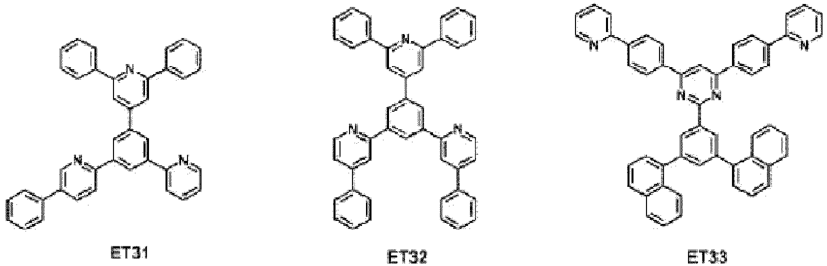

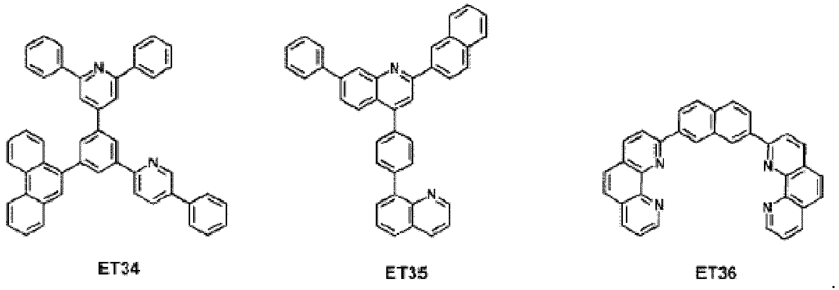

In one or more embodiments, the electron transport region ETR may include a metal halide such as LiF, NaCl, CsF, RbCl, Rbl, Cul, and/or KI, a lanthanide metal such as Yb, or a co-deposited material of the metal halide and the lanthanide metal. For example, in some embodiments, the electron transport region ETR may include KI:Yb, Rbl:Yb, LiF:Yb, and/or the like, as a co-deposited material. In one or more embodiments, the electron transport region ETR may be formed utilizing a metal oxide such as Li₂O and/or BaO, or 8-hydroxyl-lithium quinolate (Liq), and/or the like, but embodiments of the present disclosure are not limited thereto. In some embodiments, the electron transport region ETR may also be formed of a mixture material of an electron transport material and an insulating organometallic salt. The organometallic salt may be a material having an energy band gap of about 4 eV or more. For example, the organometallic salt may include, for example, a metal acetate, a metal benzoate, a metal acetoacetate, a metal acetylacetonate, and/or a metal stearate.

In one or more embodiments, the electron transport region ETR may further include at least one of 2,9-dimethyl-4,7-diphenyl-1,10-phenanthroline (BCP), diphenyl(4-(triphenylsilyl)phenyl)phosphine oxide (TSPO1), or 4,7-diphenyl-1,10-phenanthroline (Bphen) in addition to one or more of the above-described materials, but embodiments of the present disclosure are not limited thereto.

The electron transport region ETR may include one or more of the above-described compounds of the electron transport region in at least one of an electron injection layer EIL, an electron transport layer ETL, or a hole blocking layer HBL.

When the electron transport region ETR includes an electron transport layer ETL, the electron transport layer ETL may have a thickness of about 100 Å to about 1,000 Å, for example, about 150 Å to about 500 Å. If the thickness of the electron transport layer ETL satisfies the aforementioned range, satisfactory electron transport characteristics may be obtained without a substantial increase in driving voltage. When the electron transport region ETR includes an electron injection layer EIL, the electron injection layer EIL may have a thickness of about 1 Å to about 100 Å, for example, about 3 Å to about 90 Å. If the thickness of the electron injection layer EIL satisfies the above-described range, satisfactory electron injection characteristics may be obtained without a substantial increase in driving voltage.

The second electrode EL2 may be provided on the electron transport region ETR. The second electrode EL2 may be a common electrode. The second electrode EL2 may be a cathode or an anode, but embodiments of the present disclosure are not limited thereto. For example, if the first electrode EL1 is an anode, the second electrode EL2 may be a cathode, and if the first electrode EL1 is a cathode, the second electrode EL2 may be an anode.

The second electrode EL2 may be a transmissive electrode, a transflective electrode, or a reflective electrode. When the second electrode EL2 is the transmissive electrode, the second electrode EL2 may be formed of a transparent metal oxide, for example, indium tin oxide (ITO), indium zinc oxide (IZO), zinc oxide (ZnO), indium tin zinc oxide (ITZO), and/or the like.

When the second electrode EL2 is the transflective electrode or the reflective electrode, the second electrode EL2 may include Ag, Mg, Cu, Al, Pt, Pd, Au, Ni, Nd, Ir, Cr, Li, Ca, LiF/Ca, LiF/Al, Mo, Ti, Yb, W, a compound thereof, or a mixture thereof (e.g., AgMg, AgYb, or MgYb). In one or more embodiments, the second electrode EL2 may have a multilayer structure including a reflective film or a transflective film formed of one or more selected from among the above-described materials, and a transparent conductive film formed of ITO, IZO, ZnO, ITZO, and/or the like. For example, the second electrode EL2 may include one or more selected from among the above-described metal materials, combinations of at least two metal materials selected from among the above-described metal materials, oxides of the above-described metal materials, and/or the like.

In some embodiments, the second electrode EL2 may be connected with an auxiliary electrode. If the second electrode EL2 is connected with the auxiliary electrode, the resistance of the second electrode EL2 may be decreased.

In one or more embodiments, a capping layer CPL may further be arranged on the second electrode EL2 of the light emitting element ED. The capping layer CPL may include a multilayer or a single layer.

In one or more embodiments, the capping layer CPL may be an organic layer or an inorganic layer. For example, if the capping layer CPL contains an inorganic material, the inorganic material may include an alkaline metal compound (*e*.*g*., LiF), an alkaline earth metal compound (*e*.*g*., MgF₂), SiON, SiNₓ, SiO_{y}, and/or the like.

For example, in some embodiments, if the capping layer CPL includes an organic material, the organic material may include α-NPD, NPB, TPD, m-MTDATA, Alq₃, CuPc, N4,N4,N4',N4'-tetra(biphenyl-4-yl)biphenyl-4,4'-diamine (TPD15), 4,4',4"-tris(carbazol-9-yl)triphenylamine (TCTA), and/or the like, or an epoxy resin, or acrylate such as methacrylate. However, embodiments of the present disclosure are not limited thereto, for example, in one or more embodiments, the capping layer CPL may include at least one selected from among Compounds P1 to P5 :

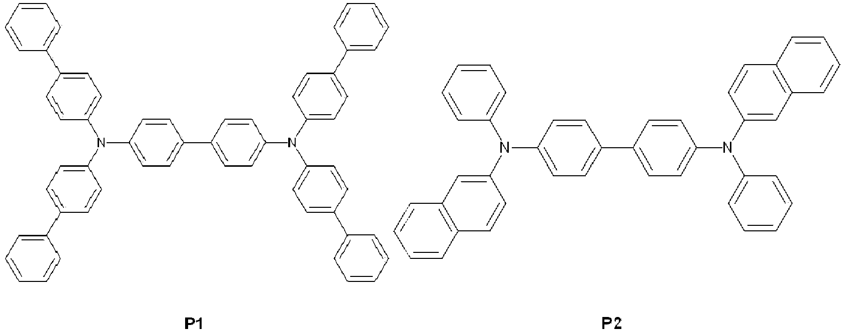

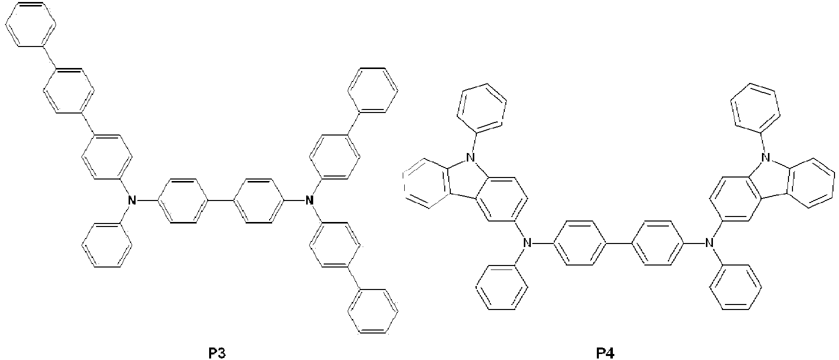

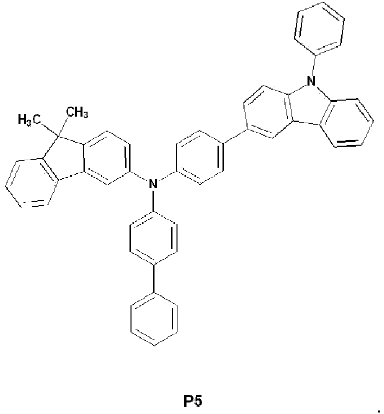

In one or more embodiments, the refractive index of the capping layer CPL may be about 1.6 or more. For example, in one or more embodiments, the refractive index of the capping layer CPL may be about 1.6 or more with respect to light in a wavelength range of about 550 nm to about 660 nm.

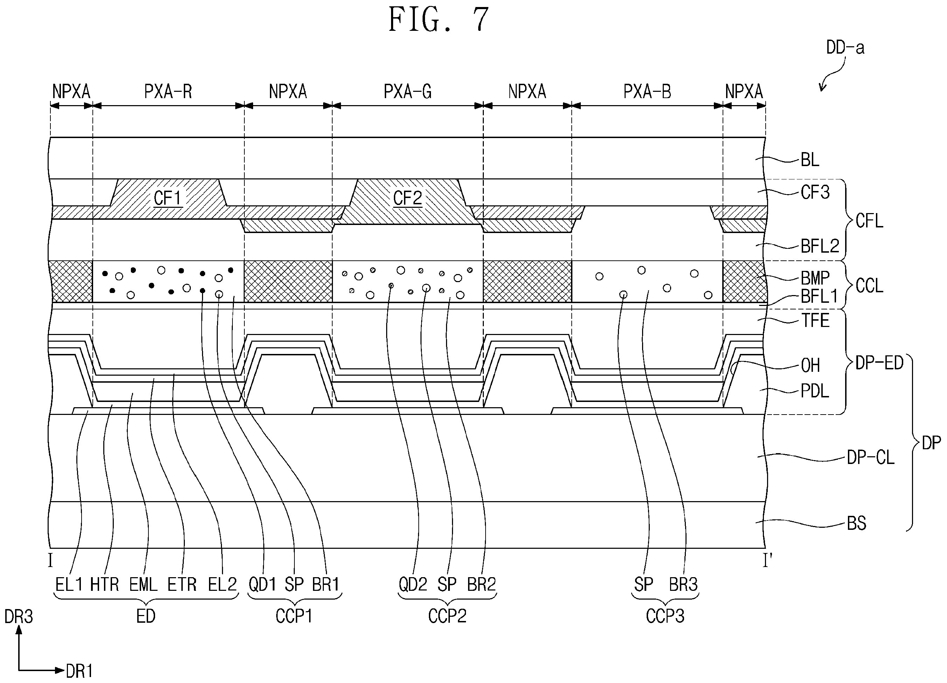

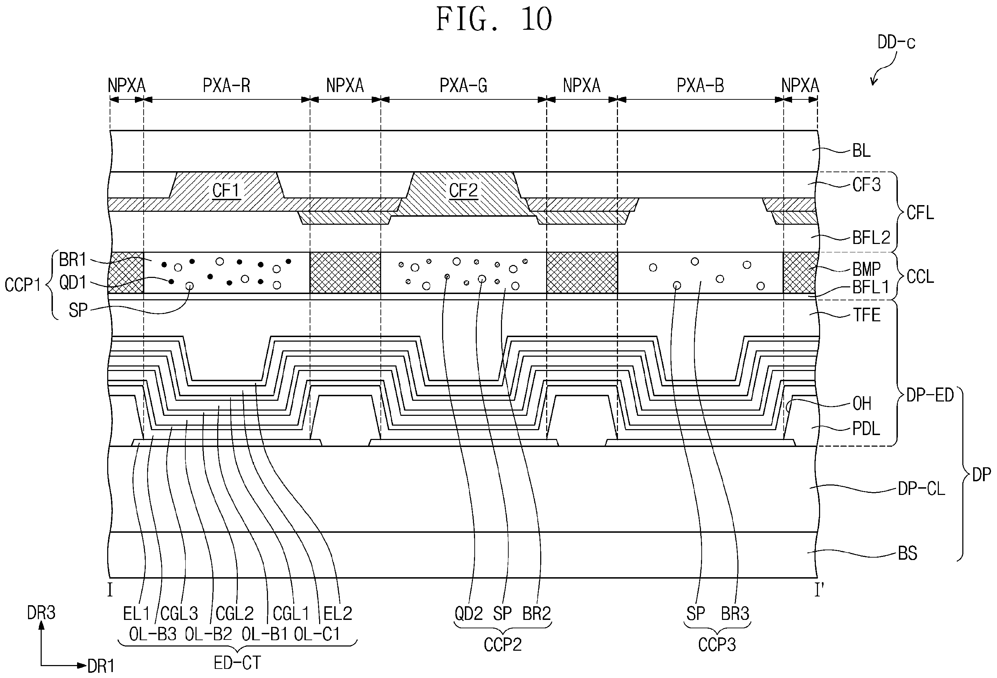

Each of FIGs. 7 to 10 is a cross-sectional view of a display apparatus according to one or more embodiments of the present disclosure. Hereinafter, in describing the display apparatuses of embodiments with reference to FIGs. 7 to 10, the duplicated features which have been described in FIGs. 1 to 6 are not described again for conciseness, only their differences will be mainly described.

Referring to FIG. 7, the display apparatus DD-a according to one or more embodiments may include a display panel DP including a display device layer DP-ED, a light control layer CCL arranged on the display panel DP, and a color filter layer CFL. In one or more embodiments illustrated in FIG. 7, the display panel DP may include a base layer BS, a circuit layer DP-CL provided on the base layer BS, and the display device layer DP-ED, and the display device layer DP-ED may include a light emitting device ED.

The light emitting device ED may include a first electrode EL1, a hole transport region HTR on the first electrode EL1, an emission layer EML on the hole transport region HTR, an electron transport region ETR on the emission layer EML, and a second electrode EL2 on the electron transport region ETR. In one or more embodiments, the structure of any one of the light emitting elements of FIGs. 3 to 6 as described above may be equally applied to the structure of the light emitting device ED illustrated in FIG. 7.

The emission layer EML of the light emitting device ED included in the display device DD-a according to one or more embodiments may include the fused polycyclic compound of one or more embodiments described above.

Referring to FIG. 7, the emission layer EML may be arranged in an opening OH defined in a pixel defining film PDL. For example, the emission layer EML which is divided by the pixel defining film PDL and provided corresponding to each of light emitting regions PXA-R, PXA-G, and PXA-B may be to emit light in substantially the same wavelength range. In the display apparatus DD-a of one or more embodiments, the emission layer EML may be to emit blue light. In one or more embodiments, the emission layer EML may be provided as a common layer in the entire light emitting regions PXA-R, PXA-G, and PXA-B.

The light control layer CCL may be arranged on the display panel DP. The light control layer CCL may include a light conversion body. The light conversion body may be a quantum dot, a phosphor, and/or the like. The light conversion body may be to emit provided light by converting the wavelength thereof. For example, the light control layer CCL may a layer containing a quantum dot or a layer containing a phosphor.

The light control layer CCL may include a plurality of light control parts CCP1, CCP2, and CCP3. The light control parts CCP1, CCP2, and CCP3 may be spaced and/or apart from each other.

Referring to FIG. 7, divided patterns BMP may be arranged between the light control parts CCP1, CCP2, and CCP3 which are spaced and/or apart from each other, but embodiments of the present disclosure are not limited thereto. FIG. 7 illustrates that the divided patterns BMP do not overlap the light control parts CCP1, CCP2, and CCP3, but, in some embodiments, at least a portion of the edges of the light control parts CCP1, CCP2, and CCP3 may overlap the divided patterns BMP.

The light control layer CCL may include a first light control part CCP1 containing a first quantum dot QD1 which converts first color light provided from the light emitting device ED into second color light, a second light control part CCP2 containing a second quantum dot QD2 which converts the first color light into third color light, and a third light control part CCP3 which transmits the first color light.

In one or more embodiments, the first light control part CCP1 may provide red light that is the second color light, and the second light control part CCP2 may provide green light that is the third color light. The third light control part CCP3 may provide blue light by transmitting the blue light that is the first color light provided from the light emitting device ED. For example, in one or more embodiments, the first quantum dot QD1 may be a red quantum dot to emit red light, and the second quantum dot QD2 may be a green quantum dot to emit green light. The same as described above on quantum dots may be applied with respect to the quantum dots QD1 and QD2.

In one or more embodiments, the light control layer CCL may further include a scatterer SP. The first light control part CCP1 may include the first quantum dot QD1 and the scatterer SP, the second light control part CCP2 may include the second quantum dot QD2 and the scatterer SP, and the third light control part CCP3 may not include (e.g., may exclude) any quantum dot but include the scatterer SP.

The scatterer SP may be inorganic particles. For example, the scatterer SP may include at least one of TiO₂, ZnO, Al₂O₃, SiO₂, or hollow sphere silica. In one or more embodiments, the scatterer SP may include any one selected from among TiO₂, ZnO, Al₂O₃, SiO₂, and hollow sphere silica, or may be a mixture of at least two materials selected from among TiO₂, ZnO, Al₂O₃, SiO₂, and hollow sphere silica.

The first light control part CCP1, the second light control part CCP2, and the third light control part CCP3 may respectively include base resins BR1, BR2, and BR3 in which the quantum dots QD1 and QD2 and the scatterer SP are dispersed. In one or more embodiments, the first light control part CCP1 may include the first quantum dot QD1 and the scatterer SP dispersed in a first base resin BR1, the second light control part CCP2 may include the second quantum dot QD2 and the scatterer SP dispersed in a second base resin BR2, and the third light control part CCP3 may include the scatterer SP dispersed in a third base resin BR3.

The base resins BR1, BR2, and BR3 are media in which the quantum dots QD1 and QD2 and the scatterer SP are dispersed, and may be formed of one or more suitable resin compositions, which may be generally referred to as a binder. For example, the base resins BR1, BR2, and BR3 may each independently be acrylic-based resins, urethane-based resins, silicone-based resins, epoxy-based resins, and/or the like. The base resins BR1, BR2, and BR3 may be transparent resins. In one or more embodiments, the first base resin BR1, the second base resin BR2, and the third base resin BR3 may be the same as or different from each other.

In one or more embodiments, the light control layer CCL may include a barrier layer BFL1. The barrier layer BFL1 may serve to prevent or reduce the penetration of moisture and/or oxygen (hereinafter, referred to as 'moisture/oxygen'). The barrier layer BFL1 may block or reduce the light control parts CCP1, CCP2 and CCP3 from being exposed to moisture/oxygen. In one or more embodiments, the barrier layer BFL1 may cover the light control parts CCP1, CCP2, and CCP3. In one or more embodiments, a barrier layer BFL2 may be provided between the light control parts CCP1, CCP2, and CCP3 and the color filter layer CFL.

The barrier layers BFL1 and BFL2 may include at least one inorganic layer. For example, in some embodiments, the barrier layers BFL1 and BFL2 may include an inorganic material. For example, the barrier layers BFL1 and BFL2 may include a silicon nitride, an aluminum nitride, a zirconium nitride, a titanium nitride, a hafnium nitride, a tantalum nitride, a silicon oxide, an aluminum oxide, a titanium oxide, a tin oxide, a cerium oxide, a silicon oxynitride, a metal thin film which secures a transmittance, and/or the like. In one or more embodiments, the barrier layers BFL1 and BFL2 may further include an organic film. The barrier layers BFL1 and BFL2 may be formed of a single layer or a plurality of layers.

In the display apparatus DD-a of one or more embodiments, the color filter layer CFL may be arranged on the light control layer CCL. For example, in some embodiments, the color filter layer CFL may be directly arranged on the light control layer CCL. In these embodiments, the barrier layer BFL2 may not be provided.

The color filter layer CFL may include color filters CF1, CF2, and CF3. The color filter layer CFL may include a first filter CF1 configured to transmit the second color light, a second filter CF2 configured to transmit the third color light, and a third filter CF3 configured to transmit the first color light. For example, in some embodiments, the first filter CF1 may be a red filter, the second filter CF2 may be a green filter, and the third filter CF3 may be a blue filter. The filters CF1, CF2, and CF3 each may include a polymeric photosensitive resin and a pigment and/or a dye. The first filter CF1 may include a red pigment and/or a red dye, the second filter CF2 may include a green pigment and/or a green dye, and the third filter CF3 may include a blue pigment and/or a blue dye.

In one or more embodiments, e the third filter CF3 may not include (e.g., may exclude) any pigment and/or dye. The third filter CF3 may include a polymeric photosensitive resin and may not include (e.g., may exclude) any pigment and/or dye. The third filter CF3 may be transparent. The third filter CF3 may be formed of a transparent photosensitive resin.

Furthermore, in some embodiments, the first filter CF1 and the second filter CF2 may each be a yellow filter. The first filter CF1 and the second filter CF2 may not be separated but be provided as one filter.

In one or more embodiments, the color filter layer CFL may further include a light shielding part . The light shielding part may be a black matrix. The light shielding part may include an organic light shielding material or an inorganic light shielding material containing a black pigment and/or a black dye. The light shielding part may prevent or reduce light leakage, and may separate boundaries between the adjacent filters CF1, CF2, and CF3.

The first to third filters CF1, CF2, and CF3 may be arranged corresponding to the red light emitting region PXA-R, the green light emitting region PXA-G, and the blue light emitting region PXA-B, respectively.

In one or more embodiments, a base substrate BL may be arranged on the color filter layer CFL. The base substrate BL may be a member which provides a base surface on which the color filter layer CFL, the light control layer CCL, and/or the like are arranged. The base substrate BL may be a glass substrate, a metal substrate, a plastic substrate, and/or the like. However, embodiments of the present disclosure are not limited thereto, and the base substrate BL may be an inorganic layer, an organic layer, or a composite material layer. In one or more embodiments, the base substrate BL may not be provided.

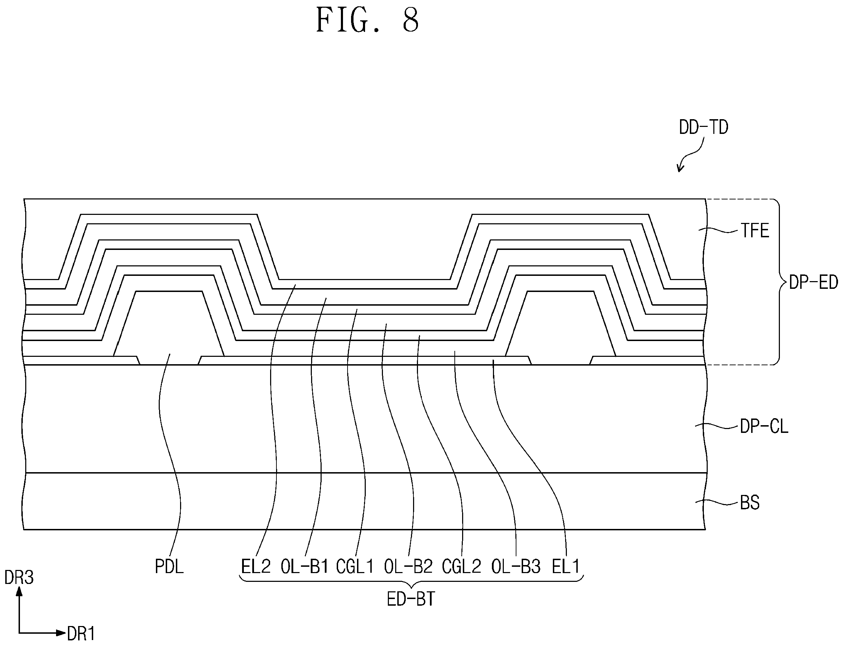

FIG. 8 is a cross-sectional view illustrating a portion of a display apparatus according to one or more embodiments. In a display apparatus DD-TD, the light emitting device ED-BT may include a plurality of light emitting structures OL-B1, OL-B2, and OL-B3. The light emitting device ED-BT may include a first electrode EL1 and a second electrode EL2 which face each other, and the plurality of light emitting structures OL-B1, OL-B2, and OL-B3 sequentially stacked in a thickness direction between the first electrode EL1 and the second electrode EL2. The light emitting structures OL-B1, OL-B2, and OL-B3 each may include an emission layer EML (FIG. 7) and a hole transport region HTR and an electron transport region ETR arranged with the emission layer EML (FIG. 7) located therebetween.

For example, in some embodiments, the light emitting device ED-BT included in the display apparatus DD-TD may be a light emitting device having a tandem structure and including a plurality of emission layers.

In one or more embodiments illustrated in FIG. 8, all light beams respectively emitted from the light emitting structures OL-B1, OL-B2, and OL-B3 may be blue light. However, embodiments of the present disclosure are not limited thereto, and the light beams respectively emitted from the light emitting structures OL-B1, OL-B2, and OL-B3 may have wavelength ranges different from each other. For example, in one or more embodiments, the light emitting device ED-BT including the plurality of light emitting structures OL-B1, OL-B2, and OL-B3 which emit light beams having wavelength ranges different from each other may be to emit white light (e.g., combined white light).

Charge generation layers CGL1 and CGL2 may be respectively arranged between two of the neighboring light emitting structures OL-B1, OL-B2, and OL-B3. The charge generation layers CGL1 and CGL2 may include a p-type or kind charge (e.g., P-charge) generation layer and/or an n-type or kind charge (e.g., N-charge) generation layer. At least one of the light emitting structures OL-B1, OL-B2, or OL-B3 included in the display device DD-TD of one or more embodiments may include the fused polycyclic compound of one or more embodiments described above. For example, in one or more embodiments, at least one of (e.g., at least one selected from among) the plurality of emission layers included in the light emitting element ED-BT may include the fused polycyclic compound of an embodiment.

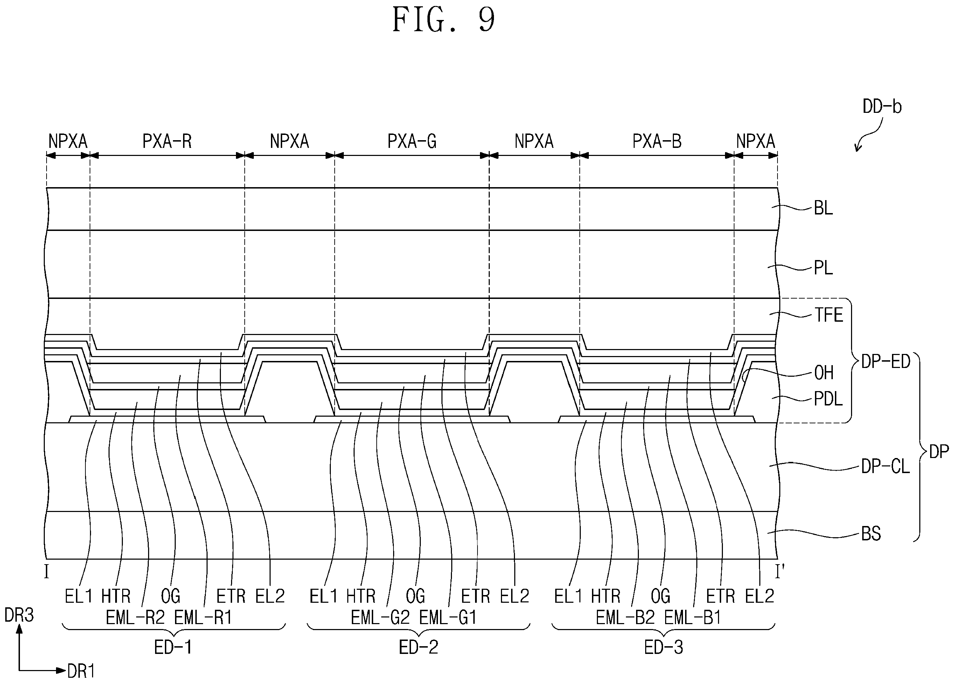

Referring to FIG. 9, a display apparatus DD-b according to one or more embodiments may include light emitting devices ED-1, ED-2, and ED-3 in each of which two emission layers are stacked. Compared with the display apparatus DD illustrated in FIG. 2, the display apparatus DD-b illustrated in FIG. 9 has a difference in that the first to third light emitting devices ED-1, ED-2, and ED-3 each include two emission layers stacked in a thickness direction. In each of the first to third light emitting devices ED-1, ED-2, and ED-3, the two emission layers may be to emit light in substantially the same wavelength region.

In one or more embodiments, the first light emitting device ED-1 may include a first red emission layer EML-R1 and a second red emission layer EML-R2. The second light emitting device ED-2 may include a first green emission layer EML-G1 and a second green emission layer EML-G2. In addition, the third light emitting device ED-3 may include a first blue emission layer EML-B1 and a second blue emission layer EML-B2. An emission auxiliary part OG may be separately arranged between the first red emission layer EML-R1 and the second red emission layer EML-R2, between the first green emission layer EML-G1 and the second green emission layer EML-G2, and between the first blue emission layer EML-B1 and the second blue emission layer EML-B2.

The emission auxiliary part OG may include a single layer or a multilayer. The emission auxiliary part OG may include a charge generation layer. In one or more embodiments, the emission auxiliary part OG may include an electron transport region, a charge generation layer, and a hole transport region that are sequentially stacked (e.g., in the stated order). The emission auxiliary part OG may be provided as a common layer in the whole of the first to third light emitting devices ED-1, ED-2, and ED-3. However, embodiments of the present disclosure are not limited thereto, and the emission auxiliary part OG may be provided by being patterned within the openings OH defined in the pixel defining film PDL.

The first red emission layer EML-R1, the first green emission layer EML-G1, and the first blue emission layer EML-B1 may each be arranged between the emission auxiliary part OG and the electron transport region ETR. The second red emission layer EML-R2, the second green emission layer EML-G2, and the second blue emission layer EML-B2 may each be arranged between the hole transport region HTR and the emission auxiliary part OG.

For example, in one or more embodiments, the first light emitting device ED-1 may include a first electrode EL1, a hole transport region HTR, a second red emission layer EML-R2, an emission auxiliary part OG, a first red emission layer EML-R1, an electron transport region ETR, and a second electrode EL2 that are sequentially stacked (e.g., for the stated order). The second light emitting device ED-2 may include a first electrode EL1, a hole transport region HTR, a second green emission layer EML-G2, an emission auxiliary part OG, a first green emission layer EML-G1, an electron transport region ETR, and a second electrode EL2 that are sequentially stacked (e.g., in the stated order). The third light emitting device ED-3 may include a first electrode EL1, a hole transport region HTR, a second blue emission layer EML-B2, an emission auxiliary part OG, a first blue emission layer EML-B1, an electron transport region ETR, and a second electrode EL2 that are sequentially stacked (e.g., in the stated order).

In one or more embodiments, an optical auxiliary layer PL may be arranged on the display device layer DP-ED. The optical auxiliary layer PL may include a polarizing layer. The optical auxiliary layer PL may be arranged on the display panel DP to control reflected light in the display panel DP due to external light. In some embodiments, the optical auxiliary layer PL may not be provided in the display apparatus .

At least one emission layer included in the display device DD-b of one or more embodiments shown in FIG. 9 may include the fused polycyclic compound of one or more embodiments described above. For example, in one or more embodiments, at least one of the first blue emission layer EML-B1 or the second blue emission layer EML-B2 may include the fused polycyclic compound of one or more embodiments.

Unlike FIGs. 8 and 9, FIG. 10 illustrates that a display apparatus DD-c includes four light emitting structures OL-B1, OL-B2, OL-B3, and OL-C1. A light emitting device ED-CT may include a first electrode EL1 and a second electrode EL2 which face each other, and first to fourth light emitting structures OL-B1, OL-B2, OL-B3, and OL-C1 that are stacked in the thickness direction between the first electrode EL1 and the second electrode EL2. Charge generation layers CGL1, CGL2, and CGL3 may each be separately arranged between the first to fourth light emitting structures OL-B1, OL-B2, OL-B3, and OL-C1. In some embodiments, among the four light emitting structures, the first to third light emitting structures OL-B1, OL-B2, and OL-B3 may each be to emit blue light, and the fourth light emitting structure OL-C1 may be to emit green light. However, embodiments of the present disclosure are not limited thereto, and the first to fourth light emitting structures OL-B1, OL-B2, OL-B3, and OL-C1 may each be to emit light beams in different wavelength regions.

The charge generation layers CGL1, CGL2, and CGL3 arranged between adjacent light emitting structures OL-B1, OL-B2, OL-B3, and OL-C1 may include a p-type or kind charge (e.g., P-charge) generation layer and/or an n-type or kind charge (e.g., N-charge) generation layer.

At least one selected from among the light emitting structures OL-B1, OL-B2, OL-B3, and OL-C1 included in the display device DD-c according to one or more embodiments may include the fused polycyclic compound of one or more embodiments described above. For example, in one or more embodiments, at least one selected from among the first to third light emitting structures OL-B1, OL-B2, and OL-B3 may include the fused polycyclic compound of one or more embodiments described above.

The light emitting device/element ED described above according to one or more embodiments of the present disclosure may include the fused polycyclic compound of one or more embodiments in at least one functional layer arranged between the first electrode EL1 and the second electrode EL2, and may thus exhibit excellent or suitable light emitting efficiency and improved lifespan. For example, the fused polycyclic compound according to one or more embodiments may be included in the emission layer EML of the light emitting element ED of one or more embodiments, and the light emitting element of one or more embodiments may exhibit long lifespan.

In one or more embodiments, an electronic apparatus may include a display apparatus including a plurality of light emitting devices, and a control part which controls the display apparatus. The electronic apparatus of one or more embodiments may be a device that is activated according to an electrical signal. The electronic apparatus may include display apparatuses of one or more suitable embodiments. For example, the electronic apparatus may include not only large-sized electronic apparatuses such as a television set, a monitor, or an outdoor billboard but also include small- and medium-sized electronic apparatuses such as a personal computer, a laptop computer, a personal digital terminal, a display apparatus for a vehicle, a game console, a portable electronic device, or a camera.

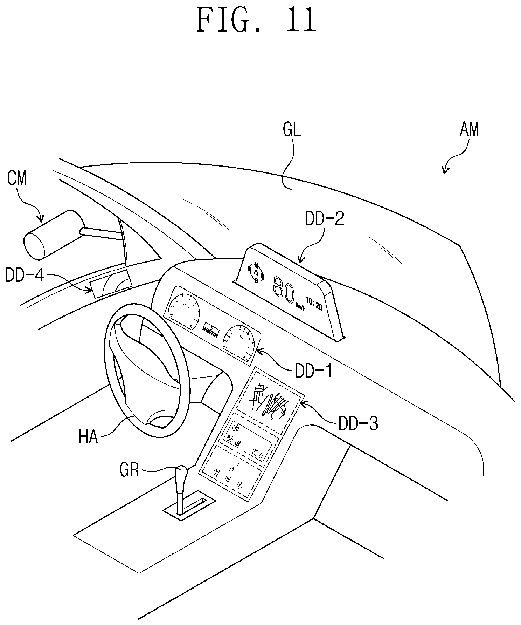

FIG. 11 is a view illustrating a vehicle AM in which first to fourth display apparatuses DD-1, DD-2, DD-3, and DD-4 are arranged. At least one selected from among the first to fourth display apparatuses DD-1, DD-2, DD-3, and DD-4 may include substantially the same configuration as the display apparatuses DD, DD-TD, DD-a, DD-b, and/or DD-c as described with reference to FIGs. 1, and 2, and 7 to 10.

FIG. 11 illustrates a vehicle AM, but this is an example, and the first to fourth display apparatuses DD-1, DD-2, DD-3, and DD-4 may be arranged in other transportation apparatuses such as bicycles, motorcycles, trains, ships, and/or airplanes. In one or more embodiments, at least one selected from among the first to fourth display apparatuses DD-1, DD-2, DD-3, and DD-4 including substantially the same configuration as the display apparatuses DD, DD-TD, DD-a, DD-b, and/or DD-c of one or more embodiments may be employed in a personal computer, a laptop computer, a personal digital terminal, a game console, a portable electronic device, a television, a monitor, an outdoor billboard, and/or the like. These are merely provided as embodiments, and thus the display apparatuses may be employed in other electronic apparatuses unless departing from the present disclosure.

In one or more embodiments, at least one selected from among the first to fourth display devices DD-1, DD-2, DD-3, and DD-4 may include the light emitting element ED of one or more embodiments described with reference to FIGs. 3 to 6. The light emitting element ED of one or more embodiments may include the fused polycyclic compound of one or more embodiments. At least one selected from among the first to fourth display devices DD-1, DD-2, DD-3, and DD-4 includes the light emitting element ED including the fused polycyclic compound of one or more embodiments, and may thus have increased display lifespan.

Referring to FIG. 11, the vehicle AM may include a steering wheel HA and a gear GR for driving the vehicle AM. In addition, the vehicle AM may include a front window GL arranged so as to face a driver.

The first display apparatus DD-1 may be arranged in a first region overlapping the steering wheel HA. For example, the first display apparatus DD-1 may be a digital cluster which displays first information of the vehicle AM. The first information may include a first scale which indicates a driving speed of the vehicle AM, a second scale which indicates an engine speed (that is, revolutions per minute (RPM)), an image which indicates a fuel state, and/or the like. The first scale and the second scale may be indicated as a digital image.

The second display apparatus DD-2 may be arranged in a second region facing a driver seat and overlapping the front window GL. The driver seat may be a seat in which the steering wheel HA faces. For example, the second display apparatus DD-2 may be a head up display (HUD) which displays second information of the vehicle AM. The second display apparatus DD-2 may be optically transparent. The second information may include digital numbers which indicate a driving speed, and may further include information such as the current time. In some embodiments, the second information of the second display apparatus DD-2 may be projected to the front window GL to be displayed.

The third display apparatus DD-3 may be arranged in a third region adjacent to the gear GR. For example, the third display apparatus DD-3 may be arranged between a driver seat and a passenger seat and may be a center information display (CID) for the vehicle for displaying third information. The passenger seat may be a seat spaced and/or apart from the driver seat with the gear GR arranged therebetween. The third information may include information about traffic (e.g., navigation information), playing music or radio or a video (or an image), temperatures inside the vehicle AM, and/or the like.

The fourth display apparatus DD-4 may be spaced and apart from the steering wheel HA and the gear GR, and may be arranged in a fourth region adjacent to a side of the vehicle AM. For example, the fourth display apparatus DD-4 may be a digital side-view mirror which displays fourth information. The fourth display apparatus DD-4 may display an image outside the vehicle AM taken by a camera module CM arranged outside the vehicle AM. The fourth information may include an image outside the vehicle AM.

The above-described first to fourth information may be examples, and the first to fourth display apparatuses DD-1, DD-2, DD-3, and DD-4 may further display information about the inside and outside of the vehicle AM. The first to fourth information may include different information. However, embodiments of the present disclosure are not limited thereto, and a part of the first to fourth information may include the same information as one another.

Hereinafter, the fused polycyclic compound according to one or more embodiments and the light emitting element of one or more embodiments of the present disclosure will be particularly explained referring to one or more embodiments and comparative embodiments. In addition, the embodiments are only illustrations to assist the understanding of the present disclosure, and the scope of the present disclosure is not limited thereto.

### Examples

### 1. Synthesis of Fused Polycyclic Compounds

First, the synthetic method of the fused polycyclic compound according to one or more embodiments will be explained in more detail by illustrating the synthetic methods of Compounds 4, 30, 61, 84, and 171. In addition, the synthetic methods of the fused polycyclic compounds explained hereinafter are example embodiments, and the synthetic method of the fused polycyclic compound according to one or more embodiments of the present disclosure is not limited to the example embodiments .

### (1) Synthesis of Compound 4

### Synthesis of Intermediate 4-1

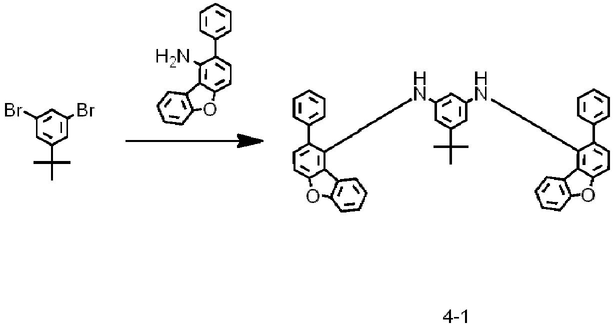

1,3-Dibromo-5-(tert-butyl)benzene (1 eq), 2-phenyldibenzo[b,d]furan-1-amine (2 eq), tris(dibenzylideneacetone)dipalladium(0) (0.05 eq), tri-tert-butylphosphine (0.1 eq), and sodium tert-butoxide (3 eq) were dissolved in toluene and stirred at about 110 degrees centigrade for about 12 hours. After cooling, the resultant was diluted with ethyl acetate and washed three times with water, an organic layer obtained by layer separation was dried over MgSO₄ and then dried under a reduced pressure. The crude product was purified by column chromatography utilizing methylene chloride (MC) and n-hexane as an eluent to obtain Intermediate 4-1 (yield: 76%).

### Synthesis of Intermediate 4-2

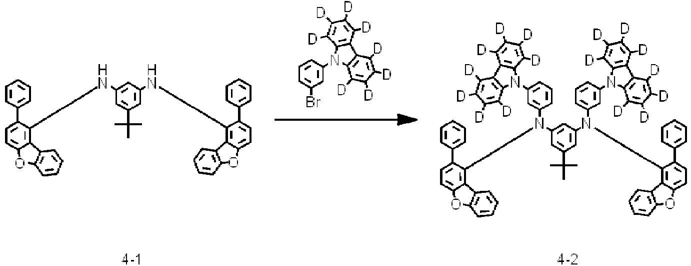

Intermediate 4-1 (1 eq), 9-(3-bromophenyl)-9H-carbazole-1,2,3,4,5,6,7,8-d8 (3 eq), tris(dibenzylideneacetone)dipalladium(0) (0.15 eq), tri-tert-butylphosphine (0.3 eq), and sodium tert-butoxide (5 eq) were dissolved in o-xylene and stirred at about 150 degrees centigrade for about 48 hours. After cooling, the resultant was diluted with ethyl acetate and washed three times with water, an organic layer obtained by layer separation was dried over MgSO₄ and then dried under a reduced pressure. The crude product was purified by column chromatography utilizing MC and n-hexane as an eluent to obtain Intermediate 4-2 (yield: 32%).

### Synthesis of Compound 4

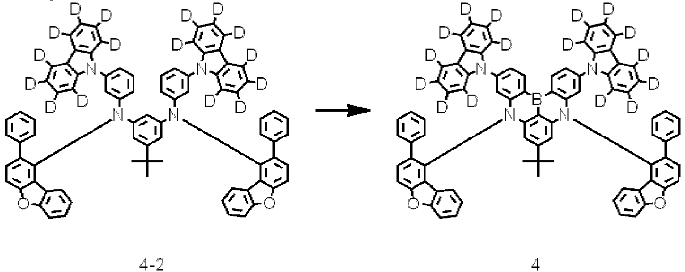

Intermediate 4-2 (1 eq) was dissolved in ortho dichlorobenzene and cooled to about 0 degrees centigrade, and BBr₃ (3 eq) was slowly injected under a nitrogen atmosphere. After finishing the dropwise addition, the temperature was raised to about 180 degrees centigrade, followed by stirring for about 24 hours. After cooling, triethylamine was slowly added to a flask containing the reaction product to quench the reaction, and ethyl alcohol was added to precipitate. The precipitate was filtered to obtain a reaction product. The solid thus obtained was purified by column chromatography utilizing MC and n-hexane as an eluent and then, recrystallized utilizing toluene and acetone to obtain Compound 4 (yield: 7%).

### (2) Synthesis of Compound 30

### Synthesis of Intermediate 30-1

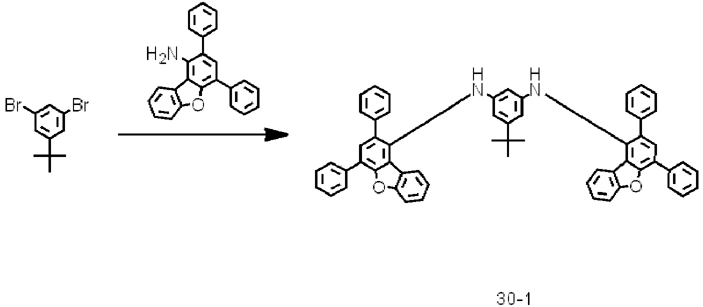

1,3-Dibromo-5-(tert-butyl)benzene (1 eq), 2,4-diphenyldibenzo[b,d]furan-1-amine (2 eq), tris(dibenzylideneacetone)dipalladium(0) (0.05 eq), tri-tert-butylphosphine (0.1 eq), and sodium tert-butoxide (3 eq) were dissolved in toluene and stirred at about 110 degrees centigrade for about 12 hours. After cooling, the resultant was diluted with ethyl acetate and washed three times with water, an organic layer obtained by layer separation was dried over MgSO₄ and then dried under a reduced pressure. The crude product was purified by column chromatography utilizing MC and n-hexane as an eluent to obtain Intermediate 30-1 (yield: 81%).

### Synthesis of Intermediate 30-2

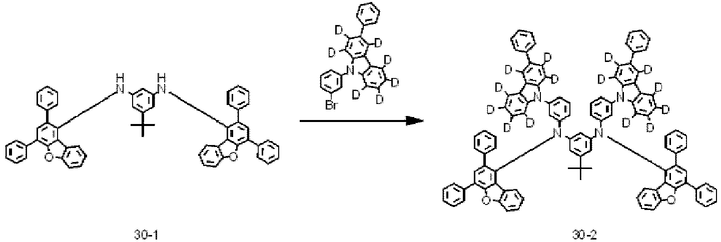

Intermediate 30-1 (1 eq), 9-(3-bromophenyl)-3-phenyl-9H-carbazole-1,2,4,5,6,7,8-d7 (3 eq), tris(dibenzylideneacetone)dipalladium(0) (0.15 eq), tri-tert-butylphosphine (0.3 eq), and sodium tert-butoxide (5 eq) were dissolved in o-xylene and stirred at about 150 degrees centigrade for about 48 hours. After cooling, the resultant was diluted with ethyl acetate and washed three times with water, an organic layer obtained by layer separation was dried over MgSO₄ and then dried under a reduced pressure. The crude product was purified by column chromatography utilizing MC and n-hexane as an eluent to obtain Intermediate 30-2 (yield: 41%).

### Synthesis of Compound 30

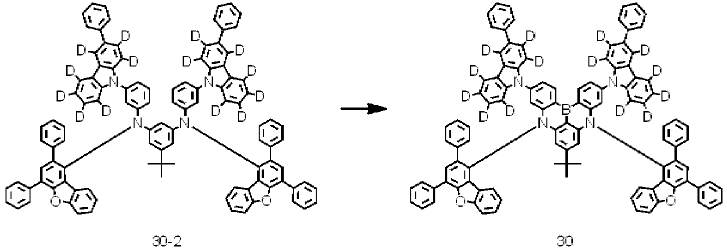

Intermediate 30-2 (1 eq) was dissolved in ortho dichlorobenzene and cooled to about 0 degrees centigrade, and BBr₃ (3 eq) was slowly injected under a nitrogen atmosphere. After finishing the dropwise addition, the temperature was raised to about 180 degrees centigrade, followed by stirring for about 24 hours. After cooling, triethylamine was slowly added to a flask containing the reaction product to quench the reaction, and ethyl alcohol was added to precipitate. The precipitate was filtered to obtain a reaction product. The solid thus obtained was purified by column chromatography utilizing MC and n-hexane as an eluent and then, recrystallized utilizing toluene and acetone to obtain Compound 30 (yield: 5%).

### (3) Synthesis of Compound 61

### Synthesis of Intermediate 61-1

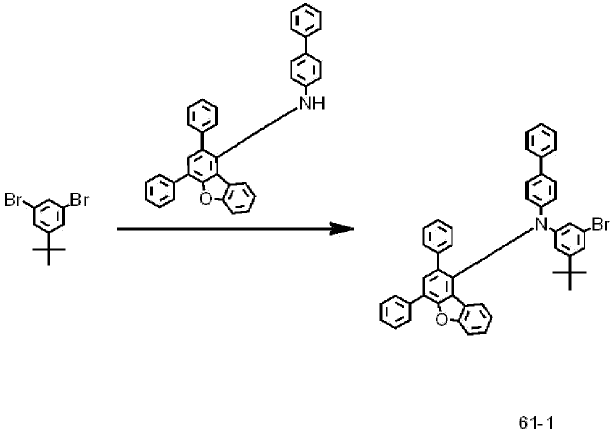

1,3-Dibromo-5-(tert-butyl)benzene (1 eq), N-([1,1'-biphenyl]-4-yl)-2,4-diphenyldibenzo[b,d]furan-1-amine (0.8 eq), tris(dibenzylideneacetone)dipalladium(0) (0.05 eq), ([1,1'-binaphthalene]-2,2'-diyl)bis(diphenylphosphane) (BINAP) (0.1 eq), and sodium tert-butoxide (3 eq) were dissolved in toluene and stirred at about 80 degrees centigrade for about 12 hours. After cooling, the resultant was diluted with ethyl acetate and washed three times with water, an organic layer obtained by layer separation was dried over MgSO₄ and then dried under a reduced pressure. The crude product was purified by column chromatography utilizing MC and n-hexane as an eluent to obtain Intermediate 61-1 (yield: 62%).

### Synthesis of Intermediate 61-2

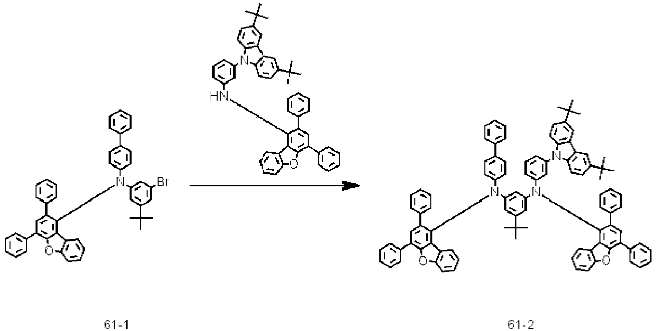

Intermediate 61-1 (1 eq), N-(3-(3,6-di-tert-butyl-9H-carbazol-9-yl)phenyl)-2,4-diphenyldibenzo[b,d]furan-1-amine (1.2 eq), tris(dibenzylideneacetone)dipalladium(0) (0.05 eq), tri-tert-butylphosphine (0.1 eq), and sodium tert-butoxide (3 eq) were dissolved in toluene and stirred at about 110 degrees centigrade for about 16 hours. After cooling, the resultant was diluted with ethyl acetate and washed three times with water, an organic layer obtained by layer separation was dried over MgSO₄ and then dried under a reduced pressure. The crude product was purified by column chromatography utilizing MC and n-hexane as an eluent to obtain Intermediate 61-2 (yield: 71%).

### Synthesis of Compound 61

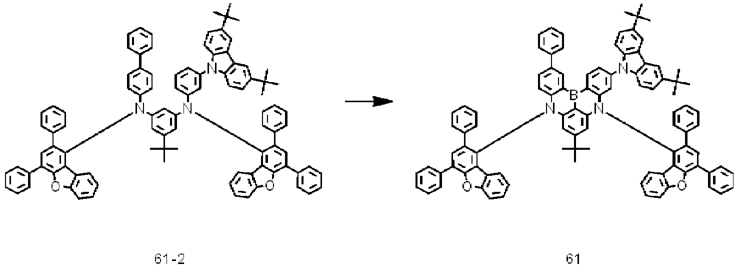

Intermediate 61-2 (1 eq) was dissolved in ortho dichlorobenzene and cooled to about 0 degrees centigrade, and BBr₃ (3 eq) was slowly injected under a nitrogen atmosphere. After finishing the dropwise addition, the temperature was raised to about 180 degrees centigrade, followed by stirring for about 24 hours. After cooling, triethylamine was slowly added to a flask containing the reaction product to quench the reaction, and ethyl alcohol was added to precipitate. The precipitate was filtered to obtain a reaction product. The solid thus obtained was purified by column chromatography utilizing MC and n-hexane as an eluent and then, recrystallized utilizing toluene and acetone to obtain Compound 61 (yield: 12%).

### (4) Synthesis of Compound 84

### Synthesis of Intermediate 84-1

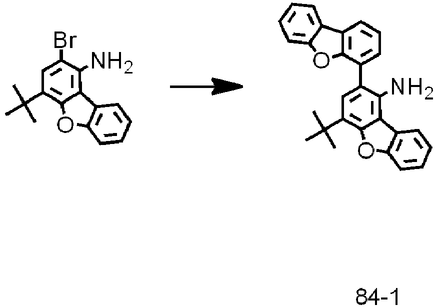

2-Bromo-4-(tert-butyl)dibenzo[b,d]furan-1-amine (1 eq), dibenzo[b,d]furan-4-ylboronic acid (2 eq), Pd(PPh₃)₄ (0.05 eq), and K₂CO₃ (3 eq) were dissolved in a mixture solution of water and tetrahydrofuran (THF) in a volume ratio of 2:1 and stirred at about 80 degrees centigrade for about 12 hours. After cooling, the resultant was diluted with ethyl acetate and washed three times with water, an organic layer obtained by layer separation was dried over MgSO₄ and then dried under a reduced pressure. The crude product was purified by column chromatography utilizing MC and n-hexane as an eluent to obtain Intermediate 84-1 (yield: 79%).

### Synthesis of Intermediate 84-2

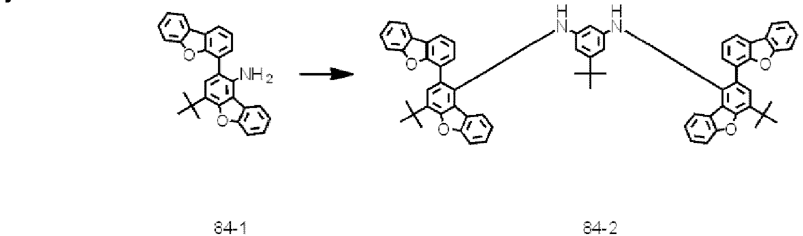

1,3-Dibromo-5-(tert-butyl)benzene (1 eq), Intermediate 84-1 (2 eq), tris(dibenzylideneacetone)dipalladium(0) (0.05 eq), tri-tert-butylphosphine (0.1 eq), and sodium tert-butoxide (3 eq) were dissolved in toluene and stirred at about 110 degrees centigrade for about 12 hours. After cooling, the resultant was diluted with ethyl acetate and washed three times with water, an organic layer obtained by layer separation was dried over MgSO₄ and then dried under a reduced pressure. The crude product was purified by column chromatography utilizing MC and n-hexane as an eluent to obtain Intermediate 84-2 (yield: 83%).

### Synthesis of Intermediate 84-3

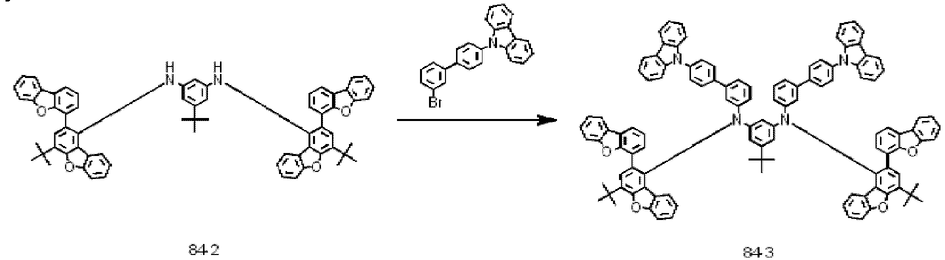

Intermediate 84-2 (1 eq), 9-(3'-bromo-[1,1'-biphenyl]-4-yl)-9H-carbazole (3 eq), tris(dibenzylideneacetone)dipalladium(0) (0.15 eq), tri-tert-butylphosphine (0.3 eq), and sodium tert-butoxide (5 eq) were dissolved in o-xylene and stirred at about 150 degrees centigrade for about 48 hours. After cooling, the resultant was diluted with ethyl acetate and washed three times with water, an organic layer obtained by layer separation was dried over MgSO₄ and then dried under a reduced pressure. The crude product was purified by column chromatography utilizing MC and n-hexane as an eluent to obtain Intermediate 84-3 (yield: 32%).

### Synthesis of Compound 84

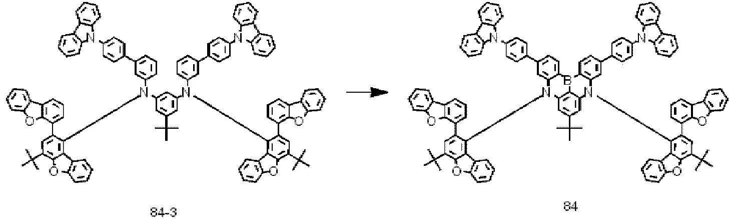

Intermediate 84-3 (1 eq) was dissolved in ortho dichlorobenzene and cooled to about 0 degrees centigrade, and BBr₃ (3 eq) was slowly injected under a nitrogen atmosphere. After finishing the dropwise addition, the temperature was raised to about 180 degrees centigrade, followed by stirring for about 24 hours. After cooling, triethylamine was slowly added to a flask containing the reaction product to quench the reaction, and ethyl alcohol was added to precipitate. The precipitate was filtered to obtain a reaction product. The solid thus obtained was purified by column chromatography utilizing MC and n-hexane as an eluent and then, recrystallized utilizing toluene and acetone to obtain Compound 84 (yield: 10%).

### (5) Synthesis of Compound 171

### Synthesis of Intermediate 171-1

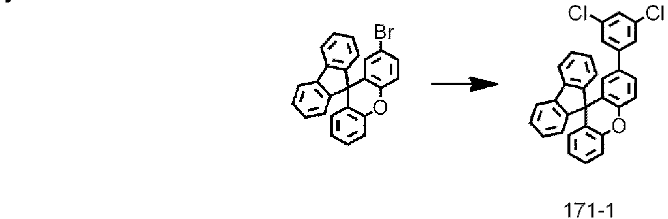

2'-Bromospiro[fluorene-9,9'-xanthene] (1 eq), (3,5-dichlorophenyl)boronic acid (1 eq), Pd(PPh₃)₄ (0.05 eq), and K₂CO₃ (3 eq) were dissolved in a mixture solution of water and THF in a volume ratio of 2:1 and stirred at about 80 degrees centigrade for about 12 hours. After cooling, the resultant was diluted with ethyl acetate and washed three times with water, an organic layer obtained by layer separation was dried over MgSO₄ and then dried under a reduced pressure. The crude product was purified by column chromatography utilizing MC and n-hexane as an eluent to obtain Intermediate 171-1 (yield: 74%).

### Synthesis of Intermediate 171-2

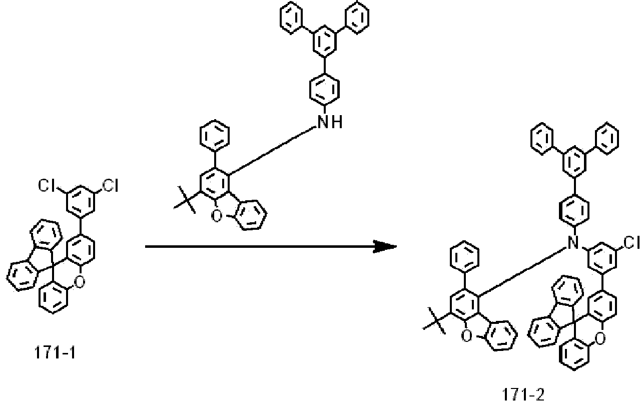

Intermediate 171-1 (1 eq), 4-(tert-butyl)-2-phenyl-N-(5'-phenyl-[1,1':3',1"-terphenyl]-4-yl)dibenzo[b,d]furan-1-amine (0.8 eq), tris(dibenzylideneacetone)dipalladium(0) (0.05 eq), BINAP (0.1 eq), and sodium tert-butoxide (3 eq) were dissolved in toluene and stirred at about 90 degrees centigrade for about 12 hours. After cooling, the resultant was diluted with ethyl acetate and washed three times with water, an organic layer obtained by layer separation was dried over MgSO₄ and then dried under a reduced pressure. The crude product was purified by column chromatography utilizing MC and n-hexane as an eluent to obtain Intermediate 171-2 (yield: 58%).

### Synthesis of Intermediate 171-3

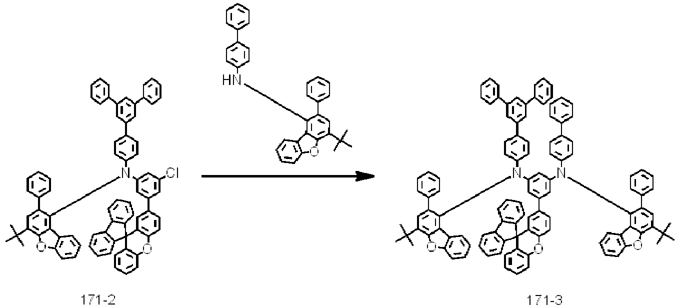

Intermediate 171-2 (1 eq), N-([1,1'-biphenyl]-4-yl)-4-(tert-butyl)-2-phenyldibenzo[b,d]furan-1-amine (1.1 eq), tris(dibenzylideneacetone)dipalladium(0) (0.05 eq), tri-tert-butylphosphine (0.1 eq), and sodium tert-butoxide (3 eq) were dissolved in toluene and stirred at about 110 degrees centigrade for about 16 hours. After cooling, the resultant was diluted with ethyl acetate and washed three times with water, an organic layer obtained by layer separation was dried over MgSO₄ and then dried under a reduced pressure. The crude product was purified by column chromatography utilizing MC and n-hexane as an eluent to obtain Intermediate 171-3 (yield: 72%).

### Synthesis of Compound 171

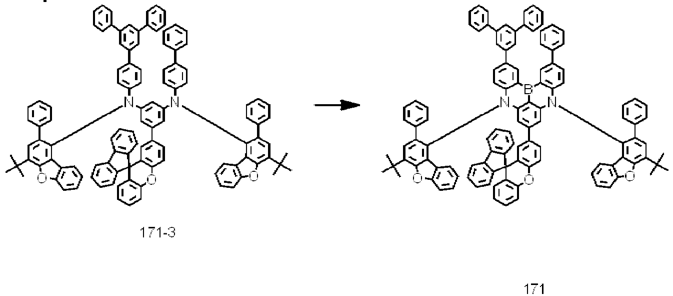

Intermediate 171-3 (1 eq) was dissolved in ortho dichlorobenzene and cooled to about 0 degrees centigrade, and BBr₃ (3 eq) was slowly injected under a nitrogen atmosphere. After finishing the dropwise addition, the temperature was raised to about 180 degrees centigrade, followed by stirring for about 24 hours. After cooling, triethylamine was slowly added to a flask containing the reaction product to quench the reaction, and ethyl alcohol was added to precipitate. The precipitate was filtered to obtain a reaction product. The solid thus obtained was purified by column chromatography utilizing MC and n-hexane as an eluent and then, recrystallized utilizing toluene and acetone to obtain Compound 171 (yield: 11%).

### 2. Manufacture and Evaluation of Light Emitting Elements

The light emitting element of one or more embodiments, including the fused polycyclic compound of one or more embodiments in an emission layer was manufactured by a method described herein. Light emitting elements of Example 1 to Example 5 were manufactured utilizing the fused polycyclic compounds of Example Compounds 4, 30, 61, 84 and 171 as the dopant materials of the emission layers, respectively. Comparative Example 1 to Comparative Example 4 corresponded to light emitting elements manufactured utilizing Comparative Compound C1 to Comparative Compound C4 as the dopant materials of the emission layers, respectively.

### Example Compounds

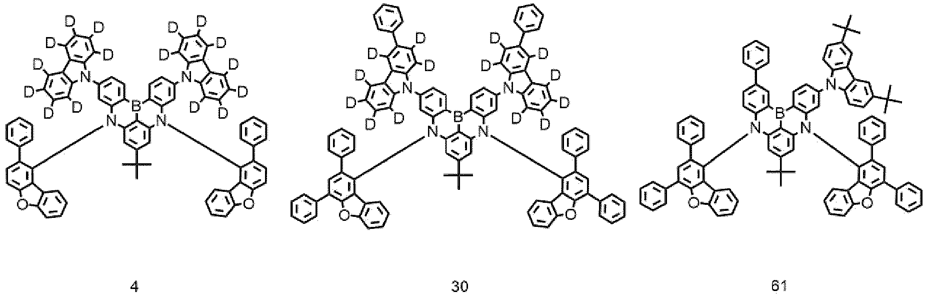

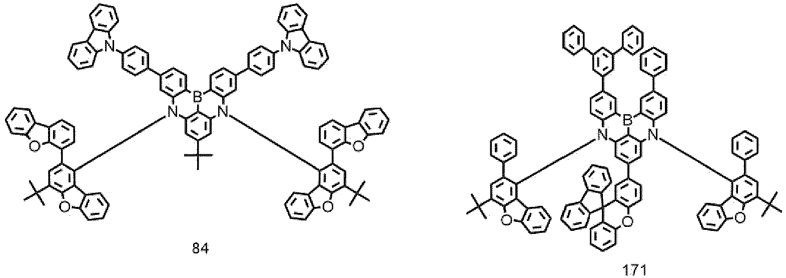

### Comparative Compounds

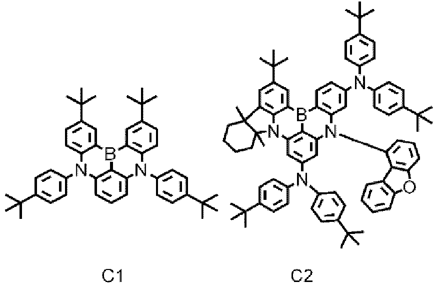

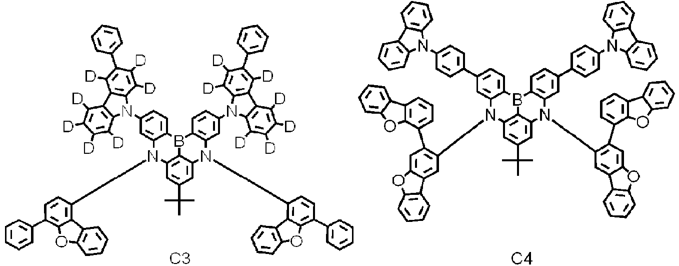

### Manufacture of Light Emitting Elements

For the manufacture of the light emitting elements of the Examples and Comparative Examples, a glass substrate on which an ITO electrode of about 15 Ω/cm² (1200 Å) was formed (a product of Corning Co.) was cut to a size of about 50 mm x 50 mm x 0.7 mm, cleansed with ultrasonic waves in isopropyl alcohol and pure water for about 5 minutes each, exposed to ultraviolet for about 30 minutes, cleansed by exposing to ozone to provide an anode, and the anode was installed in a vacuum evaporation apparatus.

On the anode, NPD was deposited to form (or provide) a hole injection layer with a thickness of about 300 angstrom (Å), and on the hole injection layer, H-1-1 was deposited to form (or provide) a hole transport layer with a thickness of about 200 Å. Then, on the hole transport layer, CzSi was deposited to form (or provide) an emission auxiliary layer with a thickness of about 100 Å.

After that, a host mixture obtained by mixing a second compound and a third compound according to one or more embodiments in a weight ratio of about 1: 1, a fourth compound, and the Example Compound or the Comparative Compound were co-deposited in a weight ratio of about 85: 14: 1 to form (or provide) an emission layer with a thickness of about 200 Å, and on the emission layer, TSPO1 was deposited to form (or provide) a hole blocking layer with a thickness of about 200 Å. Then, on the hole blocking layer, TPBi was deposited to form (or provide) an electron transport layer with a thickness of about 300 Å, and on the electron transport layer, LiF was deposited to form (or provide) an electron injection layer with a thickness of about 10 Å. Then, a second electrode with a thickness of about 3000 Å was formed utilizing Al, to form (or provide) a LiF/Al electrode.

All layers were formed by a vacuum deposition method. Meanwhile, HT36 was utilized as the second compound among the compounds in Compound Group 2, ETH66 was utilized as the third compound among the compounds in Compound Group 3, and AD-38 was utilized as the fourth compound among the compounds in Compound Group 4.

The compounds utilized for the manufacture of each of the light emitting elements of the Examples and Comparative Examples are shown below. The materials below were utilized after purchasing commercial products and performing sublimation purification.

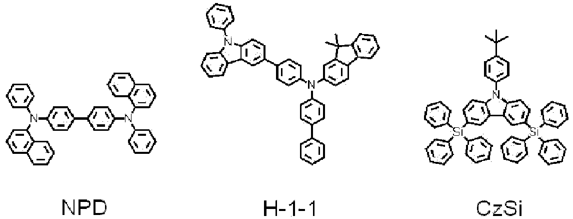

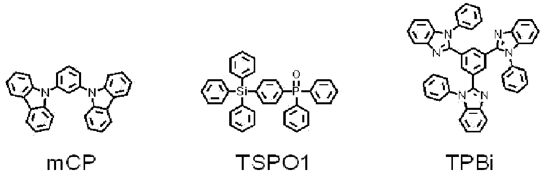

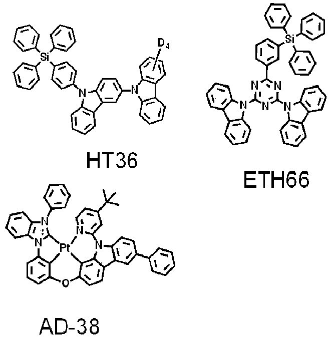

### Evaluation of Properties of Light Emitting Elements

The element efficiency and element lifetime of each of the light emitting elements manufactured by utilizing Compounds 4, 30, 61, 84 and 171 and Comparative Compounds C1 to C4 were evaluated. In Table 1, the evaluation results on each of the light emitting elements of Examples 1 to 5, and Comparative Examples 1 to 4 are shown. For the evaluation of the properties of each of the light emitting elements manufactured in the Examples and Comparative Examples, a driving voltage and a current density were measured utilizing V7000 OLED IVL Test System (Polaronix). For the evaluation of the properties of each of the light emitting elements manufactured in Examples 1 to 5 and Comparative Examples 1 to 4, a driving voltage at a current density of about 10 mA/cm², and efficiency (cd/A) were measured. The time consumed from an initial value of luminance to about 95% luminance deterioration, while continuously driven at a current density of about 10 mA/cm², was regarded as relative element lifetime with respect to Comparative Example 1 (i.e., lifetime ratio (T95)) for evaluation .

**Table 1**

| | Host (second compound: third compound = 5:5) | Fourth compound | First compound | Driving voltage (V) | Efficiency (cd/A) | Emission wavelength (nm) | Lifetime ratio (T95) |
|---|---|---|---|---|---|---|---|
| Example 1 | HT36/ETH66 | AD-38 | Compound 4 | 4.4 | 25.7 | 459 | 6.8 |
| Example 2 | HT36/ETH66 | AD-38 | Compound 30 | 4.4 | 26.5 | 461 | 6.9 |
| Example 3 | HT36/ETH66 | AD-38 | Compound 61 | 4.5 | 26.3 | 462 | 7.3 |
| Example 4 | HT36/ETH66 | AD-38 | Compound 84 | 4.5 | 27.2 | 464 | 6.5 |
| Example 5 | HT36/ETH66 | AD-38 | Compound 171 | 4.5 | 26.8 | 462 | 6.4 |
| Comparative Example 1 | HT36/ETH66 | AD-38 | Comparative Compound C1 | 5.2 | 19.8 | 465 | 1 |
| Comparative Example 2 | HT36/ETH66 | AD-38 | Comparative Compound C2 | 5.1 | 22.1 | 461 | 1.9 |
| Comparative Example 3 | HT36/ETH66 | AD-38 | Comparative Compound C3 | 4.6 | 25.5 | 463 | 4.1 |
| Comparative Example 4 | HT36/ETH66 | AD-38 | Comparative Compound C4 | 4.7 | 22.1 | 463 | 3.7 |

Referring to the results of Table 1, it can be confirmed that the Examples of the light emitting elements utilizing the fused polycyclic compounds according to one or more embodiments of the present disclosure as light emitting materials, each showed a reduced driving voltage, and improved emission efficiency and lifetime characteristics when compared to the Comparative Examples.

Because the Example Compounds each include a first substituent at a nitrogen atom constituting the fused ring, the boron atom may be effectively protected, and high efficiency and long lifetime may be achieved.

The Example Compounds each include the first substituent, which is a dibenzofuran moiety or a dibenzothiophene moiety, connected with the nitrogen atom of the fused ring core having a boron atom as a center. The first substituent is connected with the first nitrogen atom at carbon of position 1 of the dibenzofuran moiety or the dibenzothiophene moiety. In the first substituent, a second substituent which is an aryl group or a heteroaryl group is substituted at carbon of position 2 of the dibenzofuran moiety or the dibenzothiophene moiety. The fused polycyclic compound of one or more embodiments includes the first substituent connected with the first nitrogen atom, and the trigonal planar structure of the boron atom may be effectively maintained through the steric hindrance effects of the first substituent which has a high steric bulkiness. The boron atom has electron-deficient properties due to a vacant p-orbital, and may form a bond with another nucleophile to change its structure to a tetrahedral structure, and this may be a factor deteriorating an element. According to the present disclosure, the fused polycyclic compound of one or more embodiments introduces the first substituent into the fused ring core, and the vacant p-orbital of the boron atom may be effectively protected, and thus, deterioration phenomenon due to the structural deformation may be prevented or reduced. The Example Compounds may have an increased intermolecular distance due to the structure having a large steric hindrance, Dexter energy transfer may be suppressed or reduced, and the deterioration of lifetime induced by the increase of the concentration of triplet excitons may be suppressed or reduced. The light emitting element of one or more embodiments includes the fused polycyclic compound of one or more embodiments as the light emitting dopant of a thermally activated delayed fluorescence (TADF) light emitting element, and high element efficiency may be accomplished, particularly in a blue light wavelength region.

Comparative Example 1 showed the results of a high driving voltage, and deteriorated element lifetime and efficiency in contrast to the Examples. Comparative Compound C1 included in Comparative Example 1 includes a fused ring structure with one boron atom and two nitrogen atoms as a center, but does not include the first substituent suggested in the present disclosure. Accordingly, the sterically protecting effect of the boron atom in a plate-type or kind structure of the fused ring core may be degraded, and intermolecular interaction effect may become difficult to expect. Accordingly, when Comparative Compound C1 was applied to an element, it can be confirmed that the driving voltage was high, and the emission efficiency and lifetime were degraded in contrast to the Examples.

Comparative Example 2 showed the results of a high driving voltage, and deteriorated element lifetime and efficiency in contrast to the Examples. Comparative Compound C2 included in Comparative Example 2 does not include the first substituent suggested in the present disclosure, and the HOMO level of Comparative Compound C2 was shallow by the introduction of a diphenylamine substituent, hole trapping phenomenon was shown, and the increase in driving voltage and the deterioration of lifetime were shown. In the element of Comparative Example 2, including Comparative Compound C2, due to the hole trapping, a Comparative Compound C2 dopant directly produced excitons, and the concentration of triplet excitons was increased to induce the deterioration of lifetime.

Comparative Example 3 and Comparative Example 4 showed the results of high driving voltages, and deteriorated element lifetime and efficiency in contrast to the Examples. Comparative Compounds C3 and C4 included in Comparative Example 3 and Comparative Example 4 have the similar HOMO levels as the Example Compounds through a similar core structure, but do not include the first substituent suggested in the present disclosure. Accordingly, bulky properties were insufficient, the suppressing or reducing of Dexter energy transfer was insufficient, and the elements of Comparative Example 3 and Comparative Example 4 showed particularly deteriorated element lifetime.

The light emitting element of one or more embodiments may show improved element properties of high efficiency and long lifetime.

The fused polycyclic compound of one or more embodiments may be included in the emission layer of a light emitting element and may contribute to the increase of the efficiency and lifetime of the light emitting element.

The display device of one or more embodiments may show excellent or suitable display quality by including the light emitting element of present disclosure.

In present disclosure, "not include a or any 'component'" "exclude a or any 'component'", "'component'-free", and/or the like refers to that the "component" not being added, selected or utilized as a component in a composition, but the "component" of less than a suitable amount may still be included due to other impurities and/or external factors.

Any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

In the present disclosure, when particles (e.g., quantum dots) are spherical, "size" indicates a particle diameter or an average particle diameter, and when the particles are non-spherical, the "size" indicates a major axis length or an average major axis length. The diameter (or size) of the particles may be measured utilizing a scanning electron microscope or a particle size analyzer. As the particle size analyzer, for example, HORIBA, LA-950 laser particle size analyzer, may be utilized. When the size of the particles is measured utilizing a particle size analyzer, the average particle diameter (or size) is referred to as D50. D50 refers to the average diameter (or size) of particles whose cumulative volume corresponds to 50 vol% in the particle size distribution (e.g., cumulative distribution), and refers to the value of the particle size corresponding to 50% from the smallest particle when the total number of particles is 100% in the distribution curve accumulated in the order of the smallest particle size to the largest particle size.

The light-emitting element/device, the display device, the display apparatus, or any other relevant apparatuses/devices or components according to embodiments of the present disclosure described herein may be implemented utilizing any suitable hardware, firmware (e.g., an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure.

## Claims

1. A fused polycyclic compound represented by Formula 1: 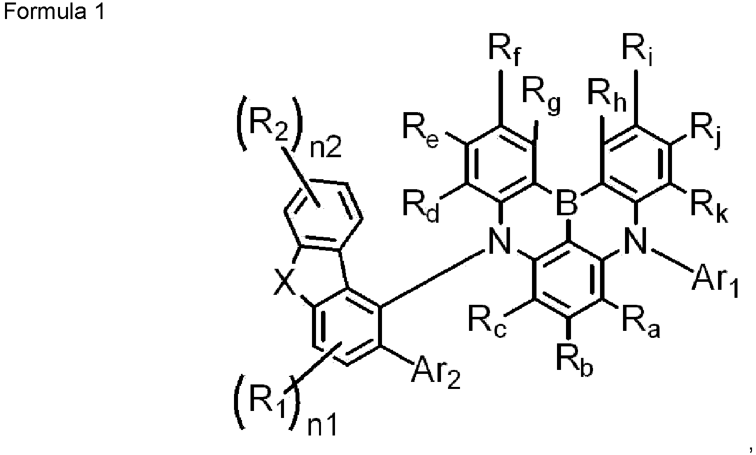 in Formula 1,
X being O or S,
Ar₁ and Ar₂ being each independently a substituted or unsubstituted aryl group of 6 to 30 ring-forming carbon atoms or a substituted or unsubstituted heteroaryl group of 2 to 30 ring-forming carbon atoms,
R₁, R₂, and Rₐ to Rₖ being each independently hydrogen, deuterium, a halogen, a cyano group, a nitro group, a substituted or unsubstituted amine group, a substituted or unsubstituted oxy group, a substituted or unsubstituted thio group, a substituted or unsubstituted boron group, a substituted or unsubstituted silyl group, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms, and/or combined with an adjacent group to form a ring,
n1 being an integer of 0 to 2, and
n2 being an integer of 0 to 4,
wherein the term "substituted" refers to the replacement of hydrogen by one of deuterium, a halogen, a cyano group, a nitro group, an amino group, a silyl group, an oxy group, a thio group, a sulfinyl group, a sulfonyl group, a carbonyl group, a boron group, a phosphine oxide group, a phosphine sulfide group, an alkyl group, an alkenyl group, an alkynyl group, a hydrocarbon ring group, an aryl group, and a heterocyclic group.

2. The fused polycyclic compound of claim 1, wherein the fused polycyclic compound represented by Formula 1 is represented by Formula 2: 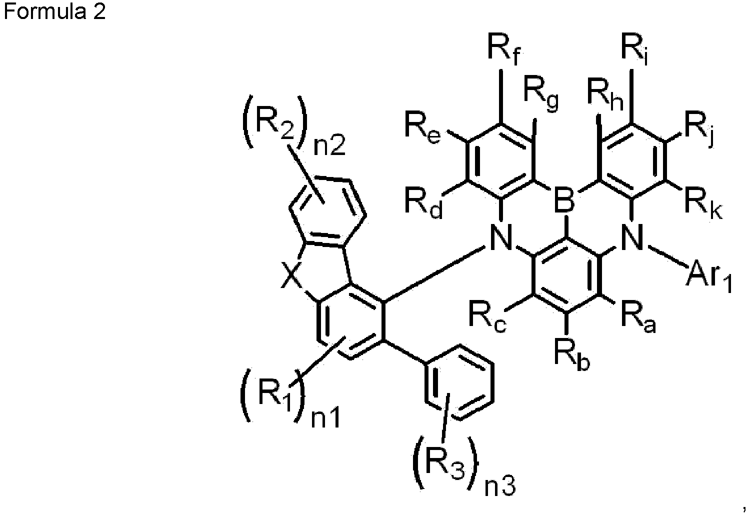 in Formula 2,
R₃ being hydrogen, deuterium, a halogen, a cyano group, a nitro group, a substituted or unsubstituted amine group, a substituted or unsubstituted oxy group, a substituted or unsubstituted thio group, a substituted or unsubstituted boron group, a substituted or unsubstituted silyl group, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms, and/or combined with an adjacent group to form a ring,
n3 being an integer of 0 to 5, and
X, Ar₁, R₁, R₂, Rₐ to Rₖ, n1, and n2 each being the same as defined in Formula 1.

3. The fused polycyclic compound of claim 1, wherein the fused polycyclic compound represented by Formula 1 is represented by Formula 3-1 or Formula 3-2: 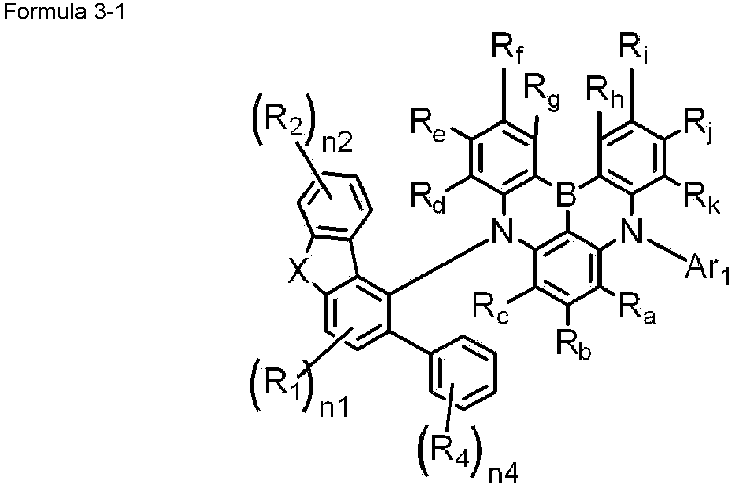 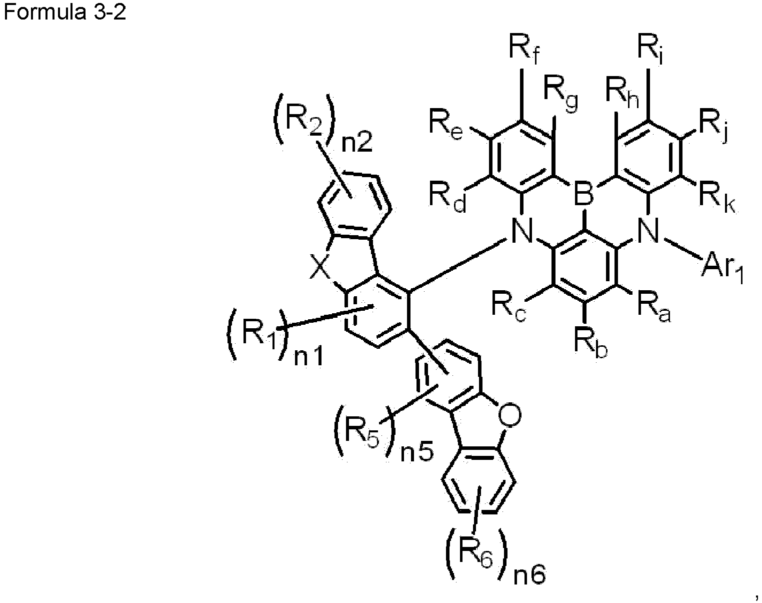 in Formula 3-1 and Formula 3-2,
R₄ to R₆ being each independently hydrogen, deuterium, a halogen, a cyano group, a nitro group, a substituted or unsubstituted amine group, a substituted or unsubstituted oxy group, a substituted or unsubstituted thio group, a substituted or unsubstituted boron group, a substituted or unsubstituted silyl group, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms,
n4 being an integer of 0 to 5,
n5 being an integer of 0 to 3,
n6 is being integer of 0 to 4, and
X, Ar₁, R₁, R₂, Rₐ to Rₖ, n1, and n2 each being the same as defined in Formula 1.

4. The fused polycyclic compound of claim 1, wherein the fused polycyclic compound represented by Formula 1 is represented by Formula 4: 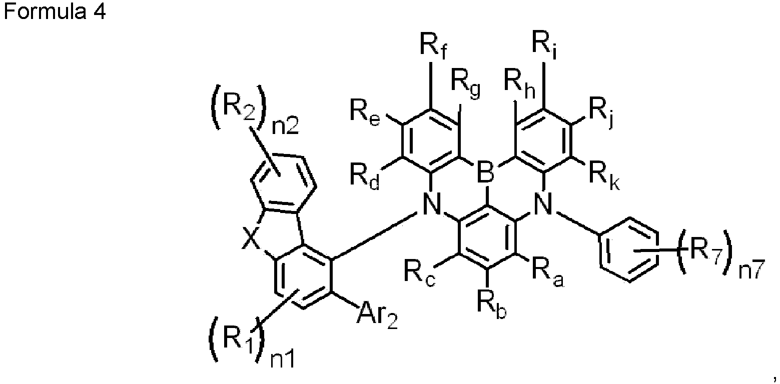 in Formula 4,
R₇ being hydrogen, deuterium, a halogen, a cyano group, a nitro group, a substituted or unsubstituted amine group, a substituted or unsubstituted oxy group, a substituted or unsubstituted thio group, a substituted or unsubstituted boron group, a substituted or unsubstituted silyl group, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms, and/or combined with an adjacent group to form a ring,
n7 being an integer of 0 to 5, and
X, Ar₂, R₁, R₂, Rₐ to Rₖ, n1, and n2 each being the same as defined in Formula 1.

5. The fused polycyclic compound of claim 1, wherein the fused polycyclic compound represented by Formula 1 is represented by Formula 5-1 or Formula 5-2: 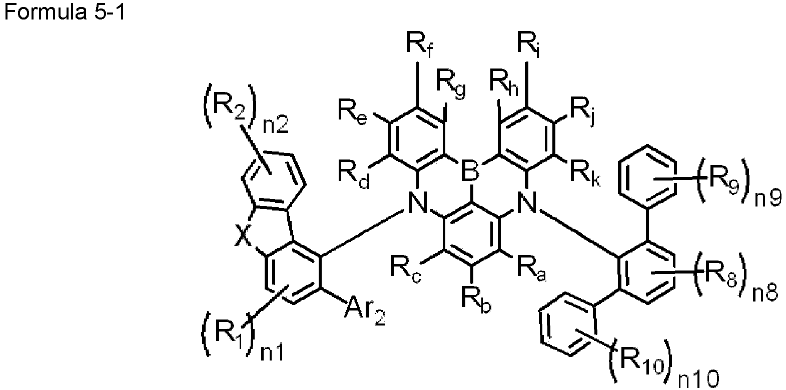 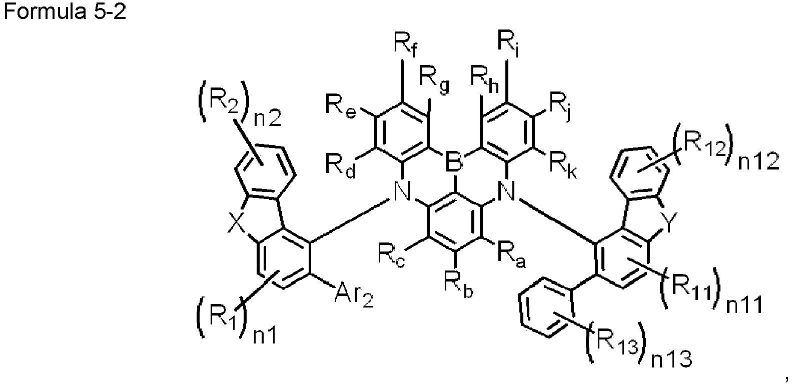 in Formula 5-1 and Formula 5-2,
Y being O or S,
R₈ to R₁₂ being each independently hydrogen, deuterium, a halogen, a cyano group, a nitro group, a substituted or unsubstituted amine group, a substituted or unsubstituted oxy group, a substituted or unsubstituted thio group, a substituted or unsubstituted boron group, a substituted or unsubstituted silyl group, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms,
R₁₃ being hydrogen, deuterium, a halogen, a cyano group, a nitro group, a substituted or unsubstituted amine group, a substituted or unsubstituted oxy group, a substituted or unsubstituted thio group, a substituted or unsubstituted boron group, a substituted or unsubstituted silyl group, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms, and/or combined with an adjacent group to form a ring,
n8 being an integer of 0 to 3,
n12 being an integer of 0 to 4,
n9, n10, and n13 being each independently an integer of 0 to 5,
n11 being an integer of 0 to 2, and
X, Ar₂, R₁, R₂, Rₐ to Rₖ, n1, and n2 each being the same as defined in Formula 1.

6. The fused polycyclic compound of claim 1, wherein the fused polycyclic compound represented by Formula 1 is represented by one selected from among Formula 6-1 to Formula 6-4: 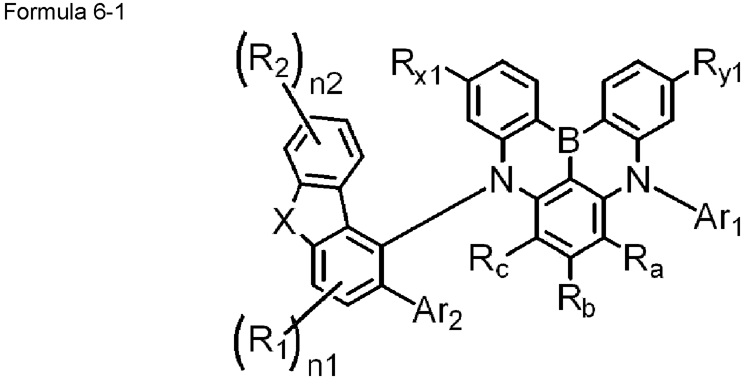 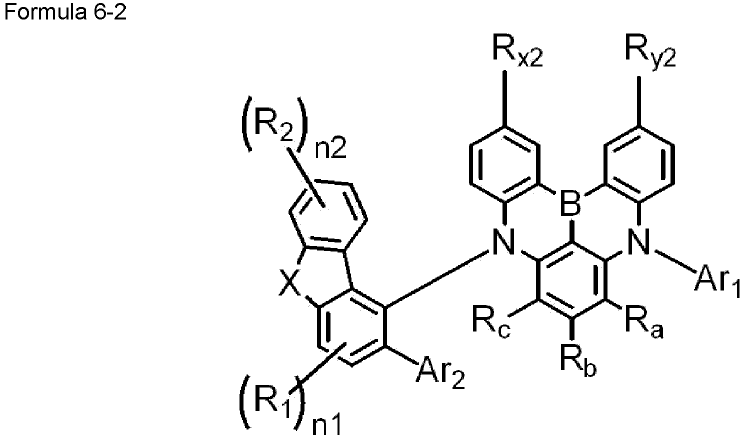 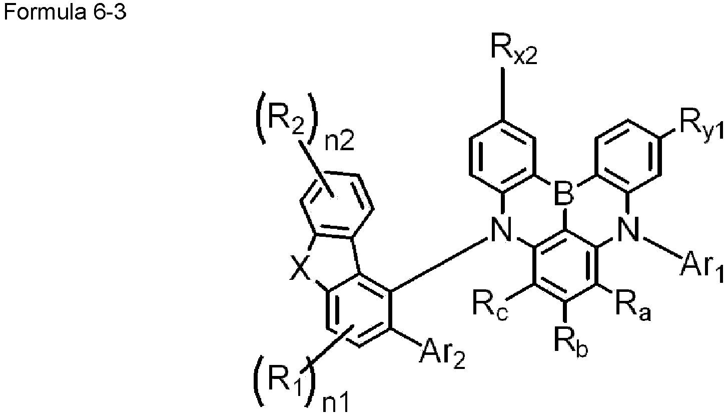 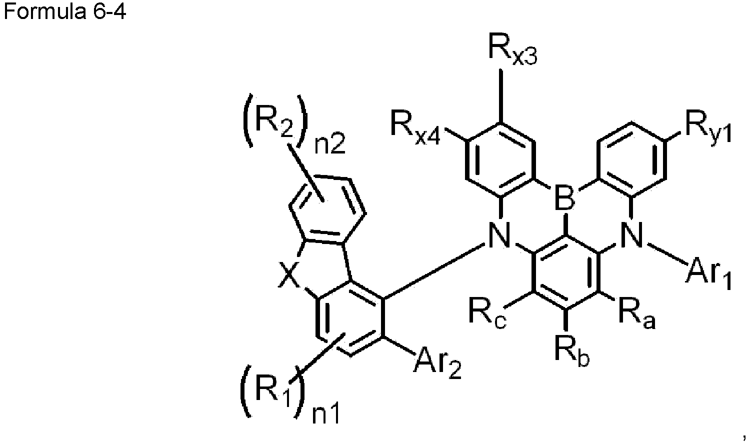 in Formula 6-1 to Formula 6-4,
Rₓ₁, Rₓ₂, R_{y1}, and R_{y2} being each independently deuterium, a halogen, a substituted or unsubstituted amine group, a substituted or unsubstituted silyl group, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms,
Rₓ₃ and Rₓ₄ being each independently deuterium, a halogen, a substituted or unsubstituted amine group, a substituted or unsubstituted silyl group, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms, and/or combined with an adjacent group to form a ring, and
X, Ar₁, Ar₂, R₁, R₂, Rₐ to R_{c}, n1, and n2 each being the same as defined in Formula 1.

7. The fused polycyclic compound of claim 6, wherein, in Formula 6-1 to Formula 6-4, Rₓ₁, Rₓ₂, R_{y1}, and R_{y2} are each independently a substituted or unsubstituted silyl group, a substituted or unsubstituted amine group, a substituted or unsubstituted phenyl group, a substituted or unsubstituted biphenyl group, a substituted or unsubstituted dibenzofuran group, a substituted or unsubstituted N-carbazole group, or a substituted or unsubstituted acridine group.

8. The fused polycyclic compound of claim 1, wherein the fused polycyclic compound represented by Formula 1 is represented by Formula 7: 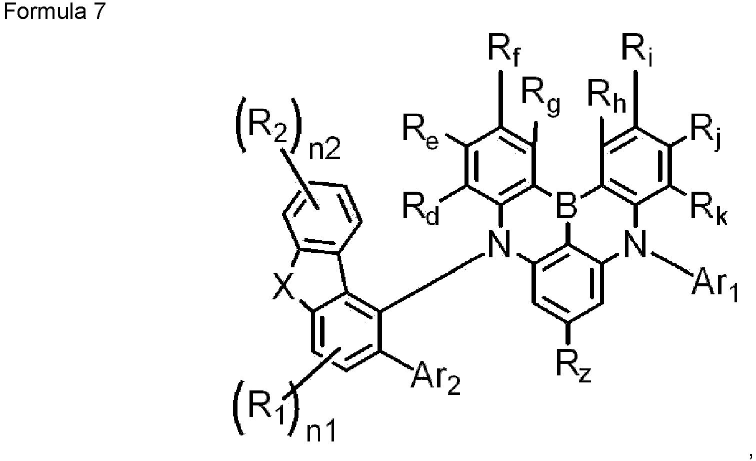 in Formula 7,
R_{z} being deuterium, a halogen, a substituted or unsubstituted amine group, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms, and
X, Ar₁, Ar₂, R₁, R₂, R_{d} to Rₖ, n1, and n2 each being the same as defined in Formula 1.

9. The fused polycyclic compound of claim 8, wherein, in Formula 7,
R_{z} is a substituted or unsubstituted t-butyl group, a substituted or unsubstituted phenyl group, a substituted or unsubstituted biphenyl group, a substituted or unsubstituted terphenyl group, a substituted or unsubstituted dibenzofuran group, a substituted or unsubstituted carbazole group, a substituted or unsubstituted fluorenyl group, a substituted or unsubstituted xanthene group, or a substituted or unsubstituted indolocarbazole group.

10. The fused polycyclic compound of claim 1, wherein the first compound represented by Formula 1 is represented by Formula 8: 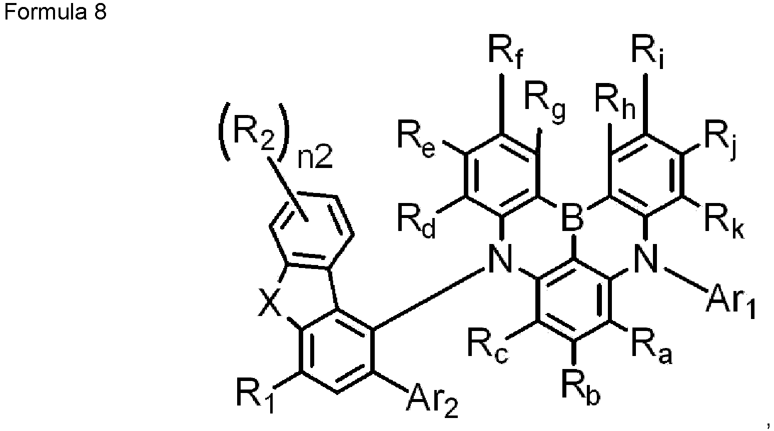 in Formula 8,
X, Ar₁, Ar₂, R₁, R₂, Rₐ to Rₖ, and n2 each being the same as defined in Formula 1.

11. The fused polycyclic compound of claim 1, wherein the fused polycyclic compound represented by Formula 1 is any one selected from among the compounds in Compound Group 1:

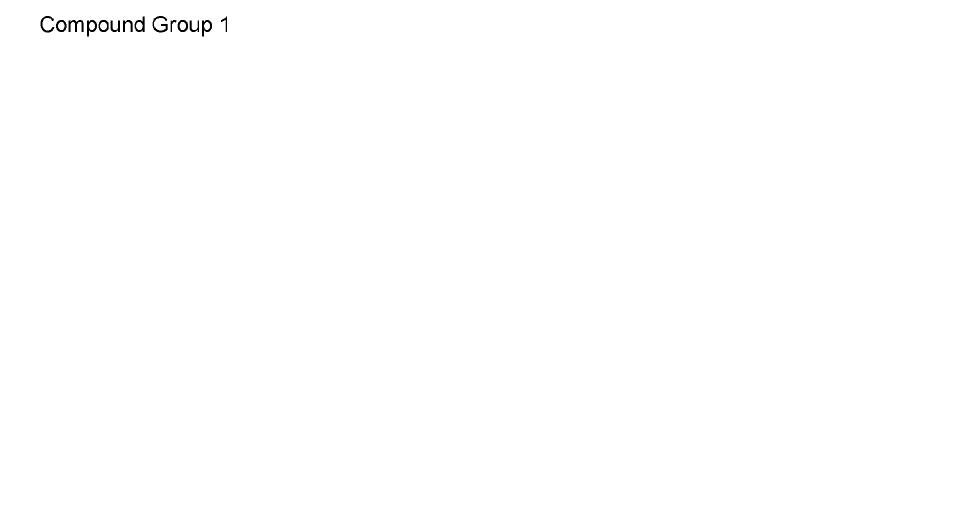

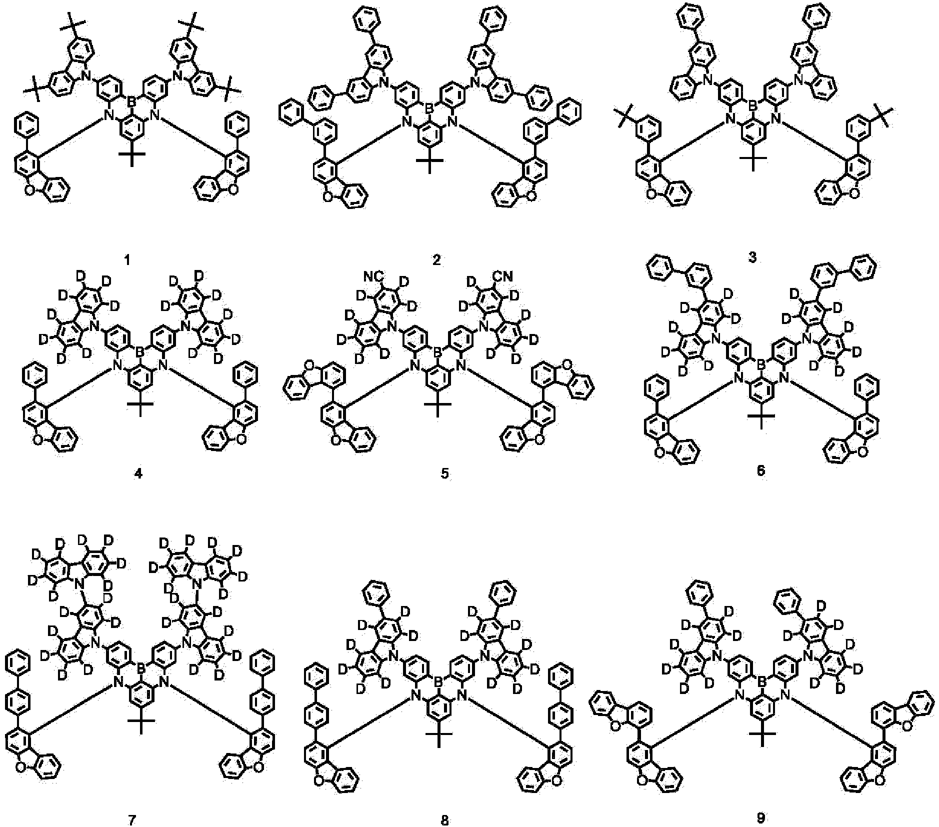

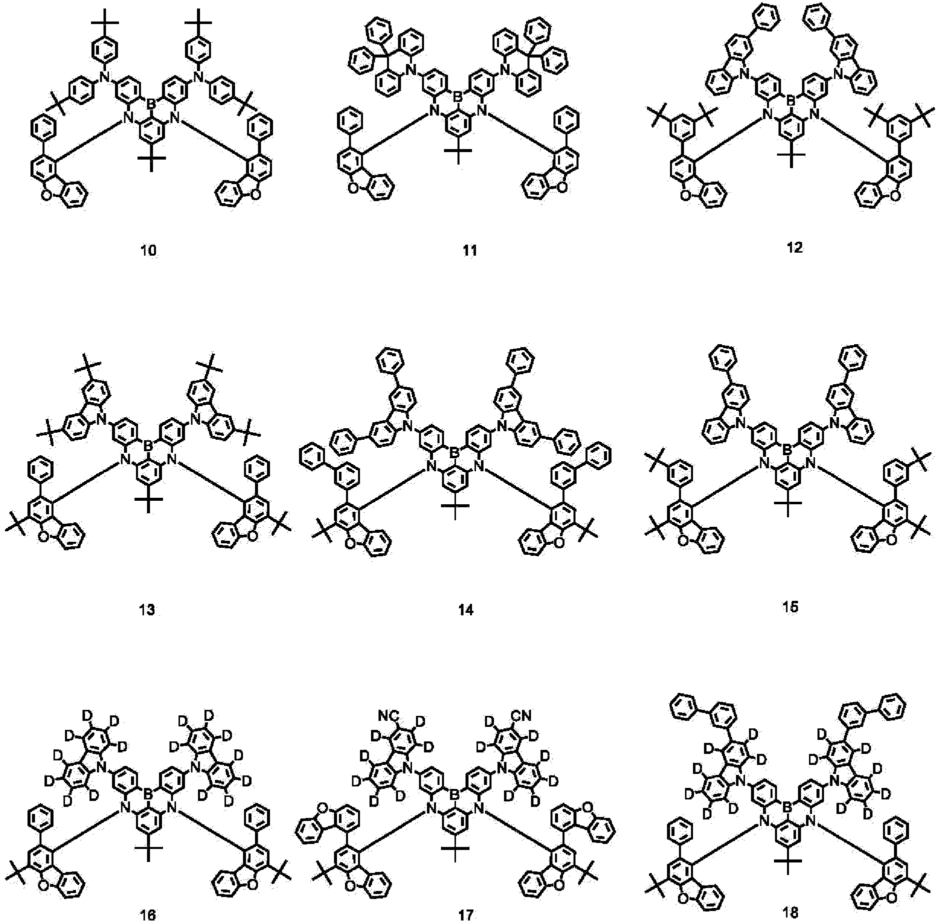

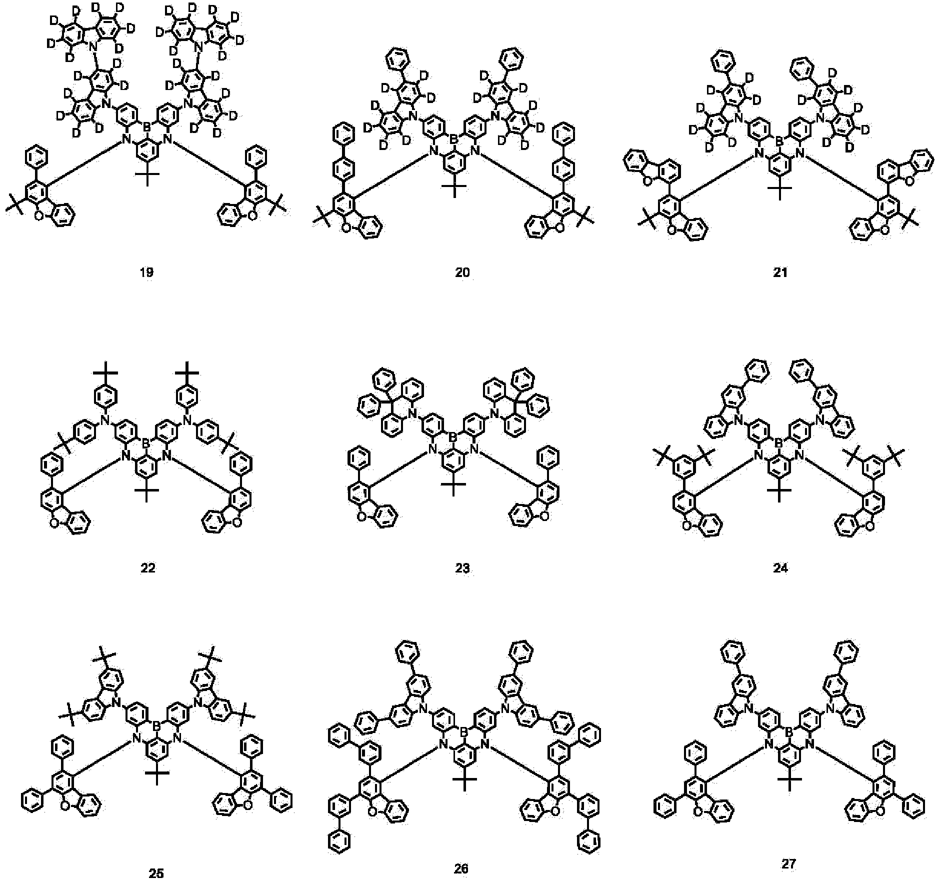

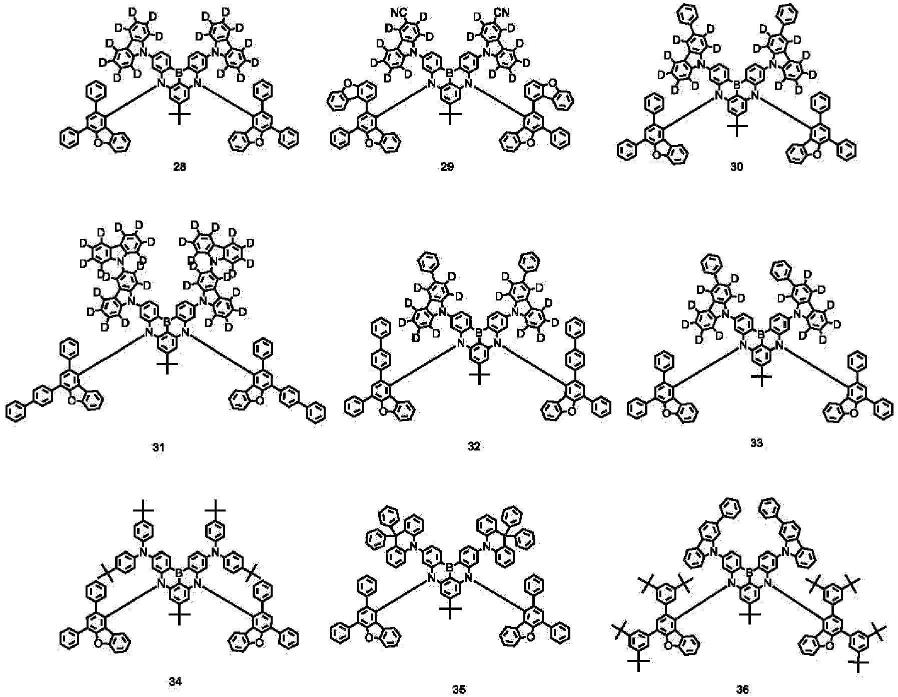

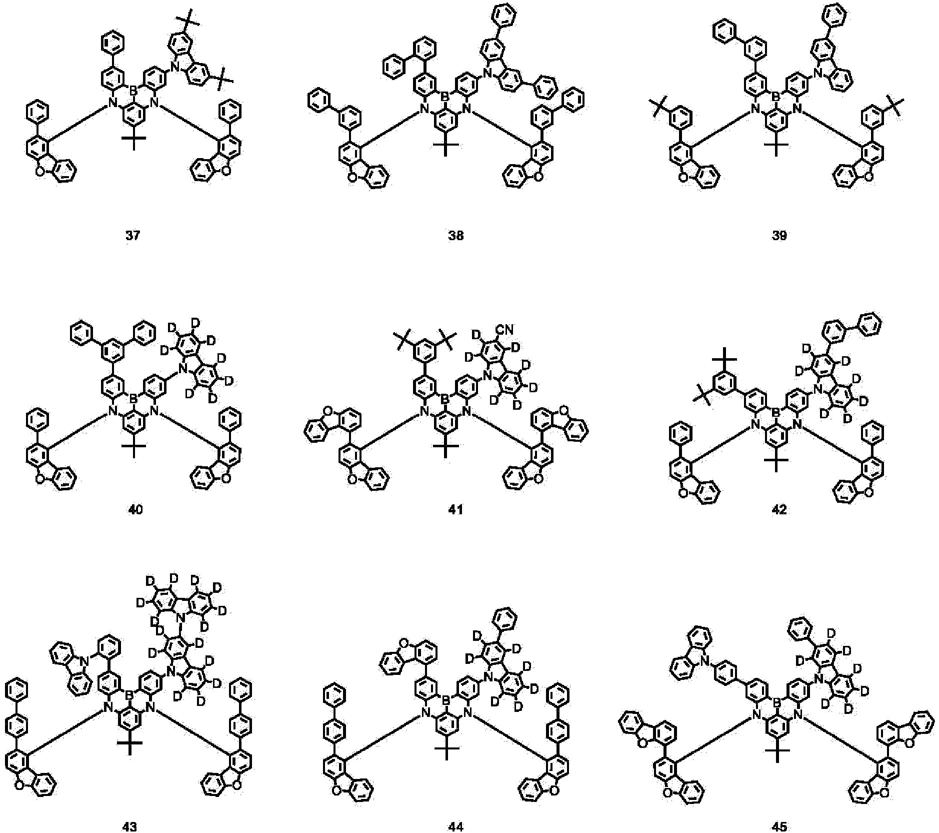

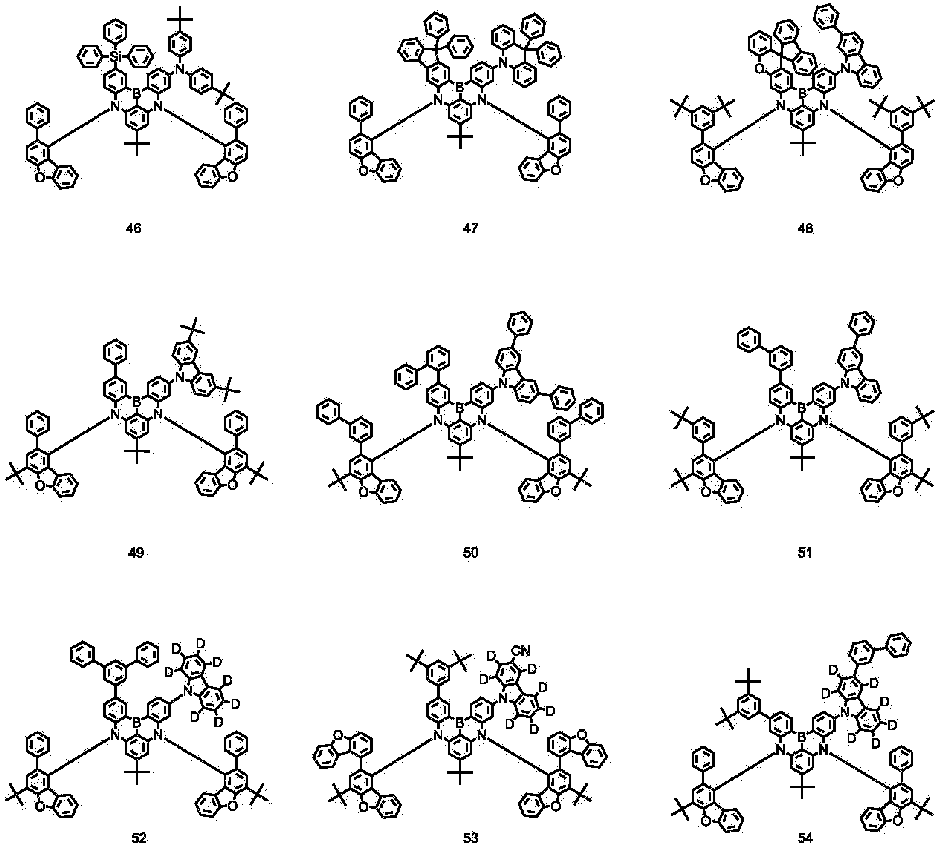

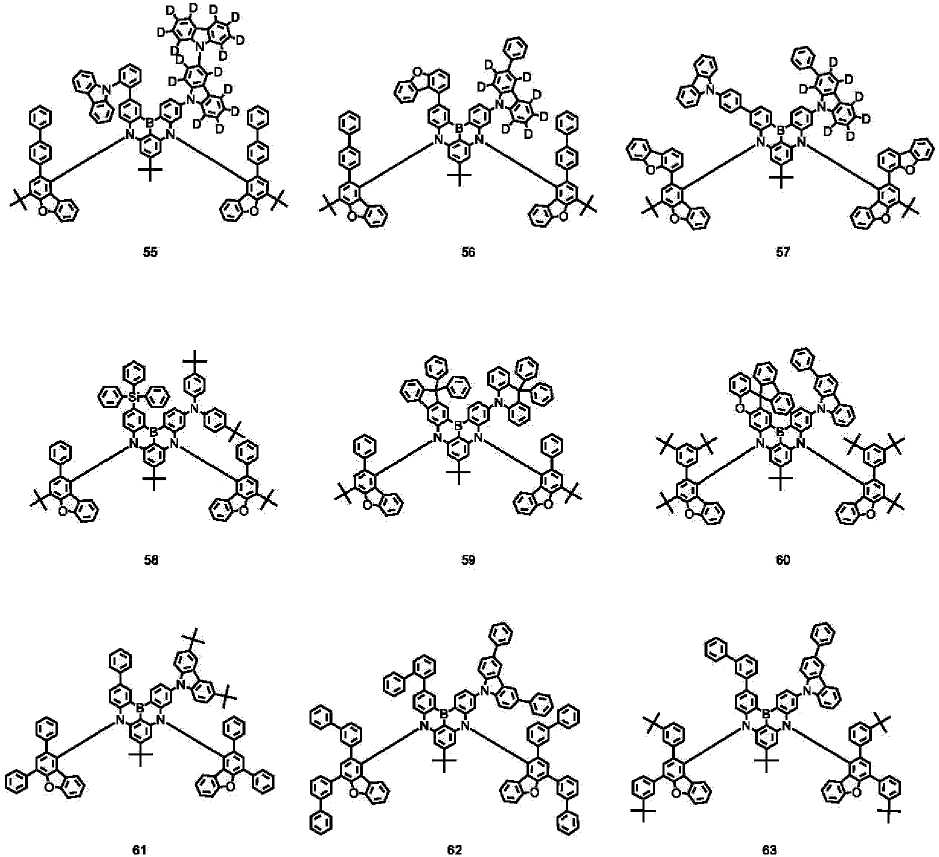

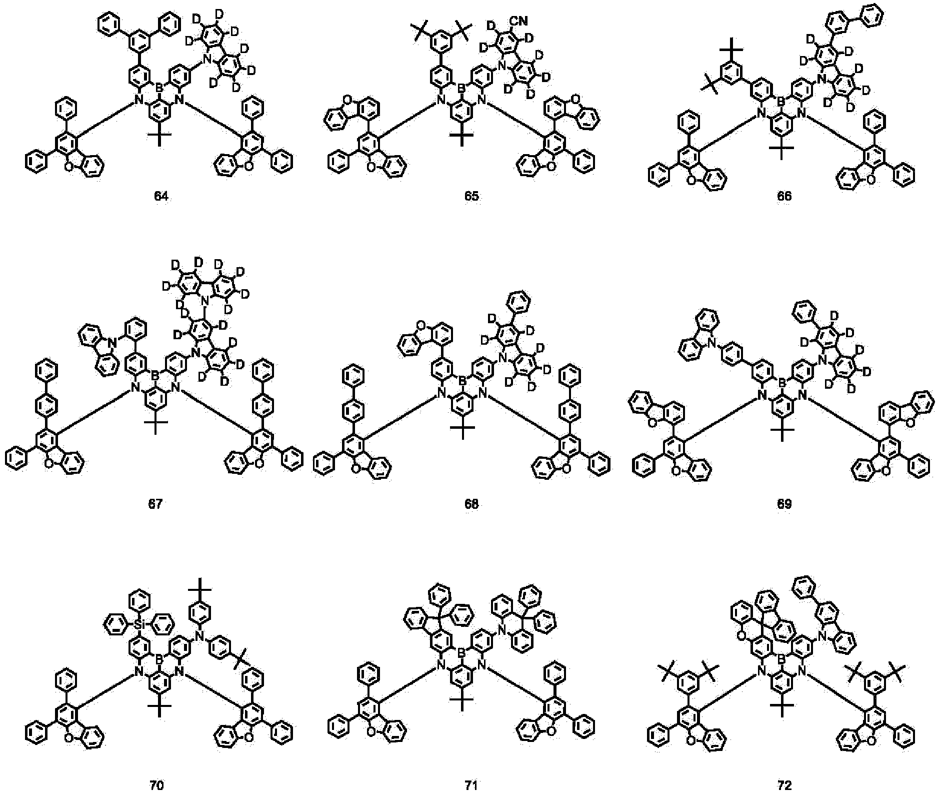

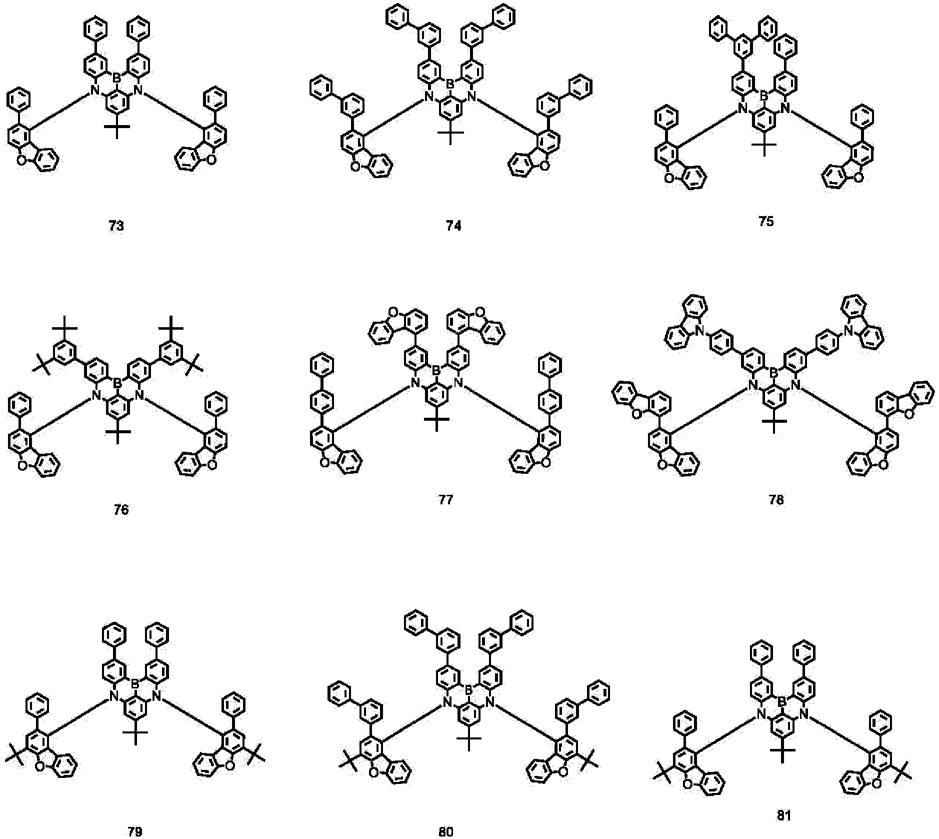

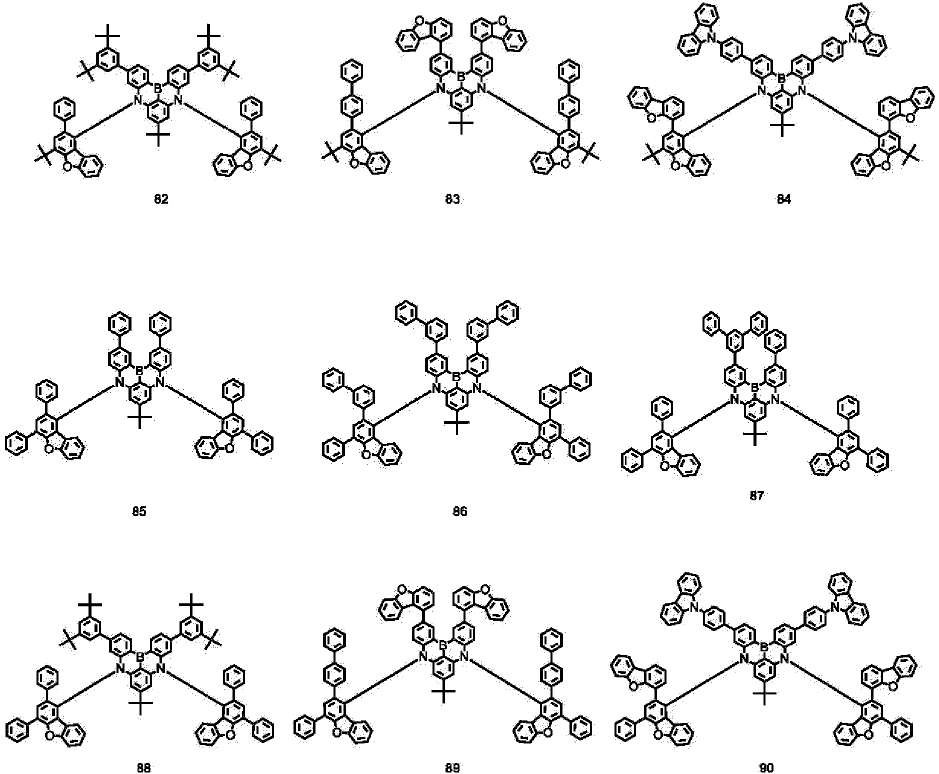

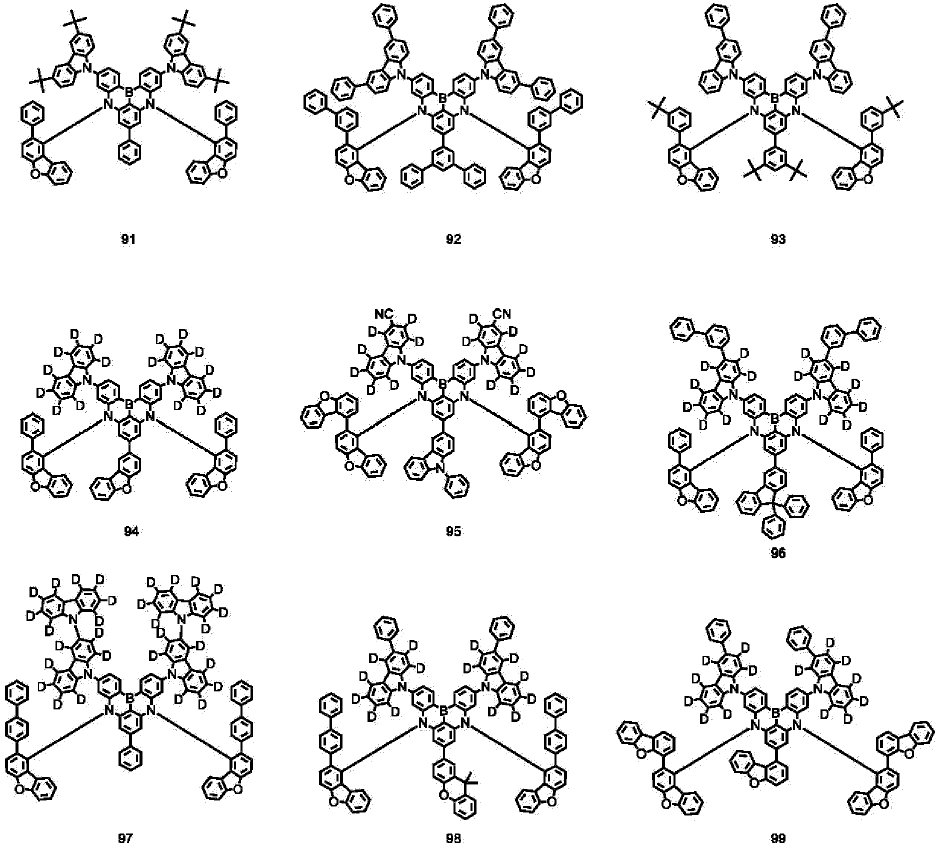

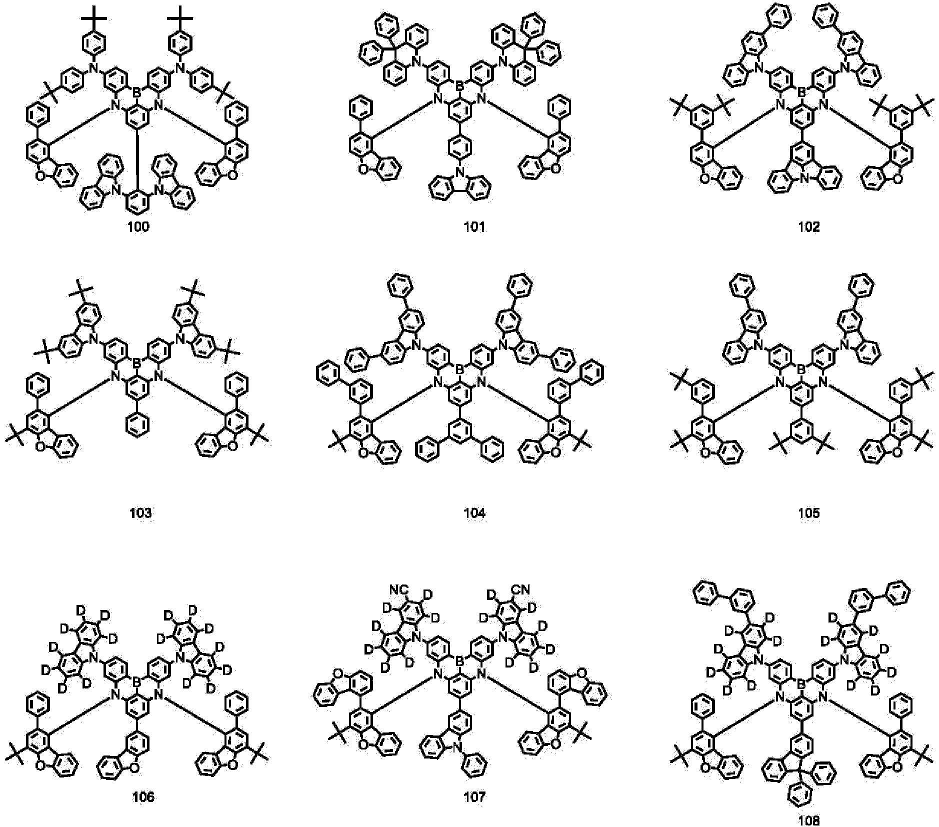

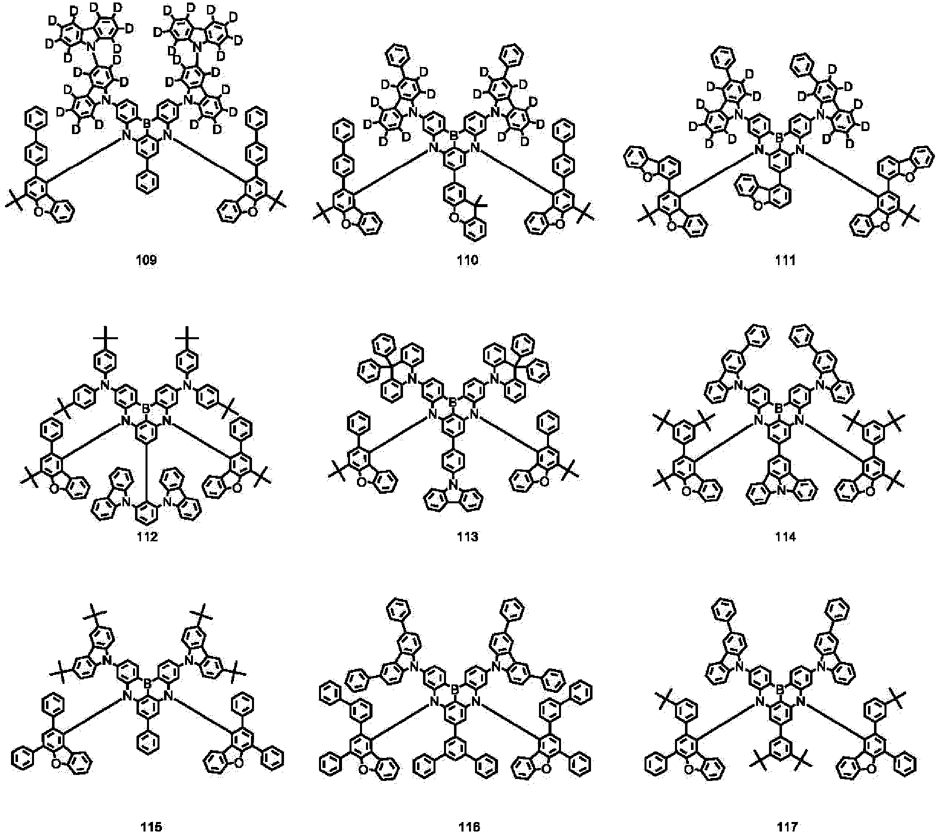

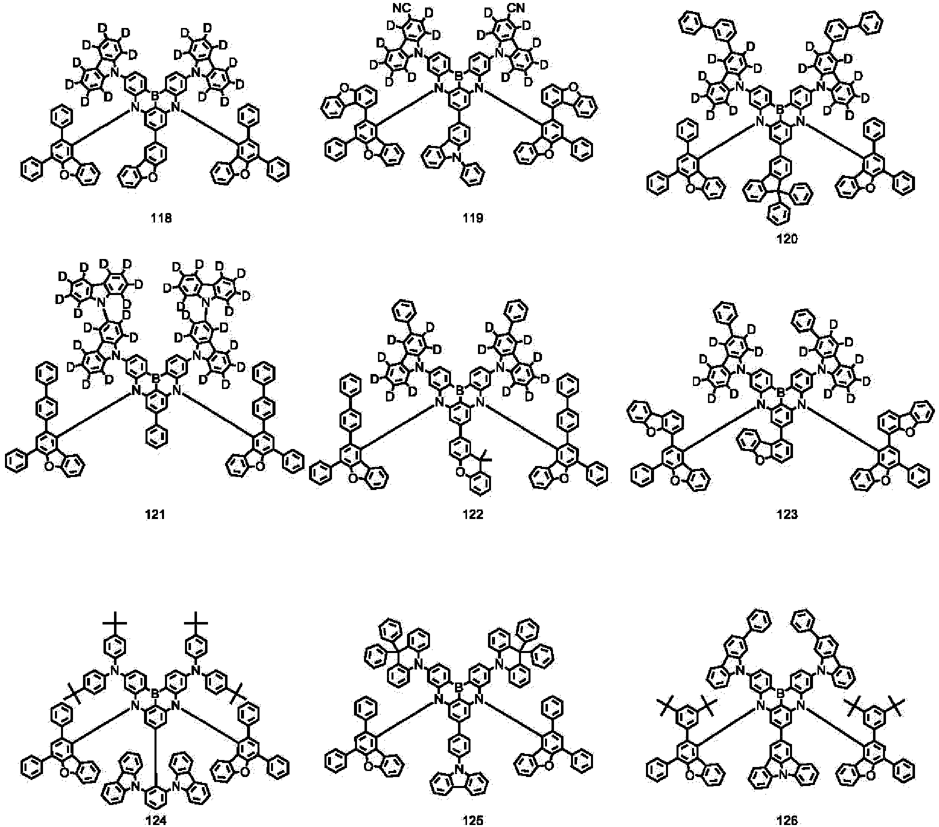

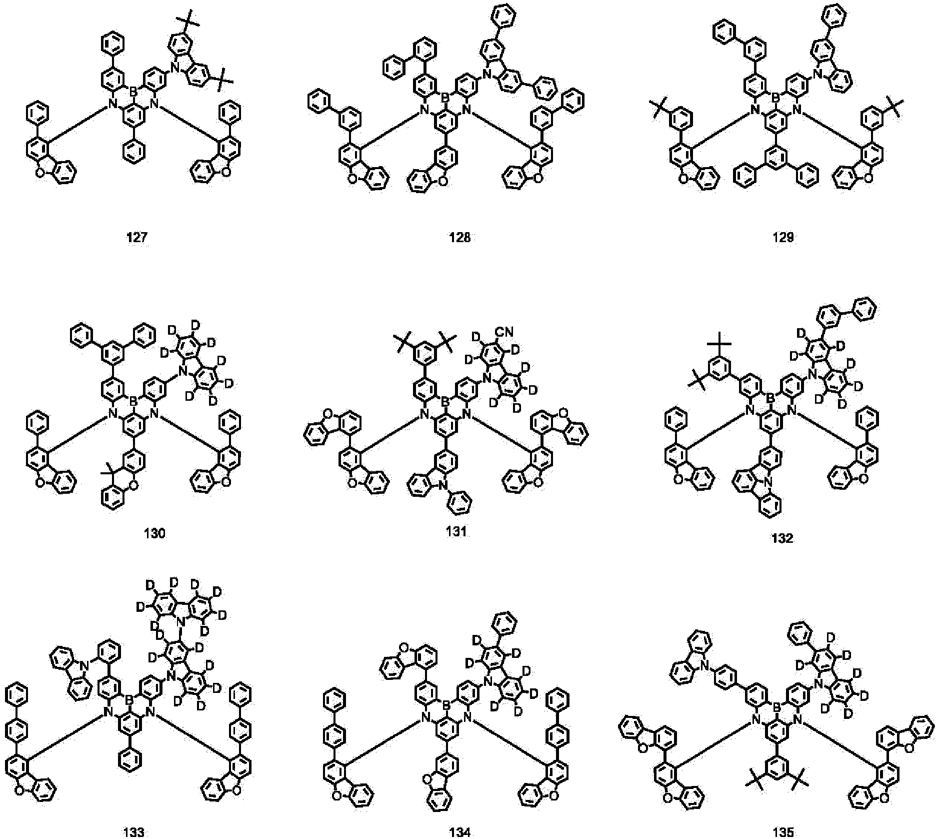

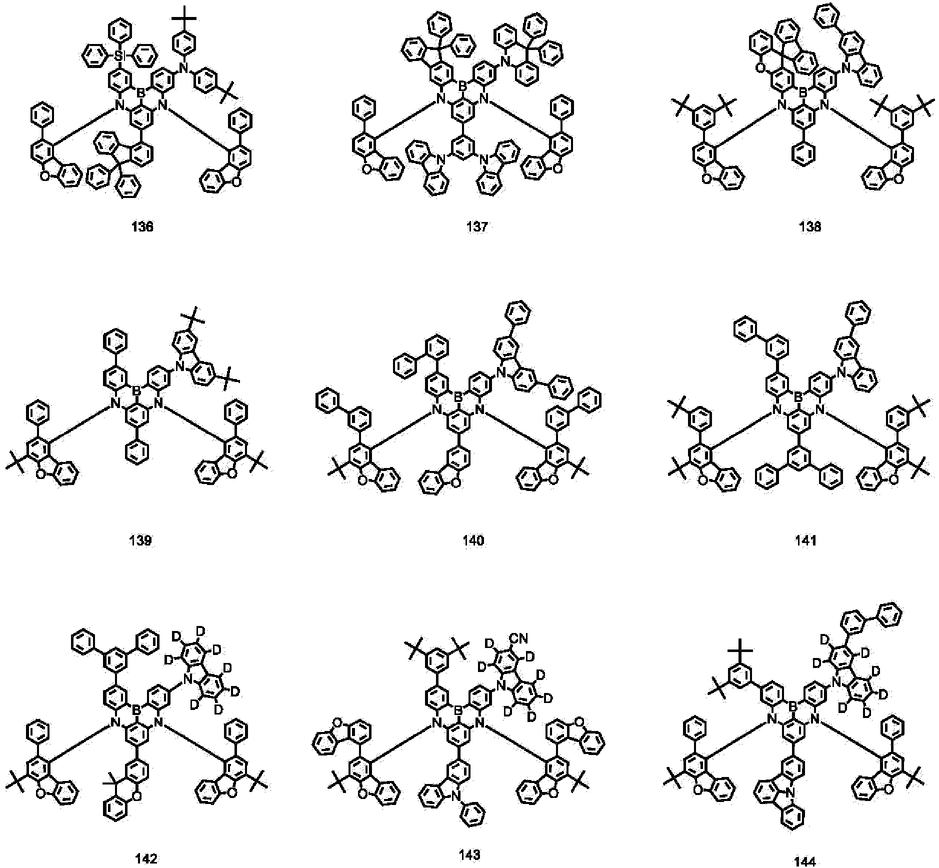

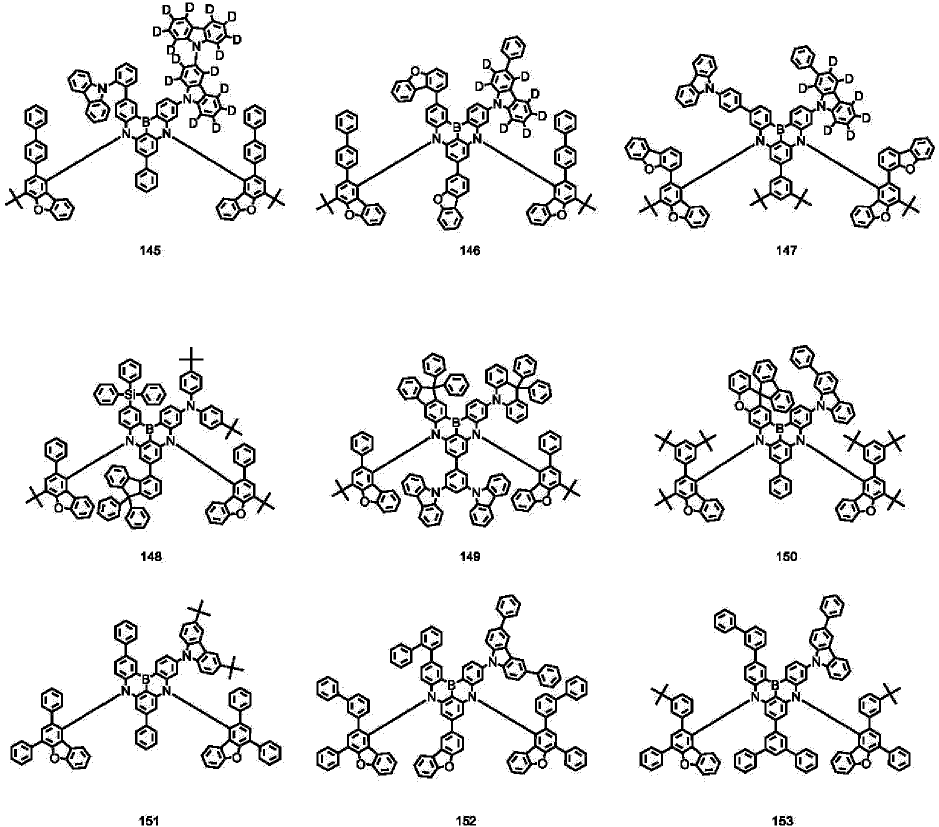

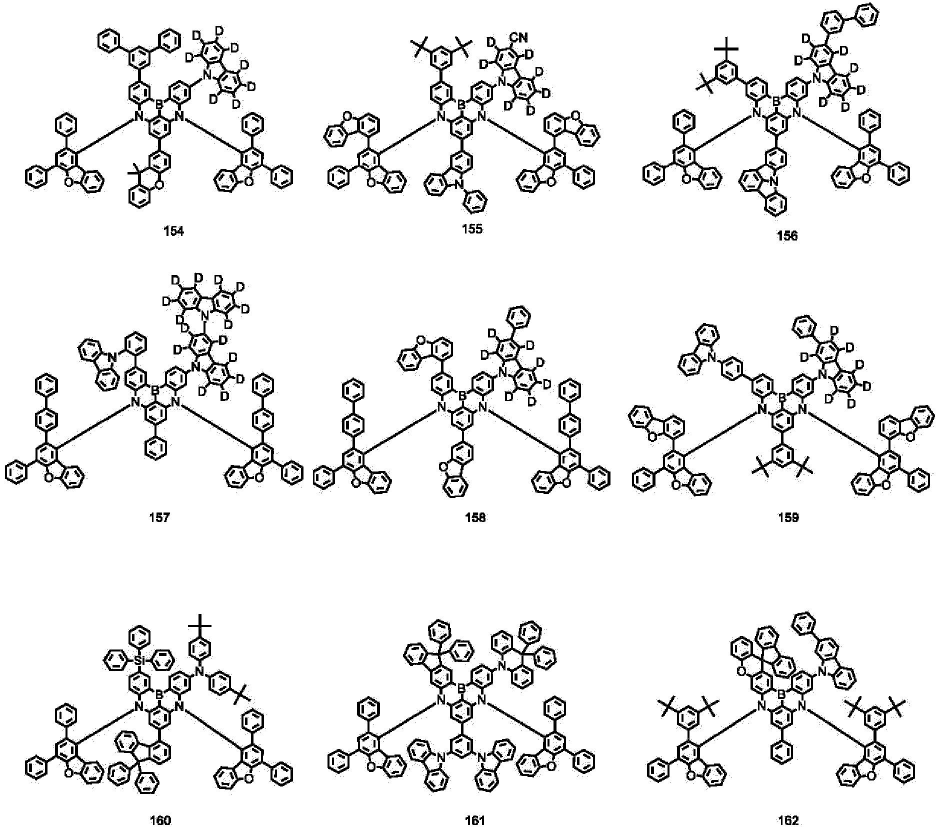

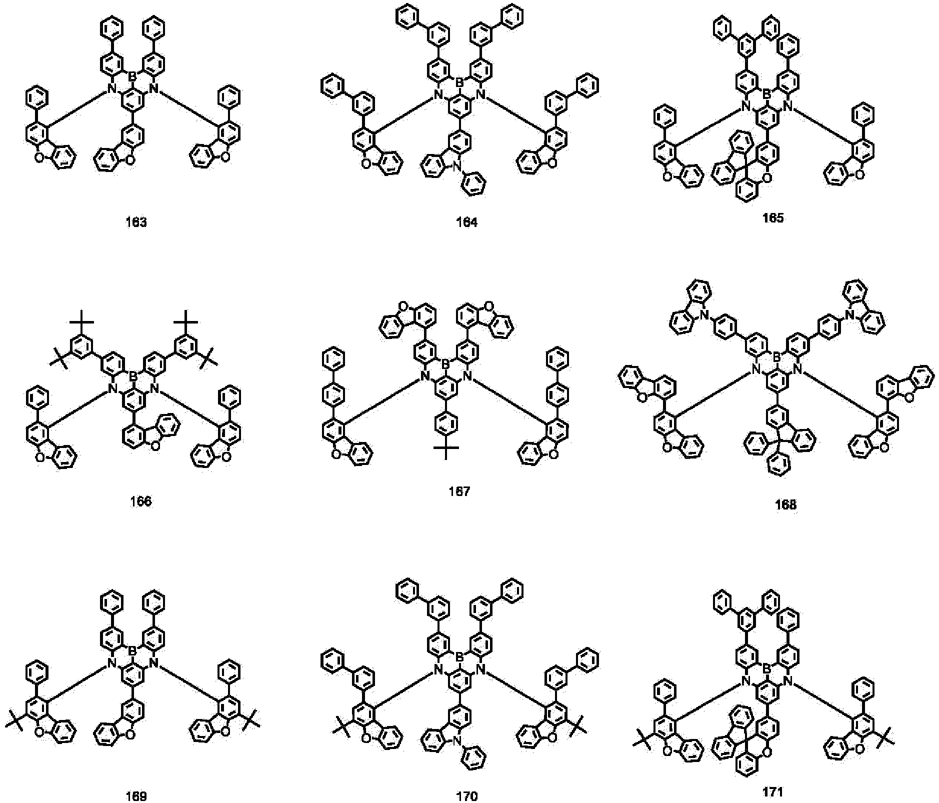

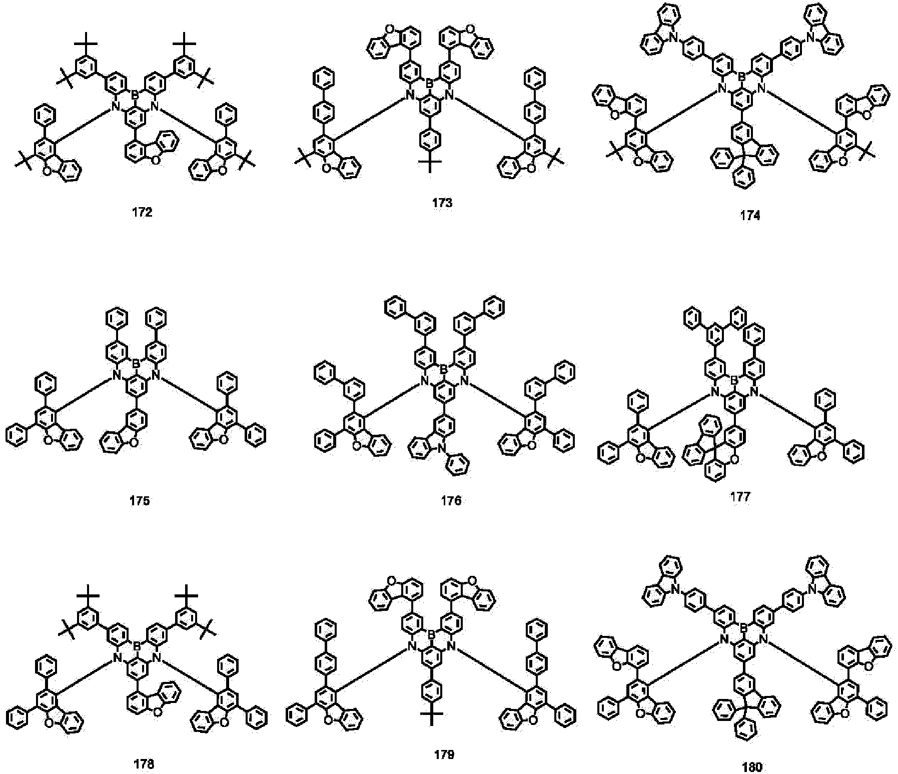

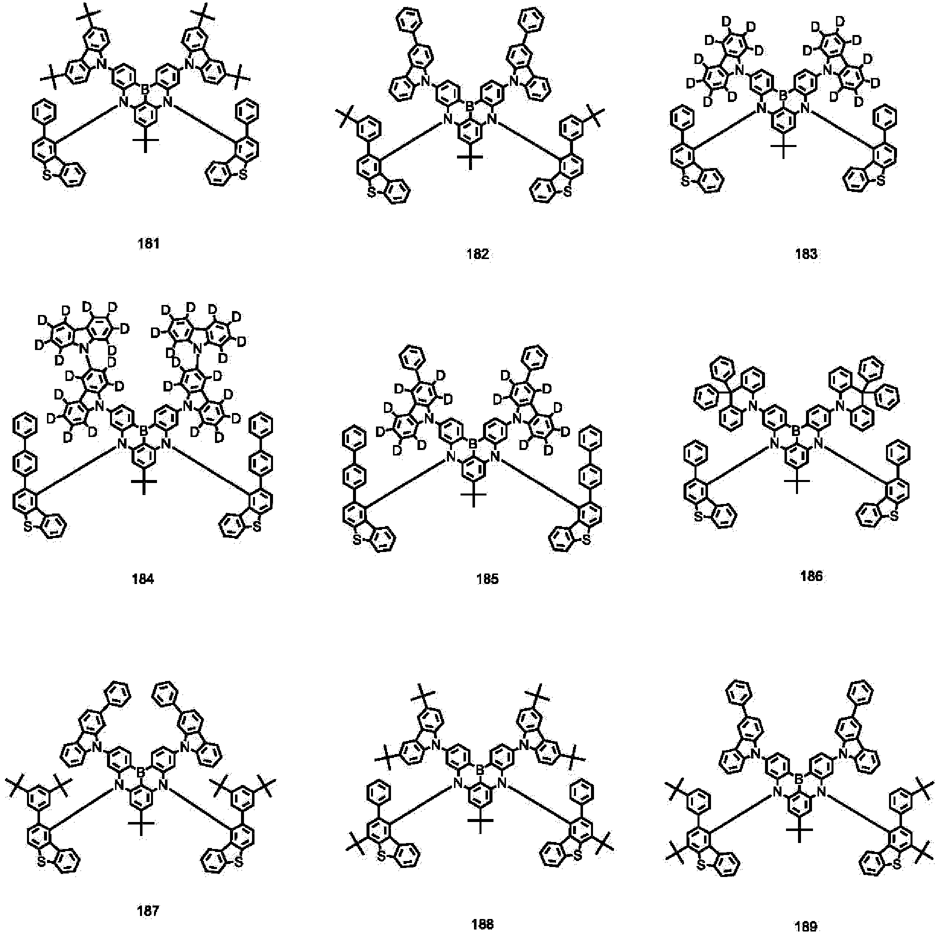

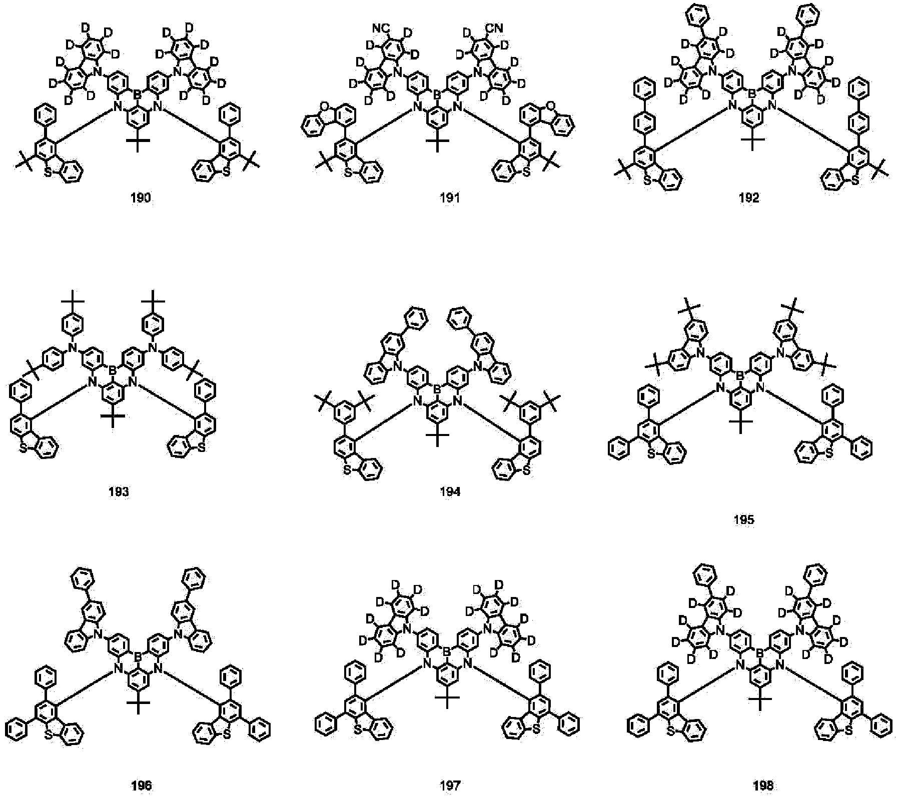

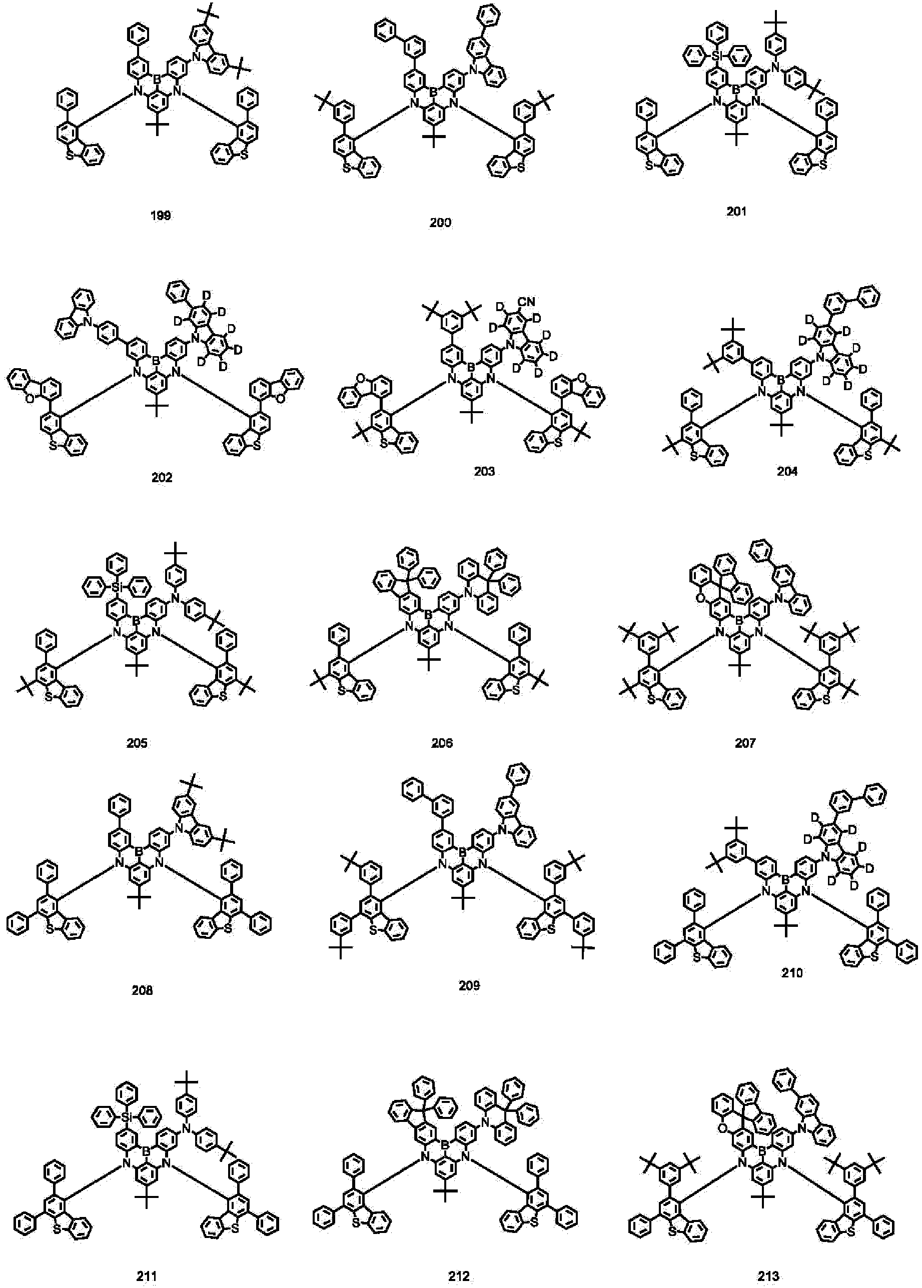

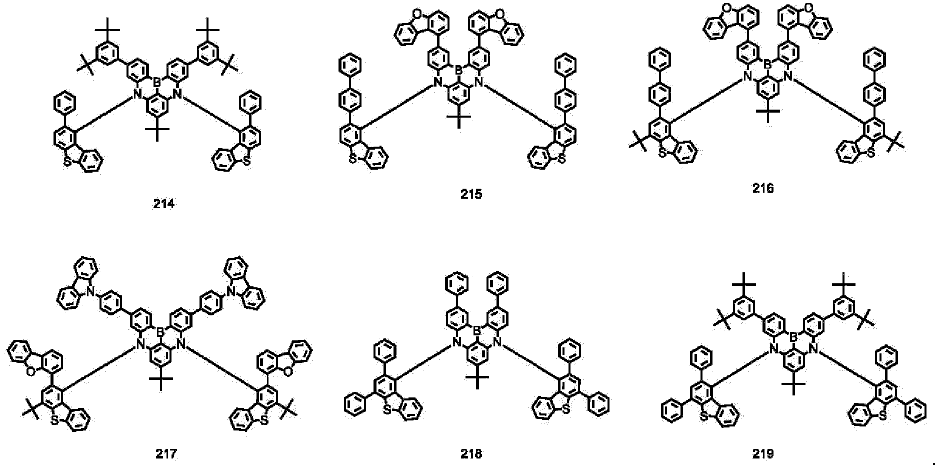

12. A light emitting device (ED) comprising:
a first electrode (EL1);
a second electrode (EL2) facing the first electrode (EL1); and
an emission layer (EML) between the first electrode (EL1) and the second electrode (EL2),
wherein the emission layer (EML) comprises the fused polycyclic compound as a first compound according to any one of claims 1 to 11.

13. The light emitting element (ED) of claim 11, wherein the emission layer (EML) further comprises at least one selected from among a second compound represented by Formula HT-1, a third compound represented by Formula ET-1, and a fourth compound represented by Formula D-1: 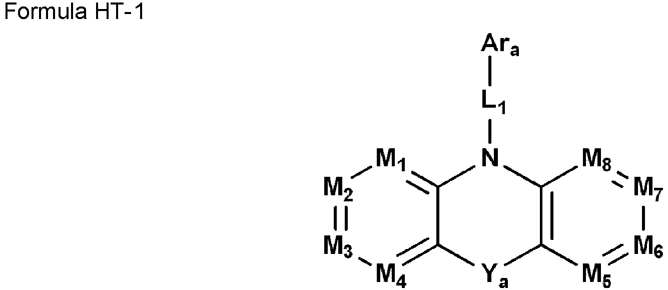 in Formula HT-1,
M₁ to M₈ being each independently N or CR₅₁,
L₁ being a direct linkage, a substituted or unsubstituted arylene group of 6 to 30 ring-forming carbon atoms, or a substituted or unsubstituted heteroarylene group of 2 to 30 ring-forming carbon atoms,
Ya being a direct linkage, CR₅₂R₅₃, or SiR₅₄R₅₅,
Arₐ being a substituted or unsubstituted aryl group of 6 to 30 ring-forming carbon atoms or a substituted or unsubstituted heteroaryl group of 2 to 30 ring-forming carbon atoms, and
R₅₁ to R₅₅ being each independently hydrogen, deuterium, a halogen, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group of 1 to 20 carbon atoms, a substituted or unsubstituted alkenyl group of 2 to 20 carbon atoms, a substituted or unsubstituted aryl group of 6 to 60 ring-forming carbon atoms, or a substituted or unsubstituted heteroaryl group of 2 to 60 ring-forming carbon atoms, and/or combined with an adjacent group to form a ring; 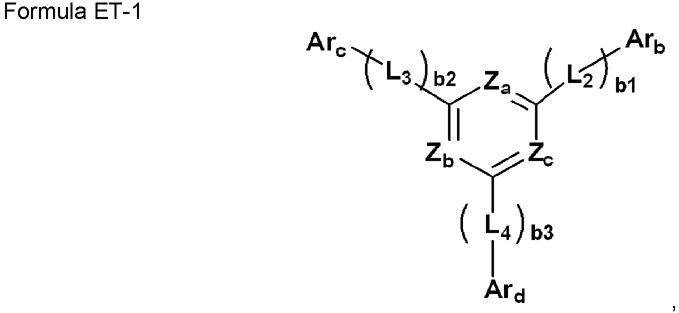 in Formula ET-1,
at least one selected from among Zₐ to Z_{c} being N, and the remainder being CR₅₆,
R₅₆ being hydrogen, deuterium, a substituted or unsubstituted alkyl group of 1 to 20 carbon atoms, a substituted or unsubstituted aryl group of 6 to 60 ring-forming carbon atoms, or a substituted or unsubstituted heteroaryl group of 2 to 60 ring-forming carbon atoms,
b1 to b3 being each independently an integer of 0 to 10,
Ar_{b} to Ar_{d} being each independently hydrogen, deuterium, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms, and
L₂ to L₄ being each independently a direct linkage, a substituted or unsubstituted arylene group of 6 to 30 ring-forming carbon atoms, or a substituted or unsubstituted heteroarylene group of 2 to 30 ring-forming carbon atoms; and 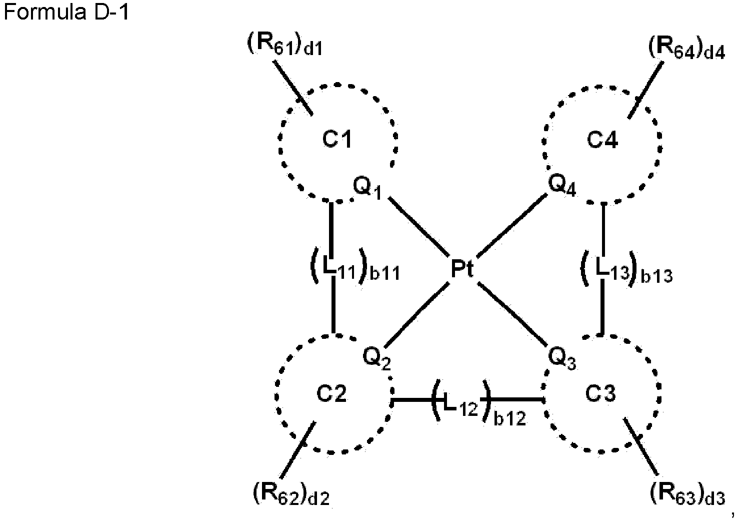 in Formula D-1,
Q₁ to Q₄ being each independently C or N,
C1 to C4 being each independently a substituted or unsubstituted hydrocarbon ring of 5 to 30 ring-forming carbon atoms, or a substituted or unsubstituted heterocycle of 2 to 30 ring-forming carbon atoms,
L₁₁ to L₁₃ being each independently a direct linkage, *-O-*, *-S-*, 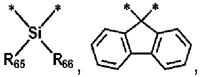
a substituted or unsubstituted alkylene group of 1 to 20 carbon atoms, a substituted or unsubstituted arylene group of 6 to 30 ring-forming carbon atoms, or a substituted or unsubstituted heteroarylene group of 2 to 30 ring-forming carbon atoms,
b11 to b13 being each independently 0 or 1,
R₆₁ to R₆₆ being each independently hydrogen, deuterium, a halogen, a cyano group, a substituted or unsubstituted silyl group, a substituted or unsubstituted thio group, a substituted or unsubstituted oxy group, a substituted or unsubstituted amine group, a substituted or unsubstituted boron group, a substituted or unsubstituted alkyl group of 1 to 20 carbon atoms, a substituted or unsubstituted alkenyl group of 2 to 20 carbon atoms, a substituted or unsubstituted aryl group of 6 to 60 ring-forming carbon atoms, or a substituted or unsubstituted heteroaryl group of 2 to 60 ring-forming carbon atoms, and
d1 to d4 being each independently an integer of 0 to 4.

14. A display panel (DP) comprising:
a base layer (BS);
a circuit layer (DP-CL) on the base layer (BS); and
a display device layer (DP-ED) on the circuit layer (DP-CL) and comprising a light emitting element (ED) as defined in claim 12.

15. The display panel (DP) of claim 14, wherein the display panel (DP) further comprises a light control layer (CCL) on the display device layer (DP-ED) and comprising a quantum dot, the light emitting element being configured to emit first color light, and
the light control layer (CCL) comprises:
a first light control part (CCP1) comprising a first quantum dot (QD1) converting first color light into second color light in a wavelength region longer than the first color light;
a second light control part (CCP2) comprising a second quantum dot (QD2) converting the first color light into third color light in a wavelength region longer than the first color light and the second color light; and
a third light control part (CCP3) configured to transmit the first color light.

## Patentansprüche

1. Verschmolzene polyzyklische Verbindung, dargestellt durch Formel 1: 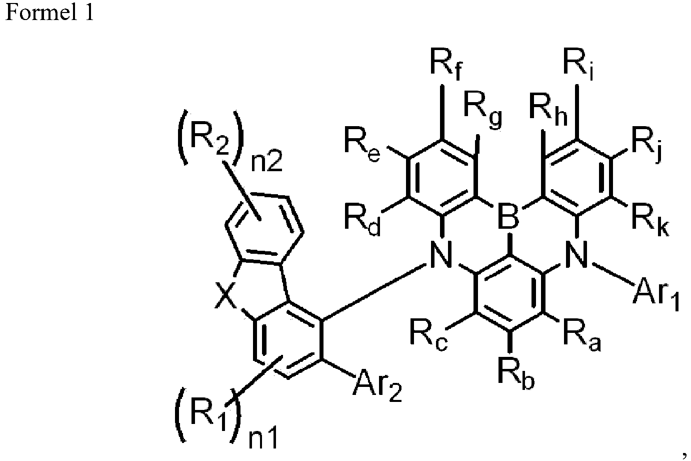 wobei in Formel 1
X O oder S ist,
Ar₁ und Ar₂ jeweils unabhängig voneinander eine substituierte oder unsubstituierte Arylgruppe mit 6 bis 30 ringbildenden Kohlenstoffatomen oder eine substituierte oder unsubstituierte Heteroarylgruppe mit 2 bis 30 ringbildenden Kohlenstoffatomen sind,
R₁, R₂ und Rₐ bis Rₖ jeweils unabhängig voneinander Wasserstoff, Deuterium, ein Halogen, eine Cyanogruppe, eine Nitrogruppe, eine substituierte oder unsubstituierte Amingruppe, eine substituierte oder unsubstituierte Oxygruppe, eine substituierte oder unsubstituierte Thiogruppe, eine substituierte oder unsubstituierte Borgruppe, eine substituierte oder unsubstituierte Silylgruppe, eine substituierte oder unsubstituierte Alkylgruppe mit 1 bis 20 Kohlenstoffatomen, eine substituierte oder unsubstituierte Arylgruppe mit 6 bis 30 ringbildenden Kohlenstoffatomen oder eine substituierte oder unsubstituierte Heteroarylgruppe mit 2 bis 30 ringbildenden Kohlenstoffatomen sind und/oder mit einer benachbarten Gruppe unter Bildung eines Rings kombiniert sind, wobei n1 eine ganze Zahl von 0 bis 2 und n2 eine ganze Zahl von 0 bis 4 ist, wobei der Begriff "substituiert" den Ersatz von Wasserstoff durch eines von Deuterium, einem Halogen, einer Cyanogruppe, einer Nitrogruppe, einer Aminogruppe, einer Silylgruppe, einer Oxygruppe, einer Thiogruppe, einer Sulfinylgruppe, einer Sulfonylgruppe, einer Carbonylgruppe, einer Borgruppe, einer Phosphinoxidgruppe, einer Phosphinsulfidgruppe, einer Alkylgruppe, einer Alkenylgruppe, einer Alkinylgruppe, einer Kohlenwasserstoffringgruppe, einer Arylgruppe und einer heterocyclischen Gruppe.

2. Verschmolzene polyzyklische Verbindung nach Anspruch 1, wobei die durch Formel 1 dargestellte verschmolzene polyzyklische Verbindung durch Formel 2 dargestellt wird: 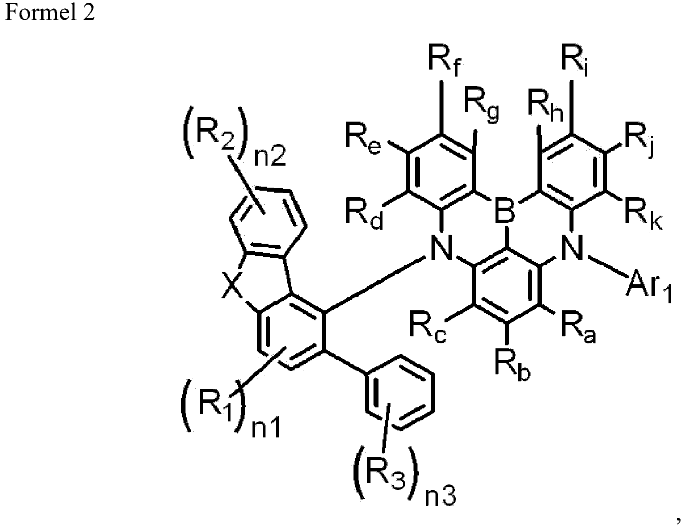 wobei in Formel 2
R₃ Wasserstoff, Deuterium, ein Halogen, eine Cyanogruppe, eine Nitrogruppe, eine substituierte oder unsubstituierte Amingruppe, eine substituierte oder unsubstituierte Oxygruppe, eine substituierte oder unsubstituierte Thiogruppe, eine substituierte oder unsubstituierte Borgruppe, eine substituierte oder unsubstituierte Silylgruppe, eine substituierte oder unsubstituierte Alkylgruppe mit 1 bis 20 Kohlenstoffatomen, eine substituierte oder unsubstituierte Arylgruppe mit 6 bis 30 ringbildenden Kohlenstoffatomen oder eine substituierte oder unsubstituierte Heteroarylgruppe mit 2 bis 30 ringbildenden Kohlenstoffatomen ist und/oder mit einer benachbarten Gruppe unter Bildung eines Rings kombiniert ist, wobei n3 eine ganze Zahl von 0 bis 5 ist, und
X, Ar₁, R₁, R₂, Rₐ bis Rₖ, n1 and n2 jeweils die gleichen wie in der Formel 1 definiert sind.

3. Verschmolzene polyzyklische Verbindung nach Anspruch 1, wobei die durch Formel 1 dargestellte verschmolzene polyzyklische Verbindung durch Formel 3-1 oder Formel 3-2 dargestellt wird: 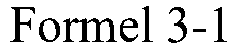 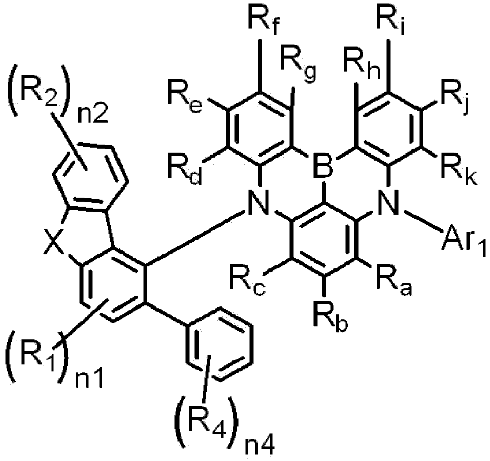 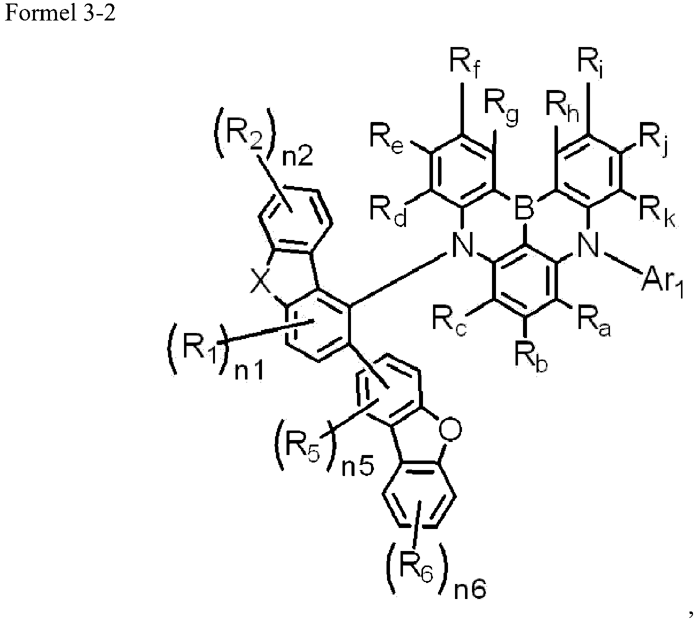 wobei in Formel 3-1 und Formel 3-2
R₄ bis R₆ jeweils unabhängig voneinander Wasserstoff, Deuterium, ein Halogen, eine Cyanogruppe, eine Nitrogruppe, eine substituierte oder unsubstituierte Amingruppe, eine substituierte oder unsubstituierte Oxygruppe, eine substituierte oder unsubstituierte Thiogruppe, eine substituierte oder unsubstituierte Borgruppe, eine substituierte oder unsubstituierte Silylgruppe, eine substituierte oder unsubstituierte Alkylgruppe mit 1 bis 20 Kohlenstoffatomen, eine substituierte oder unsubstituierte Arylgruppe mit 6 bis 30 ringbildenden Kohlenstoffatomen oder eine substituierte oder unsubstituierte Heteroarylgruppe mit 2 bis 30 ringbildenden Kohlenstoffatomen sind,
n4 eine ganze Zahl von 0 bis 5 ist,
n5 eine ganze Zahl von 0 bis 3 ist, n6 eine ganze Zahl von 0 bis 4 ist und
X, Ar₁, R₁, R₂, Rₐ bis Rₖ, n1 und n2 jeweils die gleichen wie in der Formel 1 definiert sind.

4. Verschmolzene polyzyklische Verbindung nach Anspruch 1, wobei die durch Formel 1 dargestellte verschmolzene polyzyklische Verbindung durch Formel 4 dargestellt wird: 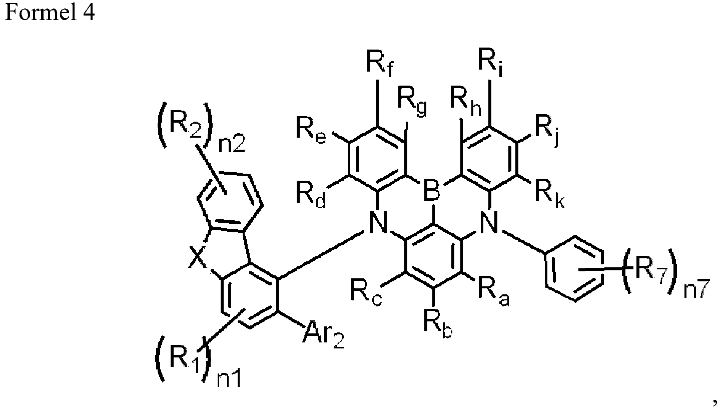 wobei in Formel 4
R₇ Wasserstoff, Deuterium, ein Halogen, eine Cyanogruppe, eine Nitrogruppe, eine substituierte oder unsubstituierte Amingruppe, eine substituierte oder unsubstituierte Oxygruppe, eine substituierte oder unsubstituierte Thiogruppe, eine substituierte oder unsubstituierte Borgruppe, eine substituierte oder unsubstituierte Silylgruppe, eine substituierte oder unsubstituierte Alkylgruppe mit 1 bis 20 Kohlenstoffatomen, eine substituierte oder unsubstituierte Arylgruppe mit 6 bis 30 ringbildenden Kohlenstoffatomen oder eine substituierte oder unsubstituierte Heteroarylgruppe mit 2 bis 30 ringbildenden Kohlenstoffatomen ist und/oder mit einer benachbarten Gruppe unter Bildung eines Rings kombiniert ist,
n7 eine ganze Zahl von 0 bis 5 ist und
X, Ar₂, R₁, R₂, Rₐ bis Rₖ, n1 und n2 jeweils die gleichen wie in der Formel 1 definiert sind.

5. Verschmolzene polyzyklische Verbindung nach Anspruch 1, wobei die durch Formel 1 dargestellte verschmolzene polyzyklische Verbindung durch Formel 5-1 oder Formel 5-2 dargestellt wird: 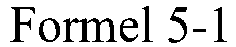 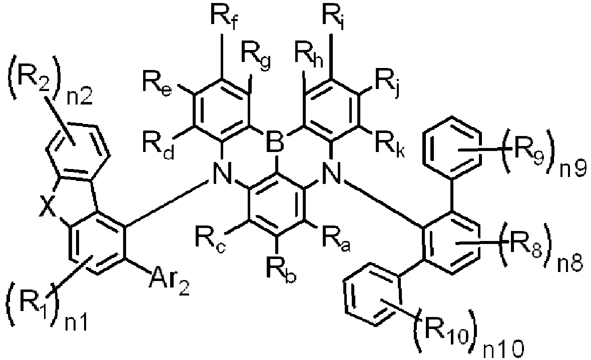 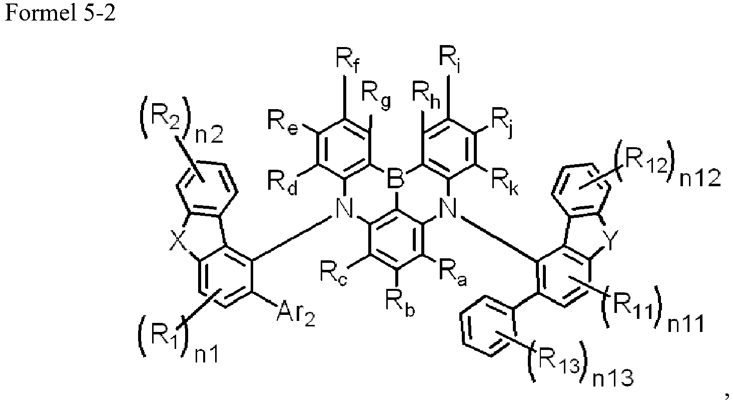 wobei in Formel 5-1 und Formel 5-2,
Y O oder S ist,
R₈ bis R₁₂ jeweils unabhängig voneinander Wasserstoff, Deuterium, ein Halogen, eine Cyanogruppe, eine Nitrogruppe, eine substituierte oder unsubstituierte Amingruppe, eine substituierte oder unsubstituierte Oxygruppe, eine substituierte oder unsubstituierte Thiogruppe, eine substituierte oder unsubstituierte Borgruppe, eine substituierte oder unsubstituierte Silylgruppe, eine substituierte oder unsubstituierte Alkylgruppe mit 1 bis 20 Kohlenstoffatomen, eine substituierte oder unsubstituierte Arylgruppe mit 6 bis 30 ringbildenden Kohlenstoffatomen oder eine substituierte oder unsubstituierte Heteroarylgruppe mit 2 bis 30 ringbildenden Kohlenstoffatomen sind,
R₁₃ Wasserstoff, Deuterium, ein Halogen, eine Cyanogruppe, eine Nitrogruppe, eine substituierte oder unsubstituierte Amingruppe, eine substituierte oder unsubstituierte Oxygruppe, eine substituierte oder unsubstituierte Thiogruppe, eine substituierte oder unsubstituierte Borgruppe, eine substituierte oder unsubstituierte Silylgruppe, eine substituierte oder unsubstituierte Alkylgruppe mit 1 bis 20 Kohlenstoffatomen, eine substituierte oder unsubstituierte Arylgruppe mit 6 bis 30 ringbildenden Kohlenstoffatomen oder eine substituierte oder unsubstituierte Heteroarylgruppe mit 2 bis 30 ringbildenden Kohlenstoffatomen ist und/oder mit einer benachbarten Gruppe unter Bildung eines Rings kombiniert ist, wobei n8 eine ganze Zahl von 0 bis 3 und n12 eine ganze Zahl von 0 bis 4 ist,
n9, n10 und n13 jeweils unabhängig voneinander eine ganze Zahl von 0 bis 5 sind,
n11 eine ganze Zahl von 0 bis 2 ist, und
X, Ar₂, R₁, R₂, Rₐ bis Rₖ, n1 und n2 jeweils die gleichen wie in der Formel 1 definiert sind.

6. Verschmolzene polyzyklische Verbindung nach Anspruch 1, wobei die durch Formel 1 dargestellte verschmolzene polyzyklische Verbindung durch eine aus Formel 6-1 bis Formel 6-4 ausgewählte Formel dargestellt wird: 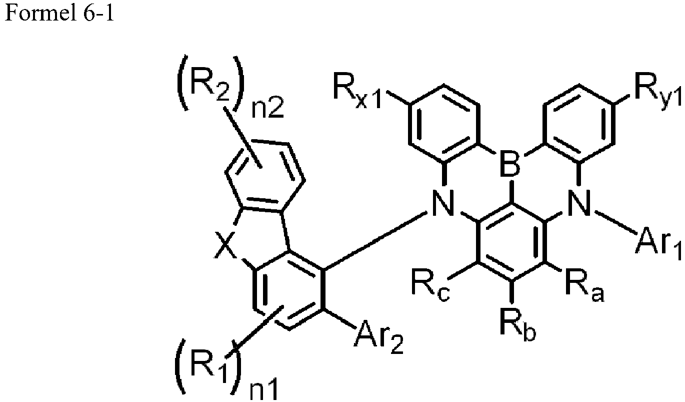 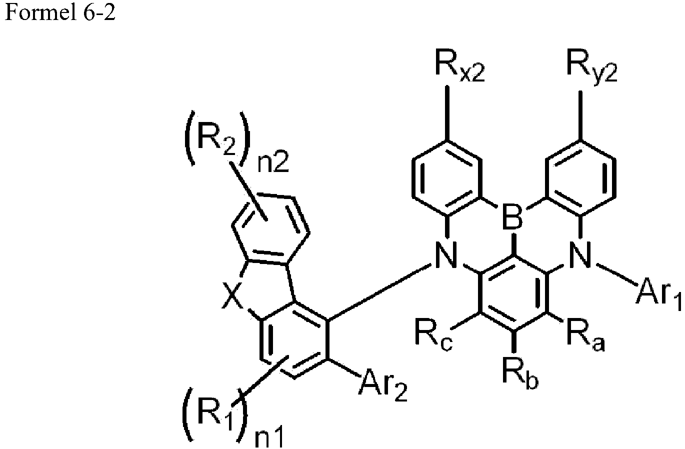 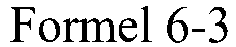 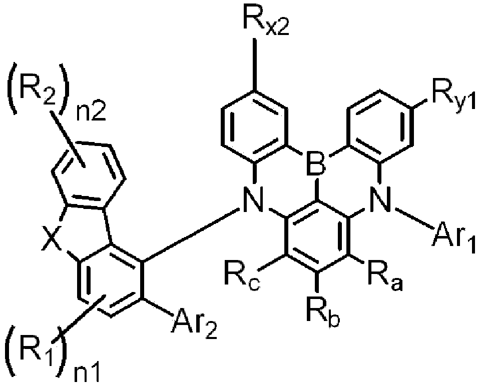 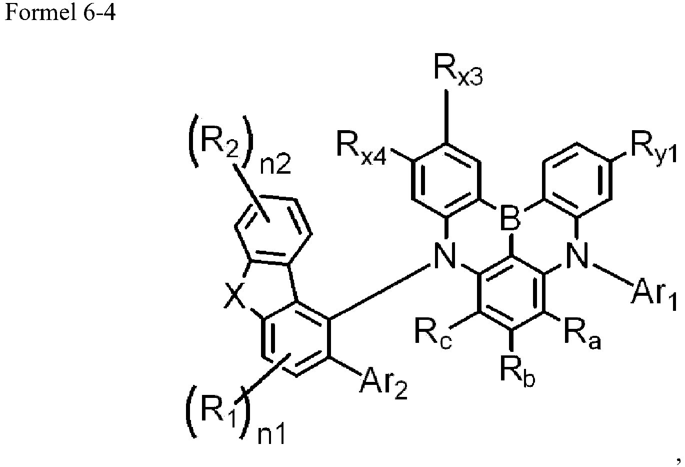 wobei in Formel 6-1 bis Formel 6-4
Rₓ₁, Rₓ₂, R_{y1} und R_{y2} jeweils unabhängig voneinander Deuterium, ein Halogen, eine substituierte oder unsubstituierte Aminogruppe, eine substituierte oder unsubstituierte Silylgruppe, eine substituierte oder unsubstituierte Alkylgruppe mit 1 bis 20 Kohlenstoffatomen, eine substituierte oder unsubstituierte Arylgruppe mit 6 bis 30 ringbildenden Kohlenstoffatomen oder eine substituierte oder unsubstituierte Heteroarylgruppe mit 2 bis 30 ringbildenden Kohlenstoffatomen sind,
R_{X3} und Rₓ₄ jeweils unabhängig voneinander Deuterium, ein Halogen, eine substituierte oder unsubstituierte Amingruppe, eine substituierte oder unsubstituierte Silylgruppe, eine substituierte oder unsubstituierte Alkylgruppe mit 1 bis 20 Kohlenstoffatomen, eine substituierte oder unsubstituierte Arylgruppe mit 6 bis 30 ringbildenden Kohlenstoffatomen oder eine substituierte oder unsubstituierte Heteroarylgruppe mit 2 bis 30 ringbildenden Kohlenstoffatomen sind und/oder mit einer benachbarten Gruppe unter Bildung eines Rings kombiniert sind, und
X, Ar₁, Ar₂, R₁, R₂, Rₐ bis R_{c}, n1 und n2 jeweils die gleichen wie in der Formel 1 definiert sind.

7. Verschmolzene polyzyklische Verbindung nach Anspruch 6, wobei in Formel 6-1 bis Formel 6-4 Rₓ₁, Rₓ₂, R_{y1} und R_{y2} jeweils unabhängig voneinander eine substituierte oder unsubstituierte Silylgruppe, eine substituierte oder unsubstituierte Amingruppe, eine substituierte oder unsubstituierte Phenylgruppe, eine substituierte oder unsubstituierte Biphenylgruppe, eine substituierte oder unsubstituierte Dibenzofurangruppe, eine substituierte oder unsubstituierte N-Carbazolgruppe oder eine substituierte oder unsubstituierte Acridingruppe sind.

8. Verschmolzene polyzyklische Verbindung nach Anspruch 1, wobei die durch Formel 1 dargestellte verschmolzene polyzyklische Verbindung durch Formel 7 dargestellt wird: 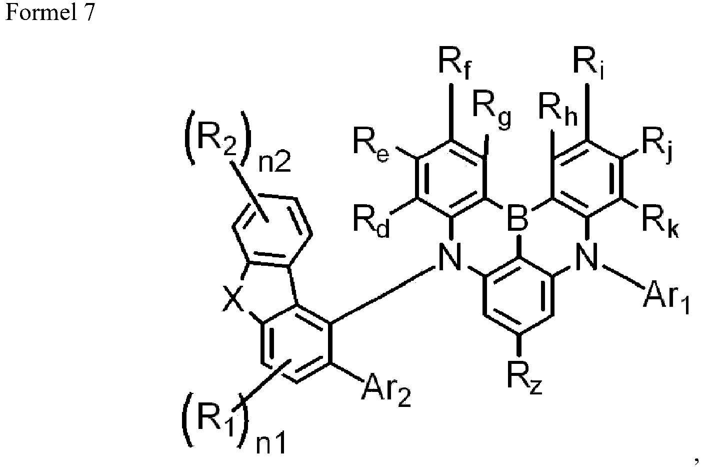 wobei in Formel 7
R_{z} Deuterium, ein Halogen, eine substituierte oder unsubstituierte Aminogruppe, eine substituierte oder unsubstituierte Alkylgruppe mit 1 bis 20 Kohlenstoffatomen, eine substituierte oder unsubstituierte Arylgruppe mit 6 bis 30 ringbildenden Kohlenstoffatomen oder eine substituierte oder unsubstituierte Heteroarylgruppe mit 2 bis 30 ringbildenden Kohlenstoffatomen ist, und
X, Ar₁, Ar₂, R₁, R₂, Rₐ to Rₖ, n1 und n2 jeweils die gleichen wie in der Formel 1 definiert sind.

9. Verschmolzene polyzyklische Verbindung nach Anspruch 8, wobei in Formel 7
R_{z} eine substituierte oder unsubstituierte t-Butylgruppe, eine substituierte oder unsubstituierte Phenylgruppe, eine substituierte oder unsubstituierte Biphenylgruppe, eine substituierte oder unsubstituierte Terphenylgruppe, eine substituierte oder unsubstituierte Dibenzofurangruppe, eine substituierte oder unsubstituierte Carbazolgruppe, eine substituierte oder unsubstituierte Fluorenylgruppe, eine substituierte oder unsubstituierte Xanthengruppe oder eine substituierte oder unsubstituierte Indolocarbazolgruppe ist.

10. Verschmolzene polyzyklische Verbindung nach Anspruch 1, wobei die durch Formel 1 dargestellte erste Verbindung durch Formel 8 dargestellt wird: 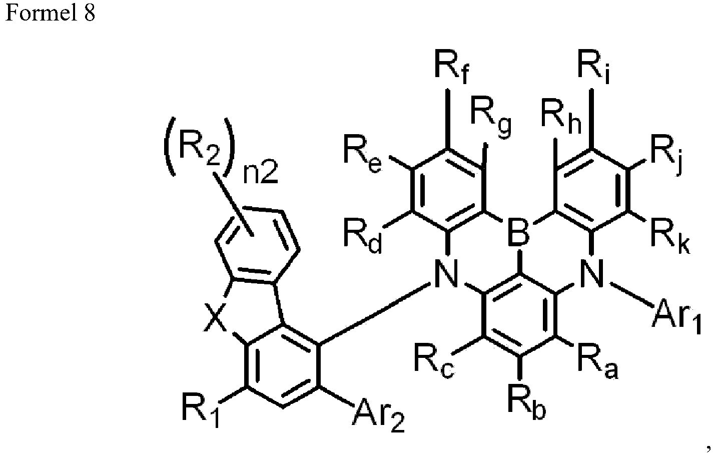 wobei in Formel 8
X, Ar₁, Ar₂, R₁, R₂, Rₐ bis Rₖ und n2 jeweils die gleichen wie in der Formel 1 definiert sind.

11. Verschmolzene polyzyklische Verbindung nach Anspruch 1, wobei die durch Formel 1 dargestellte verschmolzene polyzyklische Verbindung eine beliebige aus den Verbindungen der Verbindungsgruppe 1 ausgewählte Verbindung ist:

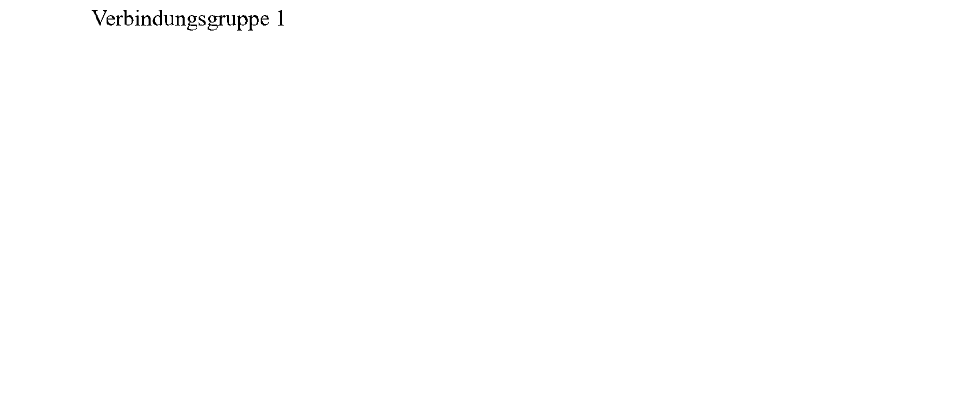

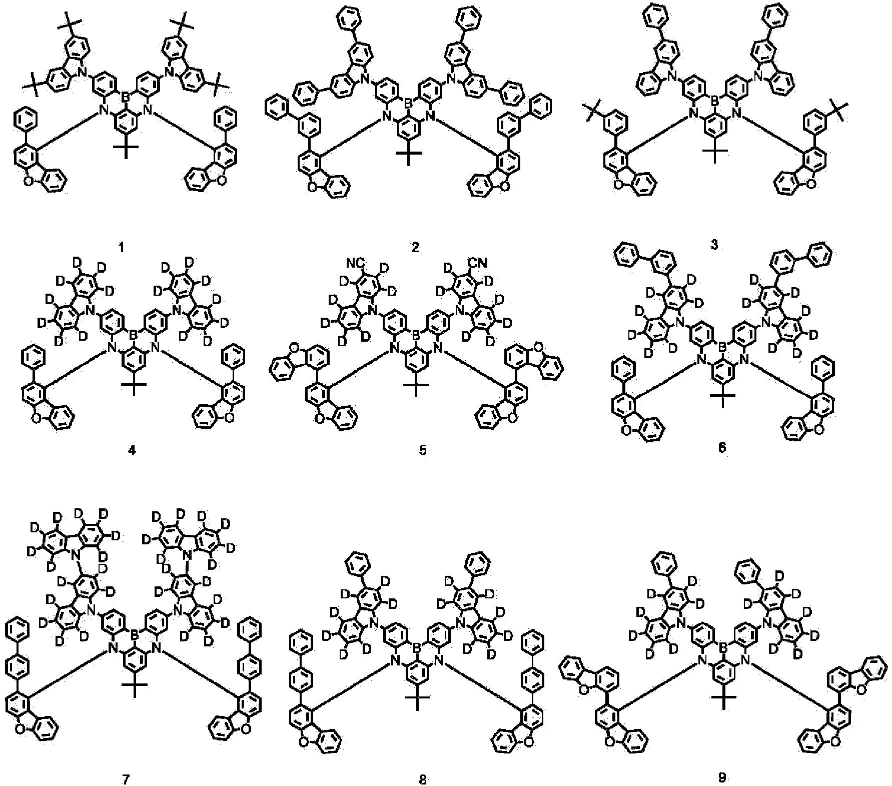

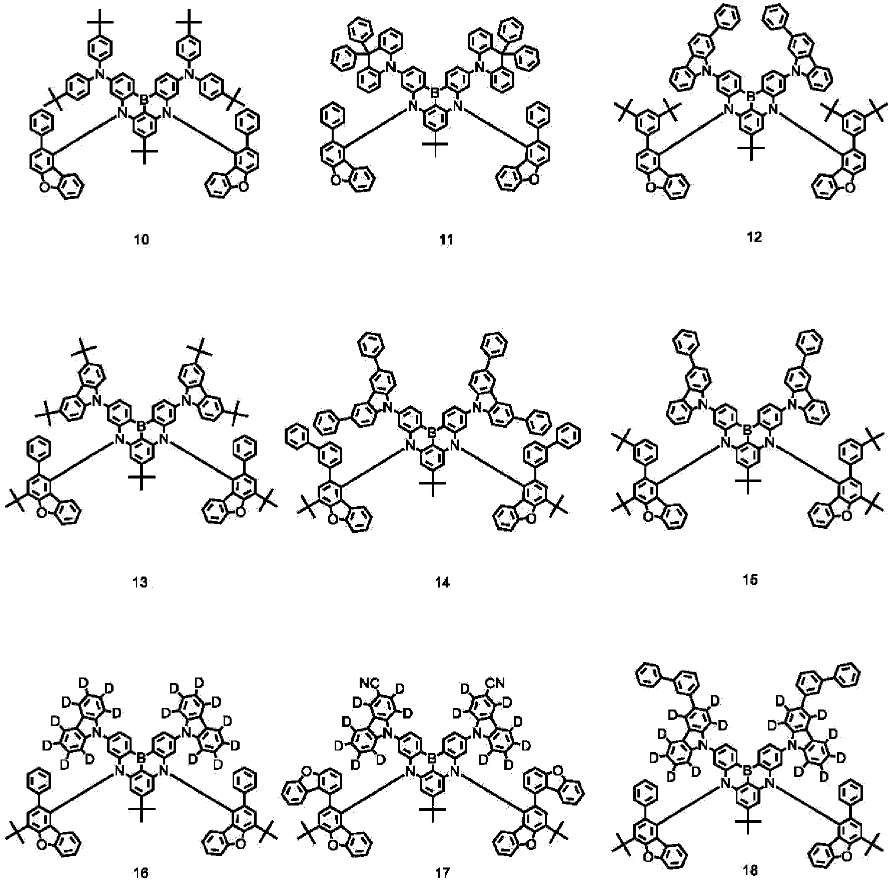

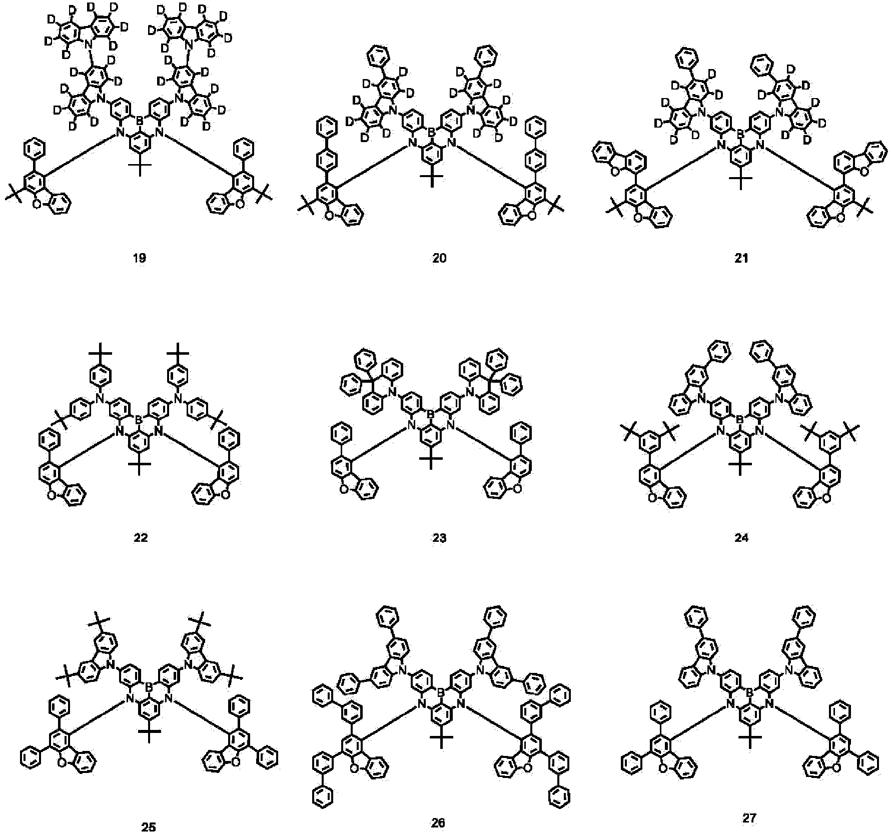

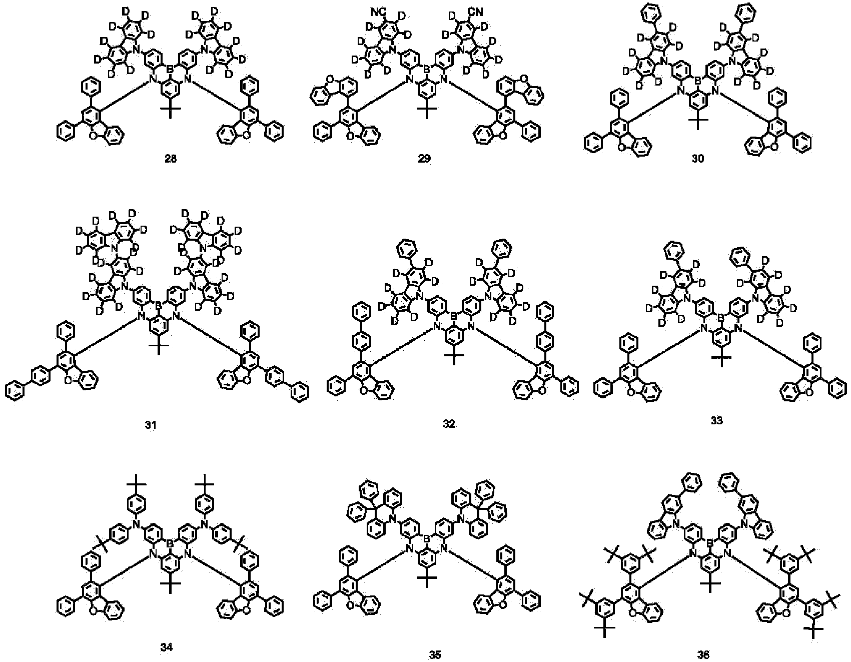

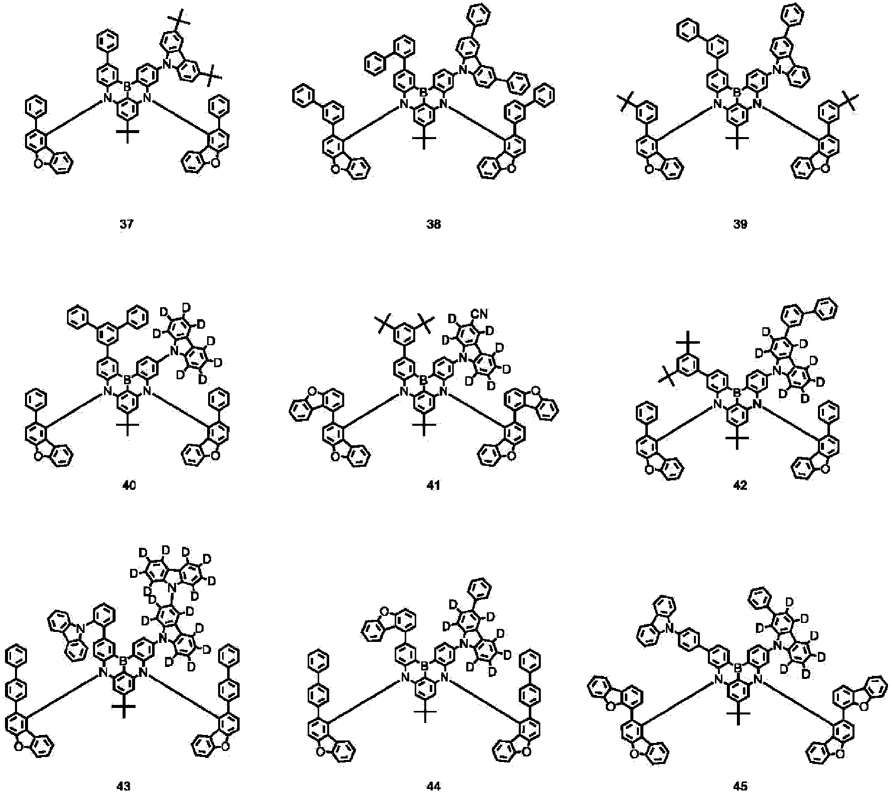

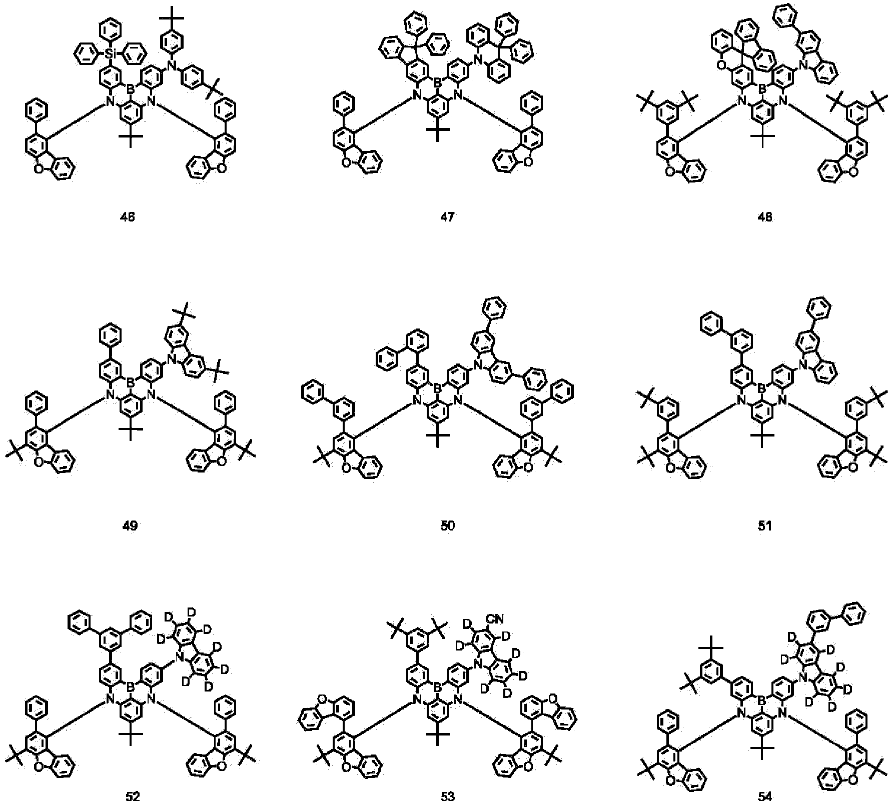

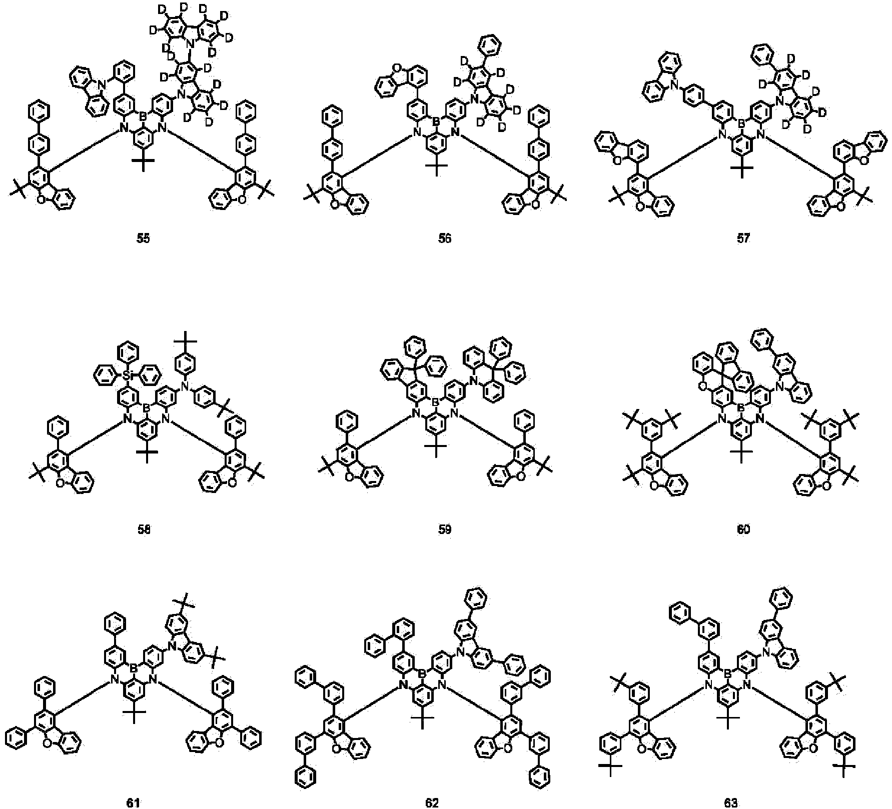

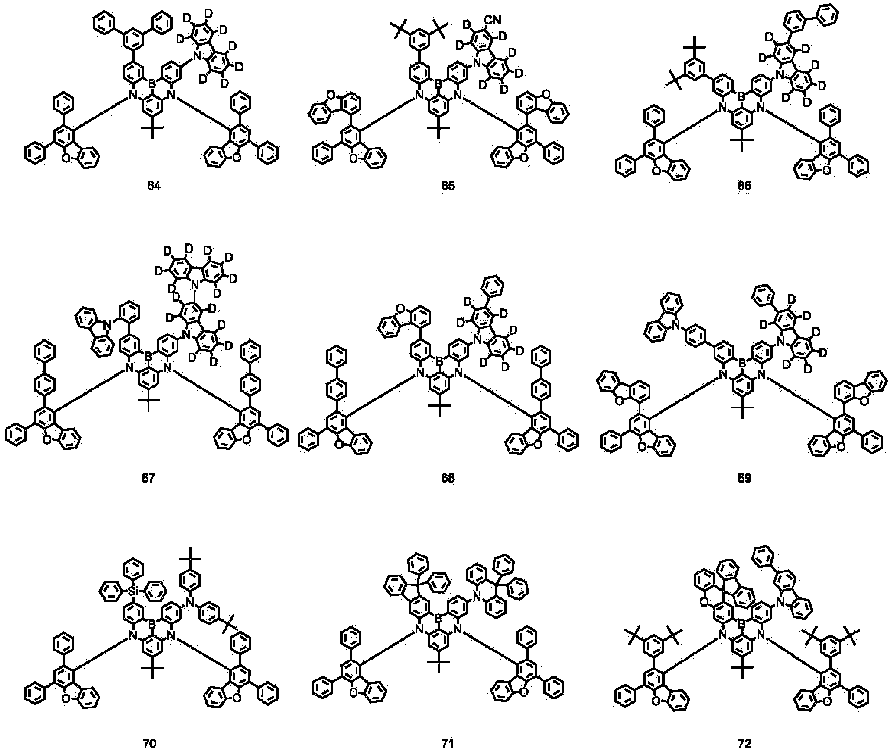

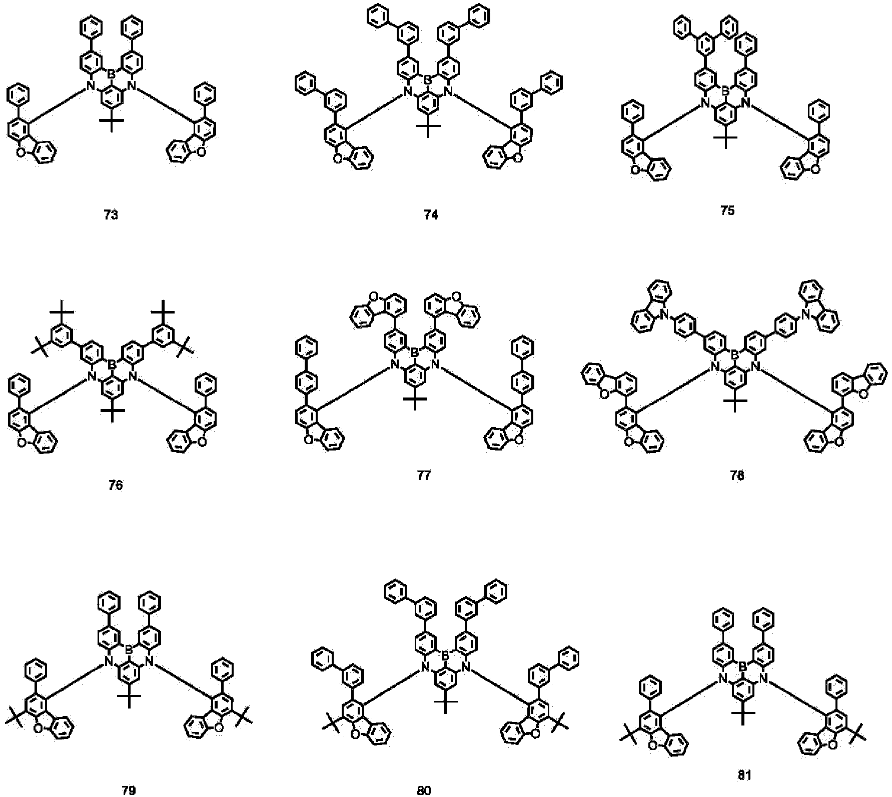

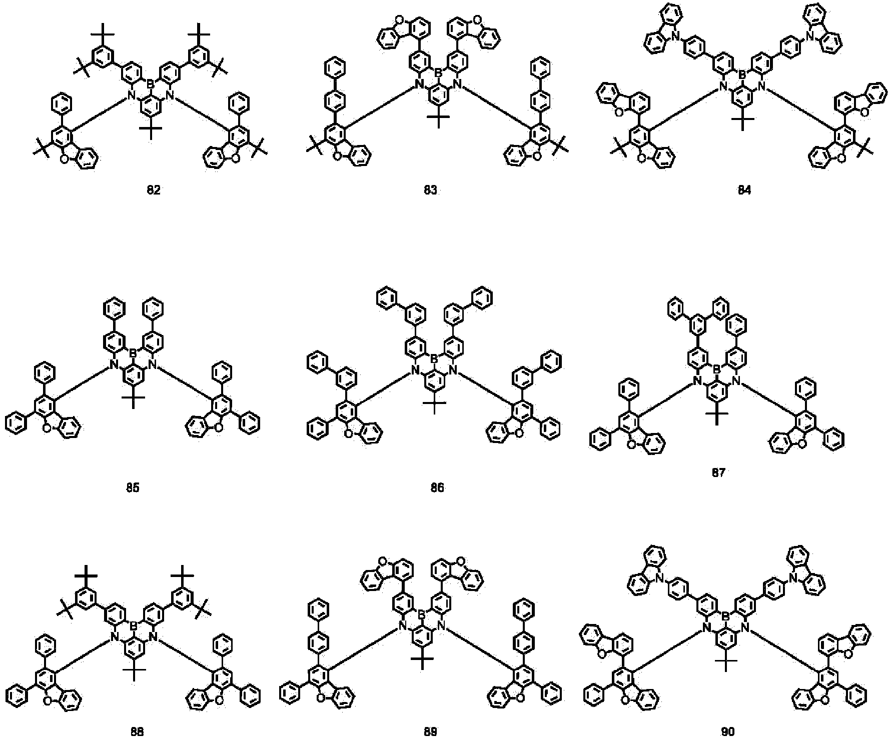

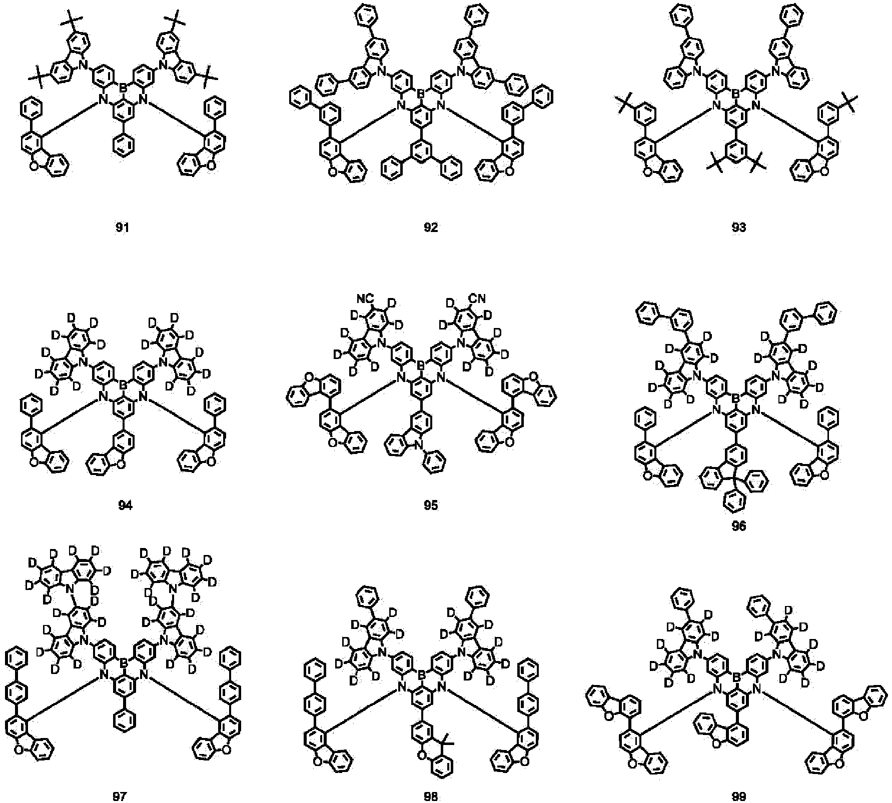

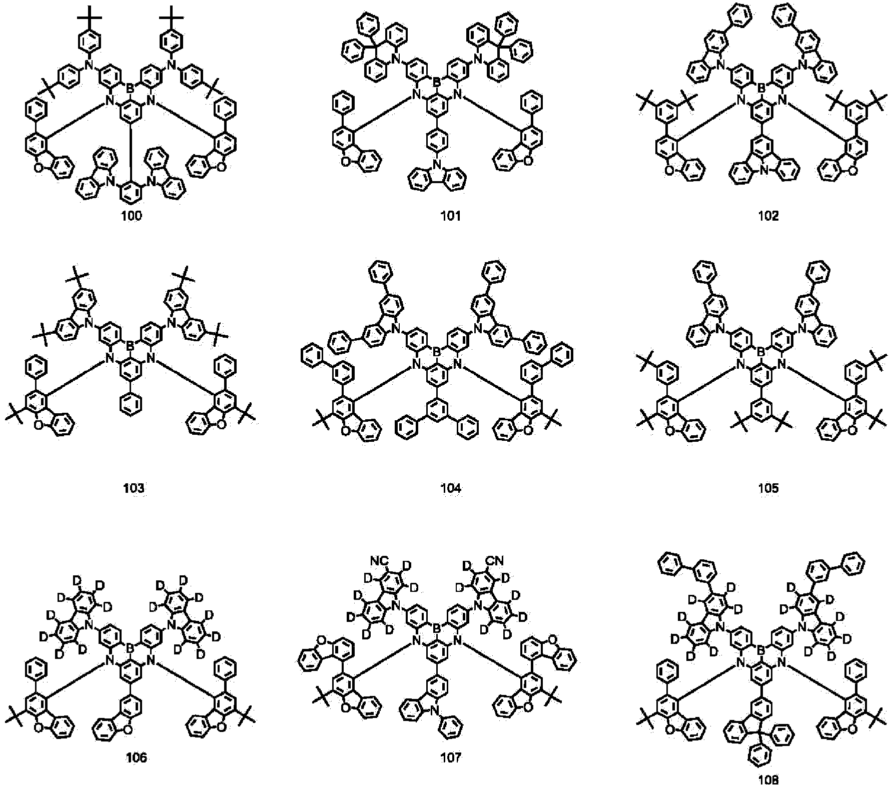

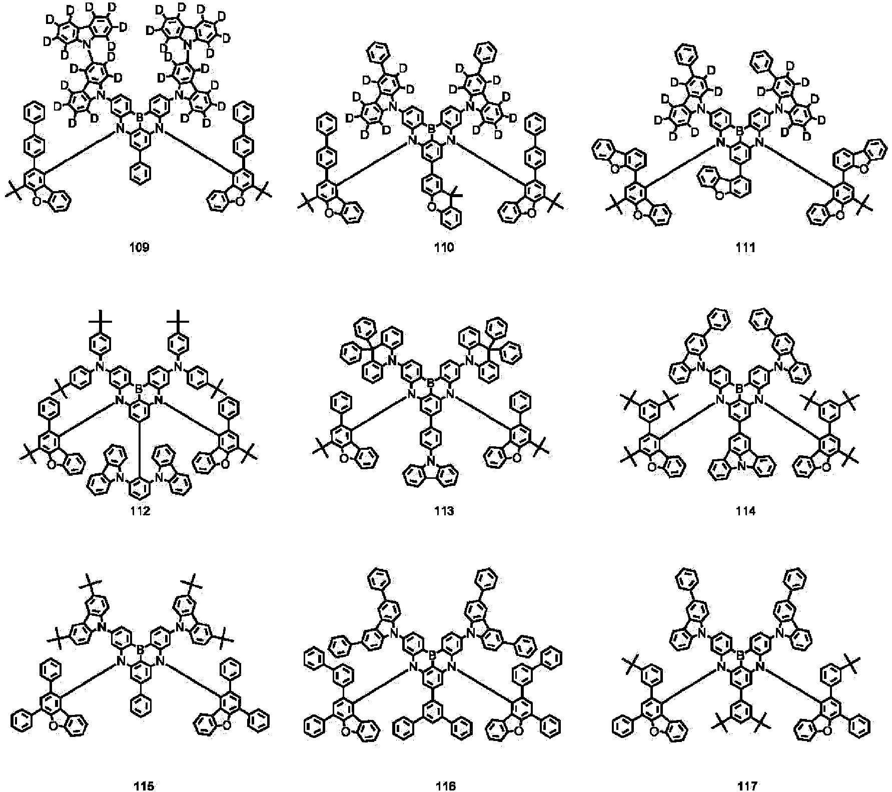

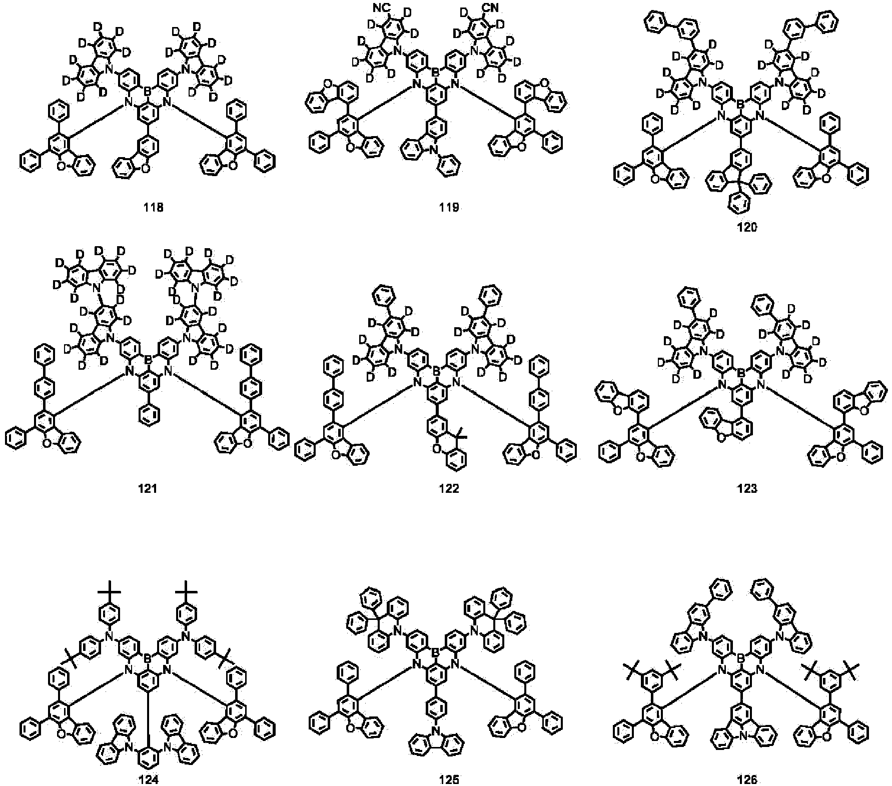

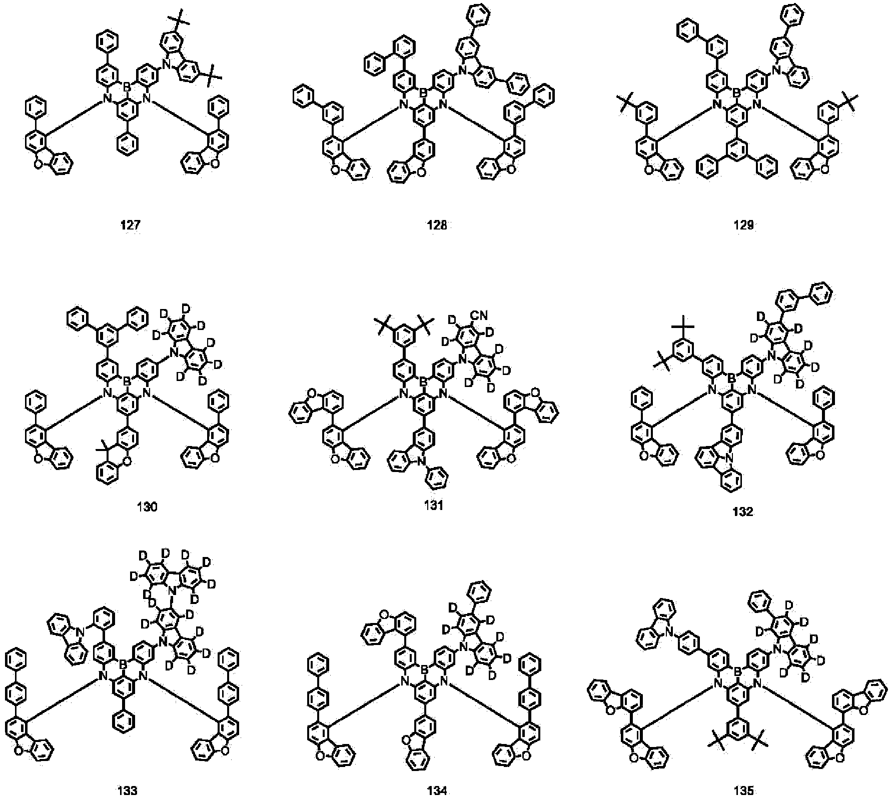

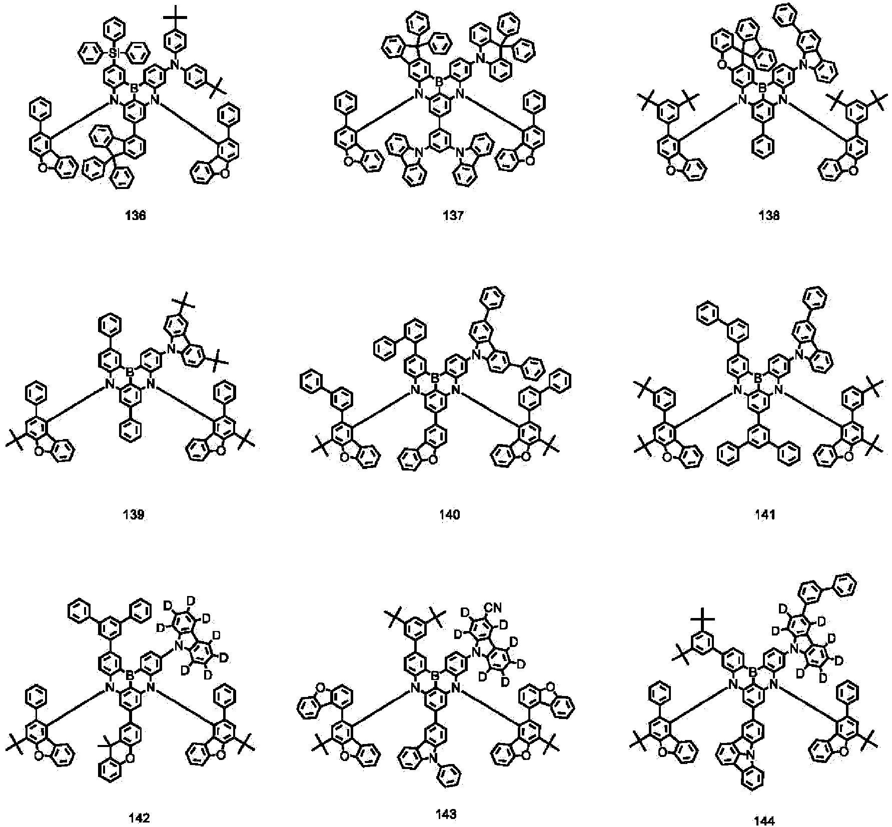

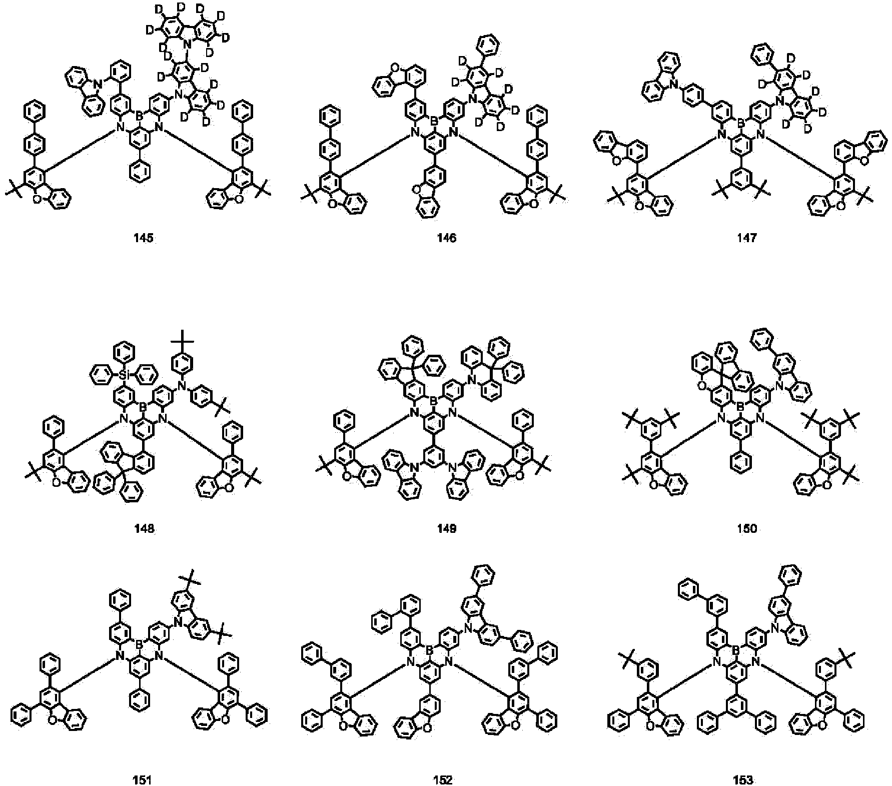

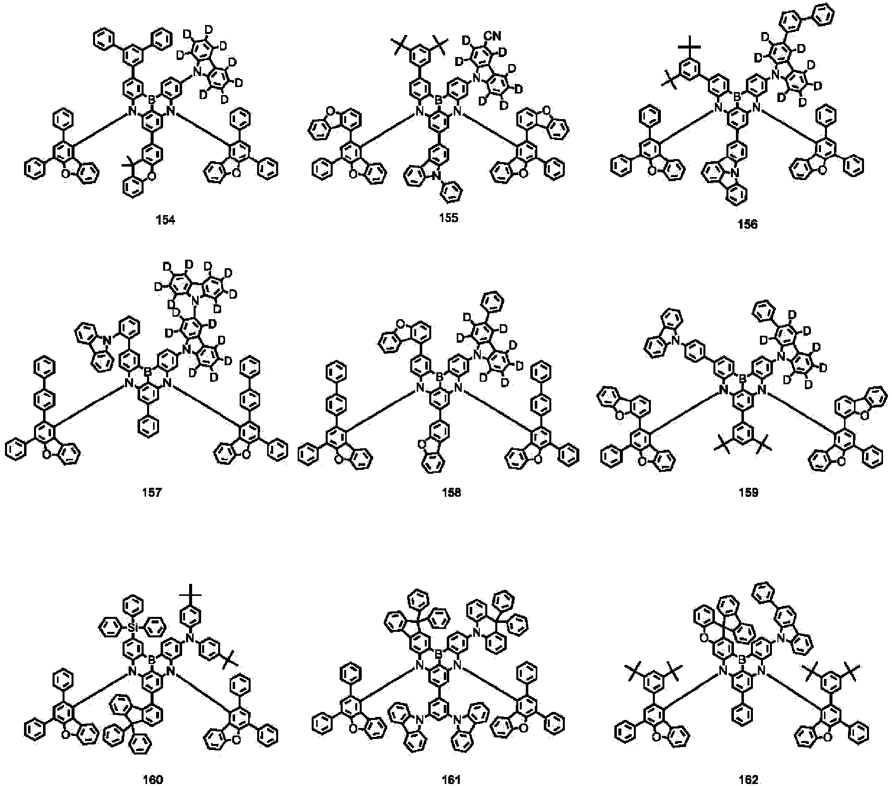

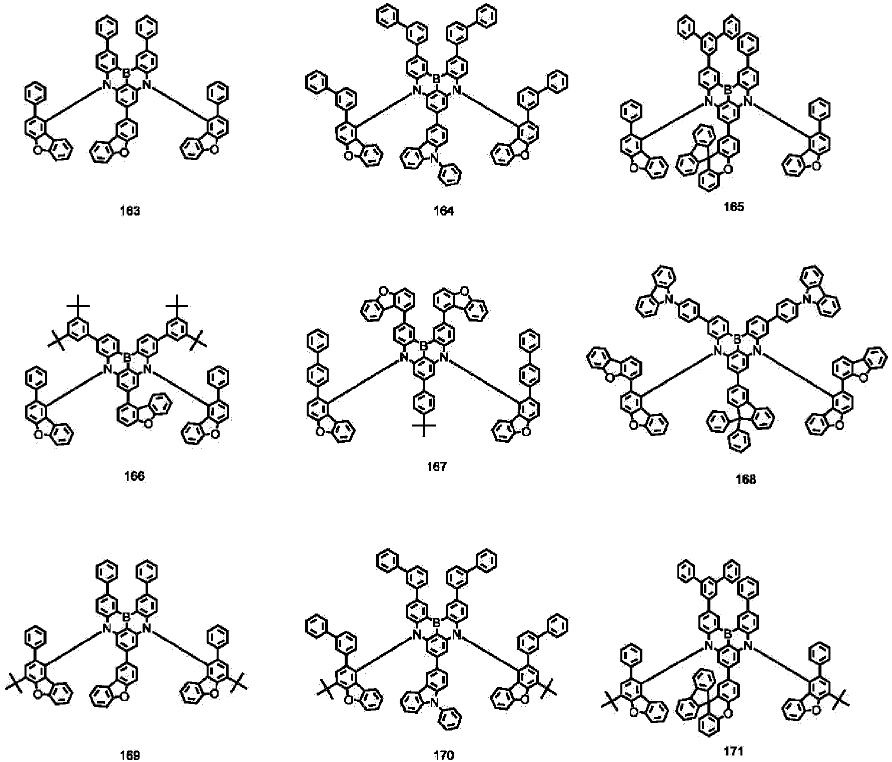

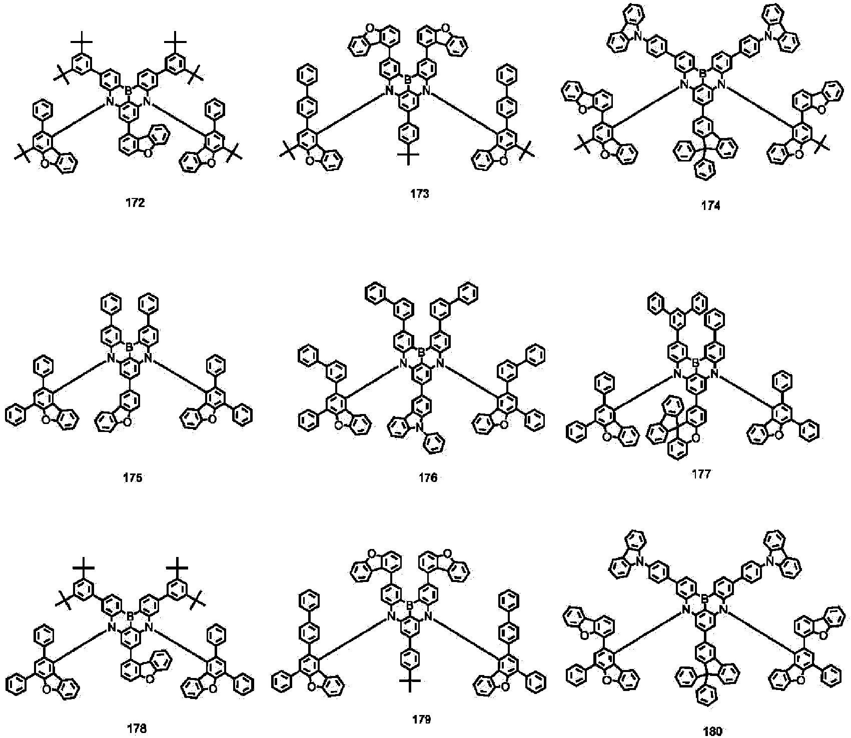

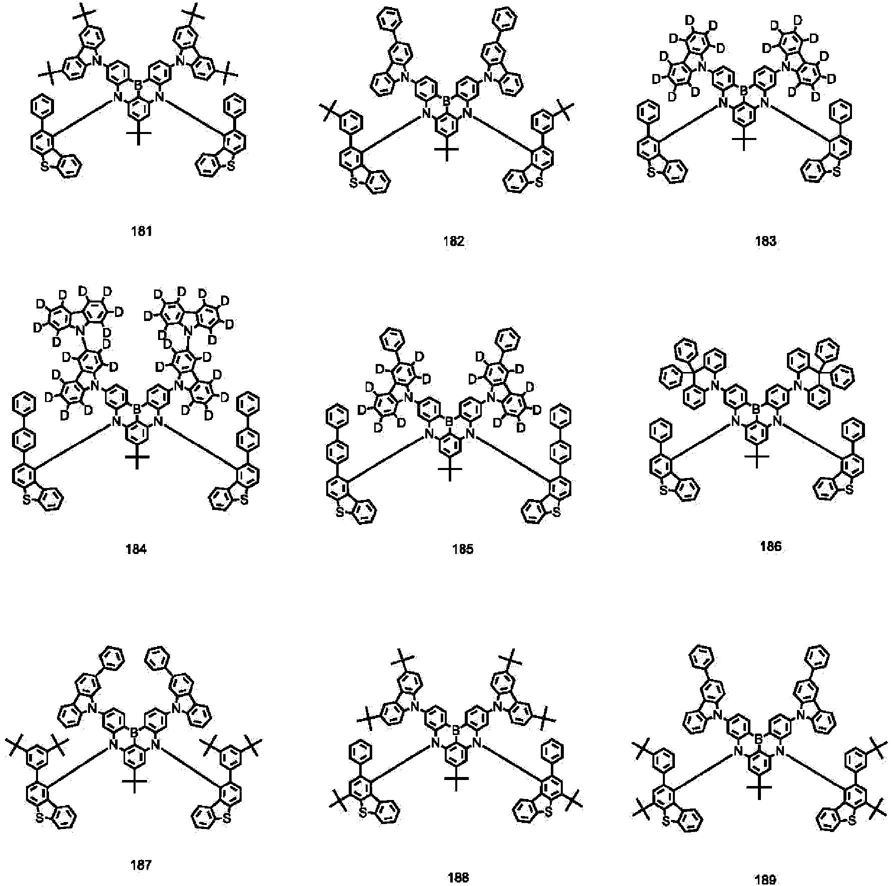

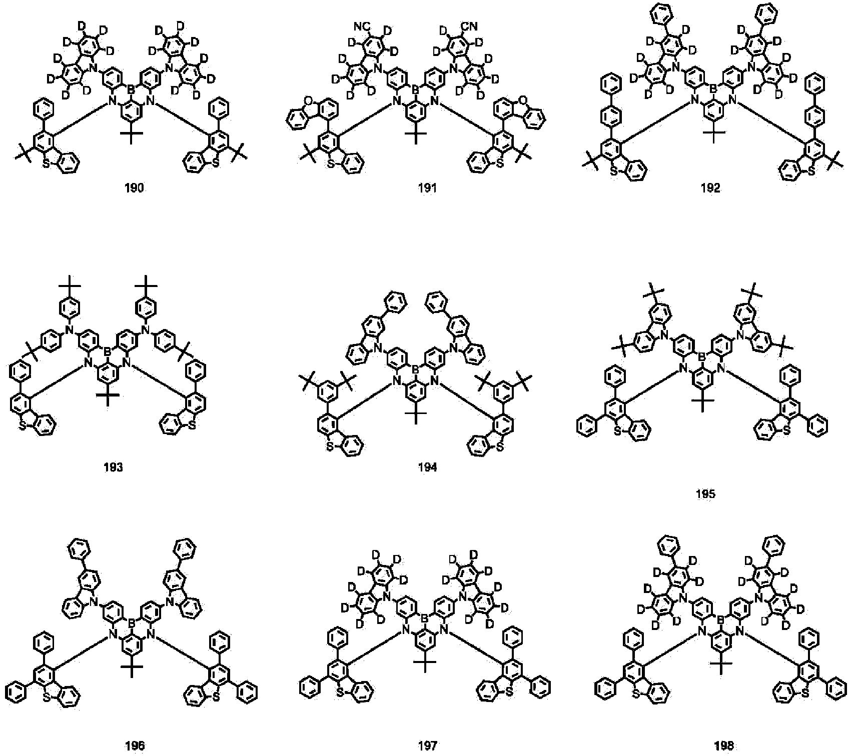

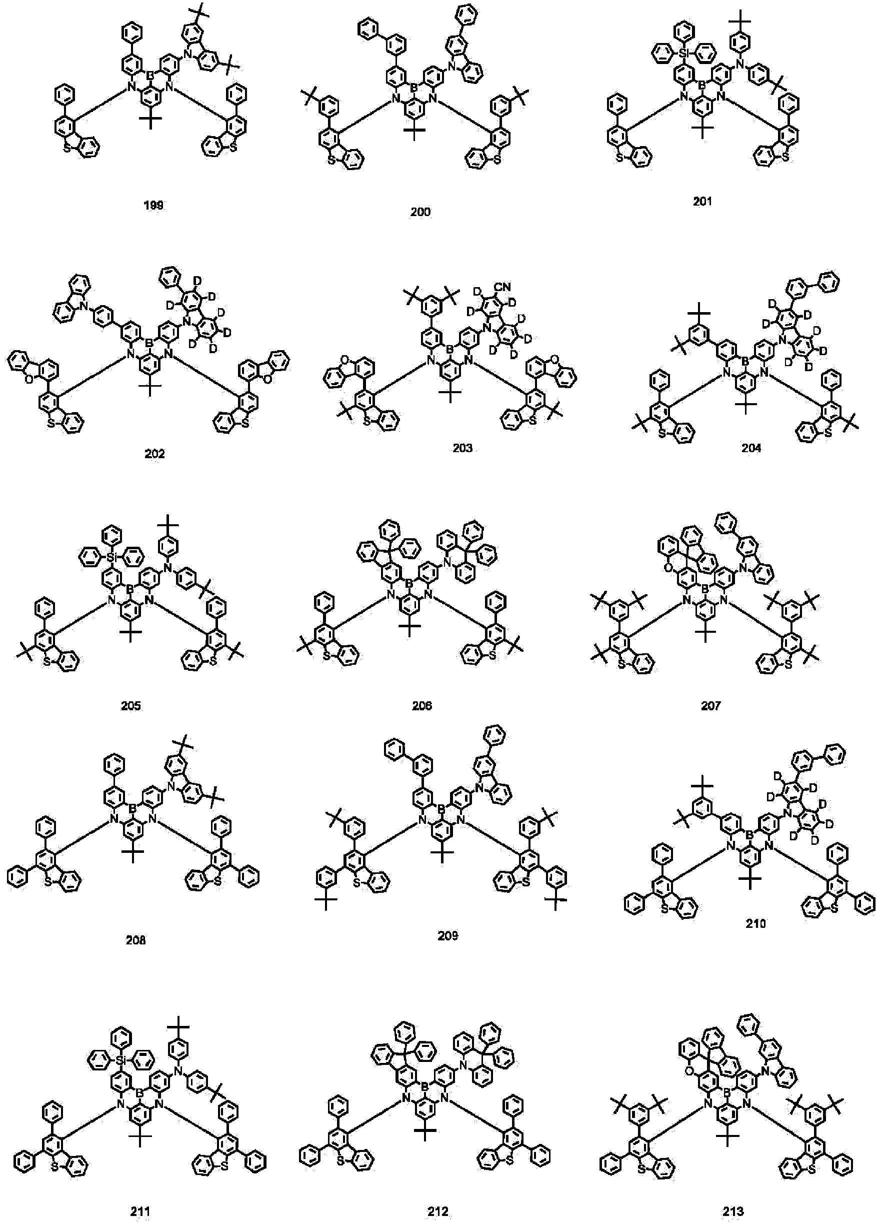

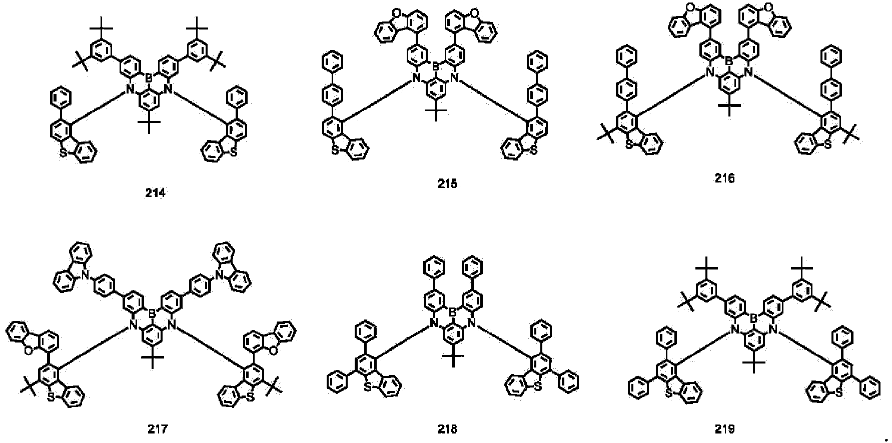

12. Lichtemissionsbauelement (ED), umfassend:
eine erste Elektrode (EL1);
eine zweite Elektrode (EL2), die der ersten Elektrode (EL1) gegenüberliegt; und
eine Emissionsschicht (EML) zwischen der ersten Elektrode (EL1) und der zweiten Elektrode (EL2), wobei die Emissionsschicht (EML) die verschmolzene polyzyklische Verbindung als erste Verbindung nach einem der Ansprüche 1 bis 11 umfasst.

13. Lichtemissionselement (ED) nach Anspruch 11, wobei die Emissionsschicht (EML) ferner mindestens eine Verbindung umfasst, die aus einer durch Formel HT-1 dargestellten zweiten Verbindung, einer durch Formel ET-1 dargestellten dritten Verbindung und einer durch Formel D-1 dargestellten vierten Verbindung ausgewählt ist: 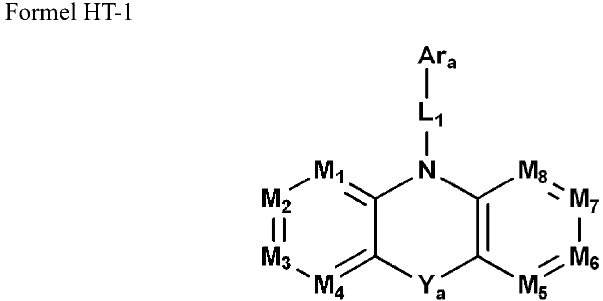 wobei in Formel HT-1
M₁ bis M₈ jeweils unabhängig voneinander N oder CR₅₁ sind,
L₁ eine direkte Bindung, eine substituierte oder unsubstituierte Arylengruppe mit 6 bis 30 ringbildenden Kohlenstoffatomen oder eine substituierte oder unsubstituierte Heteroarylengruppe mit 2 bis 30 ringbildenden Kohlenstoffatomen ist,
Yₐ eine direkte Bindung, CR₅₂R₅₃ oder SiR₅₄R₅₅ ist,
Arₐ eine substituierte oder unsubstituierte Arylgruppe mit 6 bis 30 ringbildenden Kohlenstoffatomen oder eine substituierte oder unsubstituierte Heteroarylgruppe mit 2 bis 30 ringbildenden Kohlenstoffatomen ist und R₅₁ bis R₅₅ jeweils unabhängig voneinander Wasserstoff, Deuterium, ein Halogen, eine Cyanogruppe, eine substituierte oder unsubstituierte Silylgruppe, eine substituierte oder unsubstituierte Thiogruppe, eine substituierte oder unsubstituierte Oxygruppe, eine substituierte oder unsubstituierte Amingruppe, eine substituierte oder unsubstituierte Borgruppe, eine substituierte oder unsubstituierte Alkylgruppe mit 1 bis 20 Kohlenstoffatomen, eine substituierte oder unsubstituierte Alkenylgruppe mit 2 bis 20 Kohlenstoffatomen, eine substituierte oder unsubstituierte Arylgruppe mit 6 bis 60 ringbildenden Kohlenstoffatomen oder eine substituierte oder unsubstituierte Heteroarylgruppe mit 2 bis 60 ringbildenden Kohlenstoffatomen sind und/oder mit einer benachbarten Gruppe unter Bildung eines Rings kombiniert sind; 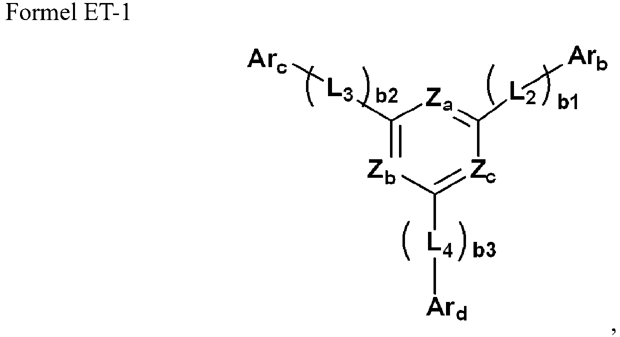 wobei in Formel ET-1
mindestens eines ausgewählt aus Za bis Zc N ist und der Rest CR₅₆ ist,
R₅₆ Wasserstoff, Deuterium, eine substituierte oder unsubstituierte Alkylgruppe mit 1 bis 20 Kohlenstoffatomen, eine substituierte oder unsubstituierte Arylgruppe mit 6 bis 60 ringbildenden Kohlenstoffatomen oder eine substituierte oder unsubstituierte Heteroarylgruppe mit 2 bis 60 ringbildenden Kohlenstoffatomen ist, wobei b1 bis b3 jeweils unabhängig voneinander eine ganze Zahl von 0 bis 10 sind,
Ar_{b} bis Ar_{d} jeweils unabhängig voneinander Wasserstoff, Deuterium, eine substituierte oder unsubstituierte Alkylgruppe mit 1 bis 20 Kohlenstoffatomen, eine substituierte oder unsubstituierte Arylgruppe mit 6 bis 30 ringbildenden Kohlenstoffatomen oder eine substituierte oder unsubstituierte Heteroarylgruppe mit 2 bis 30 ringbildenden Kohlenstoffatomen sind und
L₂ bis L₄ jeweils unabhängig voneinander eine direkte Bindung, eine substituierte oder unsubstituierte Arylengruppe mit 6 bis 30 ringbildenden Kohlenstoffatomen oder eine substituierte oder unsubstituierte Heteroarylengruppe mit 2 bis 30 ringbildenden Kohlenstoffatomen sind; und 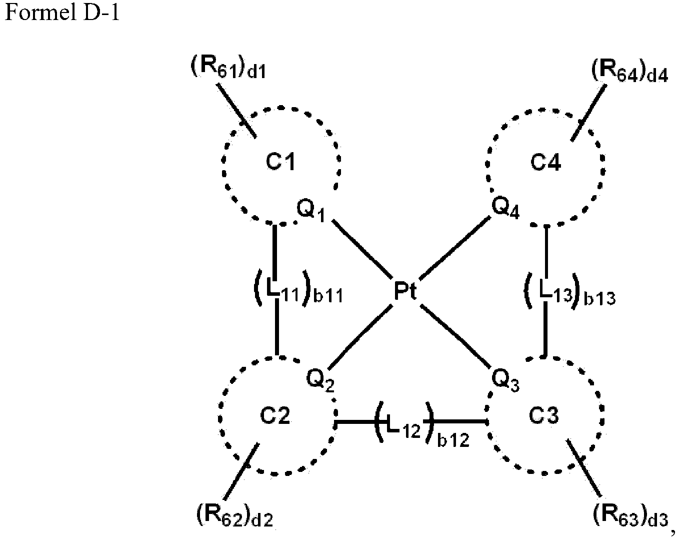 wobei in Formel D-1
Q₁ bis Q₄ jeweils unabhängig voneinander C oder N sind,
C1 bis C4 jeweils unabhängig voneinander ein substituierter oder unsubstituierter Kohlenwasserstoffring mit 5 bis 30 ringbildenden Kohlenstoffatomen oder ein substituierter oder unsubstituierter Heterocyclus mit 2 bis 30 ringbildenden Kohlenstoffatomen sind,
L₁₁ bis L₁₃ jeweils unabhängig voneinander eine direkte Bindung, *-O-*, *-S-*, 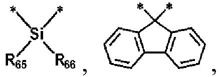 eine substituierte oder unsubstituierte Alkylengruppe mit 1 bis 20 Kohlenstoffatomen, eine substituierte oder unsubstituierte Arylengruppe mit 6 bis 30 ringbildenden Kohlenstoffatomen oder eine substituierte oder unsubstituierte Heteroarylengruppe mit 2 bis 30 ringbildenden Kohlenstoffatomen sind,
b11 bis b13 jeweils unabhängig voneinander 0 oder 1 sind,
R₆₁ bis R₆₆ jeweils unabhängig voneinander Wasserstoff, Deuterium, ein Halogen, eine Cyanogruppe, eine substituierte oder unsubstituierte Silylgruppe, eine substituierte oder unsubstituierte Thiogruppe, eine substituierte oder unsubstituierte Oxygruppe, eine substituierte oder unsubstituierte Amingruppe, eine substituierte oder unsubstituierte Borgruppe, eine substituierte oder unsubstituierte Alkylgruppe mit 1 bis 20 Kohlenstoffatomen, eine substituierte oder unsubstituierte Alkenylgruppe mit 2 bis 20 Kohlenstoffatomen, eine substituierte oder unsubstituierte Arylgruppe mit 6 bis 60 ringbildenden Kohlenstoffatomen oder eine substituierte oder unsubstituierte Heteroarylgruppe mit 2 bis 60 ringbildenden Kohlenstoffatomen sind und d1 bis d4 jeweils unabhängig voneinander eine ganze Zahl von 0 bis 4 sind.

14. Anzeigepaneel (DP), umfassend:
eine Basisschicht (BS);
eine Schaltungsschicht (DP-CL) auf der Basisschicht (BS); und
eine Anzeigevorrichtungsschicht (DP-ED) auf der Schaltungsschicht (DP-CL), die ein Lichtemissionselement (ED) nach Anspruch 12 umfasst.

15. Anzeigepaneel (DP) nach Anspruch 14, wobei das Anzeigepaneel (DP) ferner eine Lichtsteuerungsschicht (CCL) auf der Anzeigevorrichtungsschicht (DP-ED) und einen Quantenpunkt umfasst, wobei das Lichtemissionselement dazu konfiguriert ist, Licht einer ersten Farbe zu emittieren, und
wobei die Lichtsteuerungsschicht (CCL) Folgendes umfasst: einen ersten Lichtsteuerungsteil (CCP1), der einen ersten Quantenpunkt (QD1) umfasst, der das Licht der ersten Farbe in Licht einer zweiten Farbe in einem Wellenlängenbereich umwandelt, der länger ist als der des Lichts der ersten Farbe; einen zweiten Lichtsteuerungsteil (CCP2), der einen zweiten Quantenpunkt (QD2) umfasst, der das Licht der ersten Farbe in Licht einer dritten Farbe in einem Wellenlängenbereich umwandelt, der länger ist als der des Lichts der ersten Farbe und des Lichts der zweiten Farbe; und
einen dritten Lichtsteuerungsteil (CCP3), der so konfiguriert ist, dass er das Licht der ersten Farbe durchlässt.

## Revendications

1. Composé polycyclique fusionné représenté par la Formule 1 : 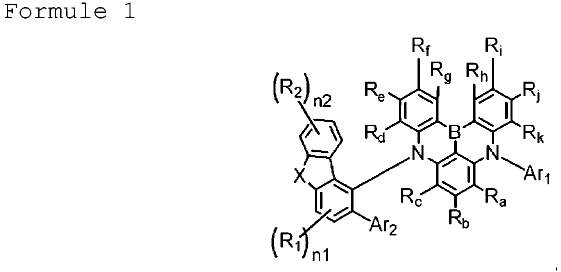 dans la Formule 1,
X étant O ou S,
Ar₁ et Ar₂ étant chacun indépendamment un groupe aryle substitué ou non substitué de 6 à 30 atomes de carbone formant cycle ou un groupe hétéroaryle substitué ou non substitué de 2 à 30 atomes de carbone formant cycle,
R₁, R₂, et Rₐ à Rₖ étant chacun indépendamment hydrogène, deutérium, un halogène, un groupe cyano, un groupe nitro, un groupe amine substitué ou non substitué, un groupe oxy substitué ou non substitué, un groupe thio substitué ou non substitué, un groupe bore substitué ou non substitué, un groupe silyle substitué ou non substitué, un groupe alkyle substitué ou non substitué de 1 à 20 atomes de carbone, un groupe aryle substitué ou non substitué de 6 à 30 atomes de carbone formant cycle, ou un groupe hétéroaryle substitué ou non substitué de 2 à 30 atomes de carbone formant cycle, et/ou combiné avec un groupe adjacent pour former un cycle,
n1 étant un nombre entier de 0 à 2, et
n2 étant un nombre entier de 0 à 4,
dans lequel le terme « substitué » fait référence au remplacement d'hydrogène par l'un parmi deutérium, un halogène, un groupe cyano, un groupe nitro, un groupe amino, un groupe silyle, un groupe oxy, un groupe thio, un groupe sulfinyle, un groupe sulfonyle, un groupe carbonyle, un groupe bore, un groupe oxyde de phosphine, un groupe sulfure de phosphine, un groupe alkyle, un groupe alcényle, un groupe alcynyle, un groupe cycle hydrocarbure, un groupe aryle et un groupe hétérocyclique.

2. Composé polycyclique fusionné selon la revendication 1, dans lequel le composé polycyclique fusionné représenté par la Formule 1 est représenté par la Formule 2 : 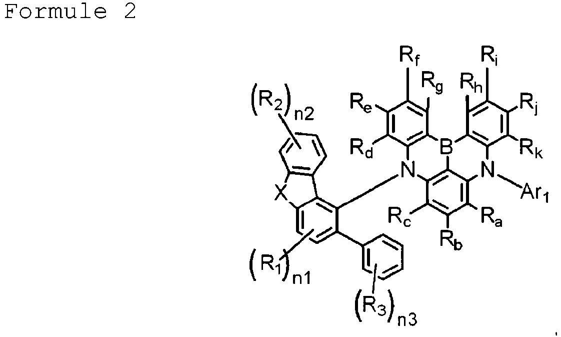 dans la Formule 2,
R₃ étant hydrogène, deutérium, un halogène, un groupe cyano, un groupe nitro, un groupe amine substitué ou non substitué, un groupe oxy substitué ou non substitué, un groupe thio substitué ou non substitué, un groupe bore substitué ou non substitué, un groupe silyle substitué ou non substitué, un groupe alkyle substitué ou non substitué de 1 à 20 atomes de carbone, un groupe aryle substitué ou non substitué de 6 à 30 atomes de carbone formant cycle, ou un groupe hétéroaryle substitué ou non substitué de 2 à 30 atomes de carbone formant cycle, et/ou combiné avec un groupe adjacent pour former un cycle,
n3 étant un nombre entier de 0 à 5, et
X, Ar₁, R₁, R₂, Rₐ à Rₖ, n1, et n2 étant chacun les mêmes que ceux définis dans la Formule 1.

3. Composé polycyclique fusionné selon la revendication 1, dans lequel le composé polycyclique fusionné représenté par la Formule 1 est représenté par la Formule 3-1 ou la Formule 3-2 : 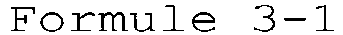 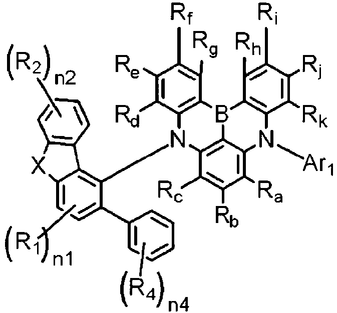 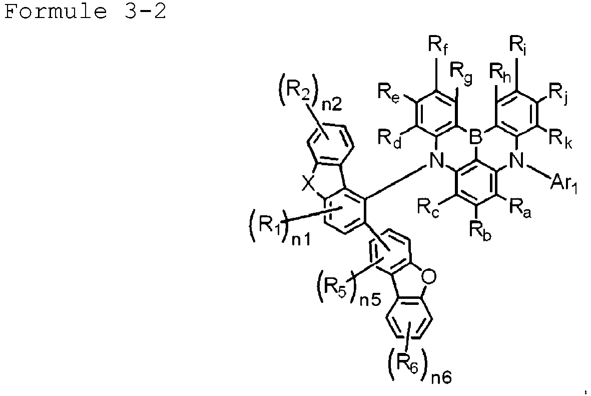 dans la Formule 3-1 et la Formule 3-2,
R₄ à R₆ étant chacun indépendamment hydrogène, deutérium, un halogène, un groupe cyano, un groupe nitro, un groupe amine substitué ou non substitué, un groupe oxy substitué ou non substitué, un groupe thio substitué ou non substitué, un groupe bore substitué ou non substitué, un groupe silyle substitué ou non substitué, un groupe alkyle substitué ou non substitué de 1 à 20 atomes de carbone, un groupe aryle substitué ou non substitué de 6 à 30 atomes de carbone formant cycle, ou un groupe hétéroaryle substitué ou non substitué de 2 à 30 atomes de carbone formant cycle,
n4 étant un nombre entier de 0 à 5,
n5 étant un nombre entier de 0 à 3,
n6 étant un nombre entier de 0 à 4, et
X, Ar₁, R₁, R₂, Rₐ à Rₖ, n1, et n2 étant chacun les mêmes que ceux définis dans la Formule 1.

4. Composé polycyclique fusionné selon la revendication 1, dans lequel le composé polycyclique fusionné représenté par la Formule 1 est représenté par la Formule 4 : 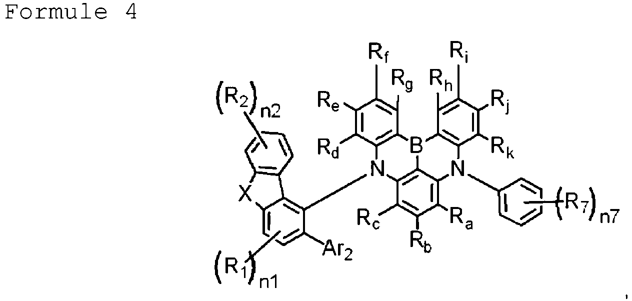 dans la Formule 4,
R₇ étant hydrogène, deutérium, un halogène, un groupe cyano, un groupe nitro, un groupe amine substitué ou non substitué, un groupe oxy substitué ou non substitué, un groupe thio substitué ou non substitué, un groupe bore substitué ou non substitué, un groupe silyle substitué ou non substitué, un groupe alkyle substitué ou non substitué de 1 à 20 atomes de carbone, un groupe aryle substitué ou non substitué de 6 à 30 atomes de carbone formant cycle, ou un groupe hétéroaryle substitué ou non substitué de 2 à 30 atomes de carbone formant cycle, et/ou combiné avec un groupe adjacent pour former un cycle,
n7 étant un nombre entier de 0 à 5, et
X, Ar₂, R₁, R₂, Rₐ à Rₖ, n1, et n2 étant chacun les mêmes que ceux définis dans la Formule 1.

5. Composé polycyclique fusionné selon la revendication 1, dans lequel le composé polycyclique fusionné représenté par la Formule 1 est représenté par la Formule 5-1 ou la Formule 5-2 : 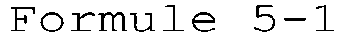 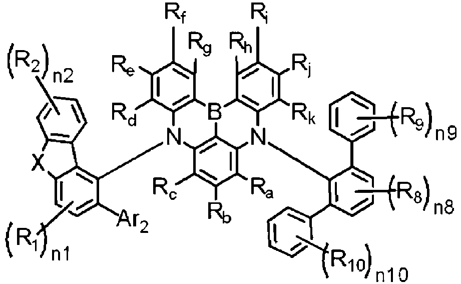 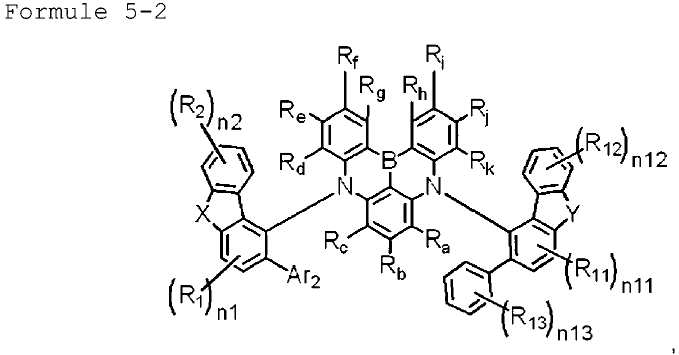 dans la Formule 5-1 et la Formule 5-2,
Y étant O ou S,
R₈ à R₁₂ étant chacun indépendamment hydrogène, deutérium, un halogène, un groupe cyano, un groupe nitro, un groupe amine substitué ou non substitué, un groupe oxy substitué ou non substitué, un groupe thio substitué ou non substitué, un groupe bore substitué ou non substitué, un groupe silyle substitué ou non substitué, un groupe alkyle substitué ou non substitué de 1 à 20 atomes de carbone, un groupe aryle substitué ou non substitué de 6 à 30 atomes de carbone formant cycle, ou un groupe hétéroaryle substitué ou non substitué de 2 à 30 atomes de carbone formant cycle,
R₁₃ étant hydrogène, deutérium, un halogène, un groupe cyano, un groupe nitro, un groupe amine substitué ou non substitué, un groupe oxy substitué ou non substitué, un groupe thio substitué ou non substitué, un groupe bore substitué ou non substitué, un groupe silyle substitué ou non substitué, un groupe alkyle substitué ou non substitué de 1 à 20 atomes de carbone, un groupe aryle substitué ou non substitué de 6 à 30 atomes de carbone formant cycle, ou un groupe hétéroaryle substitué ou non substitué de 2 à 30 atomes de carbone formant cycle, et/ou combiné avec un groupe adjacent pour former un cycle,
n8 étant un nombre entier de 0 à 3,
n12 étant un nombre entier de 0 à 4,
n9, n10 et n13 étant chacun indépendamment un nombre entier de 0 à 5,
n11 étant un nombre entier de 0 à 2, et
X, Ar₂, R₁, R₂, Rₐ à Rₖ, n1, et n2 étant chacun les mêmes que ceux définis dans la Formule 1.

6. Composé polycyclique fusionné selon la revendication 1, dans lequel le composé polycyclique fusionné représenté par la Formule 1 est représenté par une Formule sélectionnée parmi les Formule 6-1 à Formule 6-4 : 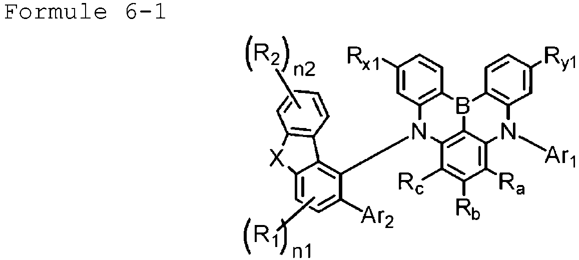 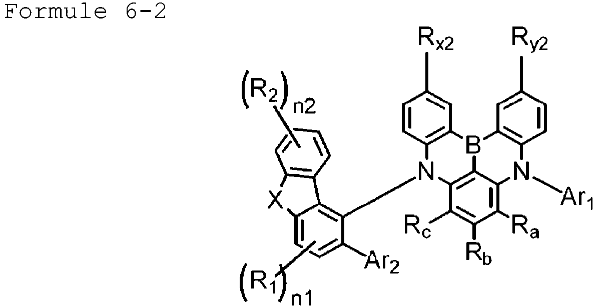 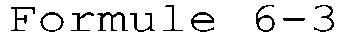 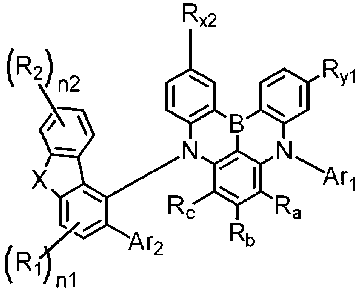 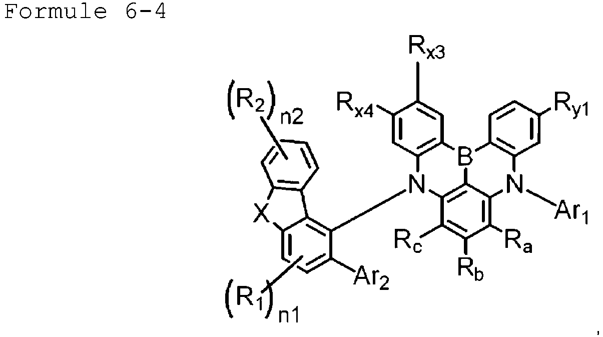 dans les Formule 6-1 à Formule 6-4,
Rₓ₁, Rₓ₂, R_{y1} et R_{y2} étant chacun indépendamment deutérium, un halogène, un groupe amine substitué ou non substitué, un groupe silyle substitué ou non substitué, un groupe alkyle substitué ou non substitué de 1 à 20 atomes de carbone, un groupe aryle substitué ou non substitué de 6 à 30 atomes de carbone formant cycle, ou un groupe hétéroaryle substitué ou non substitué de 2 à 30 atomes de carbone formant cycle,
Rₓ₃ et Rₓ₄ étant chacun indépendamment deutérium, un halogène, un groupe amine substitué ou non substitué, un groupe silyle substitué ou non substitué, un groupe alkyle substitué ou non substitué de 1 à 20 atomes de carbone, un groupe aryle substitué ou non substitué de 6 à 30 atomes de carbone formant cycle, ou un groupe hétéroaryle substitué ou non substitué de 2 à 30 atomes de carbone formant cycle, et/ou combiné avec un groupe adjacent pour former un cycle, et
X, Ar₁, Ar₂, R₁, R₂, Rₐ à R_{c}, n1, et n2 étant chacun les mêmes que ceux définis dans la Formule 1.

7. Composé polycyclique fusionné selon la revendication 6, dans lequel, dans les Formule 6-1 à Formule 6-4, Rₓ₁, Rₓ₂, R_{y1} et R_{y2} sont chacun indépendamment un groupe silyle substitué ou non substitué, un groupe amine substitué ou non substitué, un groupe phényle substitué ou non substitué, un groupe biphényle substitué ou non substitué, un groupe dibenzofurane substitué ou non substitué, un groupe N-carbazole substitué ou non substitué, ou un groupe acridine substitué ou non substitué.

8. Composé polycyclique fusionné selon la revendication 1, dans lequel le composé polycyclique fusionné représenté par la Formule 1 est représenté par la Formule 7 : 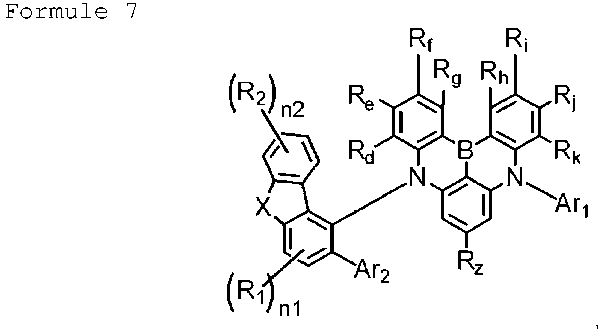 dans la Formule 7,
R_{z} étant deutérium, un halogène, un groupe amine substitué ou non substitué, un groupe alkyle substitué ou non substitué de 1 à 20 atomes de carbone, un groupe aryle substitué ou non substitué de 6 à 30 atomes de carbone formant cycle, ou un groupe hétéroaryle substitué ou non substitué de 2 à 30 atomes de carbone formant cycle, et
X, Ar₁, Ar₂, R₁, R₂, R_{d} à Rₖ, n1, et n2 étant chacun les mêmes que ceux définis dans la Formule 1.

9. Composé polycyclique fusionné selon la revendication 8, dans lequel, dans la Formule 7,
R_{z} est un groupe t-butyle substitué ou non substitué, un groupe phényle substitué ou non substitué, un groupe biphényle substitué ou non substitué, un groupe terphényle substitué ou non substitué, un groupe dibenzofurane substitué ou non substitué, un groupe carbazole substitué ou non substitué, un groupe fluorényle substitué ou non substitué, un groupe xanthéne substitué ou non substitué, ou un groupe indolocarbazole substitué ou non substitué.

10. Composé polycyclique fusionné selon la revendication 1, dans lequel le premier composé représenté par la Formule 1 est représenté par la Formule 8 : 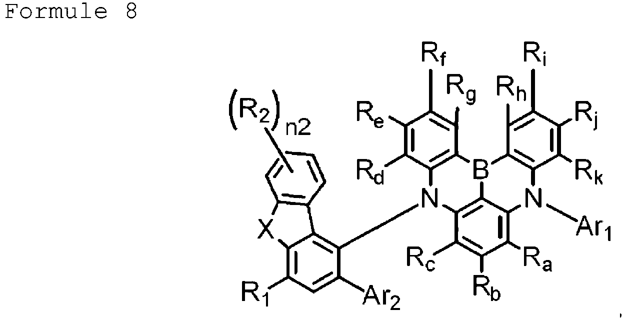 dans la Formule 8,
X, Ar₁, Ar₂, R₁, R₂, Rₐ à Rₖ, et n2 étant chacun les mêmes que ceux définis dans la Formule 1.

11. Composé polycyclique fusionné selon la revendication 1, dans lequel le composé polycyclique fusionné représenté par la Formule 1 est l'un quelconque sélectionné parmi les composés du Groupe de composés 1 :

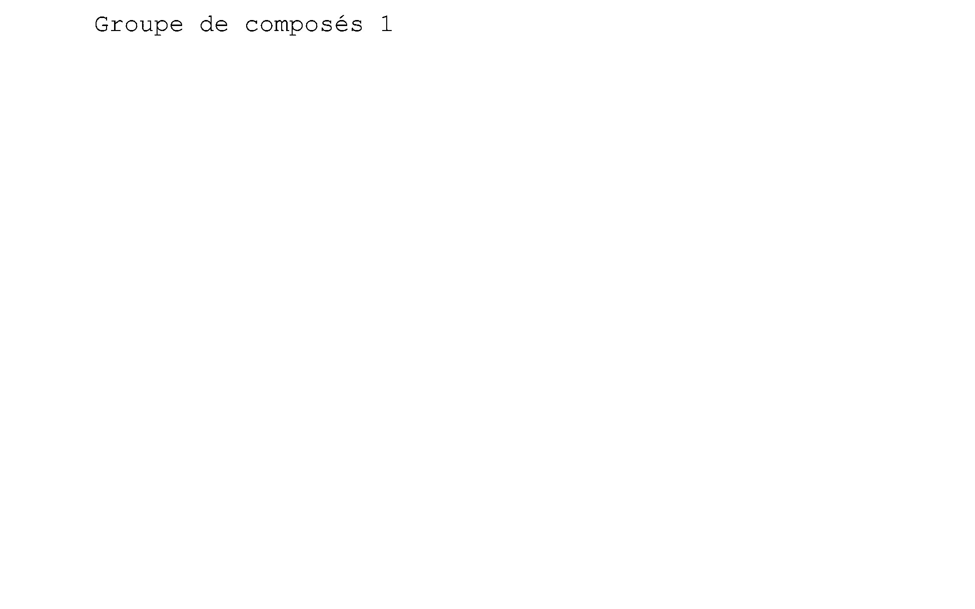

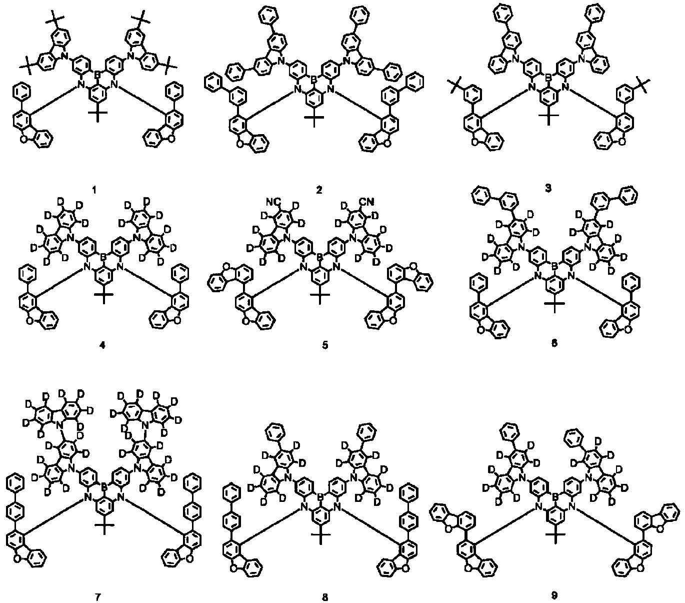

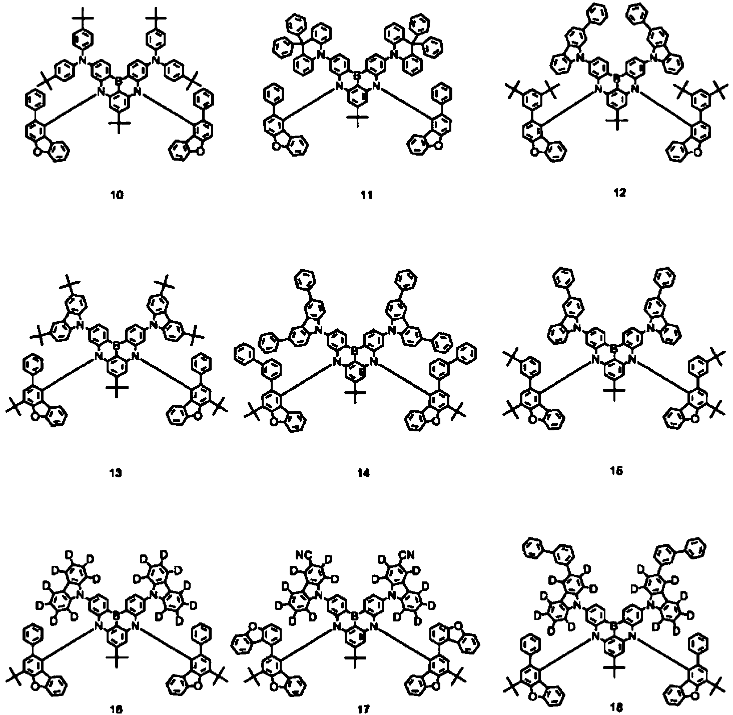

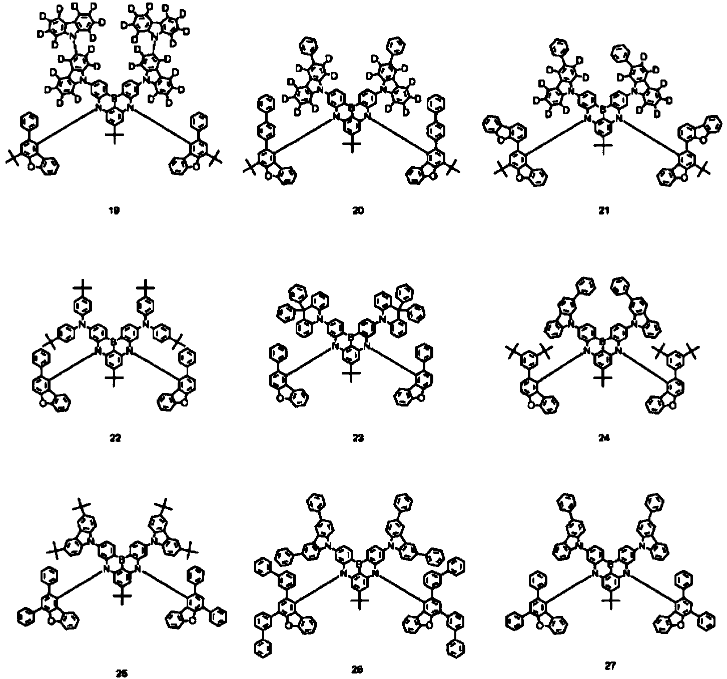

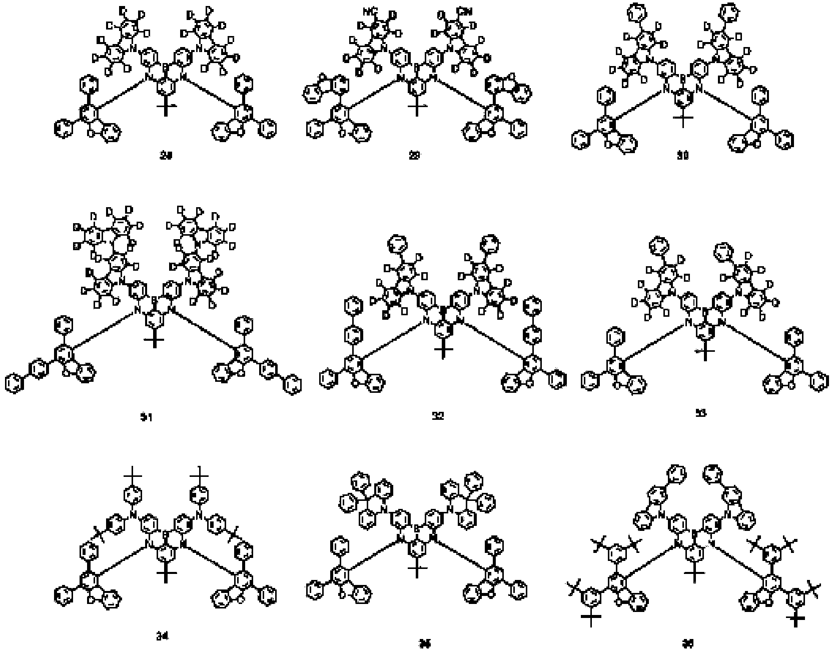

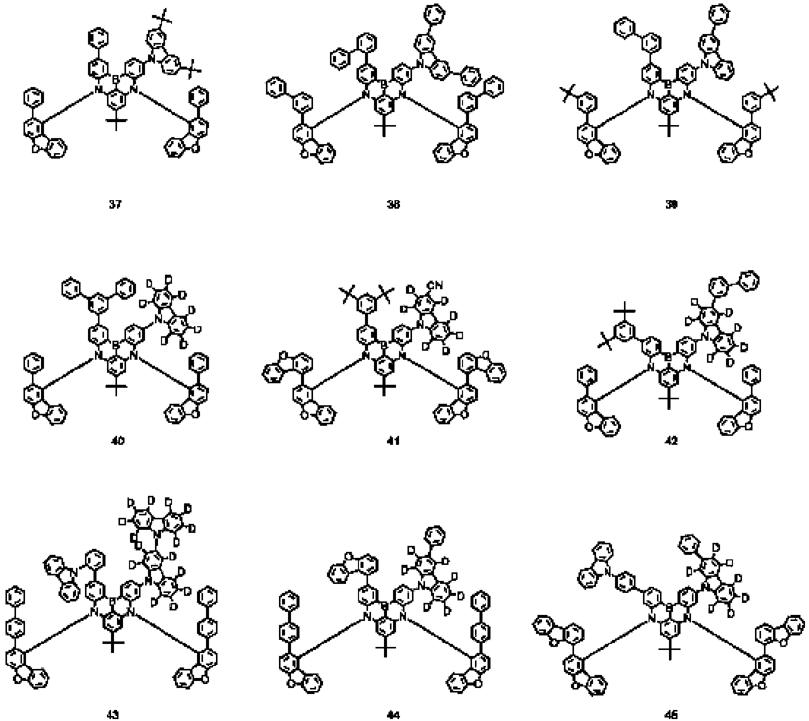

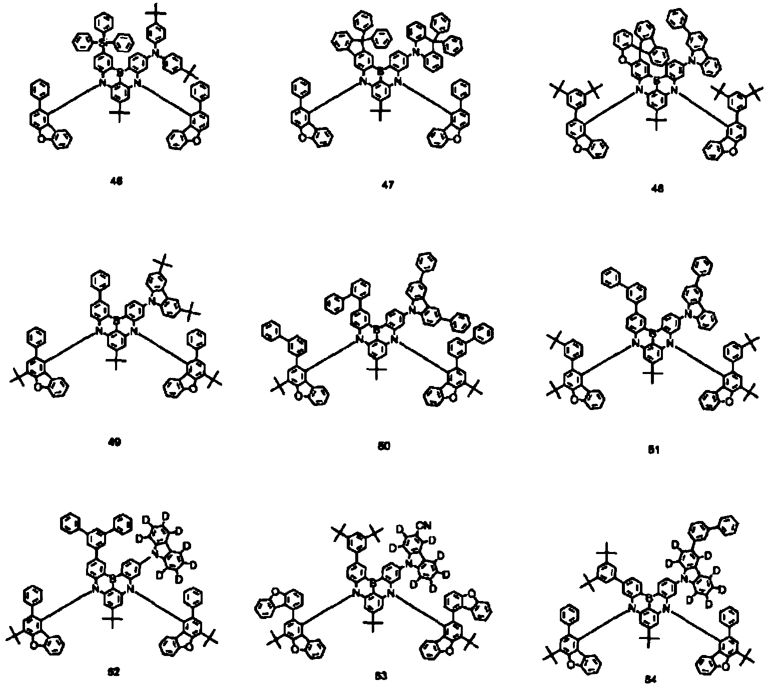

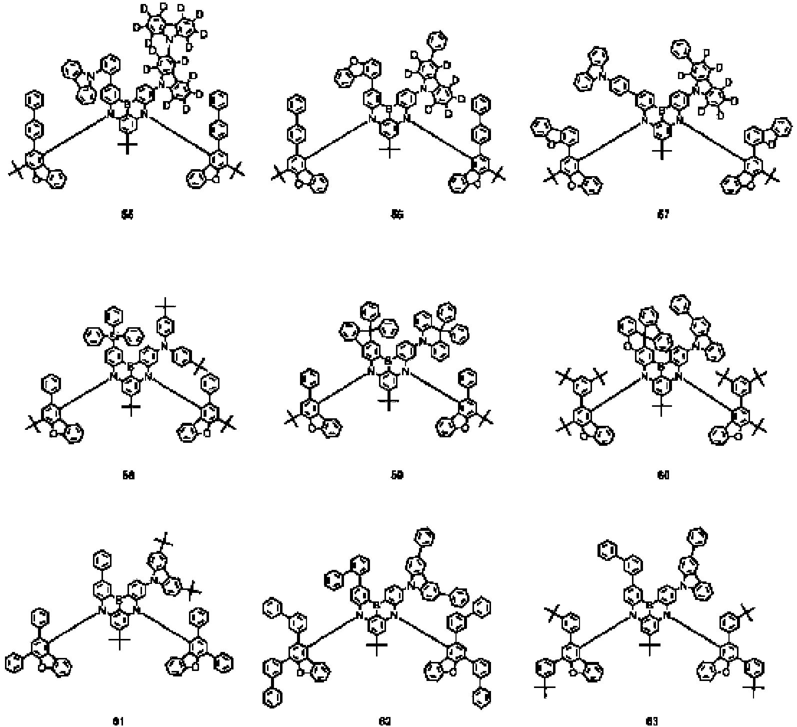

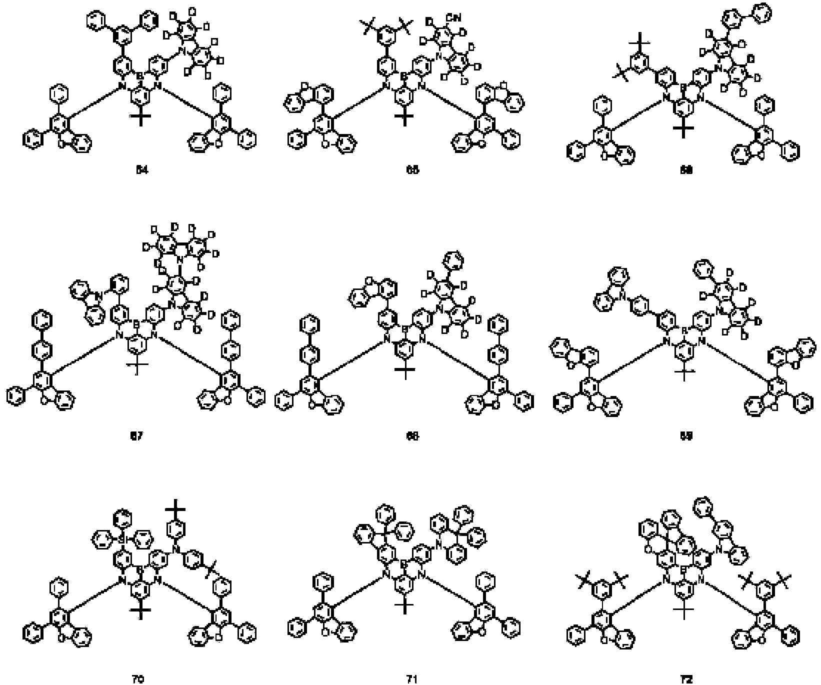

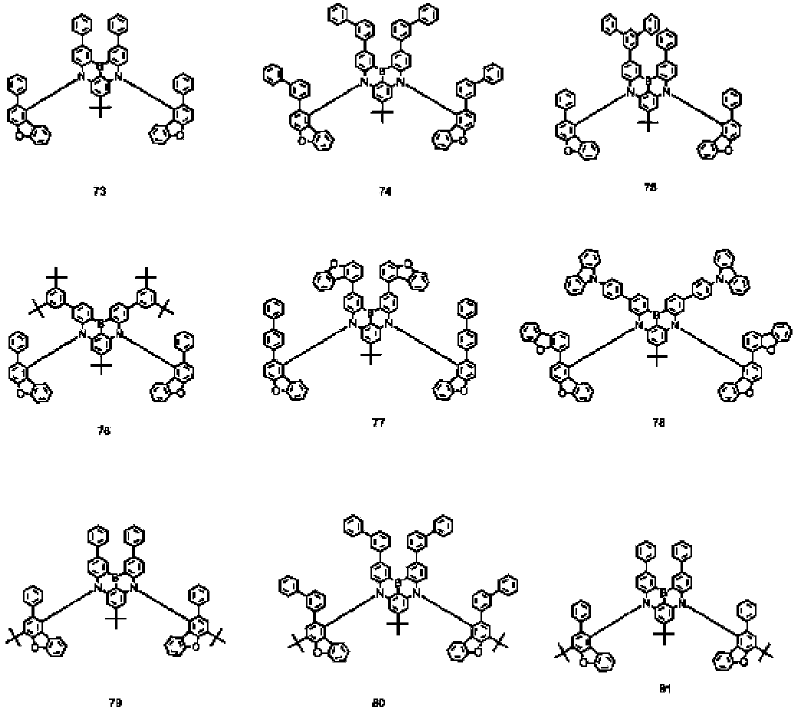

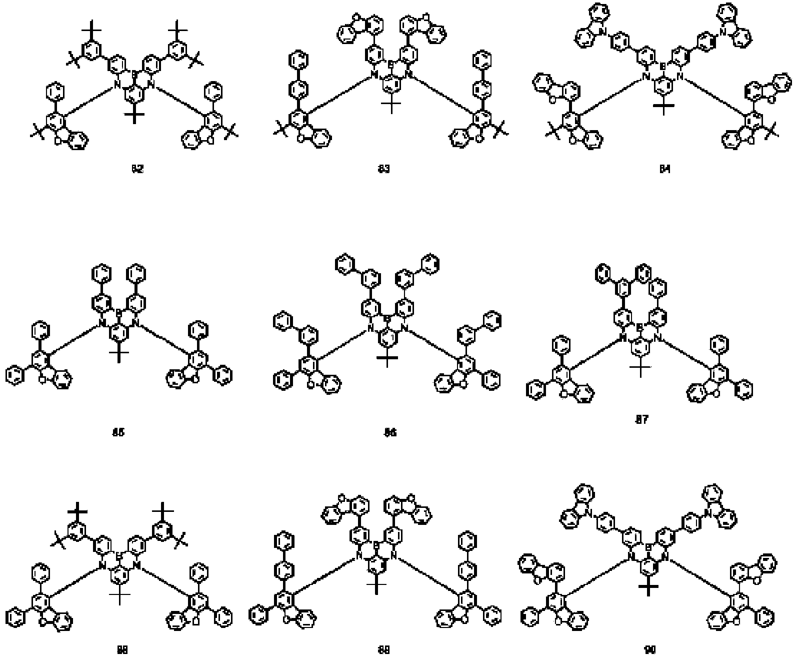

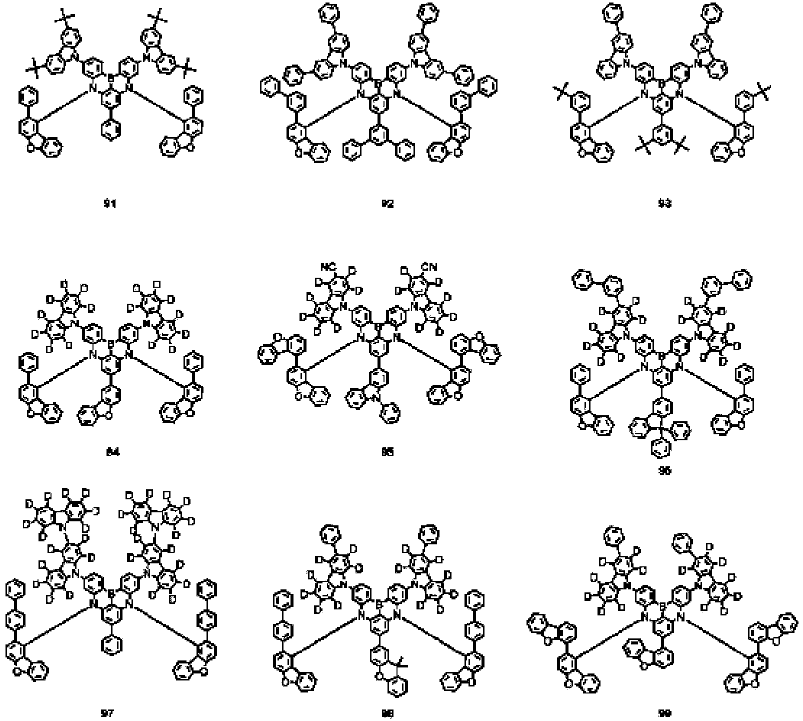

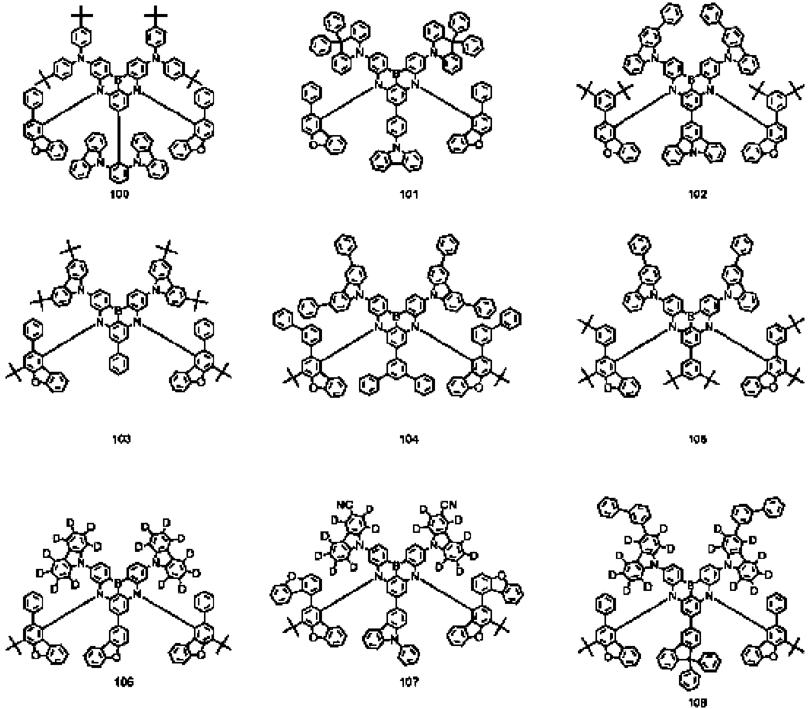

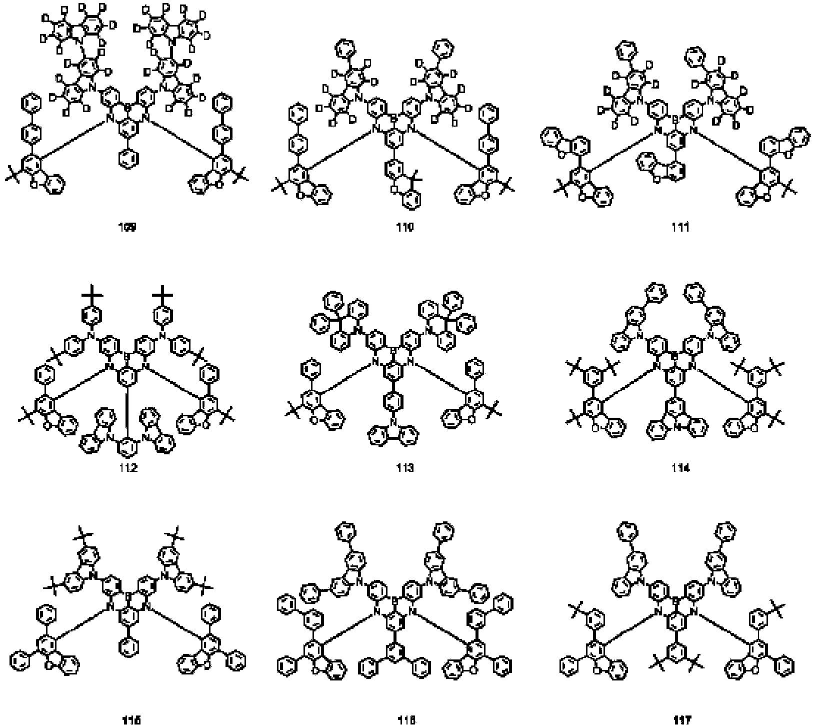

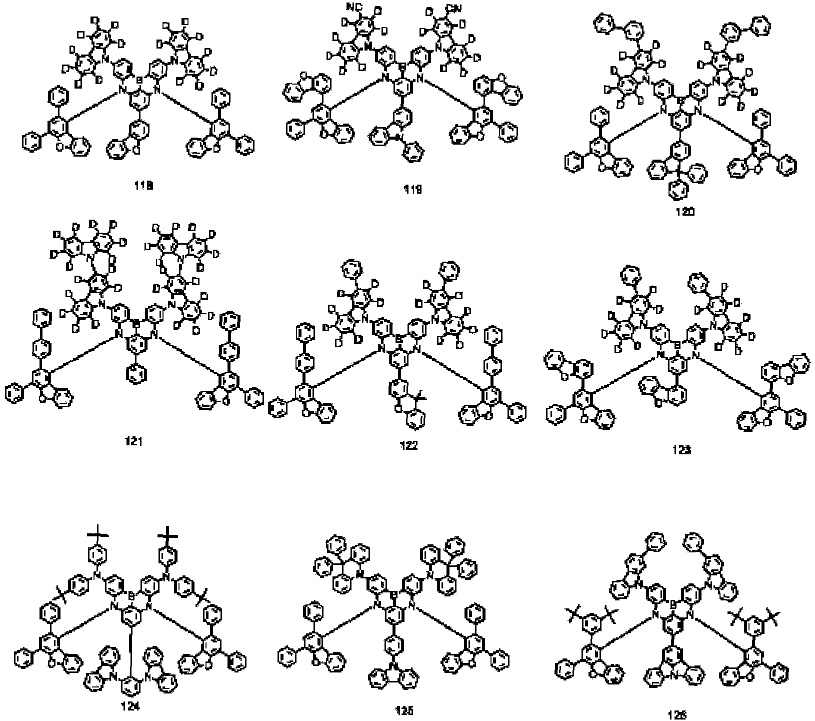

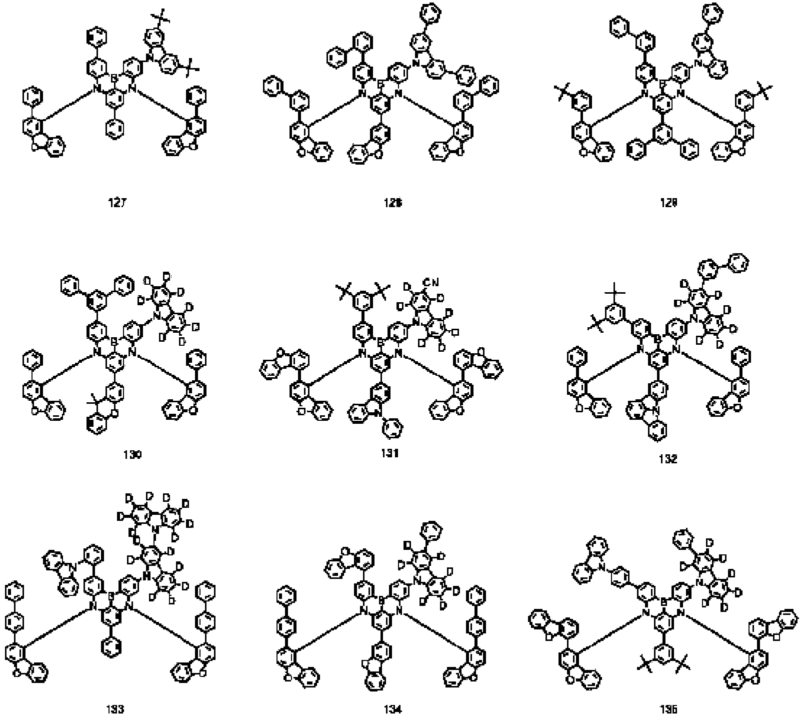

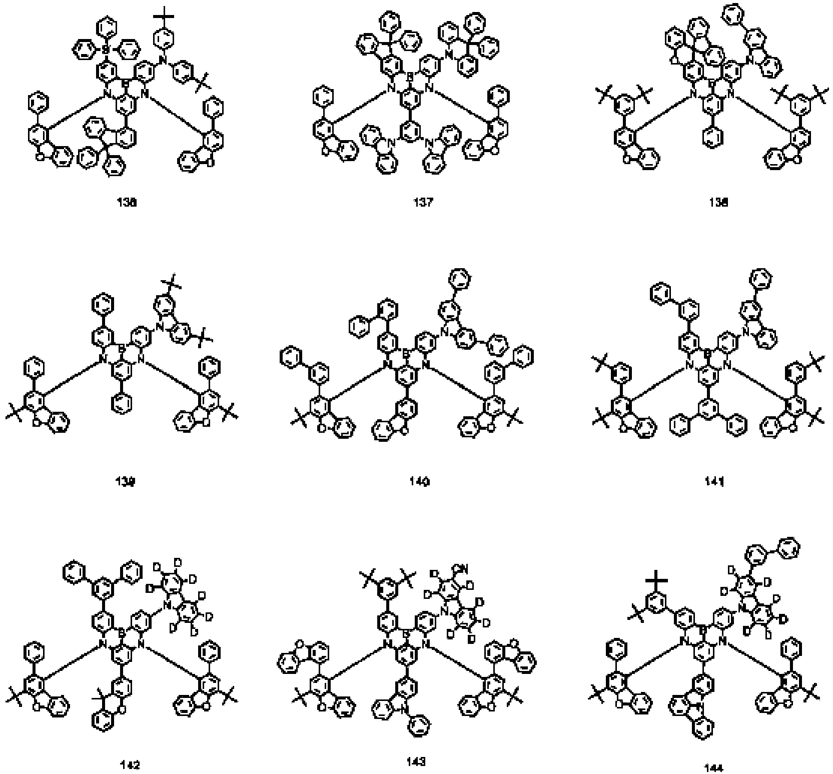

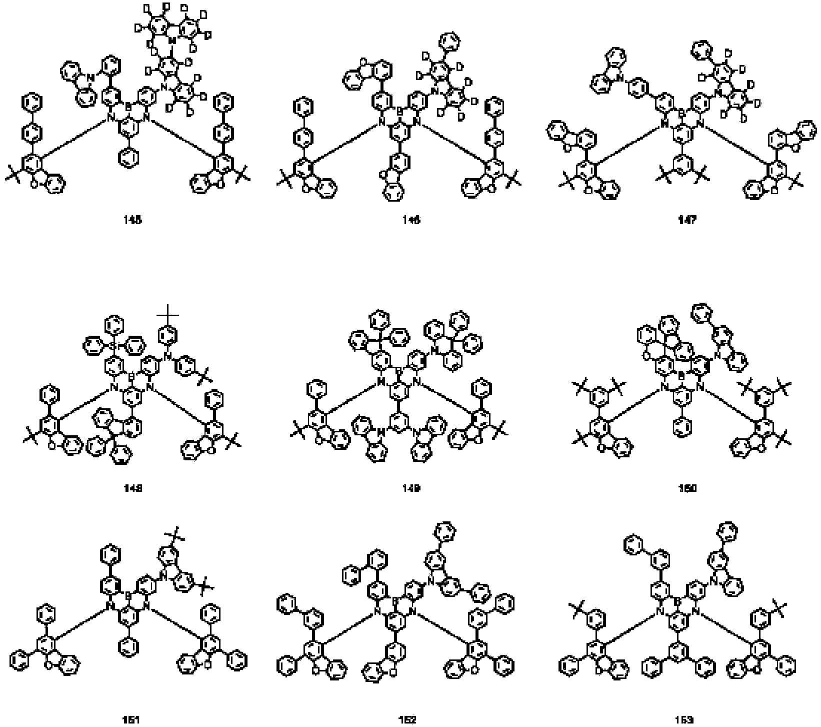

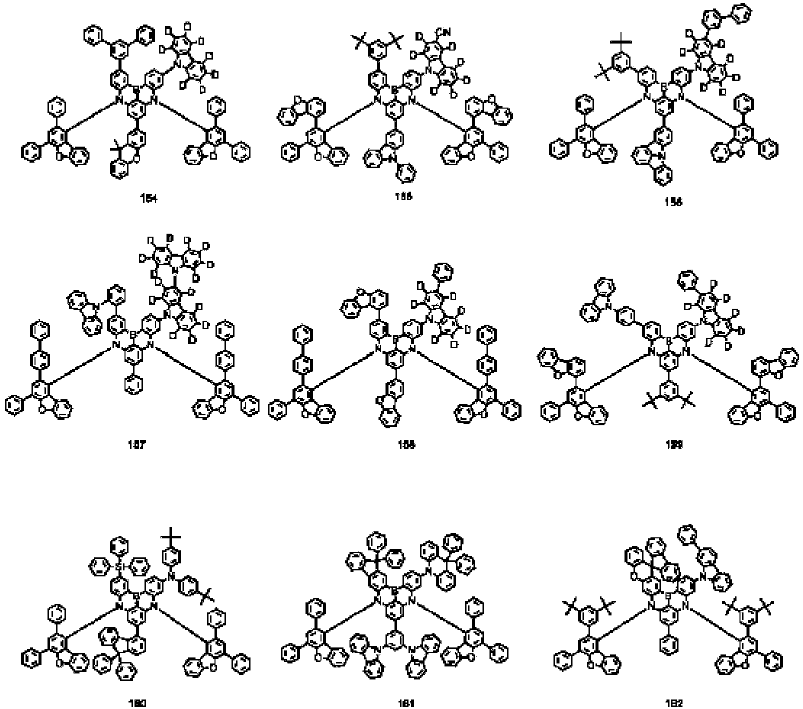

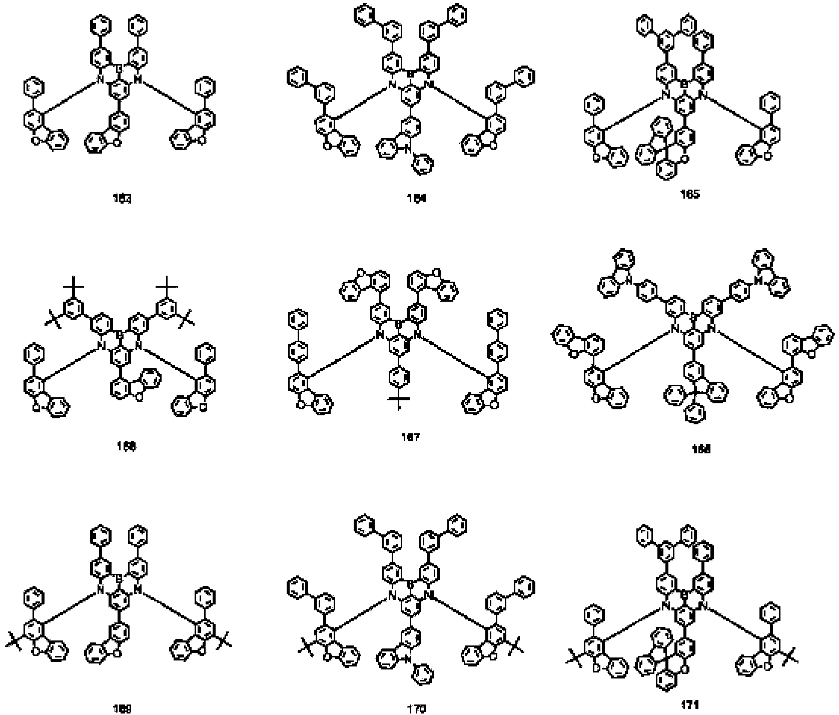

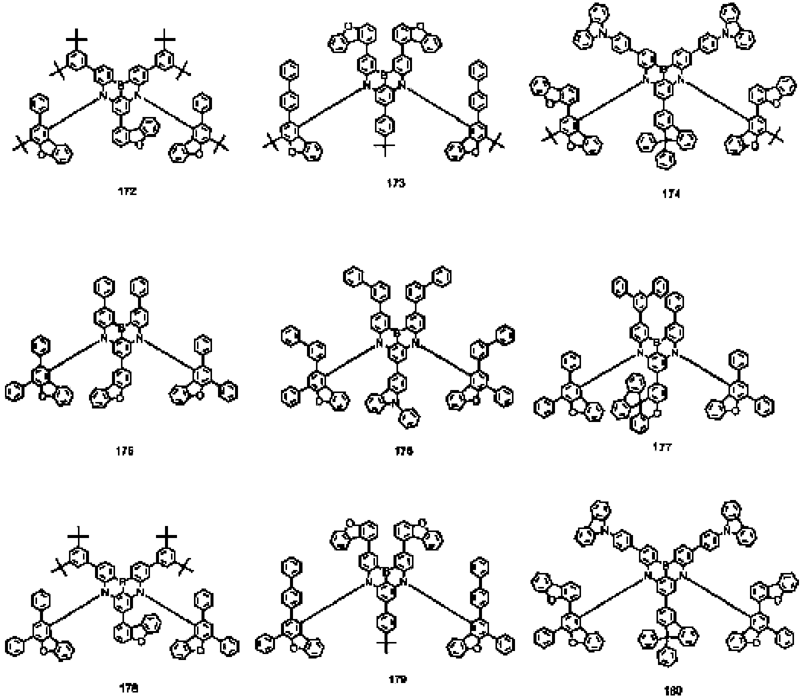

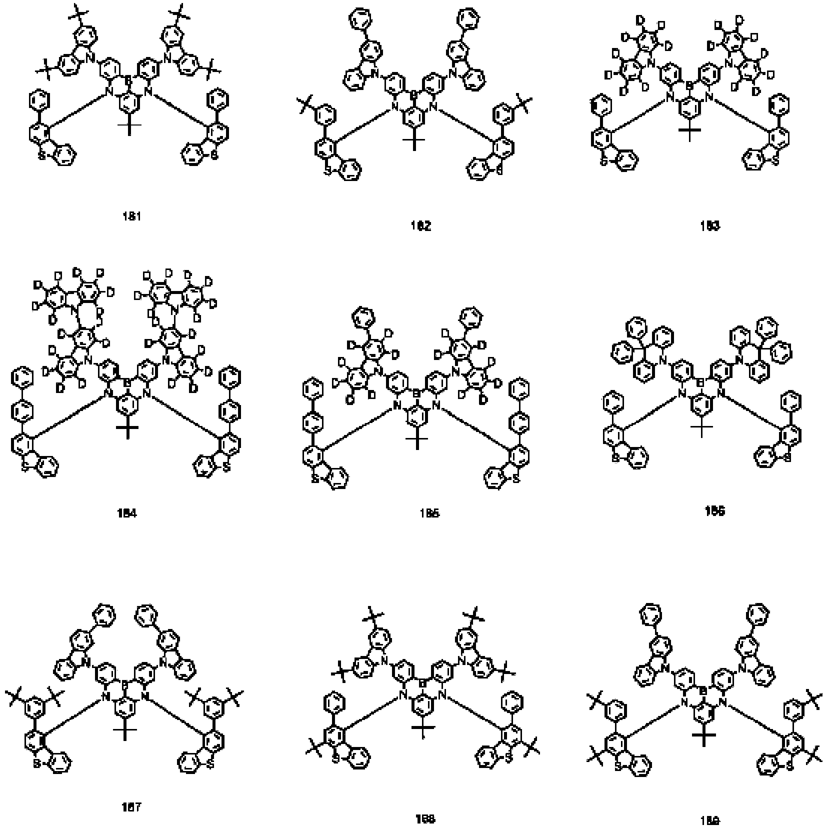

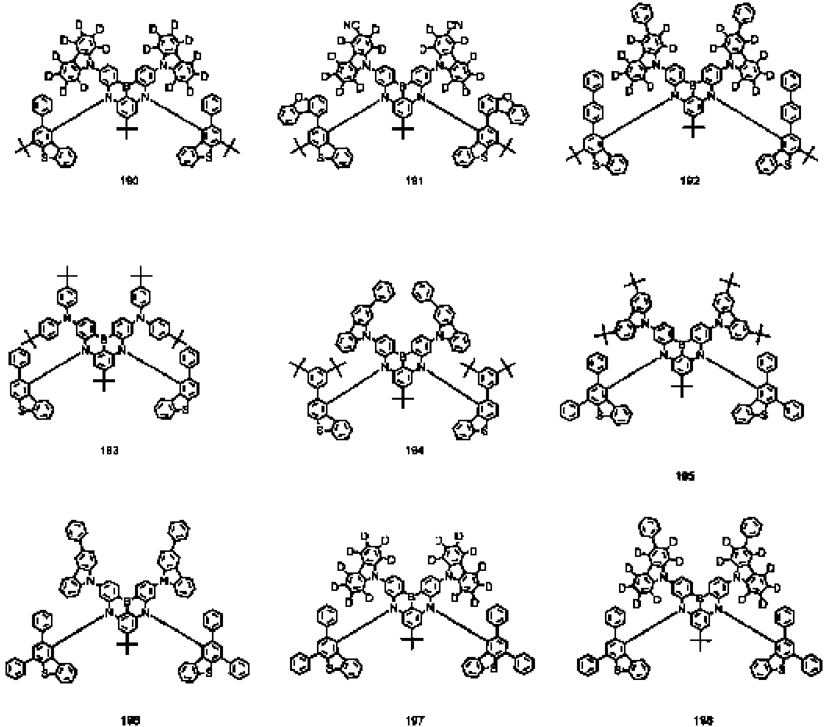

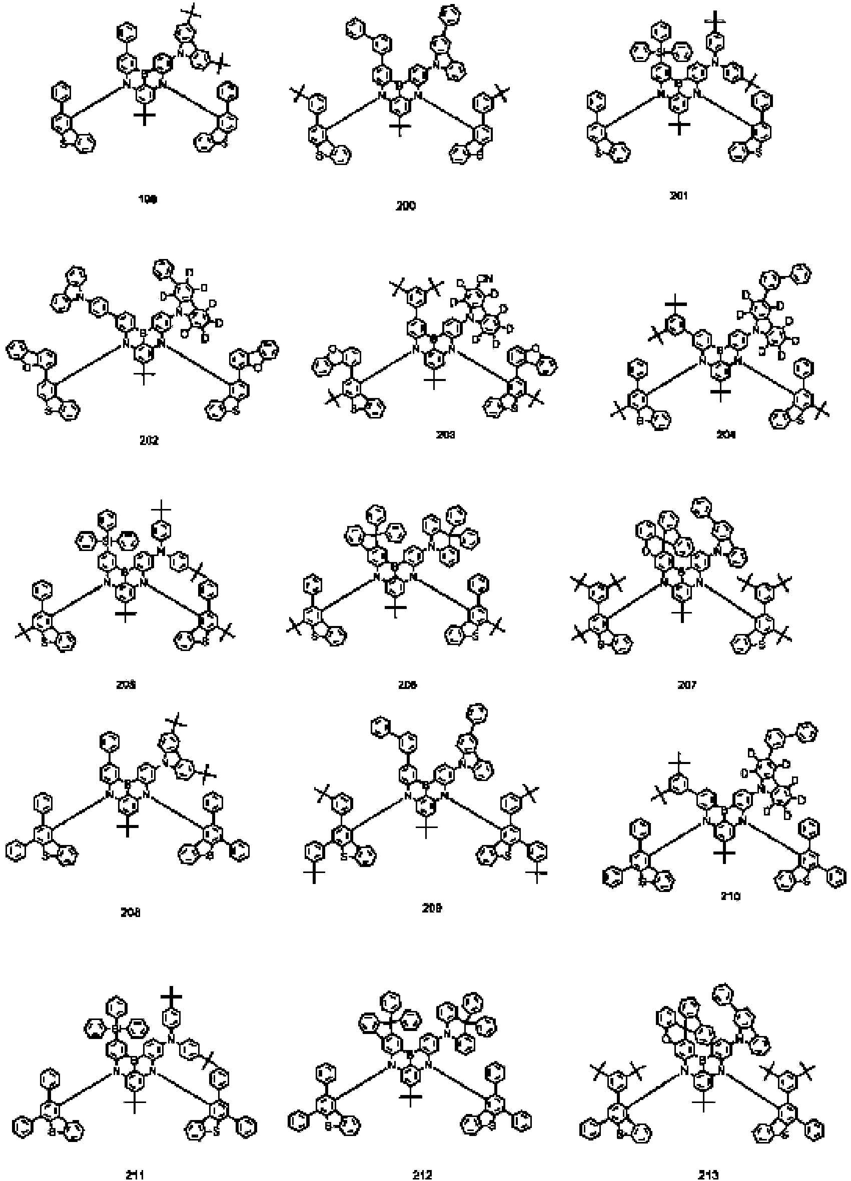

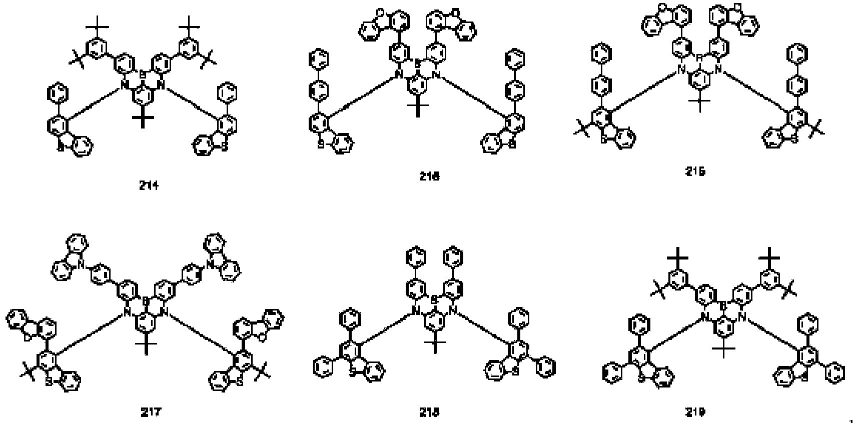

12. Dispositif électroluminescent (ED) comportant :
une première électrode (EL1) ;
une deuxième électrode (EL2) faisant face à la première électrode (EL1) ; et
une couche d'émission (EML) entre la première électrode (EL1) et la deuxième électrode (EL2),
dans lequel la couche d'émission (EML) comporte le composé polycyclique fusionné en tant que premier composé selon l'une quelconque des revendications 1 à 11.

13. Élément électroluminescent (ED) selon la revendication 11, dans lequel la couche d'émission (EML) comporte en outre au moins l'un sélectionné parmi un deuxième composé représenté par la Formule HT-1, un troisième composé représenté par la Formule ET-1, et un quatrième composé représenté par
la Formule D-1 : 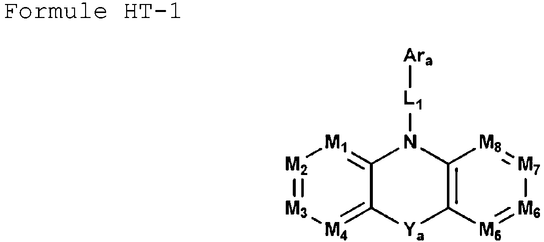
dans la Formule HT-1,
M₁ à M₈ étant chacun indépendamment N ou CR₅₁,
L₁ étant une liaison directe, un groupe arylène substitué ou non substitué de 6 à 30 atomes de carbone formant cycle, ou un groupe hétéroarylène substitué ou non substitué de 2 à 30 atomes de carbone formant cycle,
Yₐ étant une liaison directe, CR₅₂R₅₃, ou SiR₅₄R₅₅,
Arₐ étant un groupe aryle substitué ou non substitué de 6 à 30 atomes de carbone formant cycle ou un groupe hétéroaryle substitué ou non substitué de 2 à 30 atomes de carbone formant cycle, et
R₅₁ à R₅₅ étant chacun indépendamment hydrogène, deutérium, un halogène, un groupe cyano, un groupe silyle substitué ou non substitué, un groupe thio substitué ou non substitué, un groupe oxy substitué ou non substitué, un groupe amine substitué ou non substitué, un groupe bore substitué ou non substitué, un groupe alkyle substitué ou non substitué de 1 à 20 atomes de carbone, un groupe alcényle substitué ou non substitué de 2 à 20 atomes de carbone, un groupe aryle substitué ou non substitué de 6 à 60 atomes de carbone formant cycle, ou un groupe hétéroaryle substitué ou non substitué de 2 à 60 atomes de carbone formant cycle, et/ou combiné avec un groupe adjacent pour former un cycle ; 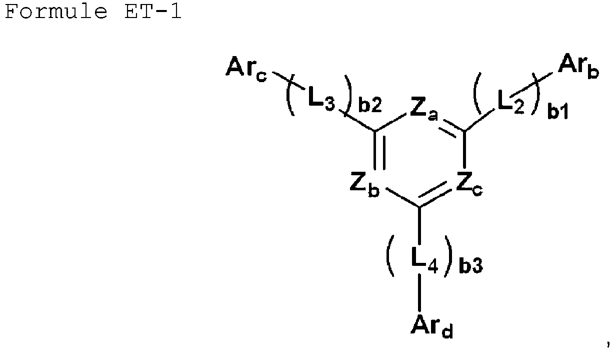 dans la Formule ET-1,
au moins l'un sélectionné parmi Zₐ à Z_{c} étant N, et le reste étant CR₅₆,
R₅₆ étant hydrogène, deutérium, un groupe alkyle substitué ou non substitué de 1 à 20 atomes de carbone, un groupe aryle substitué ou non substitué de 6 à 60 atomes de carbone formant cycle, ou un groupe hétéroaryle substitué ou non substitué de 2 à 60 atomes de carbone formant cycle,
b1 à b3 étant chacun indépendamment un nombre entier de 0 à 10,
Ar_{b} à Ar_{d} étant chacun indépendamment hydrogène, deutérium, un groupe alkyle substitué ou non substitué de 1 à 20 atomes de carbone, un groupe aryle substitué ou non substitué de 6 à 30 atomes de carbone formant cycle, ou un groupe hétéroaryle substitué ou non substitué de 2 à 30 atomes de carbone formant cycle, et
L₂ à L₄ étant chacun indépendamment une liaison directe, un groupe arylène substitué ou non substitué de 6 à 30 atomes de carbone formant cycle, ou un groupe hétéroarylène substitué ou non substitué de 2 à 30 atomes de carbone formant cycle ; et 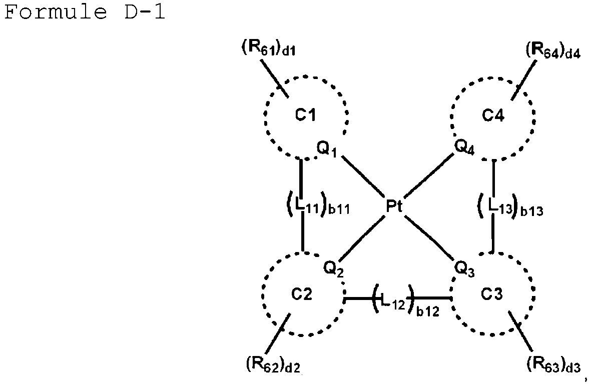 dans la Formule D-1,
Q₁ à Q₄ étant chacun indépendamment C ou N,
C1 à C4 étant chacun indépendamment un cycle hydrocarbure substitué ou non substitué de 5 à 30 atomes de carbone formant cycle ou un hétérocycle substitué ou non substitué de 2 à 30 atomes de carbone formant cycle,
L₁₁ à L₁₃ étant chacun indépendamment une liaison directe, *-O-*, *-S-* 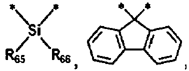 un groupe alkylène substitué ou non substitué de 1 à 20 atomes de carbone, un groupe arylène substitué ou non substitué de 6 à 30 atomes de carbone formant cycle, ou un groupe hétéroarylène substitué ou non substitué de 2 à 30 atomes de carbone formant cycle,
b11 à b13 étant chacun indépendamment 0 ou 1,
R₆₁ à R₆₆ étant chacun indépendamment hydrogène, deutérium, un halogène, un groupe cyano, un groupe silyle substitué ou non substitué, un groupe thio substitué ou non substitué, un groupe oxy substitué ou non substitué, un groupe amine substitué ou non substitué, un groupe bore substitué ou non substitué, un groupe alkyle substitué ou non substitué de 1 à 20 atomes de carbone, un groupe alcényle substitué ou non substitué de 2 à 20 atomes de carbone, un groupe aryle substitué ou non substitué de 6 à 60 atomes de carbone formant cycle, ou un groupe hétéroaryle substitué ou non substitué de 2 à 60 atomes de carbone formant cycle, et
d1 à d4 étant chacun indépendamment un nombre entier de 0 à 4.

14. Panneau d'affichage (DP) comportant :
une couche de base (BS) ;
une couche de circuit (DP-CL) sur la couche de base (BS) ; et
une couche de dispositif d'affichage (DP-ED) sur la couche de circuit (DP-CL) et comportant un élément électroluminescent (ED) tel que défini selon la revendication 12.

15. Panneau d'affichage (DP) selon la revendication 14, dans lequel le panneau d'affichage (DP) comporte en outre une couche de contrôle de lumière (CCL) sur la couche de dispositif d'affichage (DP-ED) et comportant un point quantique,
l'élément électroluminescent étant configuré pour émettre une première lumière colorée, et
la couche de contrôle de lumière (CCL) comporte :
une première partie de contrôle de lumière (CCP1) comportant un premier point quantique (QD1) convertissant une première lumière colorée en une deuxième lumière colorée dans une région de longueurs d'onde plus longue que la première lumière colorée ;
une deuxième partie de contrôle de lumière (CCP2) comportant un deuxième point quantique (QD2) convertissant la première lumière colorée en une troisième lumière colorée dans une région de longueurs d'onde plus longue que la première lumière colorée et la deuxième lumière colorée ; et
une troisième partie de contrôle de lumière (CCP3) configurée pour transmettre la première lumière colorée.
